# EUROPEAN PATENT SPECIFICATION

(11) **EP 3 185 328 B1**
(45) Date of publication and mention of the grant of the patent: **22.05.2024**
(21) Application number: 16191328.0
(22) Date of filing: 29.09.2016
(51) Int. Cl.: C09K 11/02, H10K 50/16, H10K 85/60, H10K 101/30, H10K 101/10, H10K 101/00

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 22.12.2015 KR 20150184075
(43) Date of publication of application: 28.06.2017
(73) Proprietor: Samsung Display Co., Ltd., Gyeonggi-Do (KR)
(72) Inventor: KIM, Seulong, Gyeonggi-do (KR); KIM, Younsun, Gyeonggi-do (KR); SHIN, Dongwoo, Gyeonggi-do (KR); LEE, Jungsub, Gyeonggi-do (KR); ITO, Naoyuki, Gyeonggi-do (KR); LIM, Jino, Gyeonggi-do (KR); JEONG, Hyein, Gyeonggi-do (KR)
(74) Representative: Russell, Tim

(56) References cited:
- WO-A1-2015/093812
- WO-A1-2015/133804
- WO-A2-2015/082046
- YI WEI ET AL: "Emission mechanism of doubly ortho-linked quinoxaline / diphenylfluorene or cis-stilbene / fluorene hybrid compounds based on the transient absorption and emission measurements during pulse radiolysis", JOURNAL OF THE AMERICAN CHEMICAL SOCIETY, THE SOCIETY, vol. 131, no. 19, 20 May 2009 (2009-05-20) , pages 6698-6707, XP002739995, ISSN: 0002-7863, DOI: 10.1021/JA8090005 [retrieved on 2009-04-22]

## Description

### FIELD OF THE INVENTION

The present invention relates to an organic light-emitting device.

### BACKGROUND OF THE INVENTION

Organic light emitting devices are self-emission devices that have wide viewing angles, high contrast ratios, short response times, and/or excellent brightness, driving voltage, and/or response speed characteristics compared to devices in the related art.

An example organic light-emitting device may comprise a first electrode on a substrate, and a hole transport region, an emission layer, an electron transport region, and a second electrode sequentially positioned on the first electrode. Holes provided from the first electrode may move toward the emission layer through the hole transport region, and electrons provided from the second electrode may move toward the emission layer through the electron transport region. Carriers (such as holes and electrons) may recombine in the emission layer to produce excitons. These excitons may transition (e.g., radiatively decay) from an excited state to a ground state to thereby generate light. WO2015/082046 discloses substituted oxepines and their use in optoelectronic devices; and WO2015/093812 and WO2015/133804 disclose organic compounds and their use in electroluminescent devices.

### SUMMARY OF THE INVENTION

The organic light-emitting device of the present invention has the advantages has a low driving voltage and high efficiency.

The present invention provides an organic light-emitting device according to the claims.

### BRIEF DESCRIPTION OF THE DRAWINGS

FIG. 1 is a schematic view of an organic light-emitting device according to an embodiment of the present disclosure.
FIG. 2 is a schematic view of an organic light-emitting device according to an embodiment of the present disclosure.
FIG. 3 is a schematic view of an organic light-emitting device according to an embodiment of the present disclosure.
FIG. 4 is a schematic view of an organic light-emitting device according to an embodiment of the present disclosure.
FIG. 5 is a schematic view of an organic light-emitting device according to an embodiment of the present disclosure.

### DETAILED DESCRIPTION OF THE INVENTION

As used herein, the term "and/or" includes any and all combinations of one or more of the associated listed items. Expressions such as "at least one of", "one of', and "selected from", when preceding a list of elements, modify the entire list of elements and do not modify the individual elements of the list.

The thicknesses of layers, films, panels, regions, etc., may be exaggerated in the drawings for clarity. It will be understood that when an element such as a layer, film, region, or substrate is referred to as being "on" another element, it can be directly on the other element or intervening element(s) may also be present. In contrast, when an element is referred to as being "directly on" another element, no intervening elements are present.

An organic light-emitting device according to the present invention includes a first electrode; a second electrode facing the first electrode; an emission layer between the first electrode and the second electrode; a hole transport region between the first electrode and the emission layer; and an electron transport region between the emission layer and the second electrode, wherein the emission layer may comprise a first compound, and at least one selected from the hole transport region and the electron transport region may comprise a second compound.

The first compound is represented by one selected from Formulae 1A, 1B, 1-4, 1D and 1E, and the second compound is represented by Formula 2A or 2B:

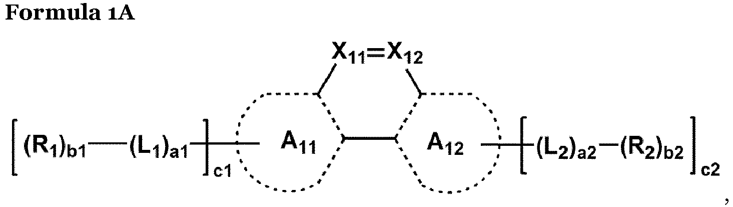

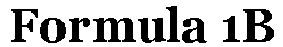

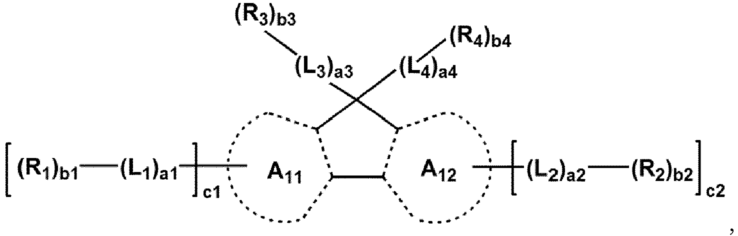

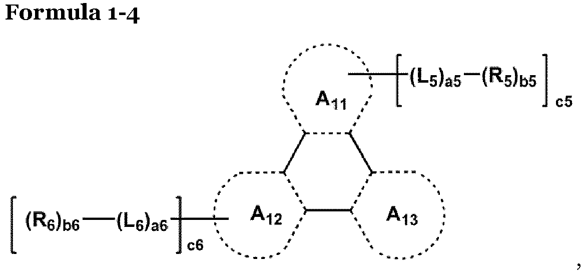

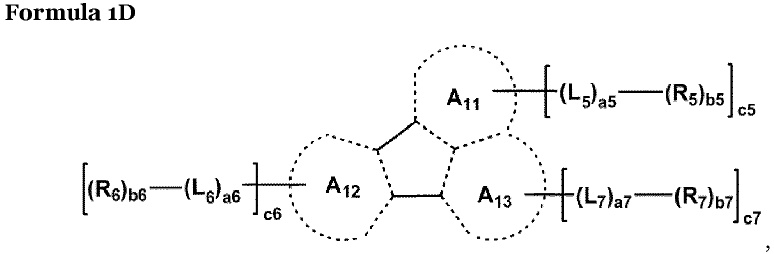

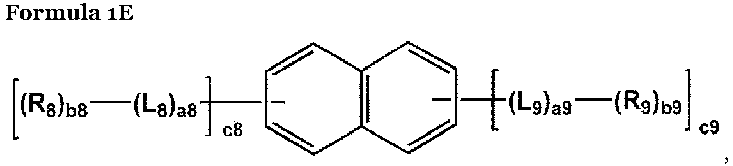

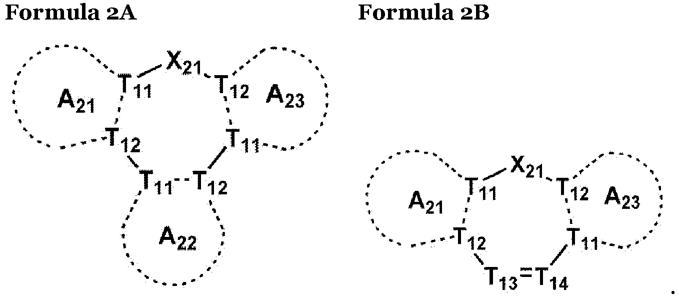

In Formulae 1A, 1B, 1-4 and 1D, rings A₁₁ to A₁₃ are each independently selected from a C₆-C₆₀ aromatic group, a C₁-C₆₀ heteroaromatic group, and a C₆-C₆₀ non-aromatic condensed C₆-C₆₀ polycyclic group.

Rings A₁₁ and A₁₂ in Formula 1A are each fused with a central 6-membered ring that comprises X₁₁ and X₁₂ as ring-forming atoms.

Rings A₁₁ and A₁₂ in Formula 1B are each fused with a central 5-membered ring.

Rings A₁₁ to A₁₃ in Formula 1-4 are each fused with a central 6-membered ring.

Rings A₁₁ to A₁₃ in Formula 1D are each fused with a central 5-membered ring.

For example, rings A₁₁ to A₁₃ in Formula 1A, 1B, 1-4 and 1D may each independently be selected from a benzene group, a naphthalene group, an anthracene group, a phenanthrene group, a pyrene group, a triphenylene group, an indene group, a fluorene group, an azafluorene group, a benzofluorene group, a spiro-bifluorene group, a pyridine group, a pyrazine group, a pyrimidine group, a pyridazine group, a pyrrole group, an imidazole group, a quinoline group, an isoquinoline group, a quinoxaline group, a quinazoline group, a triazine group, an indenopyrazine group, an indenopyridine group, a phenanthroline group, and a phenanthridine group.

In one or more embodiments, rings A₁₁ to A₁₃ in Formulae 1A, 1B, 1-4 and 1D may each independently be selected from a benzene group, a naphthalene group, a phenanthrene group, a triphenylene group, a pyridine group, a pyridazine group, a pyrimidine group, a pyrazine group, an indenopyrazine group, an indenopyridine group, a fluorene group, an azafluorene group, and an indene group, but embodiments of the present disclosure are not limited thereto.

In certatin embodiments, rings A₁₁ to A₁₃ may be independently selected from a C₆-C₆₀ aromatic group, a C₁-C₆₀ heteroaromatic group, and a C₆-C₆₀ non-aromatic condensed polycyclic group.

For example, rings A₁₁ to A₁₃ in Formula 1A, 1B, 1-4 and 1D may each independently be selected from a benzene group, a naphthalene group, an anthracene group, a phenanthrene group, a pyrene group, a triphenylene group, an indene group, a fluorene group, a benzofluorene group, a spiro-bifluorene group, a pyridine group, a pyrazine group, a pyrimidine group, a pyridazine group, a pyrrole group, an imidazole group, a quinoline group, an isoquinoline group, a quinoxaline group, a quinazoline group, a triazine group, an indenopyrazine group, an indenopyridine group, a phenanthroline group, and a phenanthridine group.

In another example of such embodiments, rings A₁₁ to A₁₃ in Formulae 1A, 1B, 1-4 and 1D may each independently be selected from a benzene group, a naphthalene group, a phenanthrene group, a triphenylene group, a pyridine group, a pyridazine group, a pyrimidine group, a pyrazine group, an indenopyrazine group, an indenopyridine group, a fluorene group, and an indene group, but embodiments of the present disclosure are not limited thereto.

Rings A₂₁, A₂₂, and A₂₃ in Formulae 2A and 2B are each independently be selected from a C₅-C₆₀ carbocyclic group and a C₁-C₆₀ heterocyclic group, each substituted with at least one *-[(L₂₂)ₐ₂₂-(R₂₂)_{b22}]. L₂₂, a22, R₂₂, and b22 will be described in detail below.

Each T₁₁ and each T₁₂ in Formulae 2A and 2B is independently selected from carbon (C) and nitrogen (N), two or more of the three T₁₁(s) in Formula 2A may be identical to or different from each other, T₁₃ may be N or C(R₂₇), T₁₄ may be N or C(R₂₈), and each bond between T₁₁ and T₁₂ represented in formulae 2A and 2B as a dashed line is a single bond or a double bond; wherein the six atoms represented by T₁₁s and T₁₂s in Formula 2A are not all nitrogen, and the six atoms represented by T₁₁s, T₁₂s, T₁₃, and T₁₄ in Formula 2B are not all nitrogen. Any one of the three T11s in formula 2A may be different from each of the other two T₁₁s, identical to each of the other two T11s, or identical to one of the other two T₁₁s and different from one of the other two T11s. Any one of the three T₁₂s in formula 2A may be different from each of the other two T12s, identical to each of the other two T12s, or identical to one of the other two T₁₂s and different from one of the other two T12s. Any one of the two T₁₁s in Formula 2B may be different from the other T11 or identical to the other T11. Any one of the two T₁₂s in Formula 2B may be different from the other T12 or identical to the other T12. Rings A₂₁, A₂₂, and A₂₃ are each be condensed (e.g., fused) with a central 7-membered ring in Formulae 2A and 2B (i.e. the 7-membered ring formed by the three T₁₁s, three T12s and X21 in formula 2A; and the 7-membered ring formed by the two T₁₁s, two T12s, T13, T14 and X21 in formula 2B), such that rings A₂₁, A₂₂, and A₂₃ each share a T11 and a T₁₂ with the central 7-membered ring.

Each *-[(L₂₂)ₐ₂₂-(R₂₂)_{b22}] in ring A₂₁, *-[(L₂₂)ₐ₂₂-(R₂₂)_{b22}] in ring A₂₂, and *-[(L₂₂)ₐ₂₂-(R₂₂)_{b22}] in ring A₂₃ may be identical to or different from each other.

In one or more embodiments, when the number of *-[(L₂₂)ₐ₂₂-(R₂₂)_{b22}](s) in ring A₂₁ is two or more, the two or more *-[(L₂₂)ₐ₂₂-(R₂₂)_{b22}](s) may be identical to or different from each other; when the number of *-[(L₂₂)ₐ₂₂-(R₂₂)_{b22}](s) in ring A₂₂ is two or more, the two or more *-[(L₂₂)ₐ₂₂-(R₂₂)_{b22}](s) may be identical to or different from each other; and when the number of *-[(L₂₂)ₐ₂₂-(R₂₂)_{b22}](s) in ring A₂₃ is two or more, the two or more *-[(L₂₂)ₐ₂₂-(R₂₂)_{b22}](s) may be identical to or different from each other.

In one embodiment, rings A₂₁, A₂₂, and A₂₃ in Formulae 2A and 2B may each independently be selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrole group, a cyclopentanaphthalene group, a naphthosilole group, a naphthoselenothiophene group, a naphthofuran group, a naphthothiophene group, a pyrroloquinoline group, a cyclopentaquinoline group, a siloloquinoline group, a selenophenoquinoline group, a furoquinoline group, a thienoquinoline group, a pyrroloisoquinoline group, a cyclopentaisoquinoline group, a siloloisoquinoline group, a selenophenoisoquinoline group, a furoisoquinoline group, a thienoisoquinoline group, an azacarbazole group, an azafluorene group, an azadibenzosilole group, an azadibenzoselenophene group, an azadibenzofuran group, an azadibenzothiophene group, an indenoquinoline group, an indenoisoquinoline group, an indenoquinoxaline group, a phenanthroline group, and an naphthoindole group, each substituted with at least one *-[(L₂₂)ₐ₂₂-(R₂₂)_{b22}].

In one or more embodiments, when rings A₂₁, A₂₂, and A₂₃ in the second compound represented by Formula 2A or 2B are all (e.g., simultaneously) benzene groups, they are not each substituted with at least one *-[(L₂₂)ₐ₂₂-(R₂₂)_{b22}].

In one or more embodiments, rings A₂₁, A₂₂, and A₂₃ in Formulae 2A and 2B may each independently be selected from groups represented by Formulae 2-1 to 2-36, each substituted with at least one *-[(L₂₂)ₐ₂₂-(R₂₂)_{b22}]:

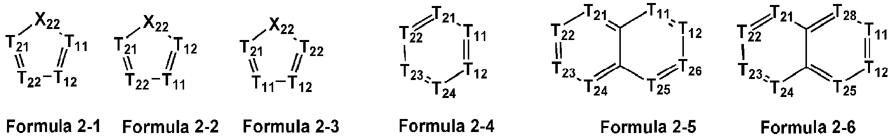

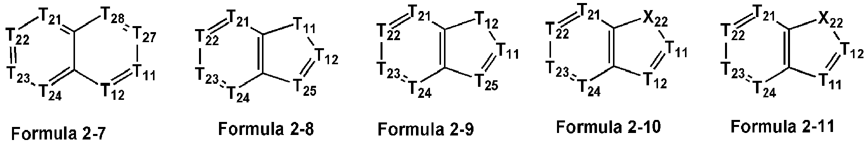

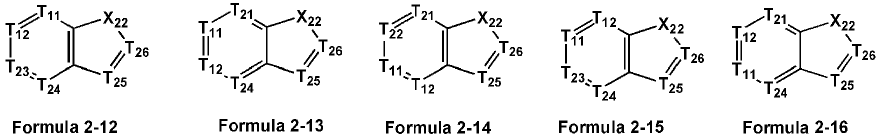

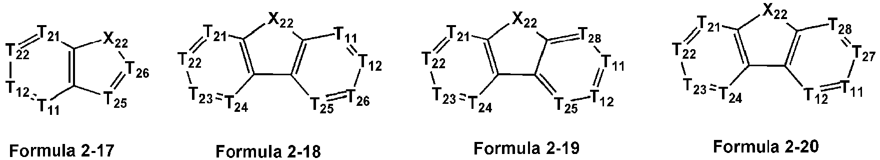

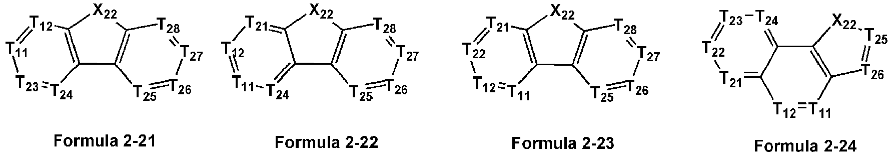

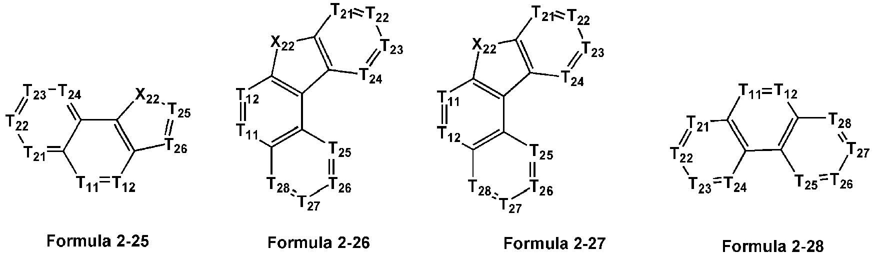

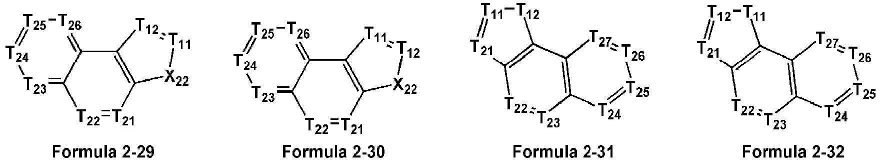

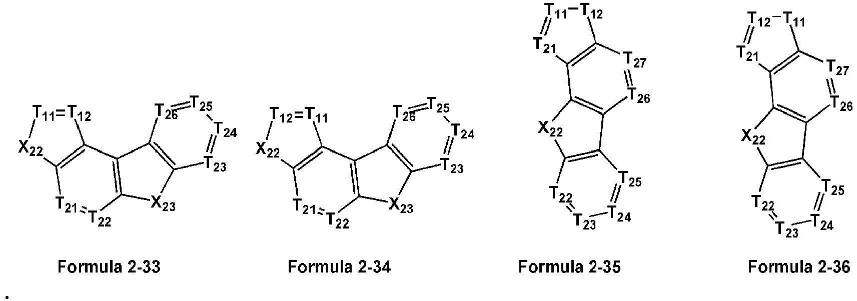

In Formulae 2-1 to 2-36,
T₁₁ and T₁₂ may each independently be the same as described herein in connection with Formulae 2A and 2B,
X₂₂ and X₂₃ may each independently be selected from oxygen (O), sulfur (S), selenium (Se), a moiety comprising C, a moiety comprising N, and a moiety comprising Si,
T₂₁ to T₂₈ may each independently be selected from N and a moiety comprising C.
When rings A₂₁ to A₂₃ comprise both X₂₂ and X₂₃, X₂₂ and X₂₃ may be identical to or different from each other.

For example, in Formulae 2-1 to 2-36, X₂₂ and X₂₃ may each independently be selected from O, S, Se, C(R₂₅)(R₂₆), N-[(L₂₂)ₐ₂₂-(R₂₂)_{b22}], and Si(R₂₅)(R₂₆), and T₂₁ to T₂₈ may each independently be selected from N and C-[(L₂₂)ₐ₂₂-(R₂₂)_{b22}]. R₂₅ and R₂₆ may each independently be selected from groups represented by *-[(L₂₂)ₐ₂₂-(R₂₂)_{b22})].

In one or more embodiments, rings A₂₁, A₂₂, and A₂₃ in Formulae 2A and 2B may each independently be selected from groups represented by Formulae 2-101 to 2-229:

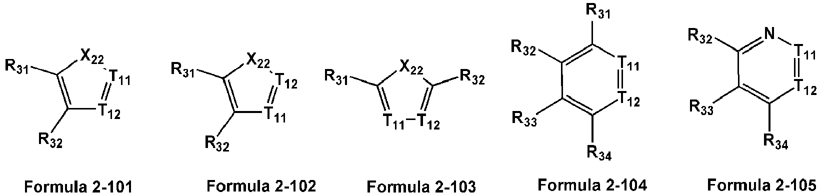

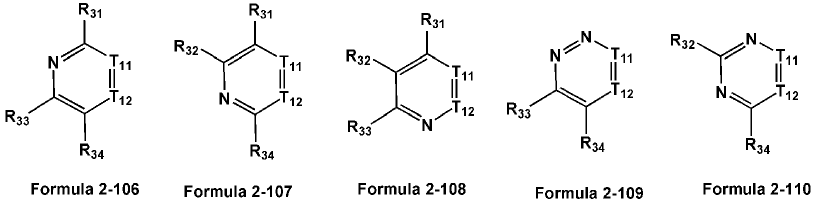

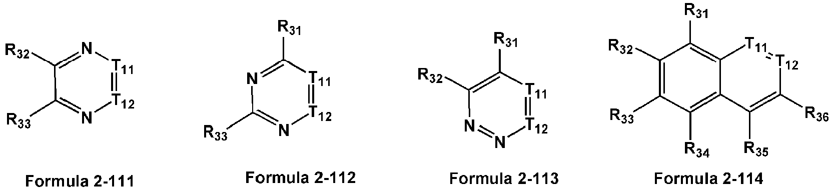

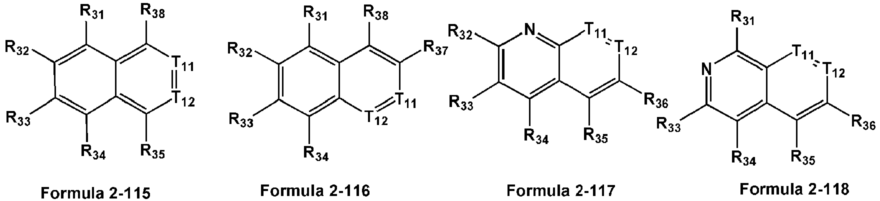

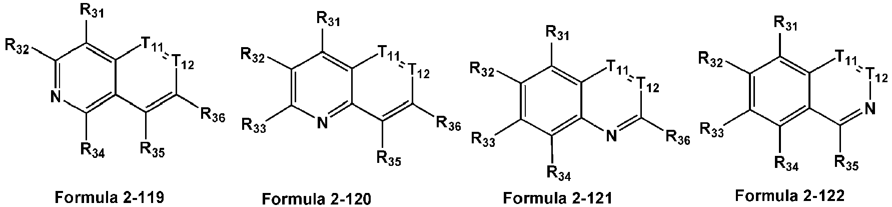

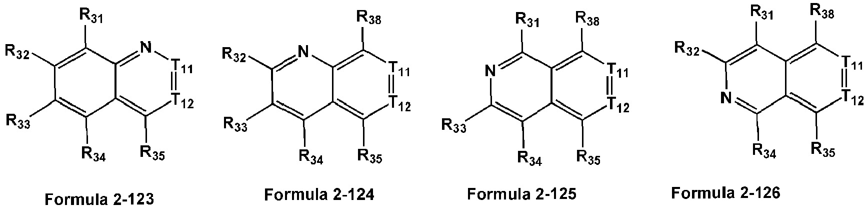

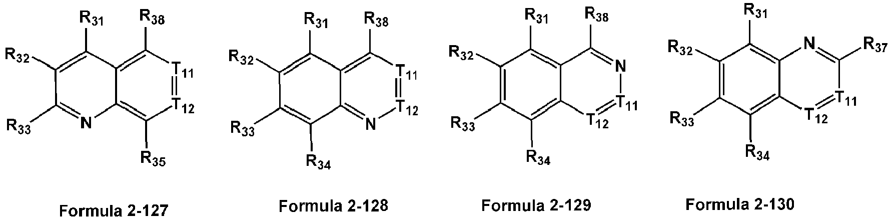

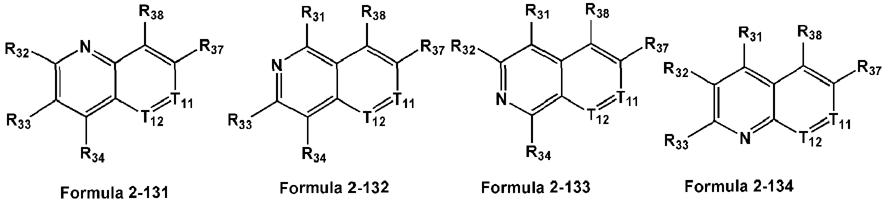

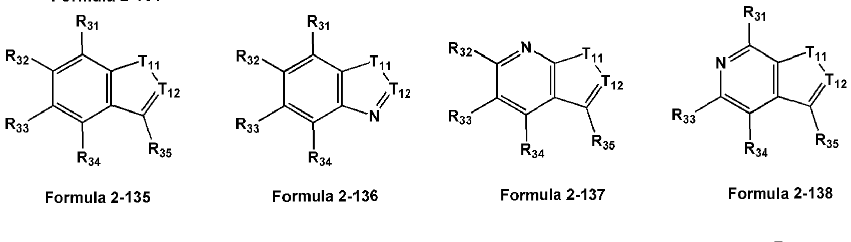

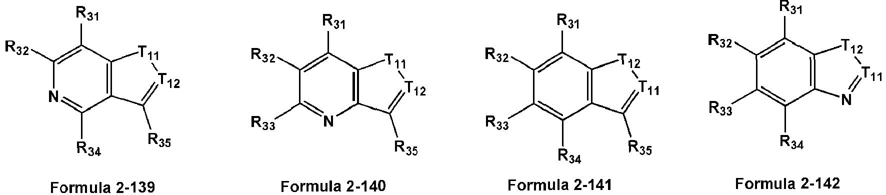

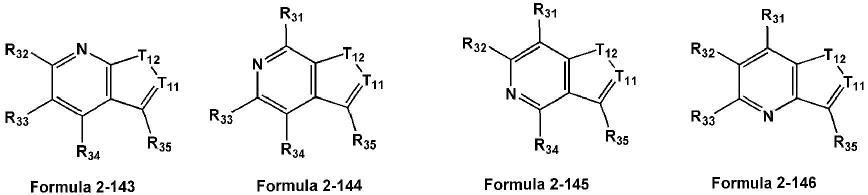

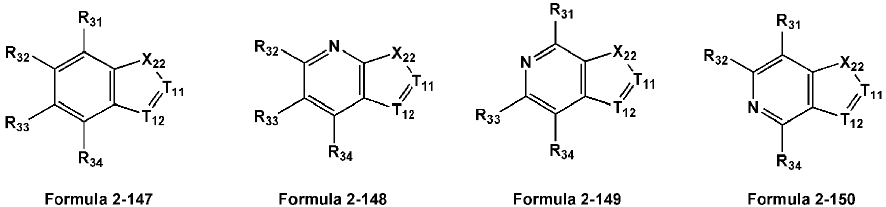

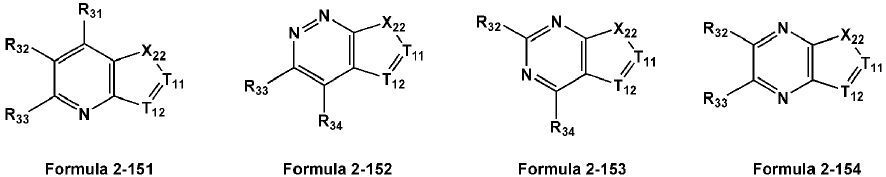

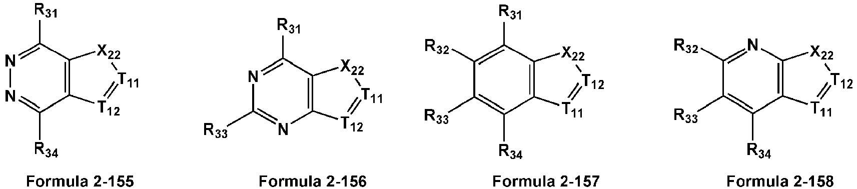

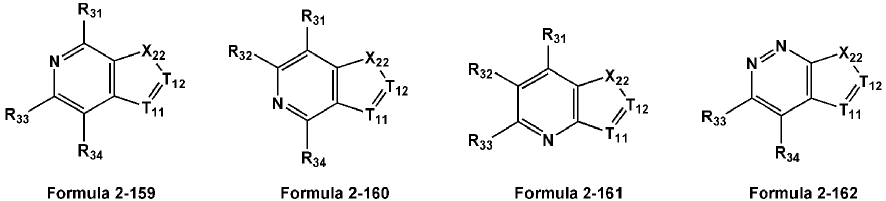

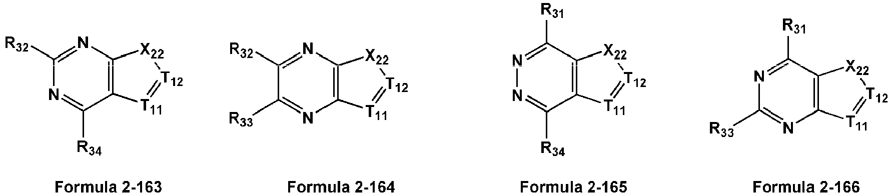

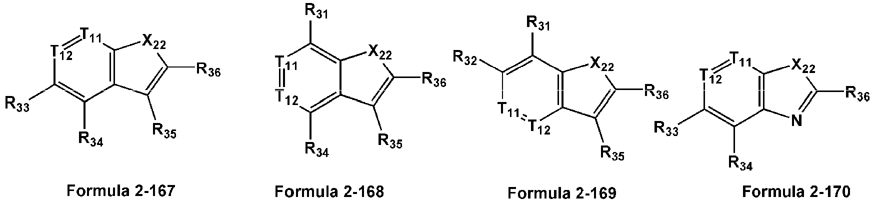

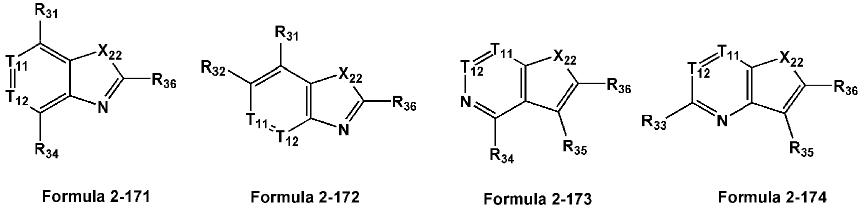

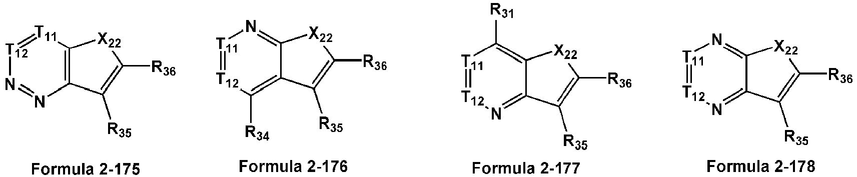

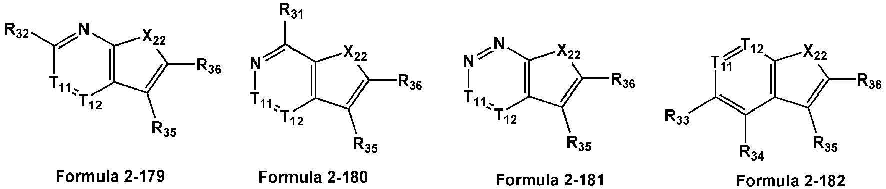

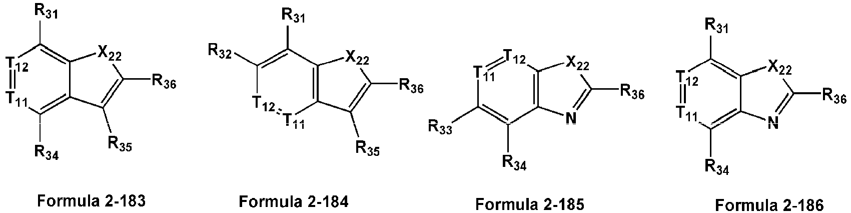

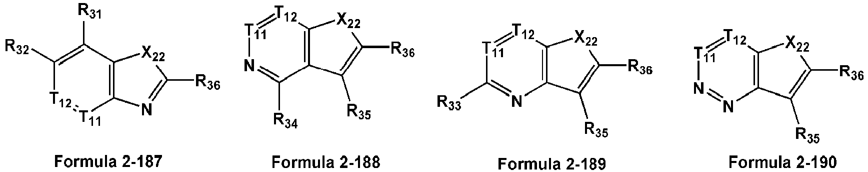

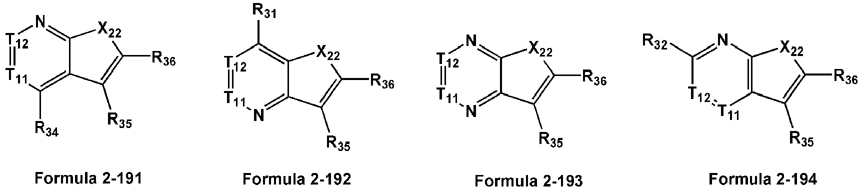

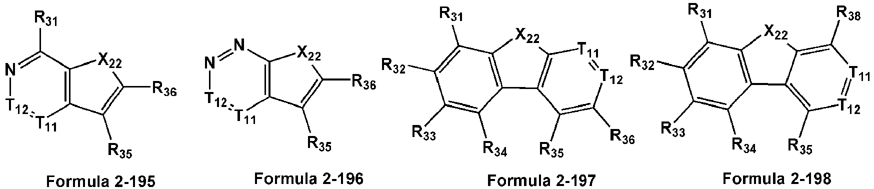

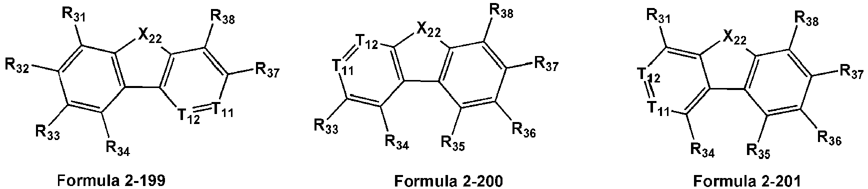

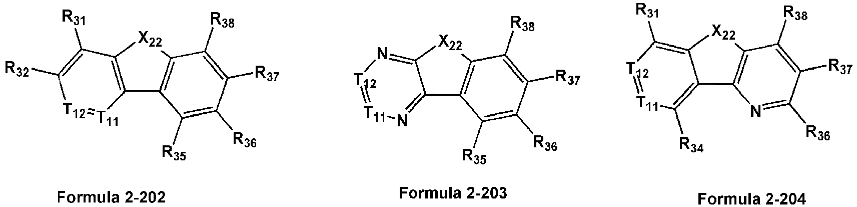

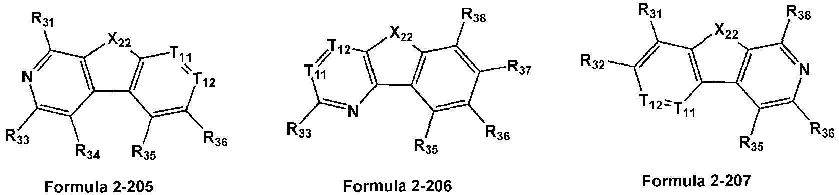

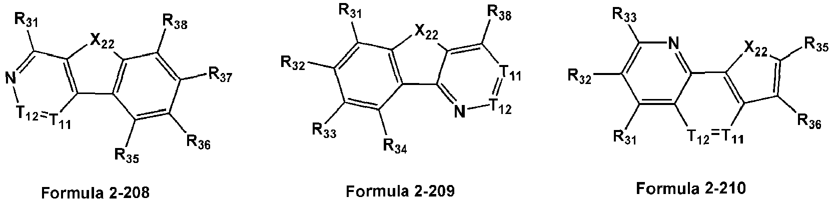

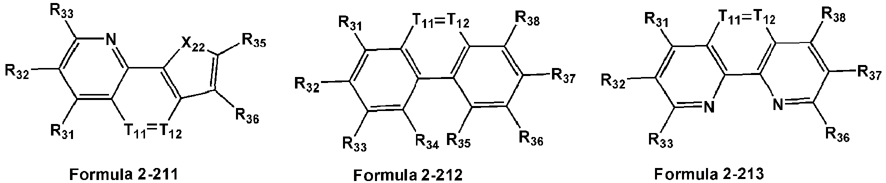

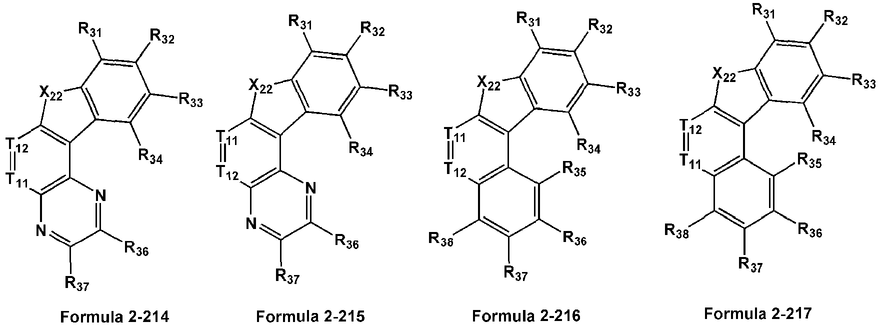

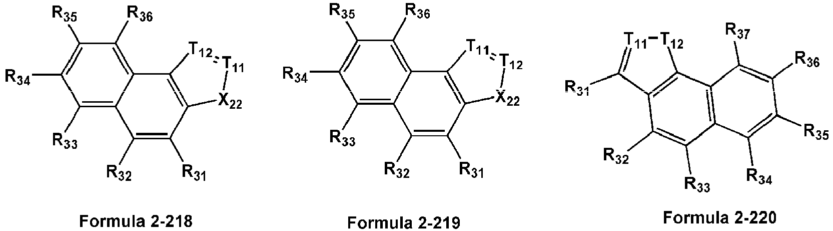

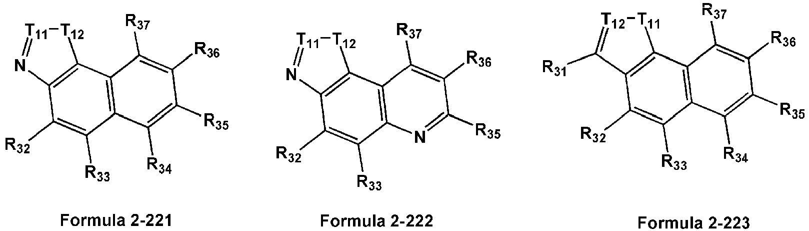

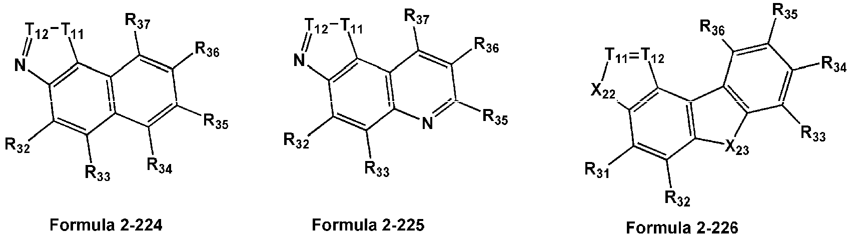

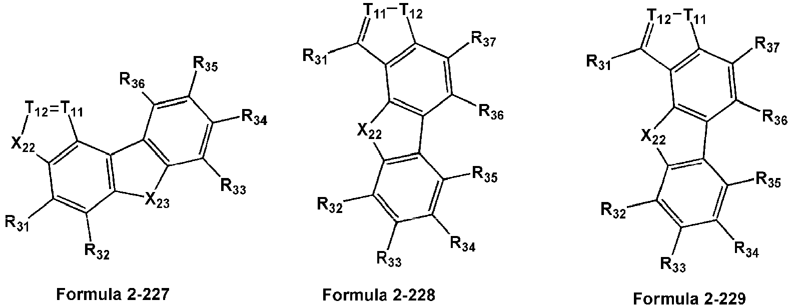

In Formulae 2-101 to 2-229,
T₁₁ and T₁₂ may each independently be the same as described above,
X₂₂ and X₂₃ may each independently be the same as described above, and
R₃₁ to R₃₈ may each independently be selected from substituents represented by *-[(L₂₂)ₐ₂₂-(R₂₂)_{b22}].
When the number of *-[(L₂₂)ₐ₂₂-(R₂₂)_{b22}](s) in R₃₁ to R₃₈ is 2 or more, the 2 or more *-[(L₂₂)ₐ₂₂-(R₂₂)_{b22}](s) may be identical to or different from each other.

In some embodiments, when the number of *-[(L₂₂)ₐ₂₂-(R₂₂)_{b22}](s) in R₃₁ to R₃₈ is 2 or more, no more than 2 *-[(L₂₂)ₐ₂₂-(R₂₂)_{b22}](s) is a cyclic group or contains a cyclic group. In some embodiments, when the number of *-[(L₂₂)ₐ₂₂-(R₂₂)_{b22}](s) in R₃₁ to R₃₈ is 2 or more, no more than 1 *-[(L₂₂)ₐ₂₂-(R₂₂)_{b22}] is a cyclic group or contains a cyclic group. In some embodiments, when the number of *-[(L₂₂)ₐ₂₂-(R₂₂)_{b22}](s) in R₃₁ to R₃₈ is 2 or more, no more than 2 *-[(L₂₂)ₐ₂₂-(R₂₂)_{b22}](s) is other than hydrogen. In some embodiments, when the number of *-[(L₂₂)ₐ₂₂-(R₂₂)_{b22}](s) in R₃₁ to R₃₈ is 2 or more, no more than 1 *-[(L₂₂)ₐ₂₂-(R₂₂)_{b22}] is other than hydrogen.In one or more embodiments, the case in which rings A₂₁, A₂₂, and A₂₃ in Formulae 2A and 2B are all (e.g., simultaneously) represented by Formula 2-104 is excluded.

In one or more embodiments, the second compound represented by Formula 2A or 2B may be represented by one selected from Formulae 2-201A to 2-269A (denoting a formula based on Formula 2A), and rings A₂₁, A₂₂, and A₂₃ in Formulae 2-201A to 2-269A may each be selected from the formulae shown in Table 1:

**Table 1**

| Formula No. | Formula No. of ring A₂₁ | Formula No. of ring A₂₂ | Formula No. of ring A₂₃ |
|---|---|---|---|
| 2-201A | 2-2 | 2-4 | 2-4 |
| 2-202A | 2-4 | 2-4 | 2-1 |
| 2-203A | 2-4 | 2-4 | 2-2 |
| 2-204A | 2-4 | 2-4 | 2-3 |
| 2-205A | 2-4 | 2-1 | 2-4 |
| 2-206A | 2-4 | 2-2 | 2-4 |
| 2-207A | 2-4 | 2-4 | 2-10 |
| 2-208A | 2-11 | 2-4 | 2-4 |
| 2-209A | 2-4 | 2-4 | 2-11 |
| 2-210A | 2-4 | 2-10 | 2-4 |
| 2-211A | 2-4 | 2-4 | 2-8 |
| 2-212A | 2-4 | 2-9 | 2-4 |
| 2-213A | 2-4 | 2-4 | 2-14 |
| 2-214A | 2-17 | 2-4 | 2-4 |
| 2-215A | 2-4 | 2-4 | 2-15 |
| 2-216A | 2-13 | 2-4 | 2-4 |
| 2-217A | 2-4 | 2-4 | 2-16 |
| 2-218A | 2-4 | 2-4 | 2-13 |
| 2-219A | 2-16 | 2-4 | 2-4 |
| 2-220A | 2-4 | 2-4 | 2-12 |
| 2-221A | 2-4 | 2-4 | 2-17 |
| 2-222A | 2-4 | 2-16 | 2-4 |
| 2-223A | 2-4 | 2-15 | 2-4 |
| 2-224A | 2-4 | 2-14 | 2-4 |
| 2-225A | 2-4 | 2-17 | 2-4 |
| 2-226A | 2-19 | 2-4 | 2-4 |
| 2-227A | 2-22 | 2-4 | 2-4 |
| 2-228A | 2-18 | 2-4 | 2-4 |
| 2-229A | 2-23 | 2-4 | 2-4 |
| 2-230A | 2-21 | 2-4 | 2-4 |
| 2-231A | 2-20 | 2-4 | 2-4 |
| 2-232A | 2-4 | 2-23 | 2-4 |
| 2-233A | 2-4 | 2-18 | 2-4 |
| 2-234A | 2-4 | 2-21 | 2-4 |
| 2-235A | 2-4 | 2-19 | 2-4 |
| 2-236A | 2-5 | 2-2 | 2-4 |
| 2-237A | 2-5 | 2-1 | 2-4 |
| 2-238A | 2-2 | 2-2 | 2-4 |
| 2-239A | 2-4 | 2-23 | 2-1 |
| 2-240A | 2-6 | 2-10 | 2-4 |
| 2-241A | 2-4 | 2-4 | 2-29 |
| 2-242A | 2-7 | 2-4 | 2-10 |
| 2-243A | 2-11 | 2-4 | 2-10 |
| 2-244A | 2-4 | 2-10 | 2-6 |
| 2-245A | 2-11 | 2-11 | 2-4 |
| 2-246A | 2-11 | 2-11 | 2-5 |
| 2-247A | 2-11 | 2-11 | 2-10 |
| 2-248A | 2-7 | 2-9 | 2-4 |
| 2-249A | 2-4 | 2-4 | 2-25 |
| 2-250A | 2-11 | 2-15 | 2-4 |
| 2-251A | 2-18 | 2-28 | 2-4 |
| 2-252A | 2-23 | 2-10 | 2-4 |
| 2-253A | 2-4 | 2-27 | 2-4 |
| 2-254A | 2-6 | 2-18 | 2-4 |
| 2-255A | 2-4 | 2-23 | 2-5 |
| 2-256A | 2-23 | 2-4 | 2-14 |
| 2-257A | 2-17 | 2-4 | 2-14 |
| 2-258A | 2-14 | 2-4 | 2-12 |
| 2-259A | 2-17 | 2-4 | 2-12 |
| 2-260A | 2-14 | 2-16 | 2-2 |
| 2-261A | 2-17 | 2-5 | 2-14 |
| 2-262A | 2-17 | 2-13 | 2-17 |
| 2-263A | 2-17 | 2-14 | 2-12 |
| 2-264A | 2-17 | 2-12 | 2-12 |
| 2-265A | 2-5 | 2-1 | 2-18 |
| 2-266A | 2-4 | 2-29 | 2-4 |
| 2-267A | 2-4 | 2-31 | 2-4 |
| 2-268A | 2-4 | 2-33 | 2-4 |
| 2-269A | 2-4 | 2-35 | 2-4 |

In one or more embodiments, the second compound represented by Formula 2A or 2B may be represented by one selected from Formulae 2-201B to 2-215B (denoting a formula based on Formula 2B), and rings A₂₁ and A₂₃ in Formulae 2-201B to 2-215B may each be selected from the formulae shown in Table 2:

**Table 2**

| Formula No. | Formula No. of ring A₂₁ | Formula No. of ring A₂₂ | Formula No. of ring A₂₃ |
|---|---|---|---|
| 2-201B | 2-4 | - | 2-19 |
| 2-202B | 2-4 | - | 2-22 |
| 2-203B | 2-4 | - | 2-18 |
| 2-204B | 2-4 | - | 2-23 |
| 2-205B | 2-4 | - | 2-21 |
| 2-206B | 2-4 | - | 2-20 |
| 2-207B | 2-5 | - | 2-23 |
| 2-208B | 2-7 | - | 2-23 |
| 2-209B | 2-4 | - | 2-26 |
| 2-210B | 2-7 | - | 2-22 |
| 2-211B | 2-13 | - | 2-16 |
| 2-212B | 2-5 | - | 2-19 |
| 2-213B | 2-7 | - | 2-20 |
| 2-214B | 2-19 | - | 2-18 |
| 2-215B | 2-18 | - | 2-18 |

In one or more embodiments, the second compound represented by Formula 2A or 2B may be represented by one selected from Formulae 2-301A to 2-421A (denoting a formula based on Formula 2A), and rings A₂₁, A₂₂, and A₂₃ in Formulae 2-301A to 2-419A and 2-421A to 2-431A may each be selected from the formulae shown in Table 3:

**Table 3**

| Formula No. | Formula No. of ring A₂₁ | Formula No. of ring A₂₂ | Formula No. of ring A₂₃ |
|---|---|---|---|
| 2-301A | 2-104 | 2-147 | 2-104 |
| 2-302A | 2-102 | 2-104 | 2-104 |
| 2-303A | 2-104 | 2-104 | 2-101 |
| 2-304A | 2-104 | 2-104 | 2-102 |
| 2-305A | 2-104 | 2-104 | 2-103 |
| 2-306A | 2-104 | 2-101 | 2-104 |
| 2-307A | 2-104 | 2-102 | 2-104 |
| 2-308A | 2-104 | 2-104 | 2-147 |
| 2-309A | 2-157 | 2-104 | 2-104 |
| 2-310A | 2-104 | 2-104 | 2-157 |
| 2-311A | 2-104 | 2-147 | 2-107 |
| 2-312A | 2-104 | 2-149 | 2-104 |
| 2-313A | 2-104 | 2-156 | 2-104 |
| 2-314A | 2-107 | 2-147 | 2-106 |
| 2-315A | 2-104 | 2-151 | 2-104 |
| 2-316A | 2-104 | 2-147 | 2-106 |
| 2-317A | 2-104 | 2-148 | 2-104 |
| 2-318A | 2-104 | 2-150 | 2-104 |
| 2-319A | 2-106 | 2-147 | 2-104 |
| 2-320A | 2-104 | 2-106 | 2-147 |
| 2-321A | 2-157 | 2-107 | 2-104 |
| 2-322A | 2-106 | 2-104 | 2-147 |
| 2-323A | 2-104 | 2-107 | 2-147 |
| 2-324A | 2-107 | 2-104 | 2-147 |
| 2-325A | 2-104 | 2-104 | 2-160 |
| 2-326A | 2-104 | 2-111 | 2-157 |
| 2-327A | 2-108 | 2-104 | 2-158 |
| 2-328A | 2-111 | 2-104 | 2-157 |
| 2-329A | 2-107 | 2-147 | 2-104 |
| 2-330A | 2-104 | 2-104 | 2-135 |
| 2-331A | 2-104 | 2-141 | 2-104 |
| 2-332A | 2-104 | 2-142 | 2-104 |
| 2-333A | 2-107 | 2-104 | 2-135 |
| 2-334A | 2-104 | 2-111 | 2-135 |
| 2-335A | 2-104 | 2-143 | 2-104 |
| 2-336A | 2-106 | 2-142 | 2-104 |
| 2-337A | 2-107 | 2-142 | 2-106 |
| 2-338A | 2-104 | 2-104 | 2-169 |
| 2-339A | 2-184 | 2-104 | 2-104 |
| 2-340A | 2-104 | 2-104 | 2-182 |
| 2-341A | 2-168 | 2-104 | 2-104 |
| 2-342A | 2-104 | 2-104 | 2-183 |
| 2-343A | 2-104 | 2-104 | 2-168 |
| 2-344A | 2-183 | 2-104 | 2-104 |
| 2-345A | 2-104 | 2-104 | 2-167 |
| 2-346A | 2-104 | 2-104 | 2-184 |
| 2-347A | 2-104 | 2-183 | 2-104 |
| 2-348A | 2-104 | 2-182 | 2-104 |
| 2-349A | 2-104 | 2-169 | 2-104 |
| 2-350A | 2-104 | 2-184 | 2-104 |
| 2-351A | 2-107 | 2-104 | 2-179 |
| 2-352A | 2-111 | 2-104 | 2-169 |
| 2-353A | 2-104 | 2-111 | 2-182 |
| 2-354A | 2-106 | 2-104 | 2-185 |
| 2-355A | 2-171 | 2-104 | 2-104 |
| 2-356A | 2-104 | 2-104 | 2-115 |
| 2-357A | 2-104 | 2-104 | 2-178 |
| 2-358A | 2-104 | 2-106 | 2-167 |
| 2-359A | 2-108 | 2-105 | 2-167 |
| 2-360A | 2-105 | 2-104 | 2-167 |
| 2-361A | 2-112 | 2-104 | 2-184 |
| 2-362A | 2-104 | 2-192 | 2-104 |
| 2-363A | 2-107 | 2-182 | 2-106 |
| 2-364A | 2-104 | 2-169 | 2-105 |
| 2-365A | 2-105 | 2-184 | 2-104 |
| 2-366A | 2-105 | 2-169 | 2-105 |
| 2-367A | 2-198 | 2-104 | 2-104 |
| 2-368A | 2-201 | 2-104 | 2-104 |
| 2-369A | 2-197 | 2-104 | 2-104 |
| 2-370A | 2-202 | 2-104 | 2-104 |
| 2-371A | 2-200 | 2-104 | 2-104 |
| 2-372A | 2-199 | 2-104 | 2-104 |
| 2-373A | 2-104 | 2-202 | 2-104 |
| 2-374A | 2-104 | 2-197 | 2-104 |
| 2-375A | 2-104 | 2-200 | 2-104 |
| 2-376A | 2-104 | 2-198 | 2-104 |
| 2-377A | 2-209 | 2-104 | 2-104 |
| 2-378A | 2-207 | 2-104 | 2-104 |
| 2-379A | 2-200 | 2-106 | 2-104 |
| 2-380A | 2-104 | 2-208 | 2-104 |
| 2-381A | 2-105 | 2-198 | 2-108 |
| 2-382A | 2-202 | 2-102 | 2-104 |
| 2-383A | 2-202 | 2-101 | 2-106 |
| 2-384A | 2-102 | 2-102 | 2-107 |
| 2-385A | 2-104 | 2-202 | 2-101 |
| 2-386A | 2-123 | 2-147 | 2-104 |
| 2-387A | 2-104 | 2-104 | 2-218 |
| 2-388A | 2-116 | 2-104 | 2-147 |
| 2-389A | 2-157 | 2-104 | 2-147 |
| 2-390A | 2-107 | 2-147 | 2-115 |
| 2-391A | 2-157 | 2-157 | 2-104 |
| 2-392A | 2-157 | 2-157 | 2-114 |
| 2-393A | 2-157 | 2-157 | 2-147 |
| 2-394A | 2-116 | 2-147 | 2-104 |
| 2-395A | 2-104 | 2-104 | 2-210 |
| 2-396A | 2-157 | 2-182 | 2-104 |
| 2-397A | 2-197 | 2-213 | 2-104 |
| 2-398A | 2-202 | 2-167 | 2-104 |
| 2-399A | 2-104 | 2-216 | 2-104 |
| 2-400A | 2-124 | 2-197 | 2-104 |
| 2-401A | 2-104 | 2-202 | 2-114 |
| 2-402A | 2-168 | 2-104 | 2-169 |
| 2-403A | 2-184 | 2-104 | 2-169 |
| 2-404A | 2-169 | 2-104 | 2-167 |
| 2-405A | 2-184 | 2-106 | 2-167 |
| 2-406A | 2-169 | 2-183 | 2-102 |
| 2-407A | 2-184 | 2-114 | 2-169 |
| 2-408A | 2-184 | 2-168 | 2-184 |
| 2-409A | 2-184 | 2-104 | 2-167 |
| 2-410A | 2-184 | 2-167 | 2-167 |
| 2-411A | 2-114 | 2-101 | 2-197 |
| 2-412A | 2-104 | 2-149 | 2-104 |
| 2-413A | 2-106 | 2-104 | 2-147 |
| 2-414A | 2-104 | 2-104 | 2-168 |
| 2-415A | 2-200 | 2-106 | 2-104 |
| 2-416A | 2-104 | 2-104 | 2-183 |
| 2-417A | 2-104 | 2-104 | 2-101 |
| 2-418A | 2-105 | 2-169 | 2-105 |
| 2-419A | 2-104 | 2-147 | 2-107 |
| 2-421A | 2-104 | 2-218 | 2-104 |
| 2-422A | 2-104 | 2-226 | 2-104 |
| 2-423A | 2-104 | 2-222 | 2-104 |
| 2-424A | 2-104 | 2-228 | 2-104 |
| 2-425A | 2-104 | 2-151 | 2-104 |
| 2-426A | 2-106 | 2-147 | 2-107 |
| 2-427A | 2-104 | 2-147 | 2-106 |
| 2-428A | 2-107 | 2-150 | 2-104 |
| 2-429A | 2-104 | 2-143 | 2-104 |
| 2-430A | 2-107 | 2-142 | 2-106 |
| 2-431A | 2-104 | 2-142 | 2-104 |

In one or more embodiments, the second compound represented by Formula 2A or 2B may be represented by one selected from Formulae 2-301B to 2-320B (denoting a formula based on Formula 2B), and rings A₂₁ and A₂₃ in Formulae 2-301B to 2-320B may each be selected from the formulae shown in Table 4:

**Table 4**

| Formula No. | Formula No. of ring A₂₁ | Formula No. of ring A₂₂ | Formula No. of ring A₂₃ |
|---|---|---|---|
| 2-301B | 2-104 | - | 2-198 |
| 2-302B | 2-104 | - | 2-201 |
| 2-303B | 2-104 | - | 2-197 |
| 2-304B | 2-104 | - | 2-202 |
| 2-305B | 2-104 | - | 2-200 |
| 2-306B | 2-104 | - | 2-199 |
| 2-307B | 2-104 | - | 2-203 |
| 2-308B | 2-104 | - | 2-204 |
| 2-309B | 2-106 | - | 2-205 |
| 2-310B | 2-104 | - | 2-206 |
| 2-311B | 2-112 | - | 2-199 |
| 2-312B | 2-114 | - | 2-202 |
| 2-313B | 2-116 | - | 2-202 |
| 2-314B | 2-104 | - | 2-214 |
| 2-315B | 2-130 | - | 2-201 |
| 2-316B | 2-168 | - | 2-183 |
| 2-317B | 2-114 | - | 2-198 |
| 2-318B | 2-116 | - | 2-199 |
| 2-319B | 2-198 | - | 2-197 |
| 2-320B | 2-197 | - | 2-197 |

In Formula 1A, X₁₁ may be N or C[(L₃)ₐ₃-(R₃)_{b3}], and X₁₂ may be N or C[(L₄)ₐ₄-(R₄)_{b4}].

For example, in Formula 1A,
X₁₁ may be N, and X₁₂ may be C[(L₄)ₐ₄-(R₄)_{b4}],
X₁₀ may be C[(L₃)ₐ₃-(R₃)_{b3}], and X₁₂ may be N, or
X₁₁ may be C[(L₃)ₐ₃-(R₃)_{b3}], and X₁₂ may be C[(L₄)ₐ₄-(R₄)_{b4}], but embodiments of X₁₁ are not limited thereto.
X₂₁ in Formulae 2A and 2B may be selected from O, S, Se, C(R₂₃)(R₂₄), Si(R₂₃)(R₂₄), and N-[(L₂₁)ₐ₂₁-(R₂₁)_{b21}].

In one embodiment, X₂₁ in Formulae 2A and 2B may be N[(L₂₁)ₐ₂₁(R₂₁)_{b21}].

In one or more embodiments, X₂₁ in Formulae 2A and 2B may be O, S, Se, C(R₂₃)(R₂₄), or Si(R₂₃)(R₂₄),
at least one selected from rings A₂₁, A₂₂, and A₂₃ in Formula 2A and at least one selected from rings A₂₁ and A₂₃ in Formula 2B may each independently be selected from groups represented by Formulae 2-1 to 2-3, 2-10 to 2-27, and 2-33 to 2-36, and X₂₂ or X₂₃ in Formulae 2-1 to 2-3, 2-10 to 2-27, and 2-33 to 2-36 may be N-[(L₂₂)ₐ₂₂-(R₂₂)_{b22}].

In one or more embodiments, X₂₁ in Formulae 2A and 2B may be O, S, Se, C(R₂₃)(R₂₄), or Si(R₂₃)(R₂₄),
at least one selected from rings A₂₁, A₂₂, and A₂₃ in Formula 2A and at least one selected from rings A₂₁ and A₂₃ in Formula 2B may each independently be selected from groups represented by Formulae 2-101 to 2-103, 2-147 to 2-211, 2-214 to 2-219, and 2-226 to 2-229, and X₂₂ or X₂₃ in Formula 2-101 to 2-103, 2-147 to 2-211, 2-214 to 2-219, and 2-226 to 2-229 may be N-[(L₂₂)ₐ₂₂-(R₂₂)_{b22}], but embodiments of the present disclosure are not limited thereto.

In Formulae 2A and 2B, X₂₁ may be O, S, Se, C(R₂₃)(R₂₄), Si(R₂₃)(R₂₄), or N-[(L₂₁)ₐ₂₁-(R₂₁)_{b21}], and X₂₂ and X₂₃ may each independently be O, S, Se, C(R₂₅)(R₂₆), Si(R₂₅)(R₂₆), or N-[(L₂₂)ₐ₂₂-(R₂₂)_{b22}]. L₂₁, L₂₂, a21, a22, R₂₁ to R₂₆, b21, and b22 may each independently be the same as described below.

L₁ to L₉ in Formulae 1A, 1B, 1-4, 1D and 1E, 2A, and 2B may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, and a substituted or unsubstituted divalent non-aromatic condensed C₆-C₆₀ polycyclic group,

L₂₁ and L₂₂ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C6-C60 polycyclic group, and a substituted or unsubstituted divalent non-aromatic condensed 6- to 60- membered heteropolycyclic group.

For example,
in Formulae 1B, 1-4, 1D and 1E, 2A, and 2B,
L₁ to L₉, L₂₁, and L₂₂ may each independently be selected from the group consisting of:
   a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
   a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60- membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂), and
   L₁ to L₉ may each not be a substituted or unsubstituted carbazolylene group, a substituted or unsubstituted dibenzofuranylene group, a substituted or unsubstituted dibenzothiophenylene group, a substituted or unsubstituted dibenzosilolylene group, or a substituted or unsubstituted dibenzocarbazolylene group,
   wherein Q₃₁ to Q₃₃ may each independently be selected from the group consisting of:
      a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
      a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

In one or more embodiments,
L₁ to L₉, L₂₁, and L₂₂ in Formulae 1A, 1B, 1-4, 1D and 1E, 2A, and 2B may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an indolylene group, an isoindolylene group, a benzofuranylene group, a benzothiophenylene group, a benzosilolylene group, a dibenzofuranylene group, a dibenzothiophenylene group, a dibenzosilolylene group, a carbazolylene group, a benzocarbazolylene group, a dibenzocarbazolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an indolylene group, an isoindolylene group, a benzofuranylene group, a benzothiophenylene group, a benzosilolylene group, a dibenzofuranylene group, a dibenzothiophenylene group, a dibenzosilolylene group, a carbazolylene group, a benzocarbazolylene group, a dibenzocarbazolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenylene group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, an isoindolyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, a dibenzocarbazolyl group, a pyridinyl group, -Si(Q₃₁)(Q₃₂)(Q₃₃) -N(Q₃₁)(Q₃₂), -B(Q₃₁)(Q₃₂), -C(=O)(Q₃₁), - S(=O)₂(Q₃₁), and -P(=O)(Q₃₁)(Q₃₂), and
L₁ to L₉ may each not be a substituted or unsubstituted carbazolylene group, a substituted or unsubstituted dibenzofuranylene group, a substituted or unsubstituted dibenzothiophenylene group, a substituted or unsubstituted dibenzosilolylene group, or a substituted or unsubstituted dibenzocarbazolylene group,
wherein Q₃₁ to Q₃₃ may each independently be selected from the group consisting of:
   a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
   a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

In one or more embodiments, in Formulae 1A, 1B, 1-4, 1D and 1E, 2A, and 2B, L₁ to L₉ may each independently be selected from groups represented by Formulae 3-1 to 3-22 and 3-25 to 3-99,

L₂₁ and L₂₂ may each independently be selected from groups Formulae 3-1 to 3-99,):

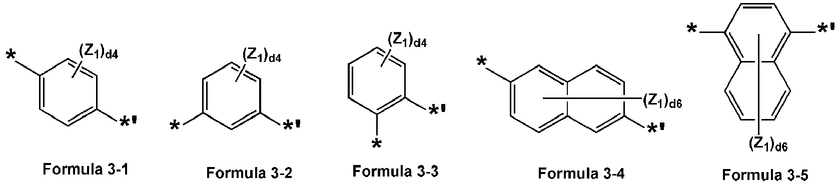

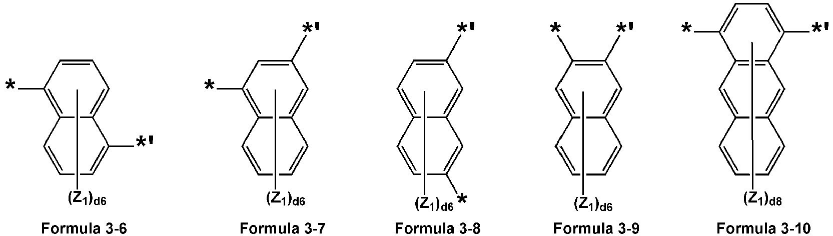

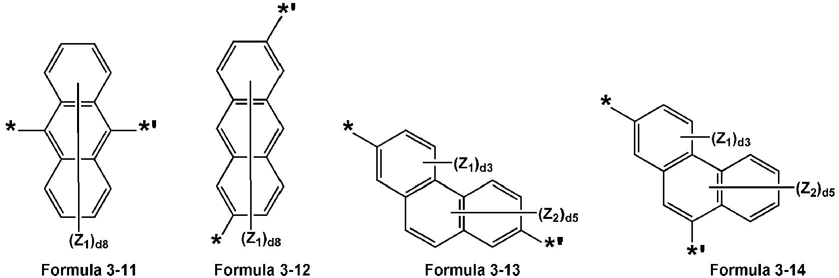

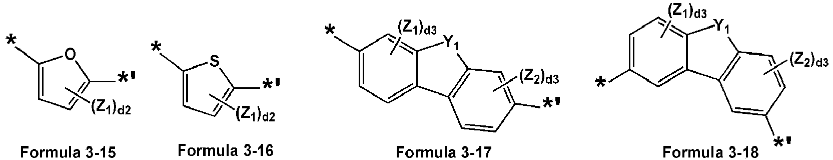

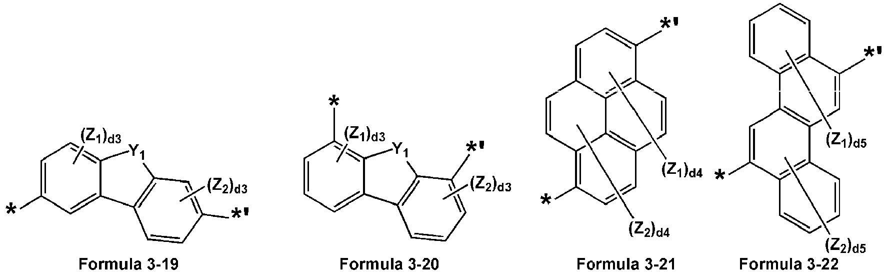

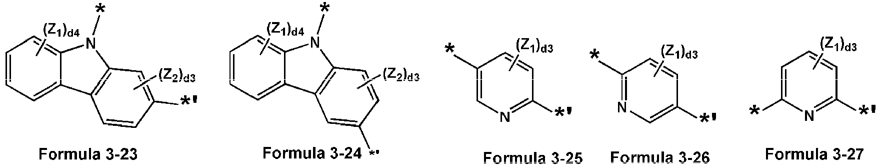

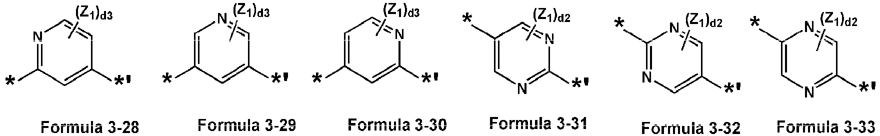

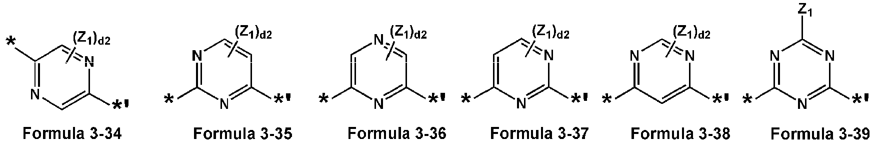

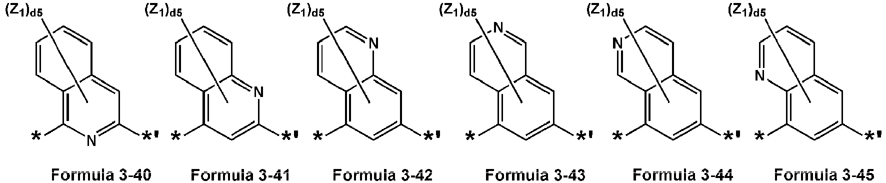

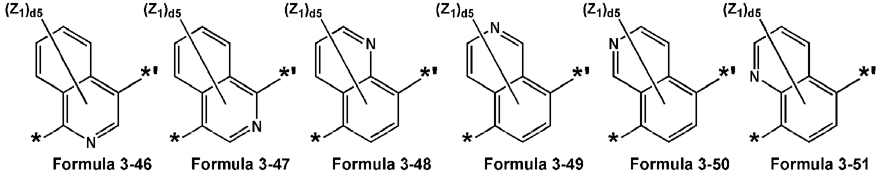

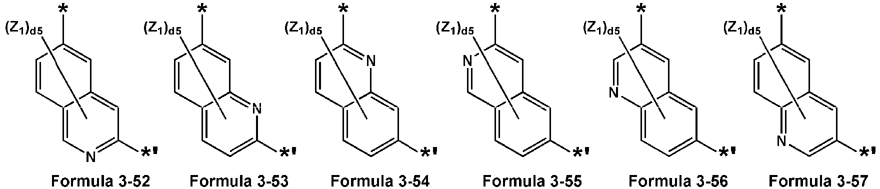

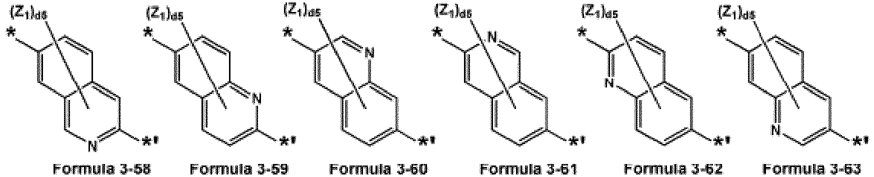

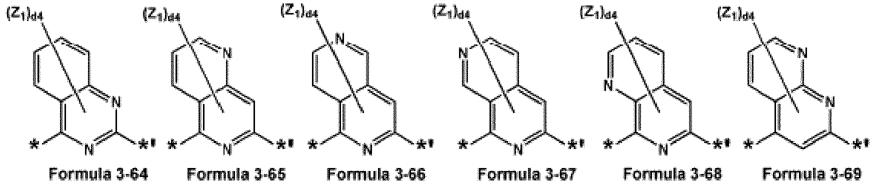

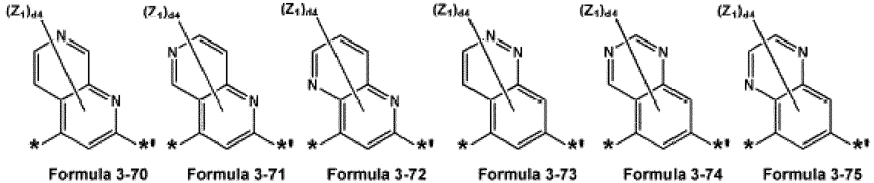

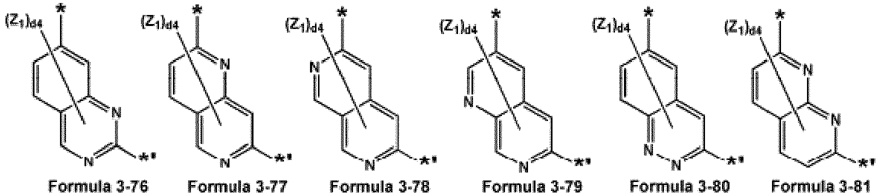

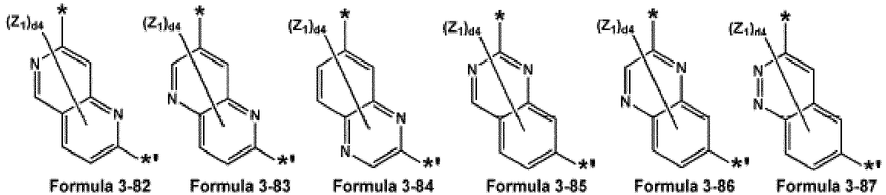

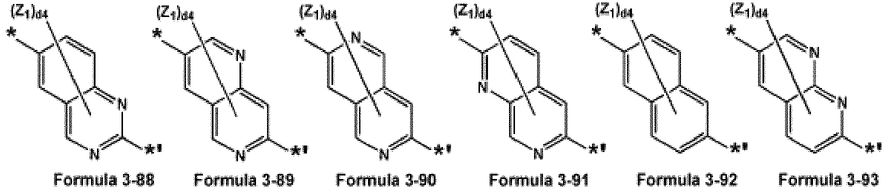

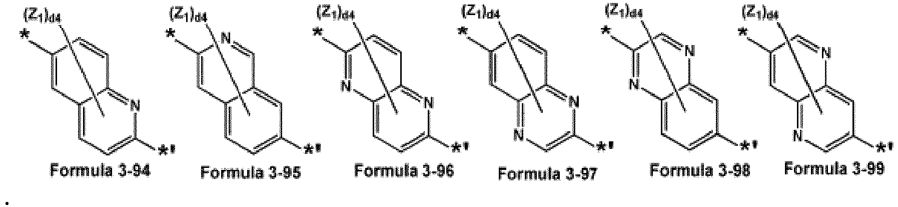

In Formulae 3-1 to 3-99,
Y₁ may be O, S, C(Z₃)(Z₄), N(Z₅), or Si(Z₆)(Z₇), provided that when any one of L₁ to L₉ is selected from groups represented by Formulae 3-17 to 3-20, Y₁ in Formulae 3-17 to 3-20 may be C(Z₃)(Z₄),
Z₁ to Z₇ may each independently be selected from hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
Q₃₁ to Q₃₃ may each independently be selected from the group consisting of: a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
d2 may be an integer selected from 0 to 2,
d3 may be an integer selected from 0 to 3,
d4 may be an integer selected from 0 to 4,
d5 may be an integer selected from 0 to 5,
d6 may be an integer selected from 0 to 6,
d8 may be an integer selected from 0 to 8, and
* and *' may each independently indicate a binding site to a neighboring atom.
a1 to a9, a21, and a22 in Formulae 1A, 1B, 1-4, 1D and 1Eand 2A to 2B indicate the numbers of L₁ to L₉, L₂₁, and L₂₂ groups, respectively, a1 to a7, a21, and a22 in Formulae 1A, 1B, 1-4, 1D and 1E and 2A to 2B may each independently be an integer selected from 0 to 5. When a1 is two or more, two or more L₁(s) may be identical to or different from each other; when a2 is two or more, two or more L₂(s) may be identical to or different from each other; when a3 is two or more, two or more L₃(s) may be identical to or different from each other; when a4 is two or more, two or more L₄(s) may be identical to or different from each other; when as is two or more, two or more L₅(s) may be identical to or different from each other; when a6 is two or more, two or more L₆(s) may be identical to or different from each other; when a7 is two or more, two or more L₇(s) may be identical to or different from each other; when a8 is two or more, two or more L₈(s) may be identical to or different from each other; when a9 is two or more, two or more L₉(s) may be identical to or different from each other; when a21 is two or more, two or more L₂₁(s) may be identical to or different from each other; and when a22 is two or more, two or more L₂₂(s) may be identical to or different from each other. When a1 is 0, *-(L₁)ₐ₁-*' indicates a single bond; when a2 is 0, *-(L₂)ₐ₂-*' indicates a single bond; when a3 is 0, *-(L₃)ₐ₃-*' indicates a single bond; when a4 is 0, *-(L₄)ₐ₄-*' indicates a single bond; when a5 is 0, *-(L₅)ₐ₅-*' indicates a single bond; when a6 is 0, *-(L₆)ₐ₆-*' indicates a single bond; when a7 is 0, *-(L₇)ₐ₇-*' indicates a single bond; when a8 is 0, *-(L₈)ₐ₈-*' indicates a single bond; when a9 is 0, *-(L₉)ₐ₉-*' indicates a single bond; when a21 is 0, *-(L₂₁)ₐ₂₁-*' indicates a single bond; and when a22 is 0, *-(L₂₂)ₐ₂₂-*' indicates a single bond.

In one embodiment, a1 to a9, a21, and a22 in Formulae 1A, 1B, 1-4, 1D and 1E and 2A to 2B may each independently be an integer selected from 0 to 3, but embodiments of the present disclosure are not limited thereto.

In Formulae 1A, 1B, 1-4, 1D and 1E, 2A, and 2B,
R₁ to R₉ may each independently be selected from hydrogen, deuterium (-D), -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C6-C60 polycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂),
R₂₁ to R₂₄ may each independently be selected from hydrogen, deuterium (-D), - F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C6-C60 polycyclic group, a substituted or unsubstituted monovalent non-aromatic condensed 6- to 60- membered heteropolycyclic group, -Si(Q₄)(Q₅)(Q₆), - N(Q₄)(Q₅), -B(Q₄)(Q₅), -C(=O)(Q₄), -S(=O)₂(Q₄), and -P(=O)(Q₄)(Q₅). Q₁ to Q₆ may each independently be the same as described above.

For example, in Formulae 1A, 1B, 1-4, 1D and 1E, 2A, and 2B,
R₁ to R₉ may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂); and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60-membered heteropolycyclic group, a biphenyl group, a terphenyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
R₂₁ to R₂₄, R₂₇, and R₂₈ may each independently be selected from the group consisting of:
   hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
   a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₄)(Q₅)(Q₆), -N(Q₄)(Q₅), -B(Q₄)(Q₅), -C(=O)(Q₄), - S(=O)₂(Q₄), and -P(=O)(Q₄)(Q₅); and
   a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60- membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
   wherein Q₁ to Q₆ and Q₃₁ to Q₃₃ may each independently be selected from the group consisting of:
      a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
      a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

For example, in Formulae 1A, 1B, 1-4, 1D and 1E, 2A, and 2B,
R₁ to R₉ may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an oxadiazolyl group, a triazinyl group, a thiadiazolyl group, an imidazopyridinyl group, an imidazopyrimidinyl group, -Si(Q₁)(Q₂)(Q₃), -N(Q₁)(Q₂), - B(Q₁)(Q₂), -C(=O)(Q₁), -S(=O)₂(Q₁), and -P(=O)(Q₁)(Q₂); and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an oxadiazolyl group, a triazinyl group, a thiadiazolyl group, an imidazopyridinyl group, and an imidazopyrimidinyl group, each substituted with at least one selected from deuterium, -F, -Cl, -Br, -I, a hydroxyl group, a cyano group, a nitro group, an amidino group, a hydrazino group, a hydrazono group, a C₁-C₁₀ alkyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60- membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂),
R₂₁ to R₂₄, R₂₇,_{,} and R₂₈ may each independently be selected from the group consisting of:
   a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a picenyl group, a perylenyl group, a pentaphenyl group, a hexacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, an imidazopyrimidinyl group, -Si(Q₄)(Q₅)(Q₆), -N(Q₄)(Q₅), - B(Q₄)(Q₅), -C(=O)(Q₄), -S(=O)₂(Q₄), and -P(=O)(Q₄)(Q₅); and
   a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a picenyl group, a perylenyl group, a pentaphenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, and an imidazopyrimidinyl group, each substituted with at least one selected from deuterium, -F, -Cl, -Br, -I, a hydroxyl group, a cyano group, a nitro group, an amidino group, a hydrazino group, a hydrazono group, a C₁-C₁₀ alkyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60- membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂),
   R₂₂ to R₂₄, R₂₇, and R₂₈ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, -Si(Q₄)(Q₅)(Q₆), -S(=O)₂(Q₄), and -P(=O)(Q₄)(Q₅), and
   Q₁ to Q₆ and Q₃₁ to Q₃₃ may each independently be selected from the group consisting of:
      a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
      a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

In one or more embodiments, in Formulae 1A, 1B, 1-4, 1D and 1E, 2A, and 2B,
R₁ to R₉ may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a group represented by any of Formulae 5-1 to 5-44, 6-1 to 6-121, 6-123, and 6-124; and
-Si(Q₁)(Q₂)(Q₃), -N(Q₁)(Q₂), -B(Q₁)(Q₂), -C(=O)(Q₁), -S(=O)₂(Q₁), and - P(=O)(Q₁)(Q₂),
R₂₁ may be selected from groups represented by Formulae 5-1 to 5-45 and 6-1 to 6-124,
R₂₂ to R₂₄, R₂₇, and R₂₈ may each independently be selected from the group consisting of:
   hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
   a group represented by any of Formulae 5-1 to 5-45 and Formulae 6-1 to 6-124; and
   -Si(Q₄)(Q₅)(Q₆), -N(Q₄)(Q₅), -B(Q₄)(Q₅), -C(=O)(Q₄), -S(=O)₂(Q₄), and - P(=O)(Q₄)(Q₅), but embodiments of the present disclosure are not limited thereto:

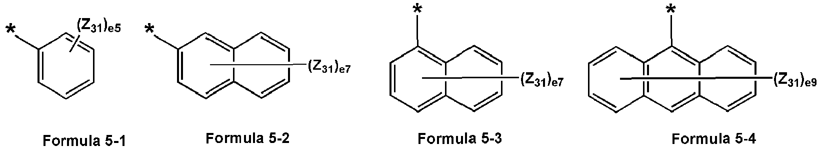

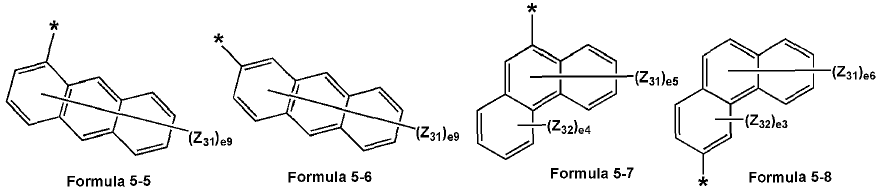

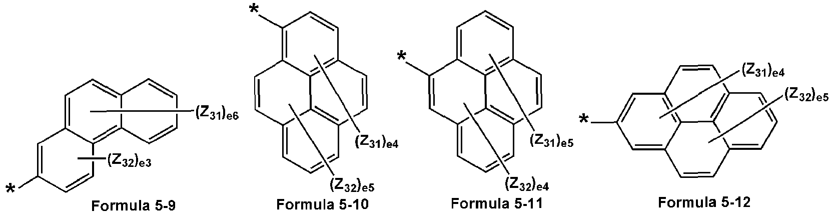

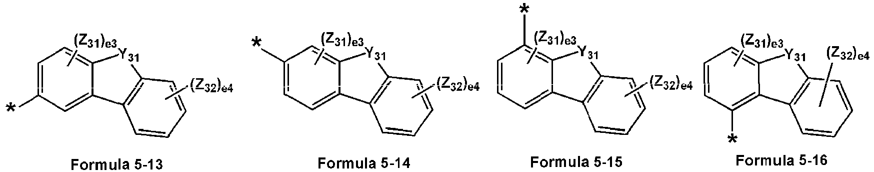

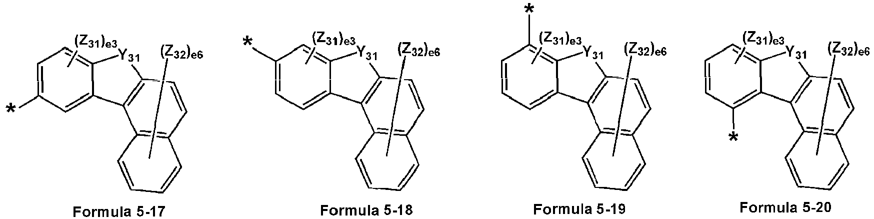

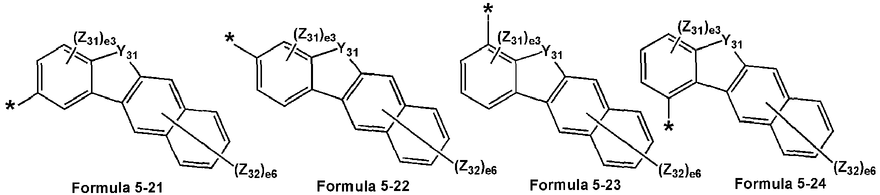

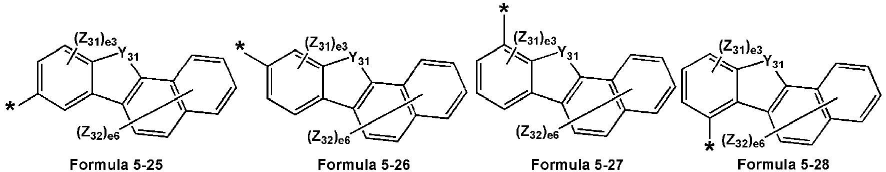

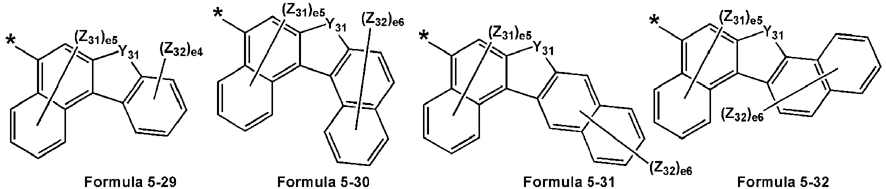

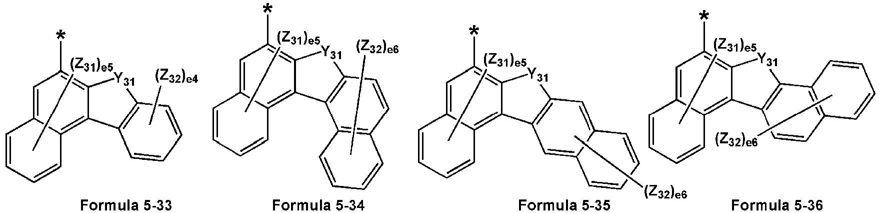

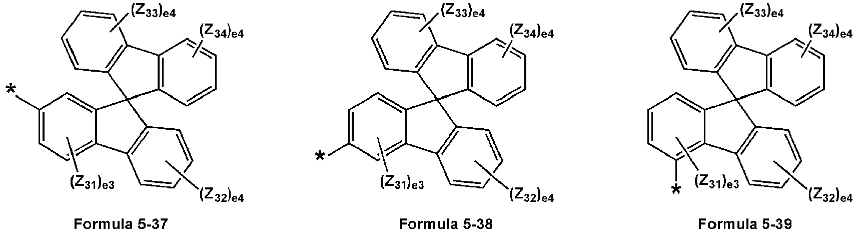

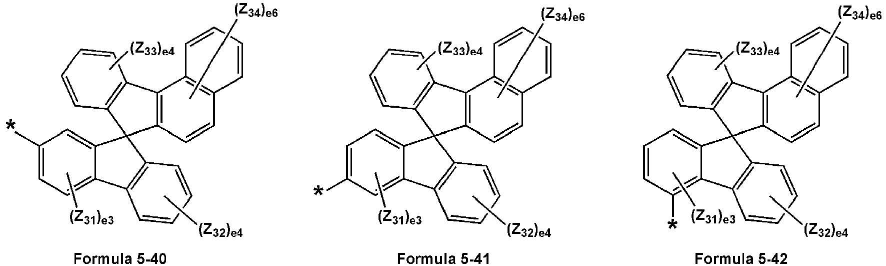

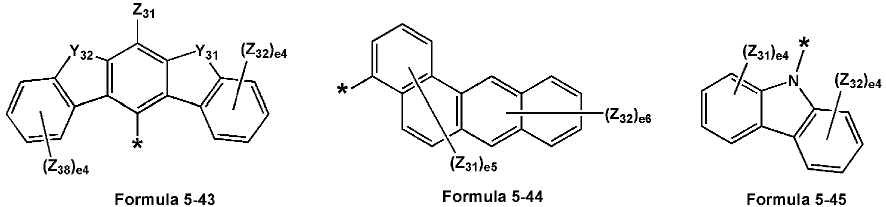

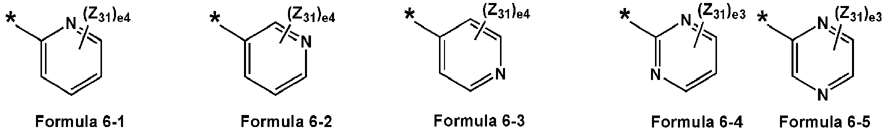

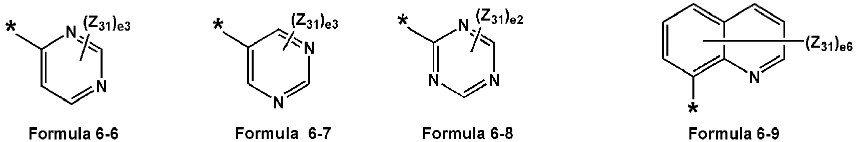

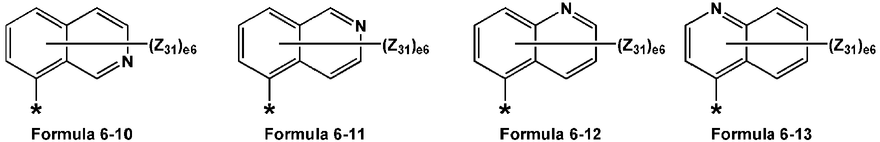

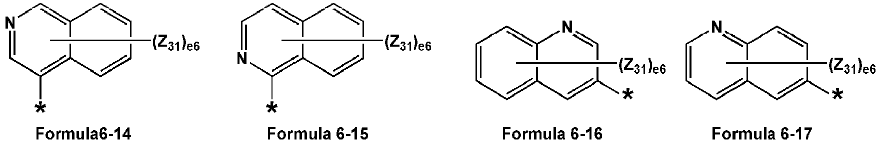

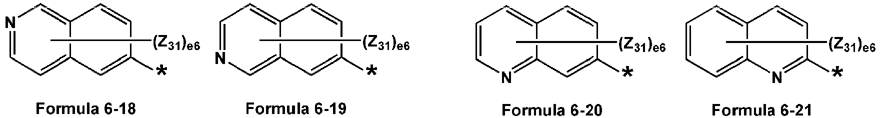

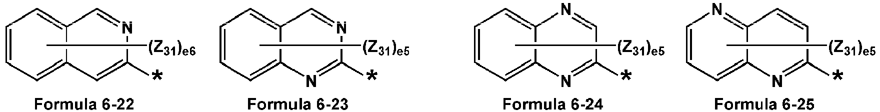

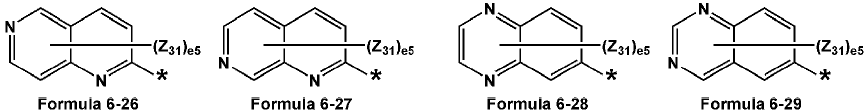

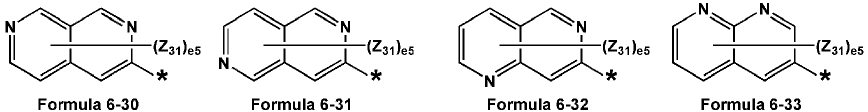

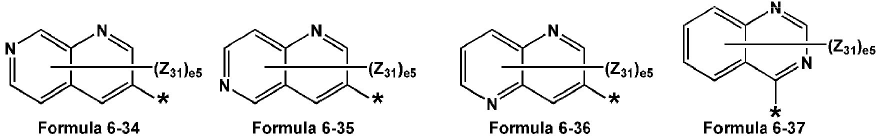

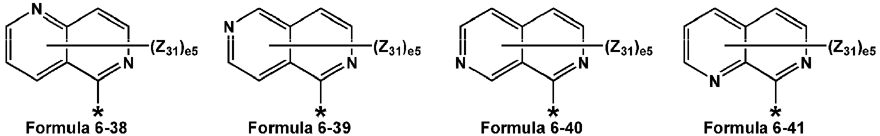

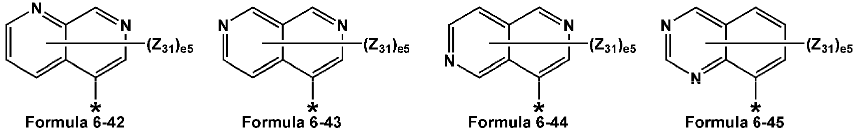

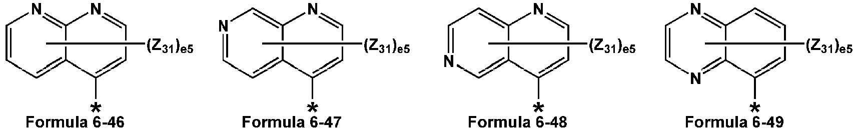

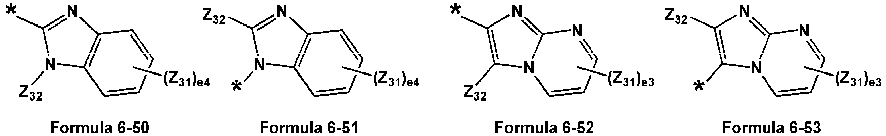

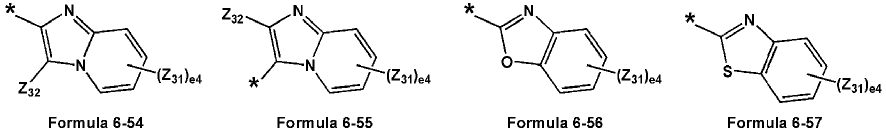

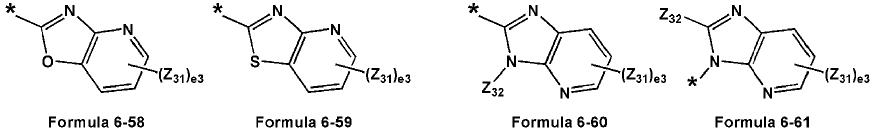

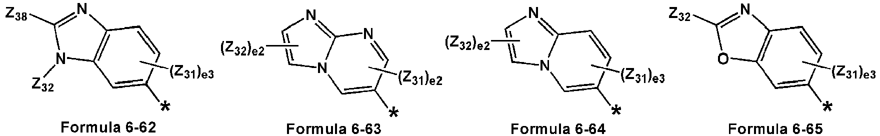

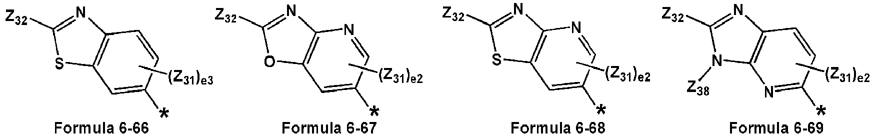

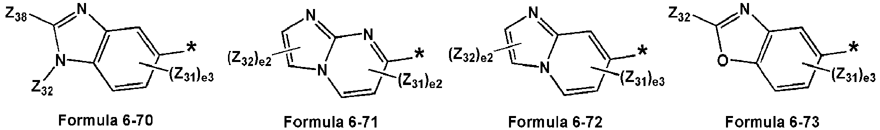

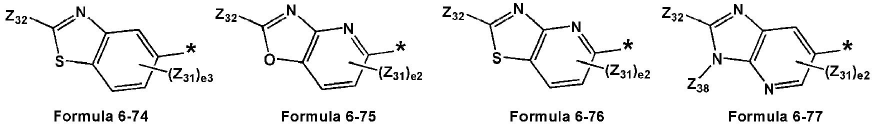

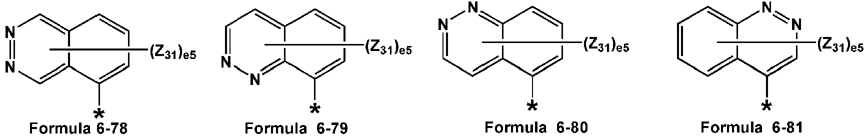

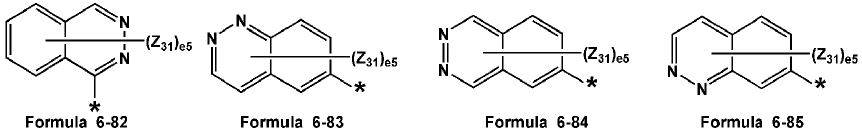

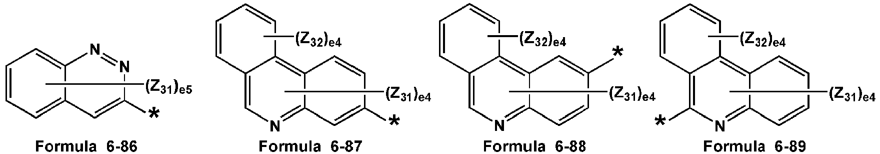

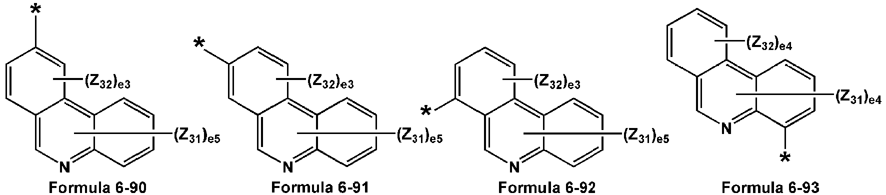

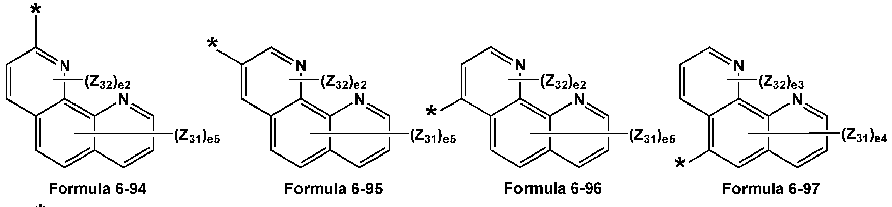

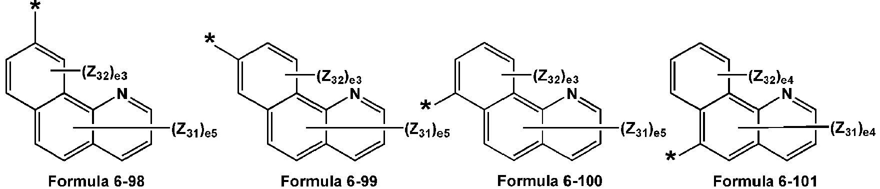

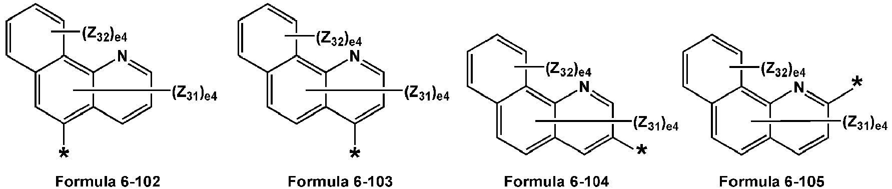

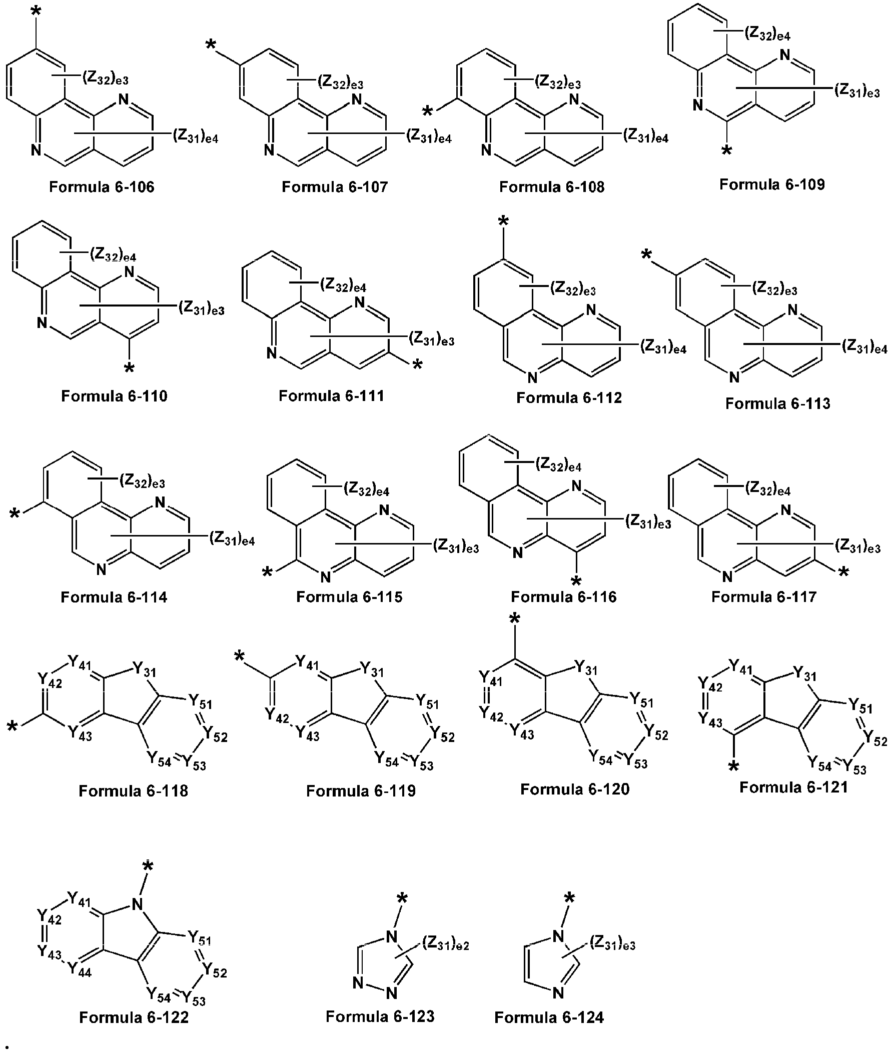

In Formulae 5-1 to 5-45 and 6-1 to 6-124,
Y₃₁ and Y₃₂ may each independently be O, S, C(Z₃₃)(Z₃₄), N(Z₃₅), or Si(Z₃₆)(Z₃₇), provided that when R₁ to R₉ are selected from groups represented by Formulae 5-13 to 5-36 and 5-43, Y₃₁ and Y₃₂ in Formulae 5-13 to 5-36 and 5-43 are each independently C(Z₃₃)(Z₃₄),
Y₄₁ may be N or C(Z₄₁), Y₄₂ may be N or C(Z₄₂), Y₄₃ may be N or C(Z₄₃), Y₄₄ may be N or C(Z₄₄), Y₅₁ may be N or C(Z₅₁), Y₅₂ may be N or C(Z₅₂), Y₅₃ may be N or C(Z₅₃), Y₅₄ may be N or C(Z₅₄), at least one selected from Y₄₁ to Y₄₃ and Y₅₁ to Y₅₄ in Formulae 5-118 to 5-121 may be N, and at least one selected from Y₄₁ to Y₄₄ and Y₅₁ to Y₅₄ in Formula 5-122 may be N,
Z₃₁ to Z₃₈, Z₄₁ to Z₄₄, and Z₅₁ to Z₅₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, and -Si(Q₃₁)(Q₃₂)(Q₃₃),
Q₁ to Q₃ and Q₃₁ to Q₃₃ may each independently be selected from the group consisting of:
   a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
   a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
   e2 may be an integer selected from 0 to 2,
   e3 may be an integer selected from 0 to 3,
   e4 may be an integer selected from 0 to 4,
   e5 may be an integer selected from 0 to 5,
   e6 may be an integer selected from 0 to 6,
   e7 may be an integer selected from 0 to 7,
   e9 may be an integer selected from 0 to 9, and
   * may indicate a binding site to a neighboring atom.

In one or more embodiments,
in Formulae 1A, 1B, 1-4, 1D and 1E, 2A, and 2B,
R₁ to R₉ may each independently be selected from the group consisting of:
   hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
   a group represented by any of Formulae 9-1 to 9-28, 9-53 to 9-88, and 10-1 to 10-121; and
   -Si(Q₁)(Q₂)(Q₃), -N(Q₁)(Q₂), -B(Q₁)(Q₂), -C(=O)(Q₁), -S(=O)₂(Q₁), and - P(=O)(Q₁)(Q₂),
   R₂₁ may be selected from groups represented by Formulae 9-1 to 9-100 and 10-1 to 10-121,
   R₂₂ to R₂₄ may each independently be selected from the group consisting of:
      hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
      a group represented by any of Formulae 9-1 to 9-100 and 10-1 to 10-121; and
      -Si(Q₄)(Q₅)(Q₆), -N(Q₄)(Q₅), -B(Q₄)(Q₅), -C(=O)(Q₄), -S(=O)₂(Q₄), and - P(=O)(Q₄)(Q₅), but embodiments of the present disclosure are not limited thereto:

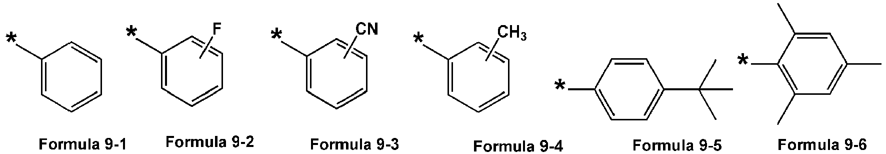

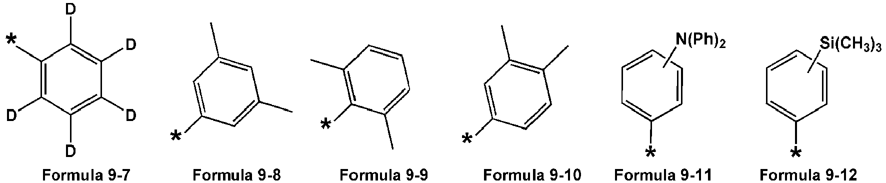

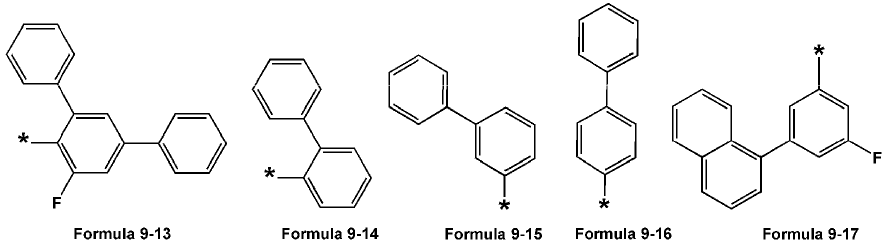

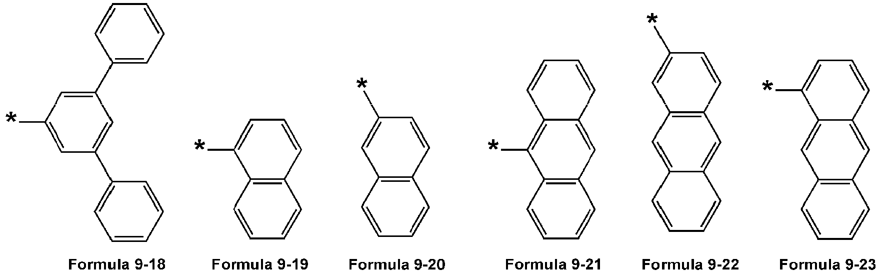

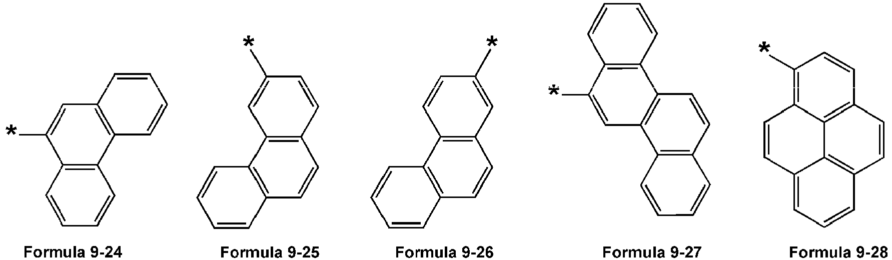

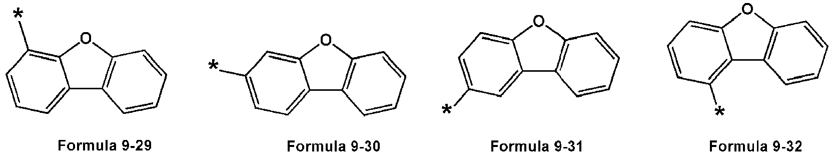

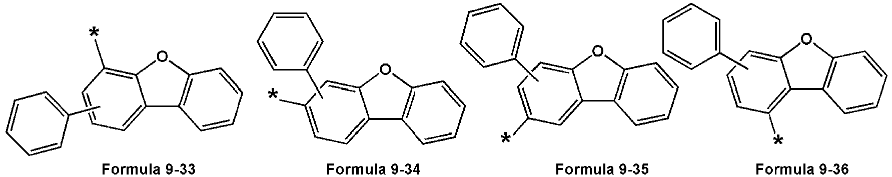

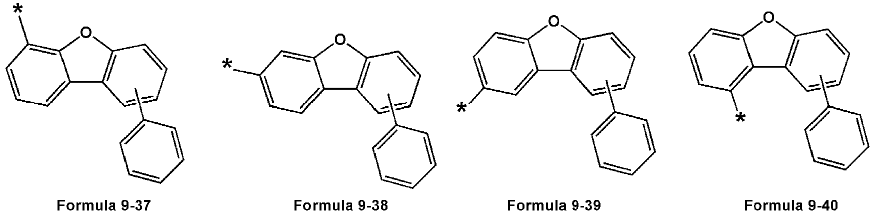

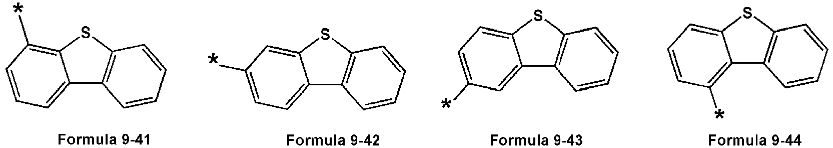

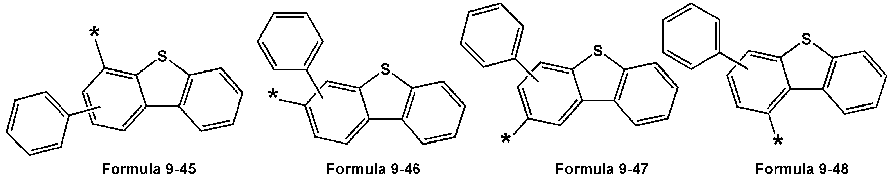

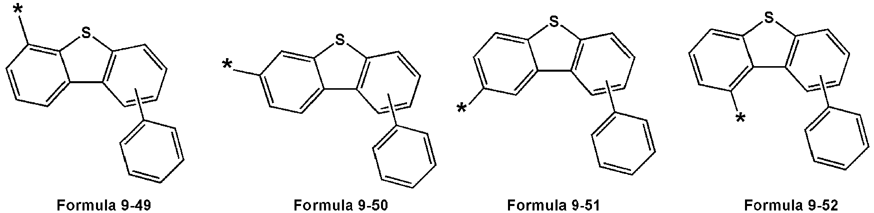

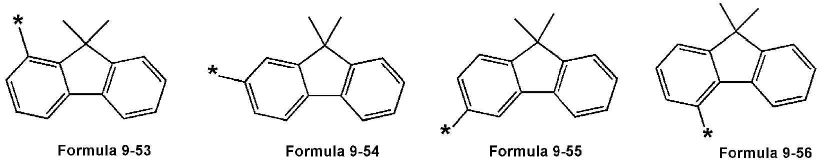

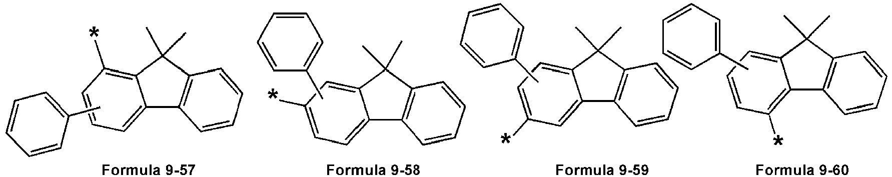

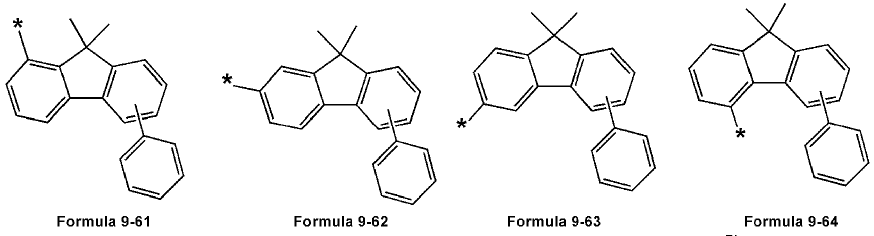

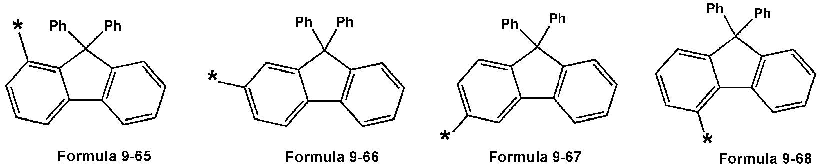

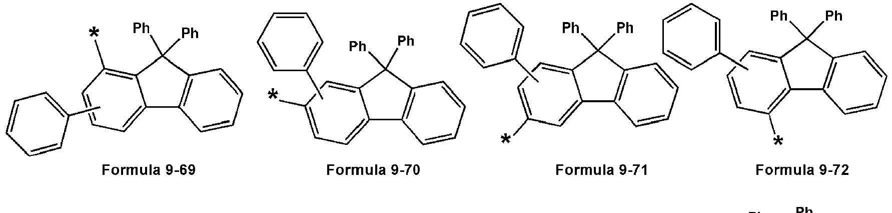

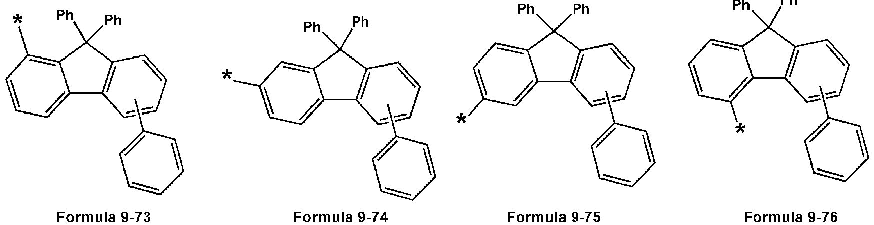

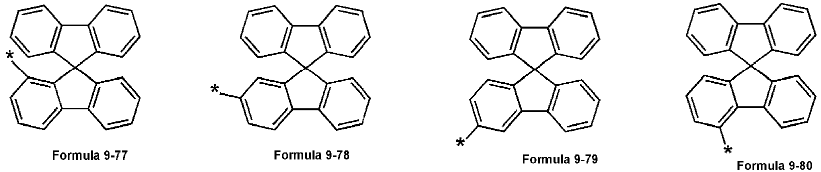

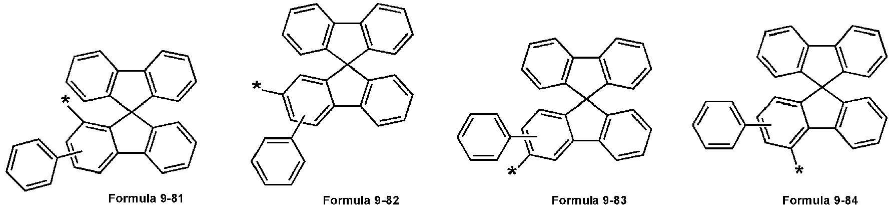

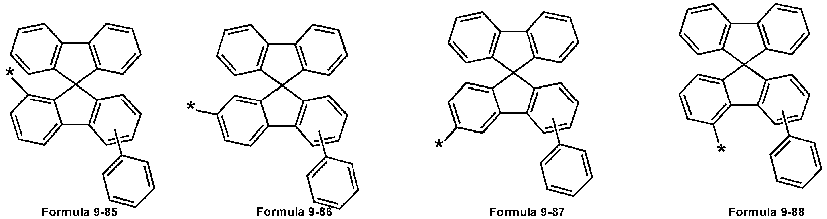

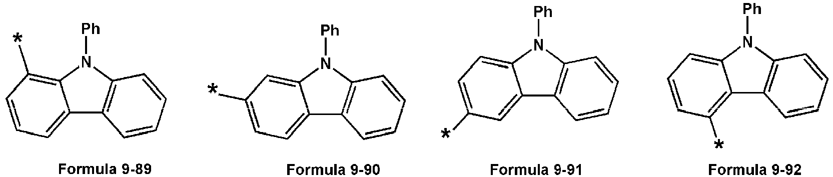

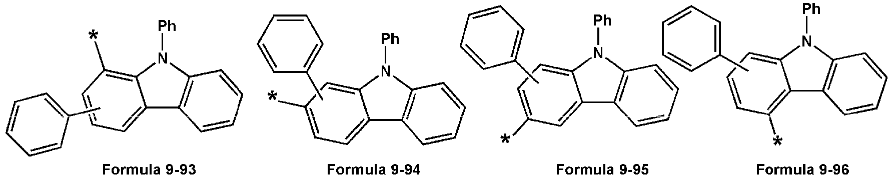

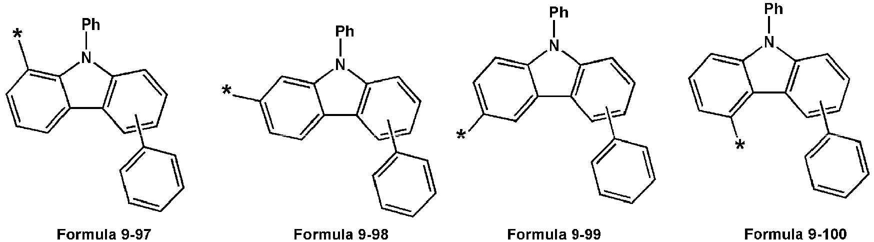

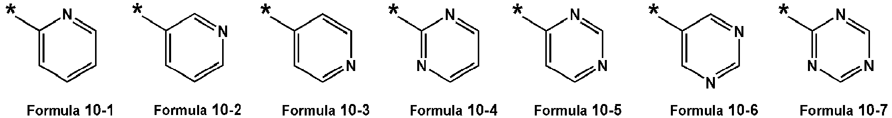

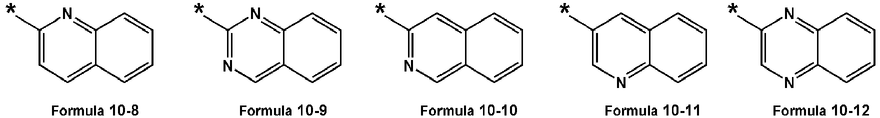

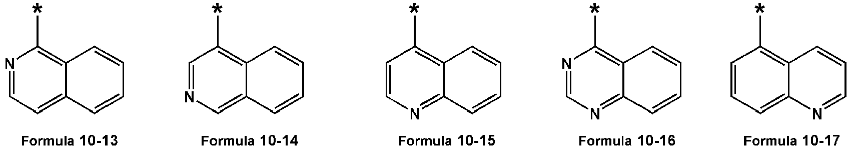

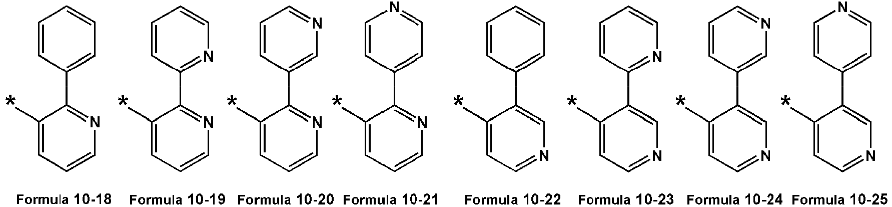

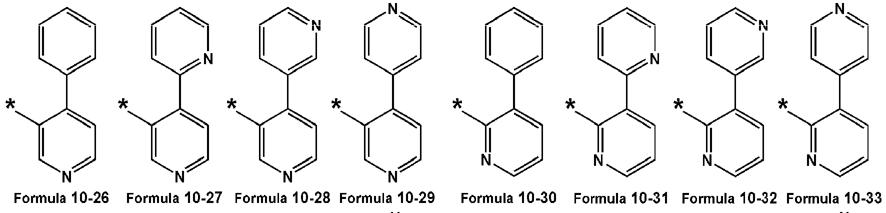

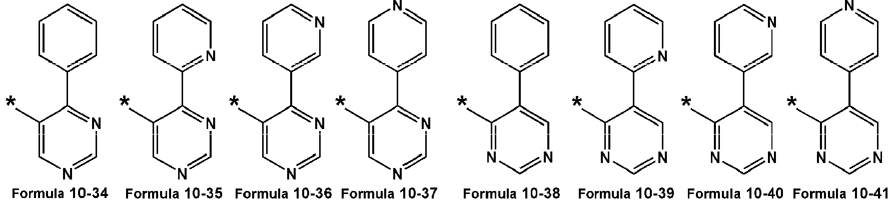

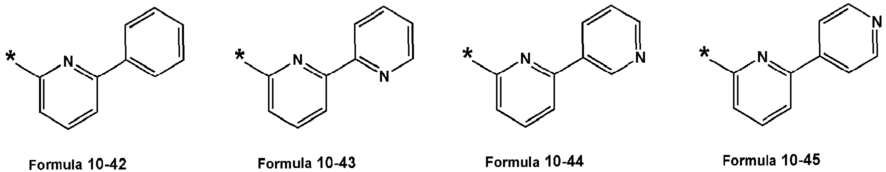

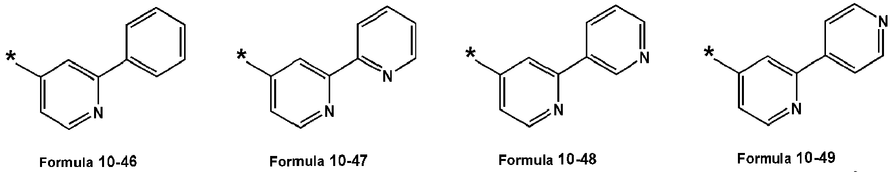

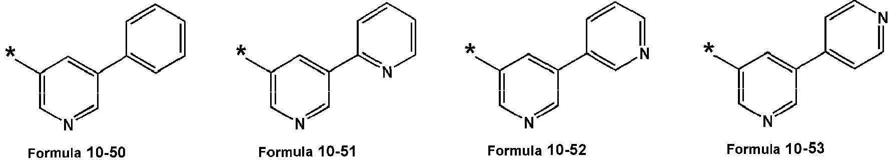

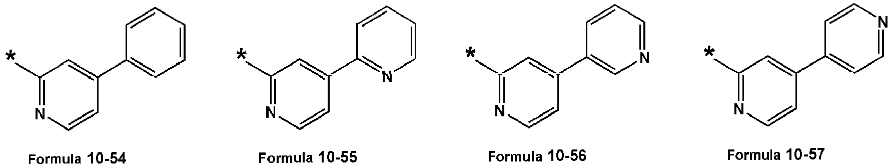

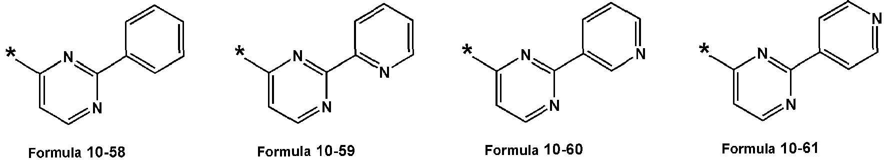

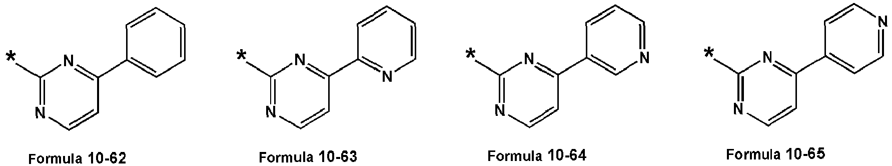

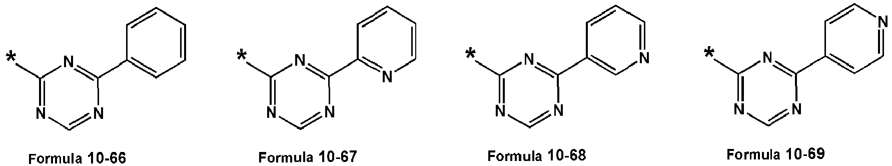

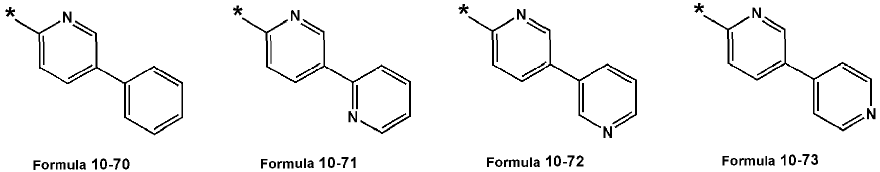

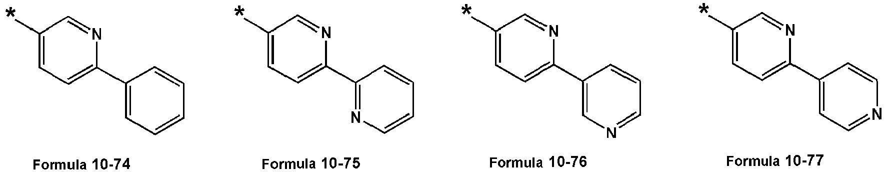

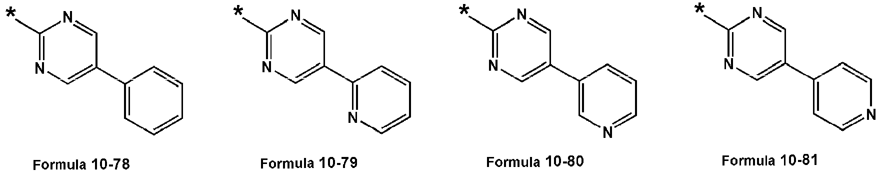

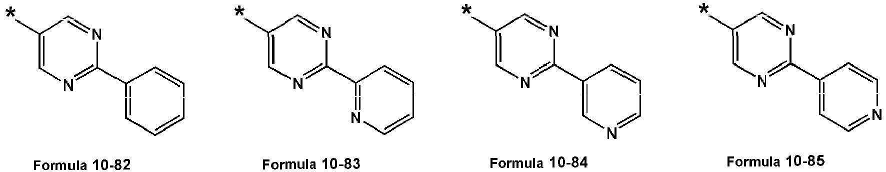

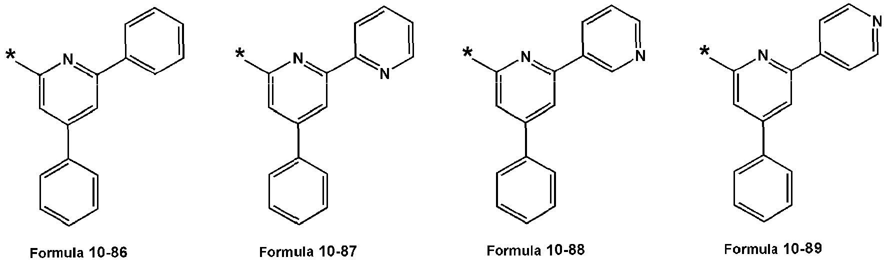

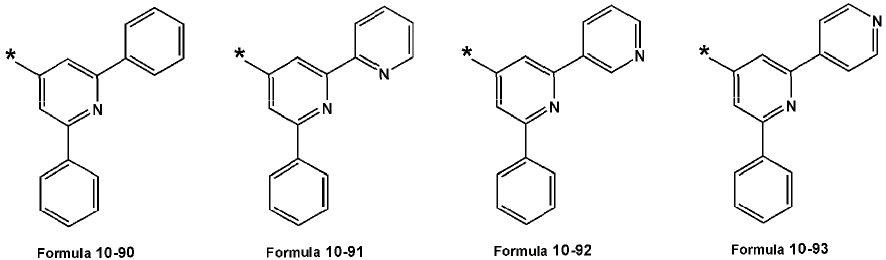

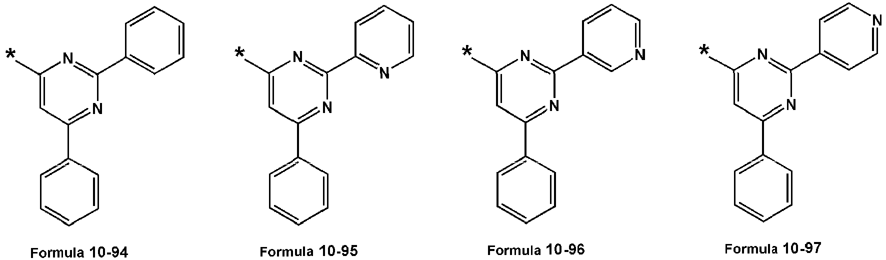

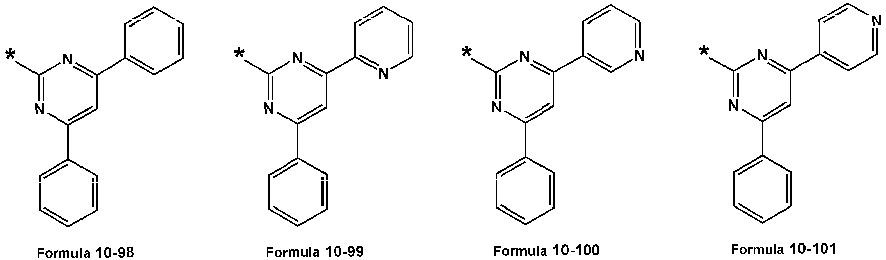

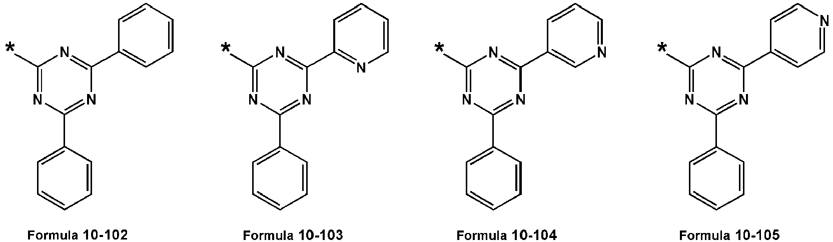

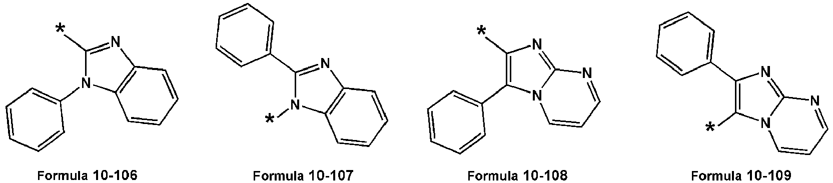

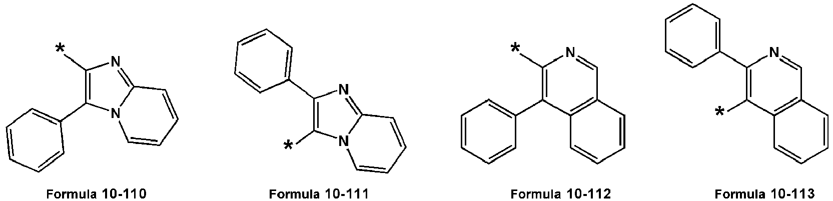

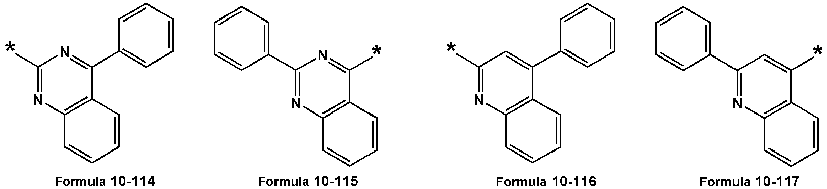

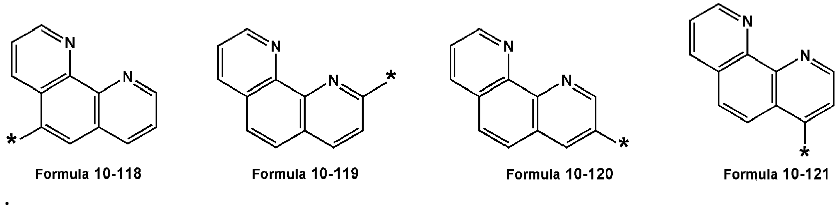

In Formulae 9-1 to 9-100 and 10-1 to 10-121, Ph indicates a phenyl group, and * indicates a binding site to a neighboring atom.

b1 to b7, b21, and b22 in Formulae 1A, 1B, 1-4, 1D and 1E, 2A, and 2B indicate the numbers of R₁ to R₉, R₂₁, and R₂₂ groups, respectively, b1 to b7, b21, and b22 may each independently be an integer selected from 1 to 3. In some embodiments, each of b1 to b9, b21, and b22 is independently 1 when each respective a1 to a9, a21 or a22 is zero. Thus, in any single incidence of a group *-[(L₁)ₐ₁-(R₁)_{b1}], in some embodiments, when a1 is zero, b1 is 1. In any single incidence of a group *-[(L₂)ₐ₂-(R₂)_{b2}], in some embodiments, when a2 is zero, b2 is 1. In any single incidence of a group *-(L₃)ₐ₃-(R₃)_{b3}, in some embodiments, when a3 is zero, b3 is 1. In any single incidence of a group *-(L₄)ₐ₄-(R₄)_{b4}, in some embodiments, when a4 is zero, b4 is 1. In any single incidence of a group *-[(L₅)ₐ₅-(R₅)_{b5}], in some embodiments, when as is zero, b5 is 1. In any single incidence of a group *-[(L₆)ₐ₆-(R₆)_{b6}], in some embodiments, when a6 is zero, b6 is 1. In any single incidence of a group *-[(L₇)ₐ₇-(R₇)_{b7}], in some embodiments, when a7 is zero, b7 is 1. In any single incidence of a group *-[(L₈)ₐ₈-(R₈)_{b8}], in some embodiments, when a8 is zero, b8 is 1. In any single incidence of a group *-[(L₉)ₐ₉-(R₂)_{b9}], in some embodiments, when a9 is zero, b9 is 1. In any single incidence of a group *-[(L₂₁)ₐ₂₁-(R₂₁)_{b21}], in some embodiments, when a21 is zero, b21 is 1. In any single incidence of a group *-[(L₂₂)ₐ₂₂-(R₂₂)_{b22}], in some embodiments, when a22 is zero, b22 is 1.

When b1 is two or more, two or more R₁(s) may be identical to or different from each other; when b2 is two or more, two or more R₂(s) may be identical to or different from each other; when b3 is two or more, two or more R₃(s) may be identical to or different from each other; when b4 is two or more, two or more R₄(s) may be identical to or different from each other; when b5 is two or more, two or more R₅(s) may be identical to or different from each other; when b6 is two or more, two or more R₆(s) may be identical to or different from each other; when b7 is two or more, two or more R₇(s) may be identical to or different from each other; when b8 is two or more, two or more R₈(s) may be identical to or different from each other; when b9 is two or more, two or more R₉(s) may be identical to or different from each other; when b21 is two or more, two or more R₂₁(s) may be identical to or different from each other; and when b22 is two or more, two or more R₂₂(s) may be identical to or different from each other.

In one embodiment, b1 to b9, b21, and b22 in Formulae 1A, 1B, 1-4, 1D and 1E, 2A, and 2B may each independently be 1 or 2, but embodiments of the present disclosure are not limited thereto.

c1, c2, and c5 to c9 in Formulae 1A, 1B, 1-4, 1D and 1E indicate the number of *-[(L₁)ₐ₁-(R₁)_{b1}], *-[(L₂)ₐ₂-(R₂)_{b2}], *-[(L₅)ₐ₅-(R₅)_{b5}], *-[(L₆)ₐ₆-(R₆)_{b6}], *-[(L₇)ₐ₇-(R₇)_{b7}], *-[(L₈)ₐ₈-(R₈)_{b8}], and *-[(L₉)ₐ₉-(R₉)_{b9}] groups, respectively, c1, c2, and c5 to c7 in Formulae 1A, 1B, 1-4, 1D and 1E are each independently an integer selected from 0 to 10, provided that the sum of c5, c6, and c7 is 1 or more, and c8 and c9 are each independently an integer selected from 0 to 4, provided that the sum of c8 and c9 is 1 or more.

In Formulae 1A, 1B, 1-4, 1D and 1E, when c1 is two or more, two or more *-[(L₁)ₐ₁-(R₁)_{b1}] (s) may be identical to or different from each other; when c2 is two or more, two or more *-[(L₂)ₐ₂-(R₂)_{b2}] (s) may be identical to or different from each other; when c5 is two or more, two or more *-[(L₅)ₐ₅-(R₅)_{b5}](s) may be identical to or different from each other; when c6 is two or more, two or more *-[(L₆)ₐ₆-(R₆)_{b6}](s) may be identical to or different from each other; when c7 is two or more, two or more *-[(L₇)ₐ₇-(R₇)_{b7}](s) may be identical to or different from each other; when c8 is two or more, two or more *-[(L₈)ₐ₈-(R₈)_{b8}](s) may be identical to or different from each other; and when c9 is two or more, two or more *-[(L₉)ₐ₉-(R₉)_{b9}](s) may be identical to or different from each other.

In one embodiment, c1, c2, and c5 to c7 in Formulae 1A, 1B, 1-4, 1D and 1E may each independently be an integer selected from 0 to 8, provided that the sum of c5, c6, and c7 is 1 or more.

In one embodiment, the first compound represented by one selected from Formulae 1A, 1B, 1-4, 1D and 1E may be represented by one selected from Formula 1E and Formulae 1-1 to 1-6:

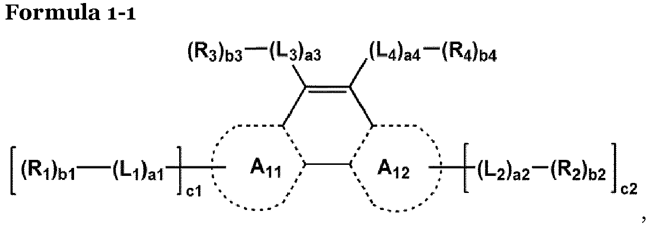

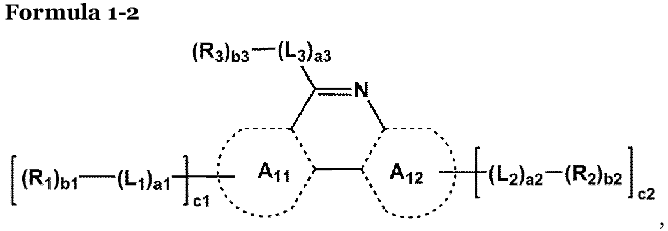

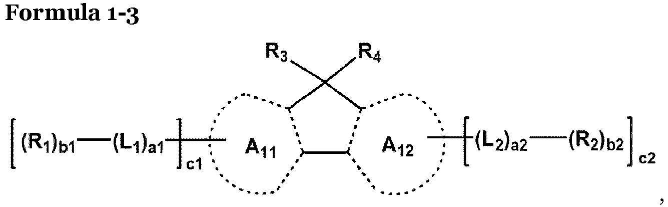

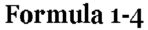

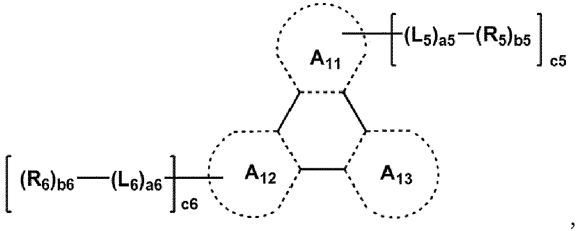

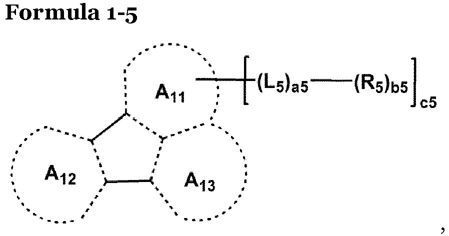

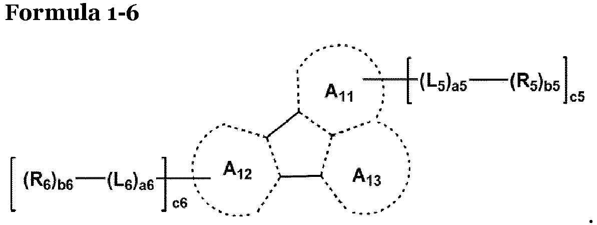

Formula 1E may be the same as described above,
in Formulae 1-1 to 1-6, rings A₁₁ to A₁₃, L₁ to L₆, a1 to a6, R₁ to R₆, and b1 to b6 may each independently be the same as described herein in connection with Formulae 1A, 1B, 1-4 and 1D,
c1, c2, and c6 may each independently be an integer selected from 0 to 10, and
c5 may be an integer selected from 1 to 10.

In one or more embodiments, the first compound represented by one selected from Formulae 1A, 1B, 1-4, 1D and 1E may be represented by one selected from Formulae 1(1) to 1(11), but embodiments of the present disclosure are not limited thereto:

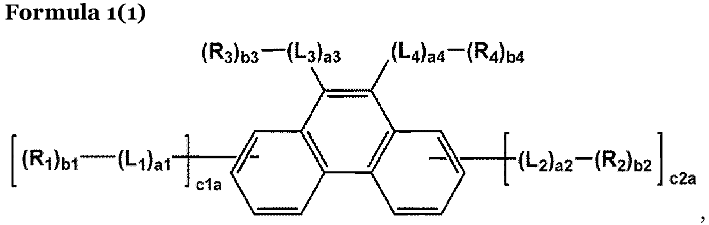

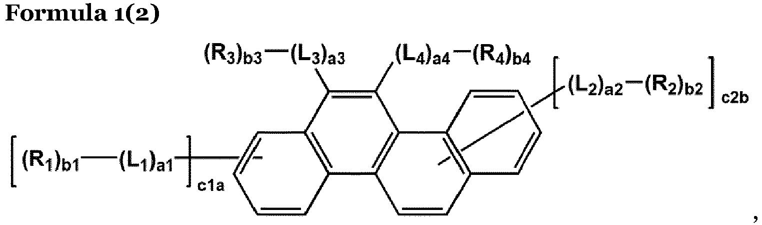

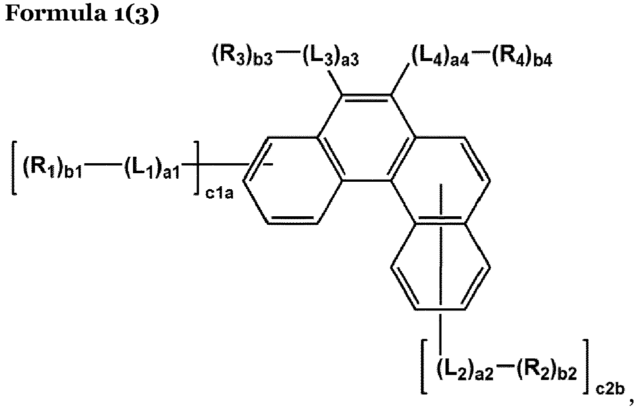

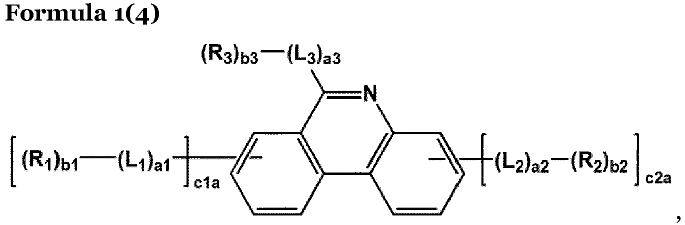

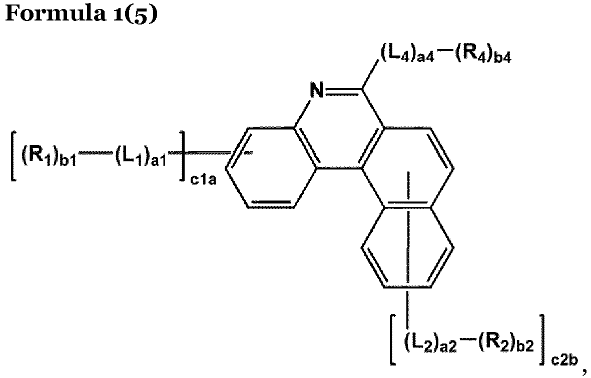

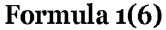

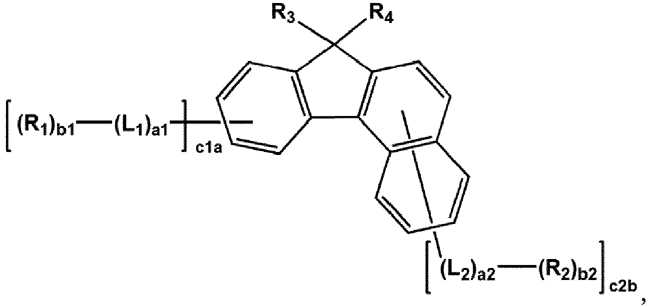

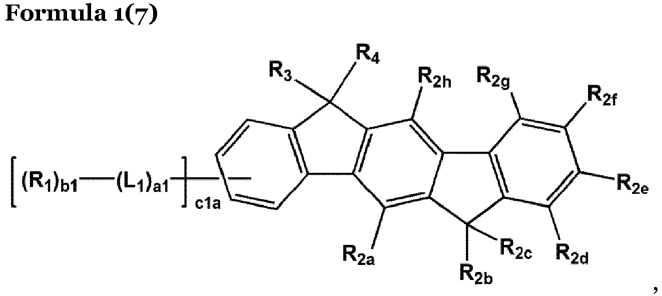

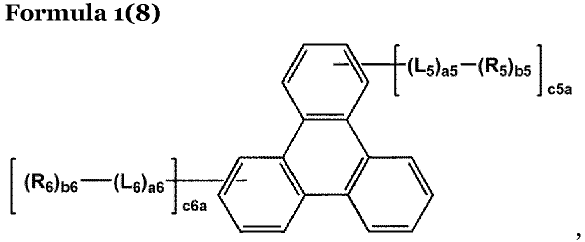

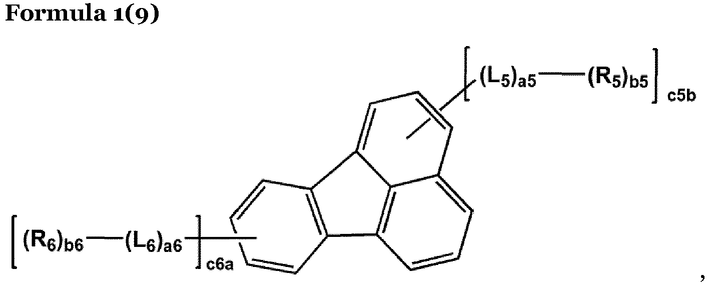

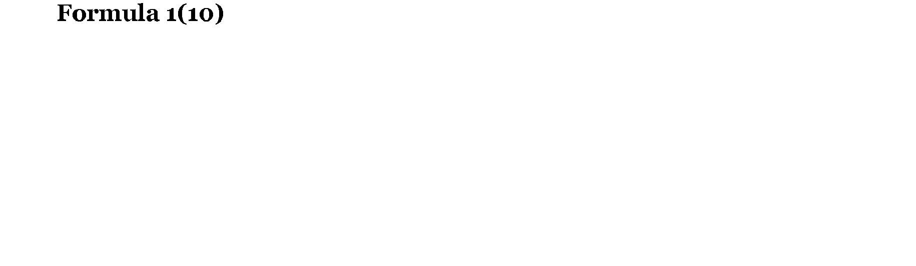

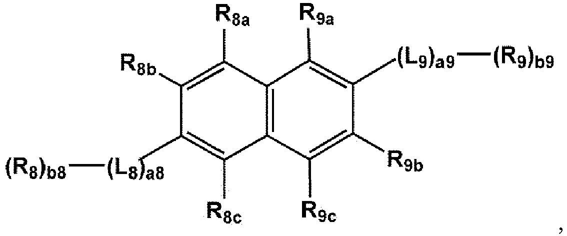

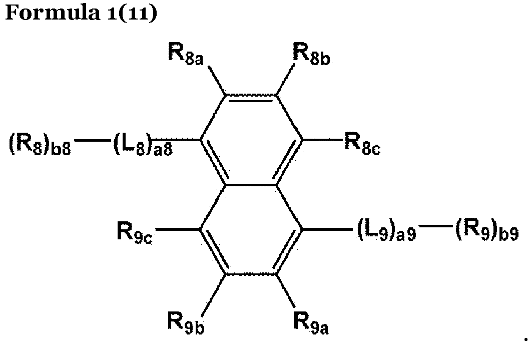

In Formulae 1(1) to 1(11),
L₁ to L₆, L₈ and L₉, a1 to a6, a8 and a9, R₁ to R₆, R₈ and R₉, and b1 to b6, b8 and b9 may each independently be the same as described above,
R₂ₐ to R₂ₕ may each independently be the same as described herein in connection with R₂,
R₈ₐ to R_{8c} may be the same as described in connection with R₈,
R₉ₐ to R_{9c} may be the same as described in connection with R₉,
cia may be an integer selected from 0 to 4,
c2a may be an integer selected from 0 to 4,
c2b may be an integer selected from 0 to 6,
c5a may be an integer selected from 0 to 4,
c5b may be an integer selected from 0 to 3,
c6a may be an integer selected from 0 to 4, and
the sum of c5a and c6a or the sum of c5b and c6a may be 1 or more.

In one embodiment, the first compound represented by one selected from Formulae 1A, 1B, 1-4, 1D and 1E may be selected from Compounds 1-1 to 1-93:

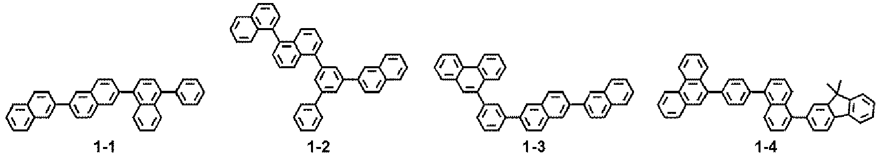

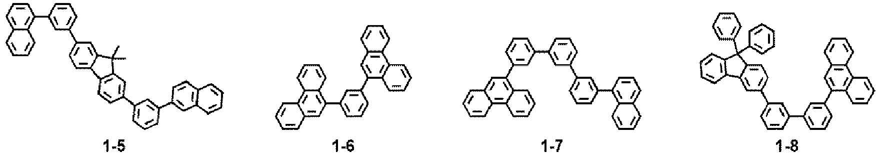

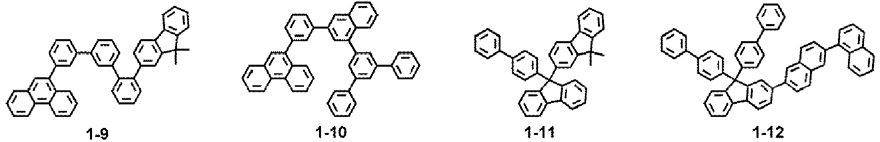

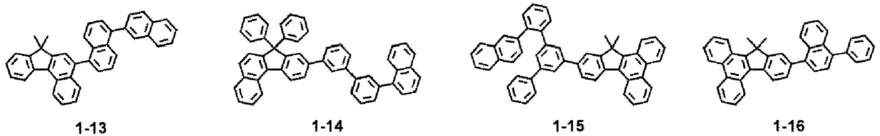

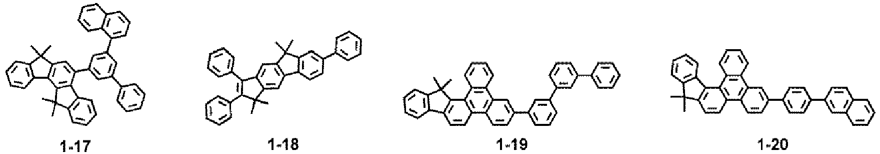

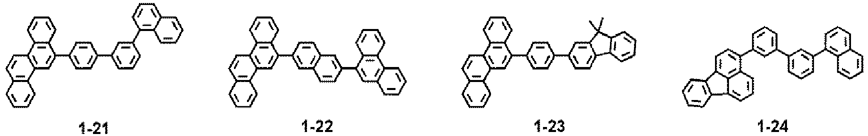

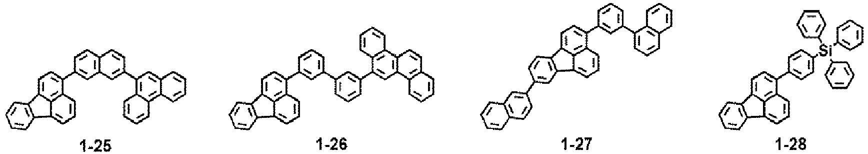

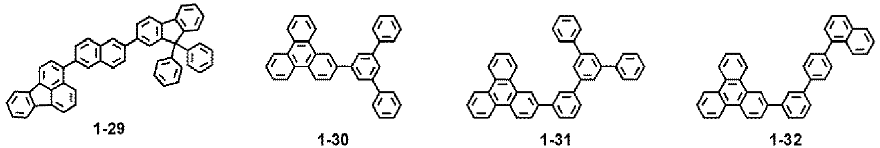

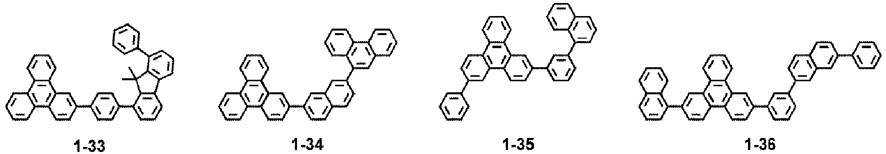

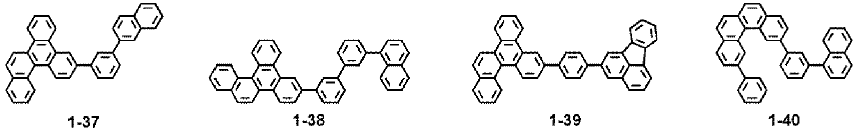

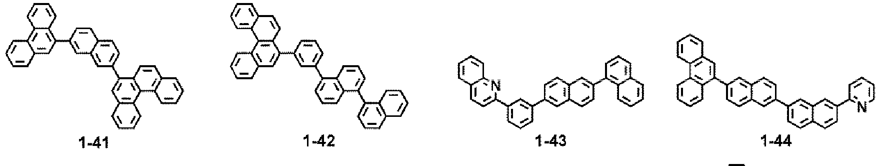

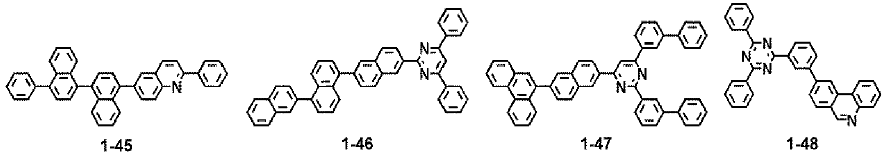

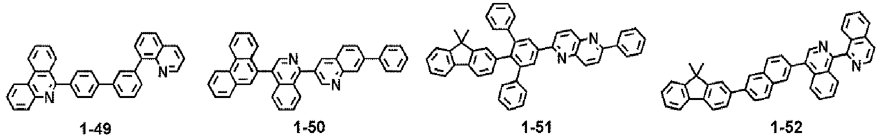

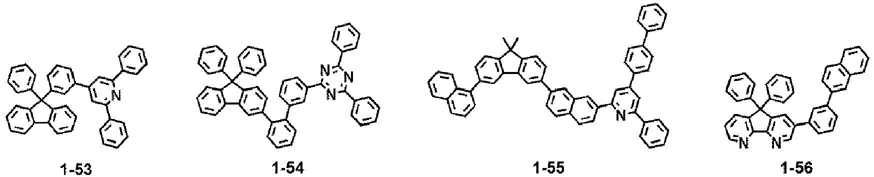

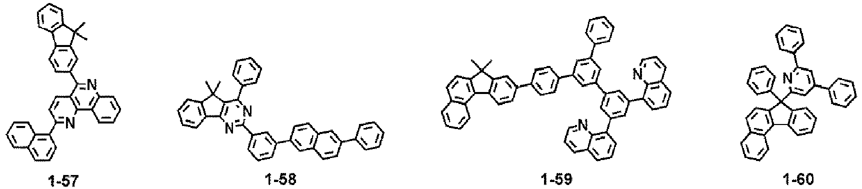

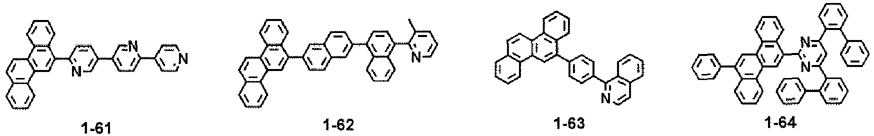

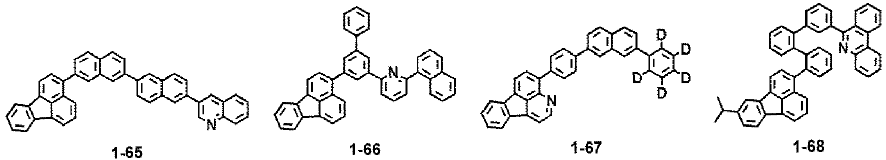

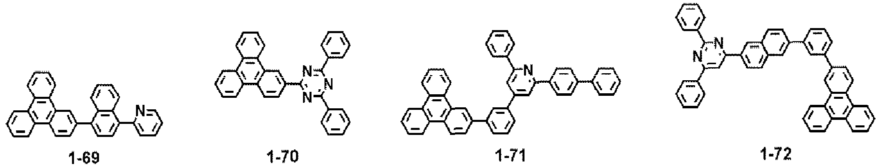

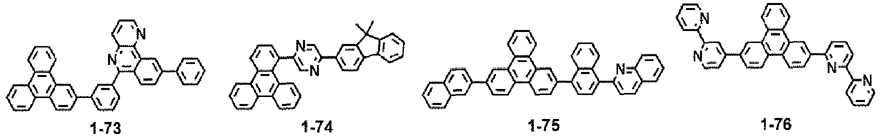

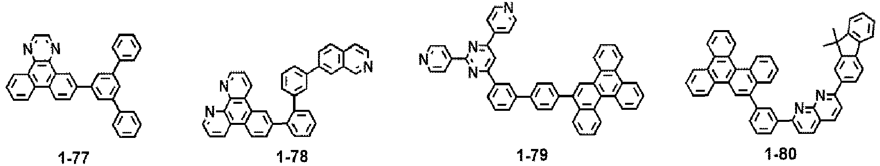

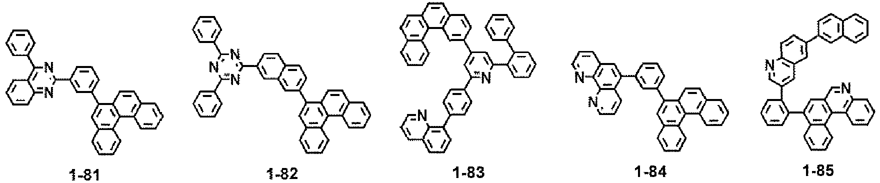

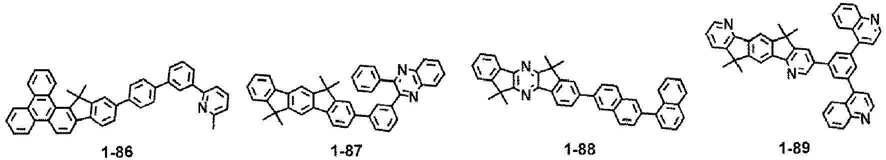

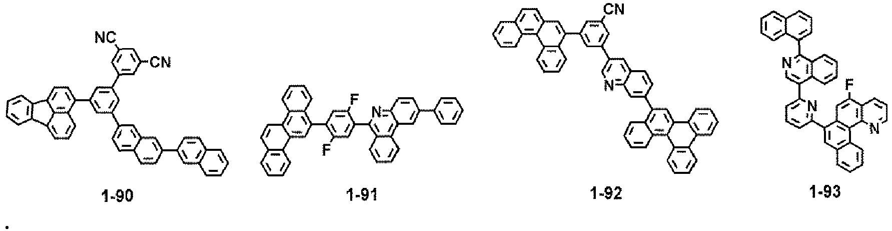

In one or more embodiments, the second compound represented by Formula 2A or 2B may be selected from Compounds 2-1a to 2-172a and 2-1 to 2-262, but embodiments of the present disclosure are not limited thereto:

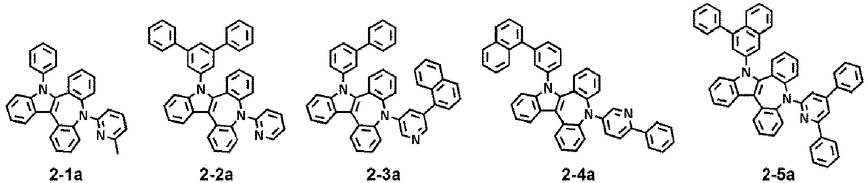

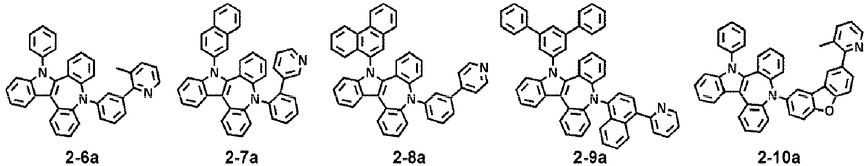

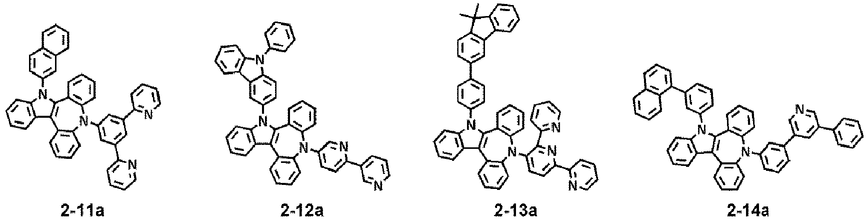

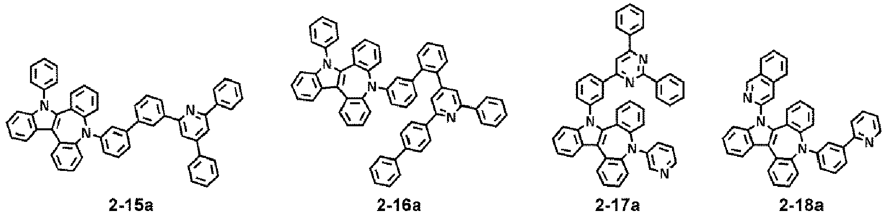

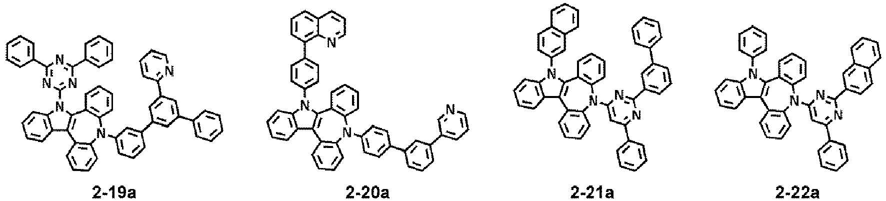

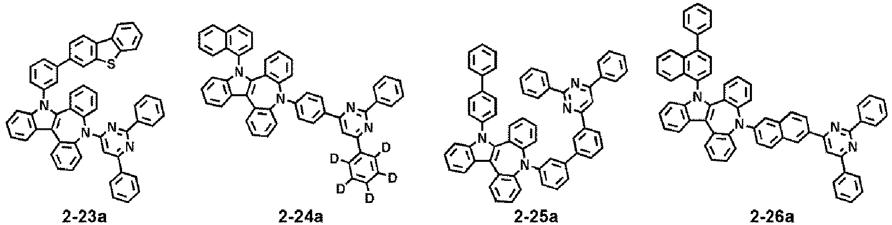

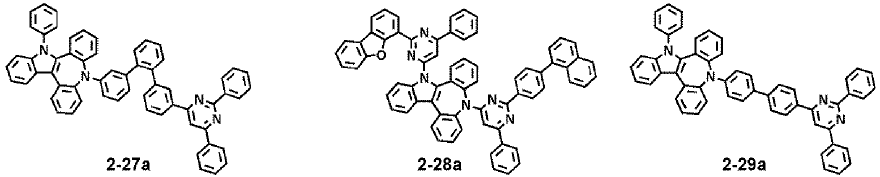

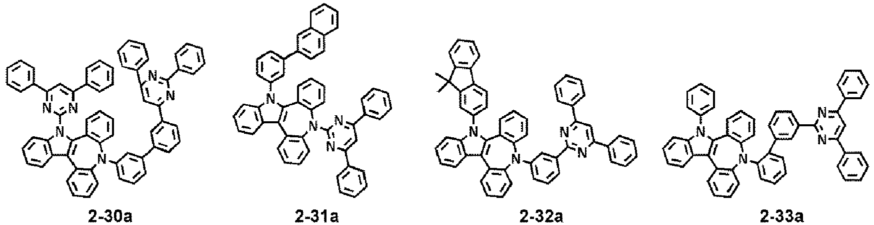

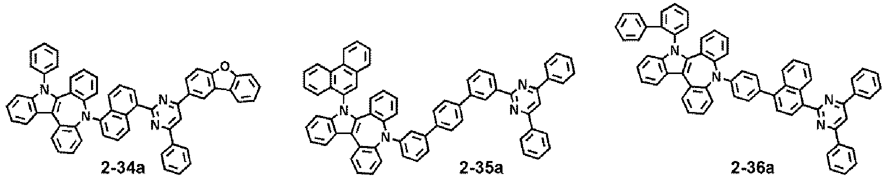

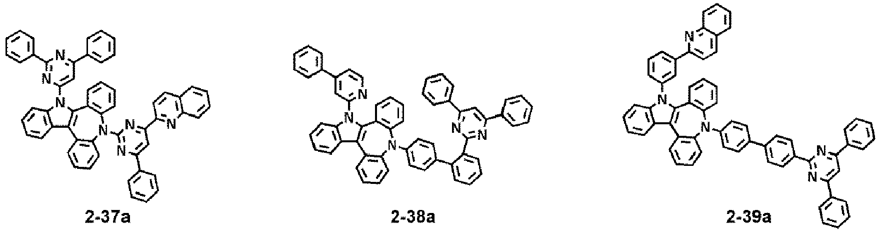

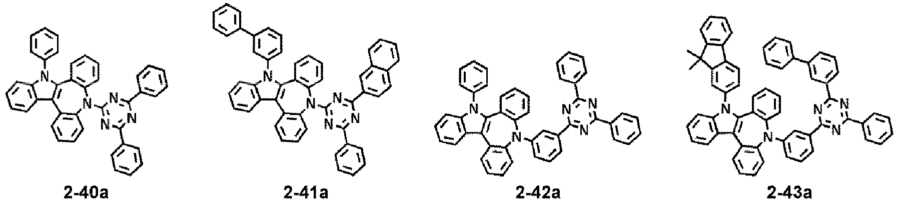

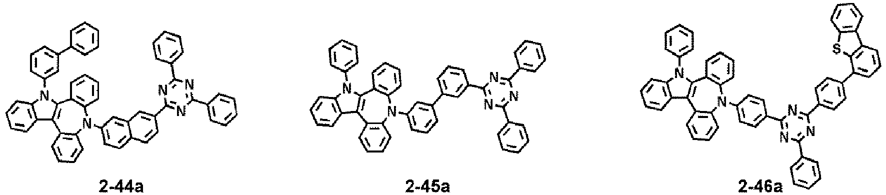

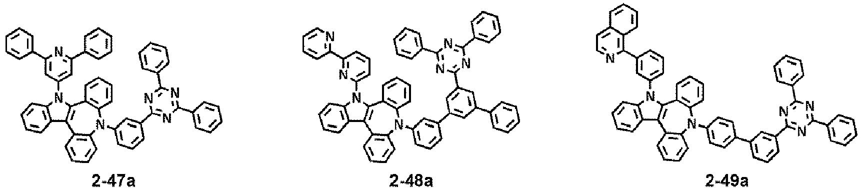

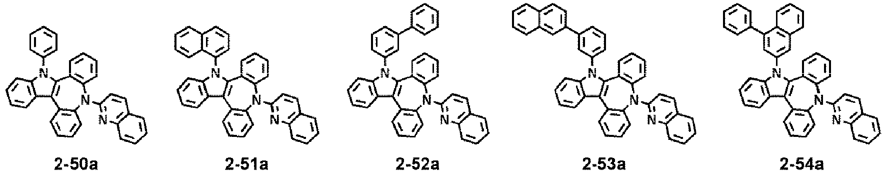

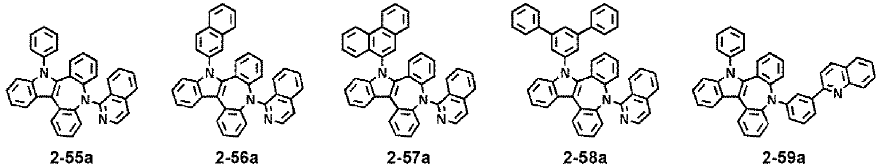

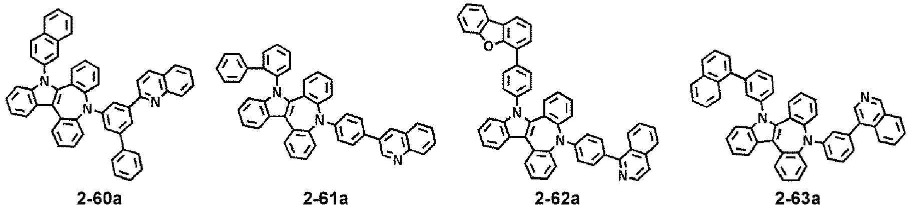

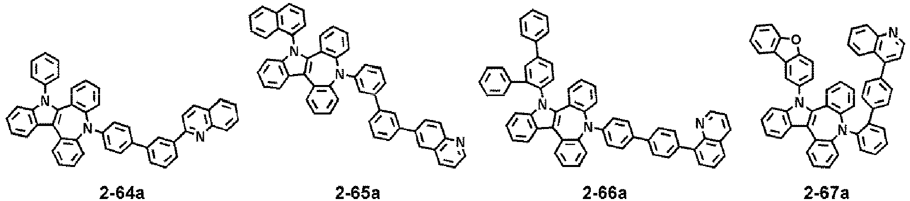

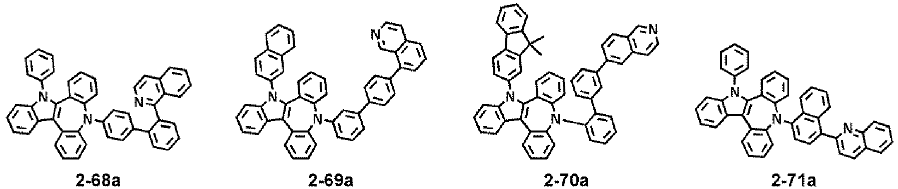

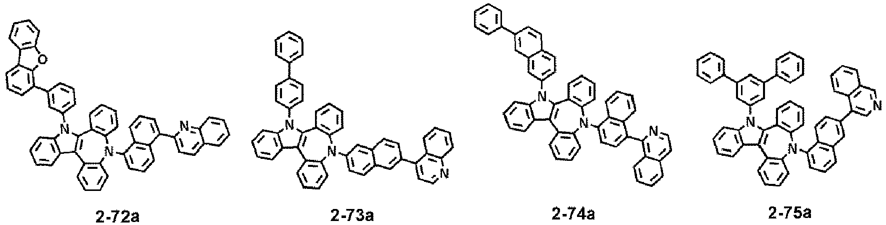

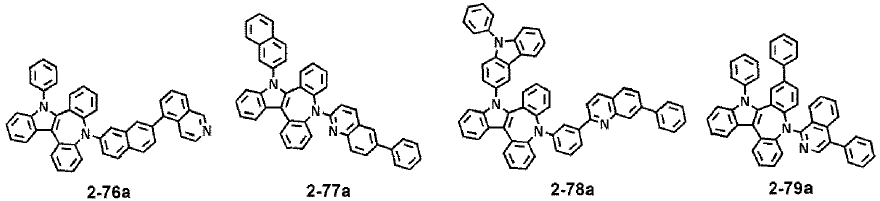

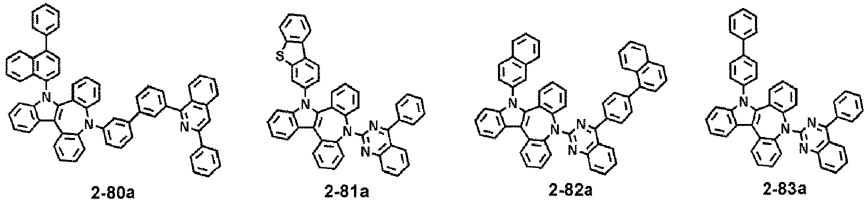

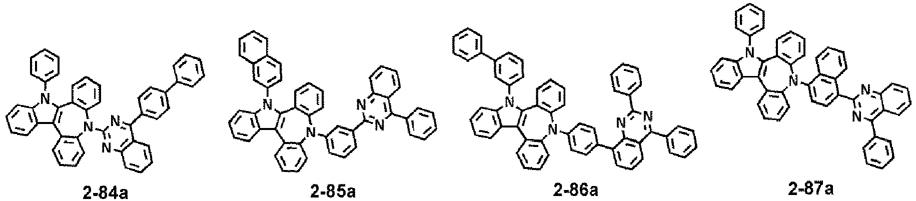

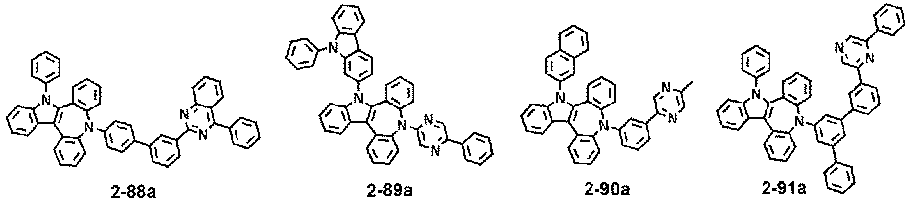

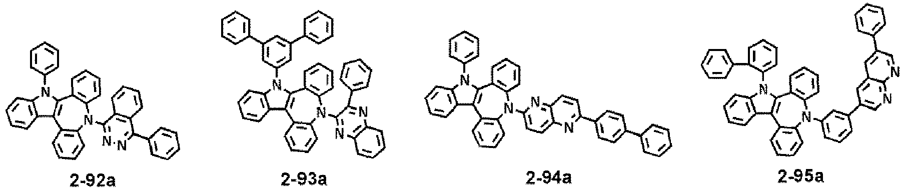

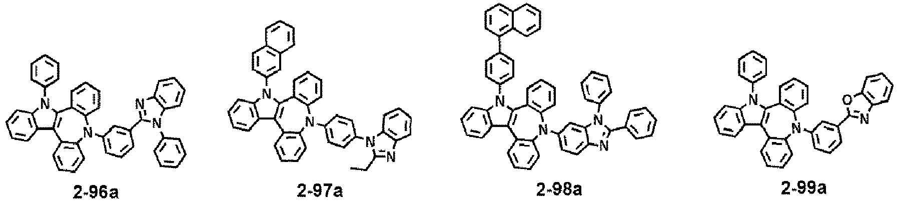

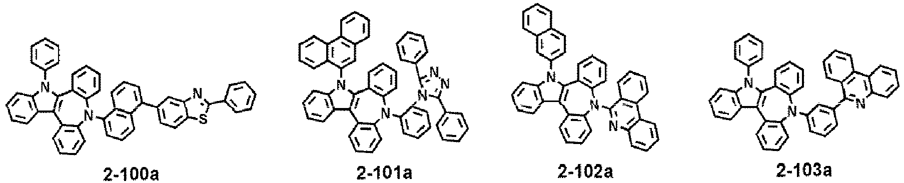

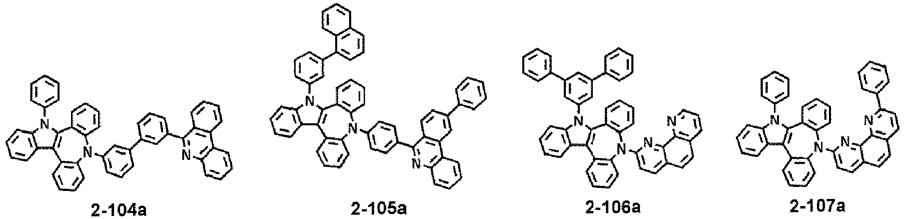

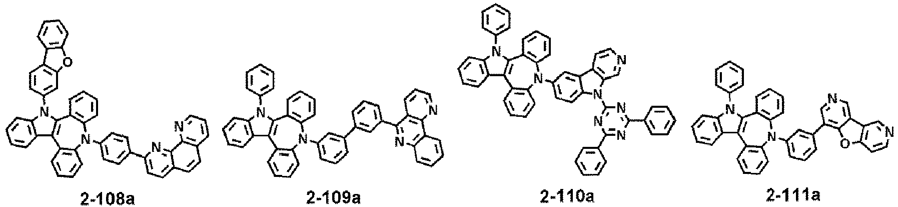

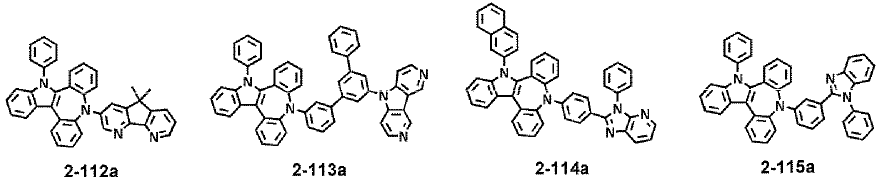

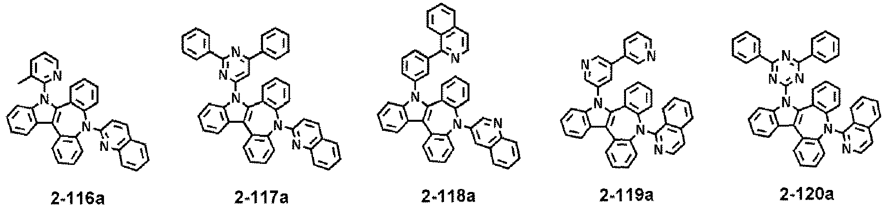

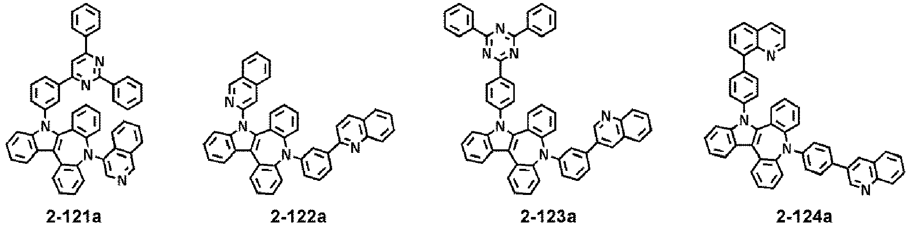

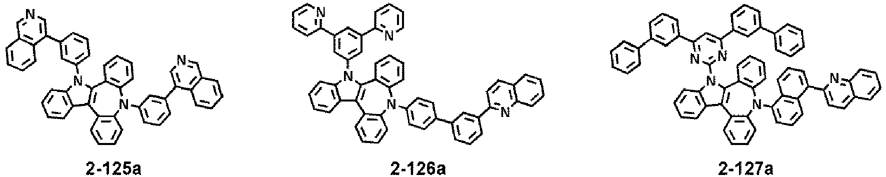

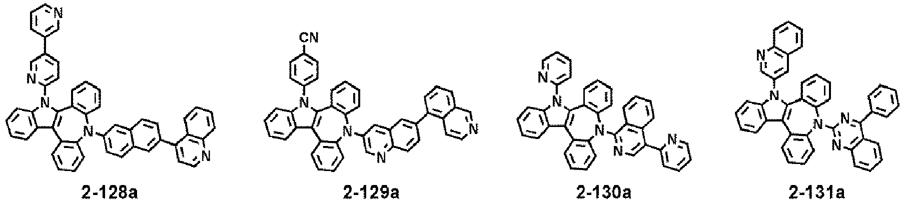

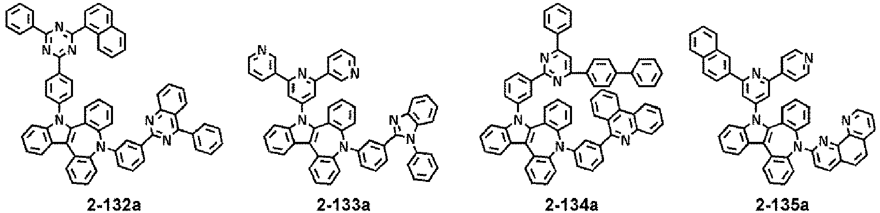

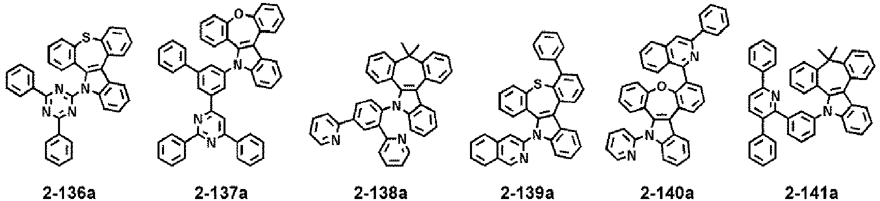

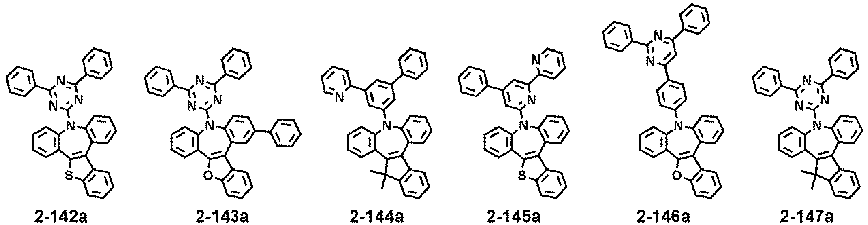

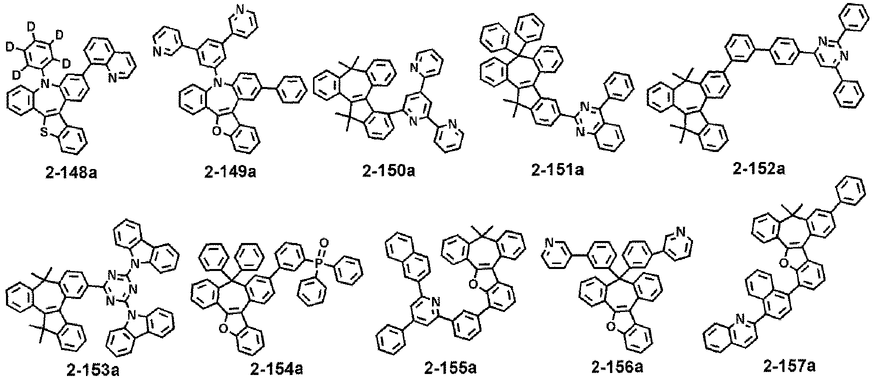

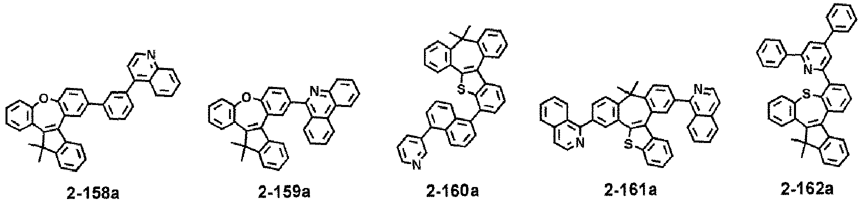

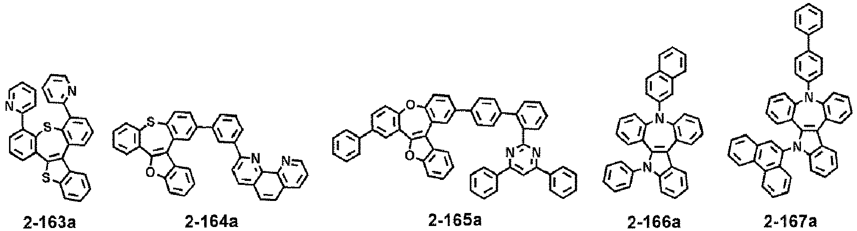

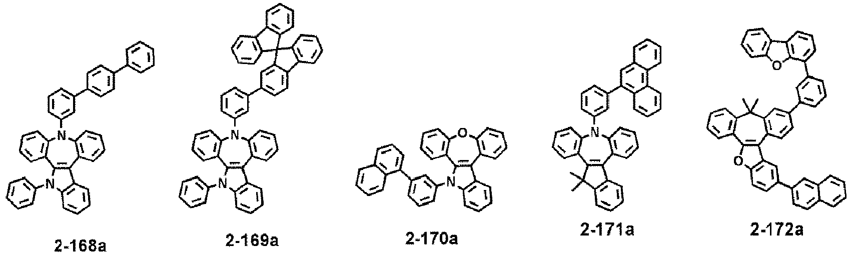

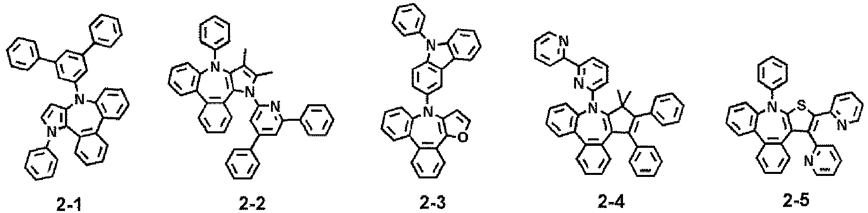

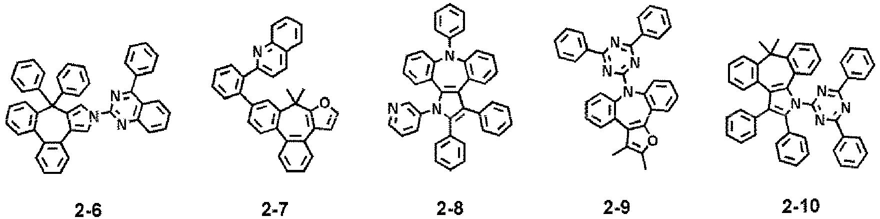

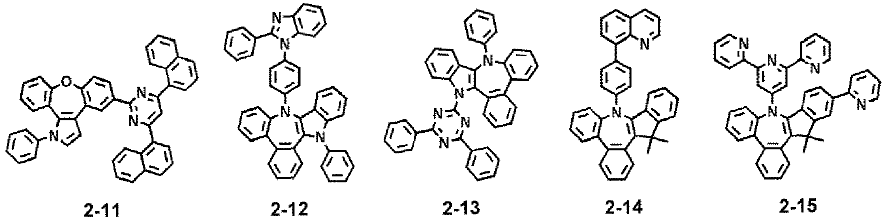

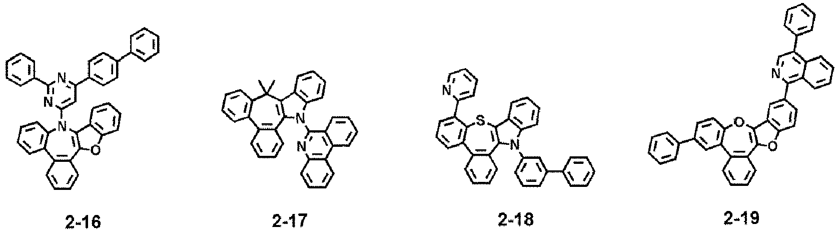

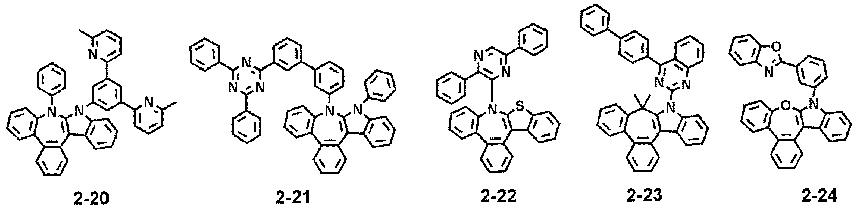

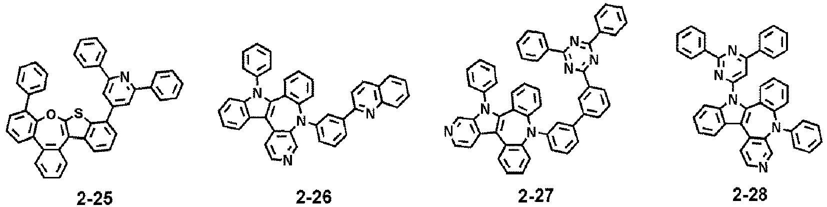

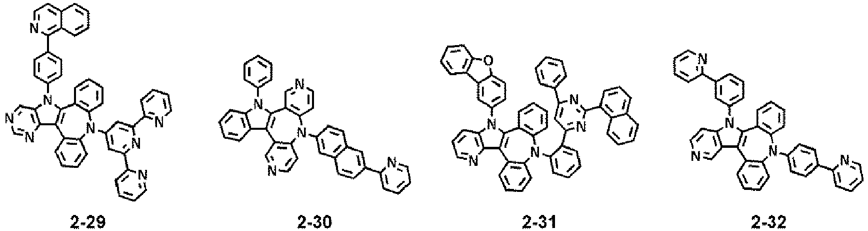

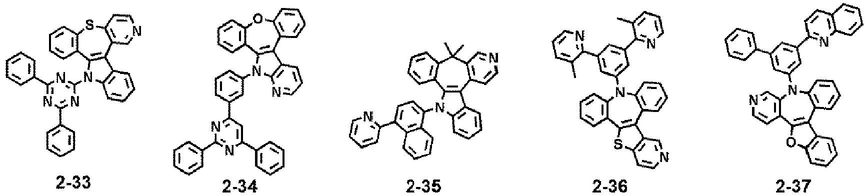

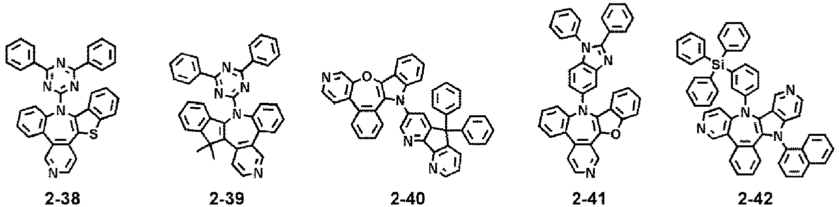

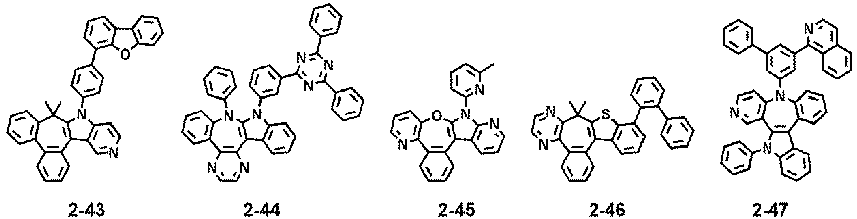

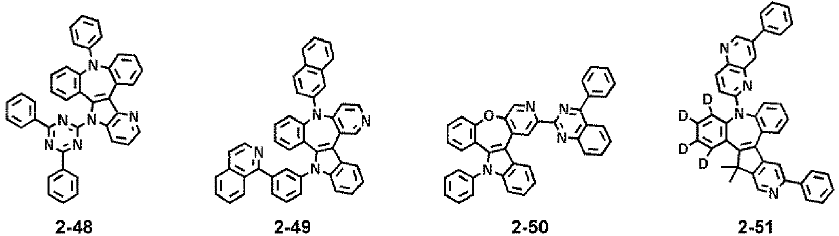

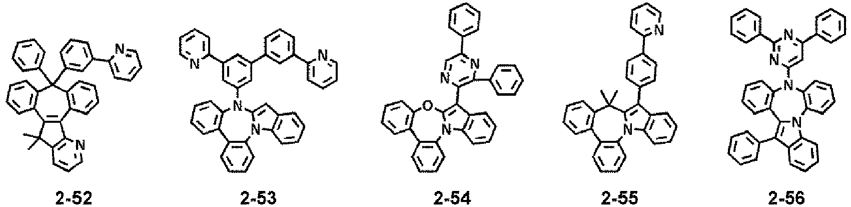

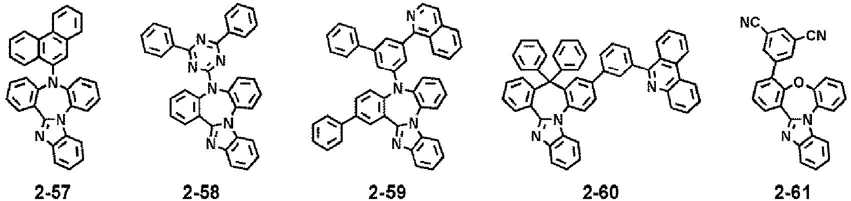

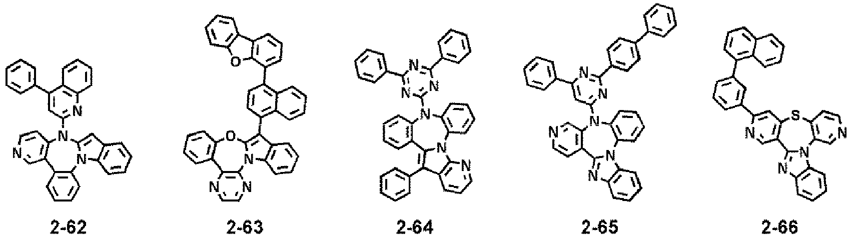

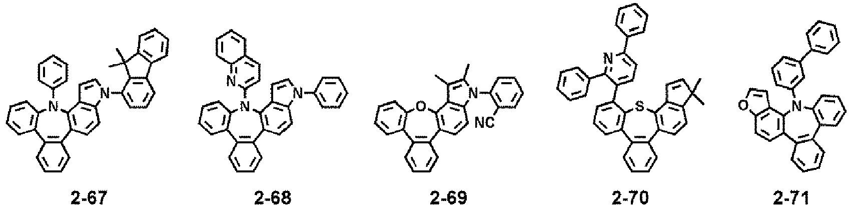

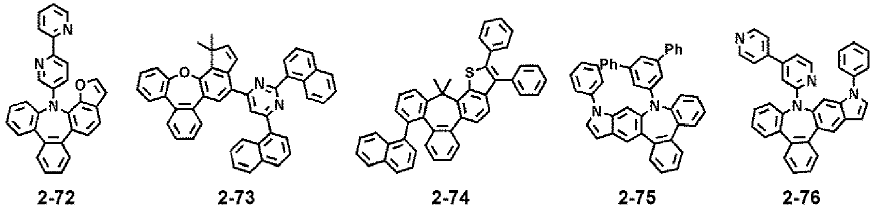

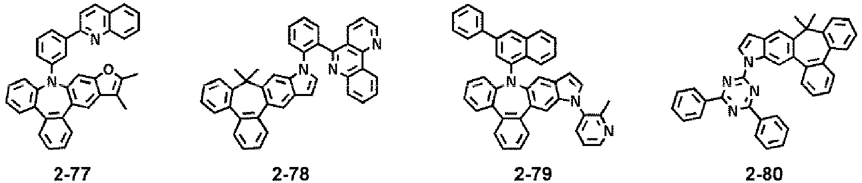

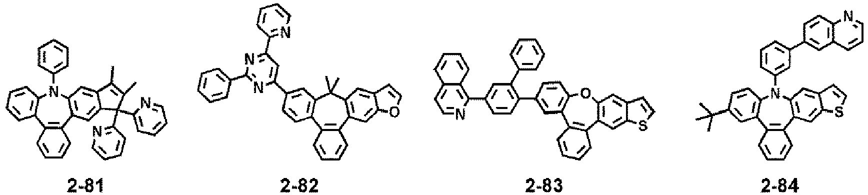

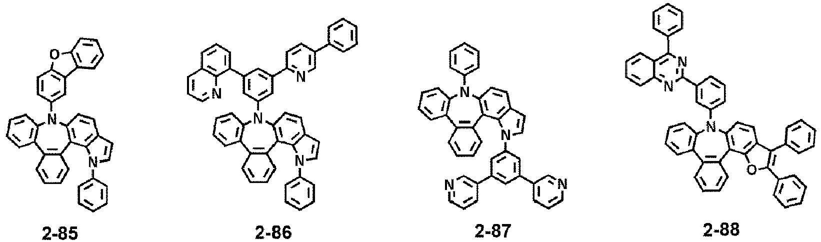

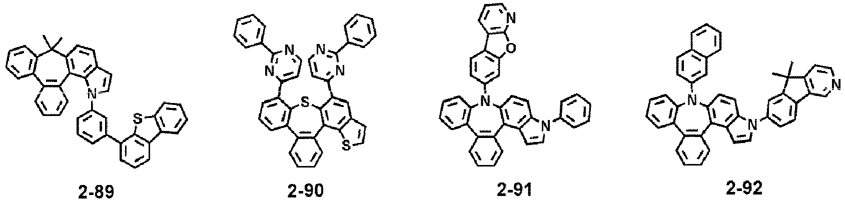

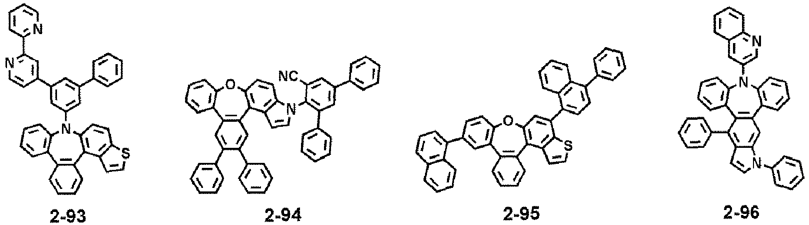

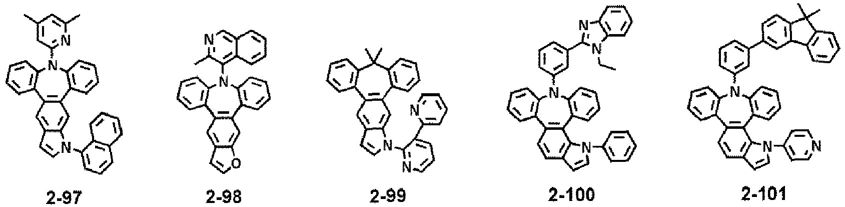

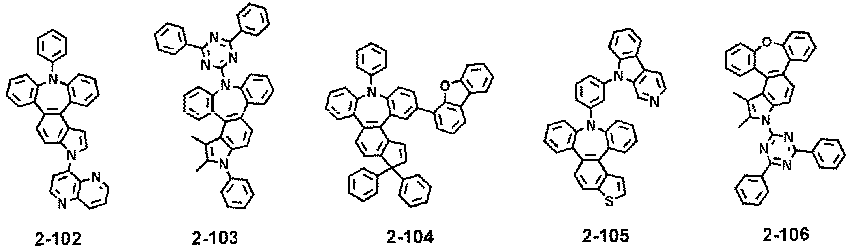

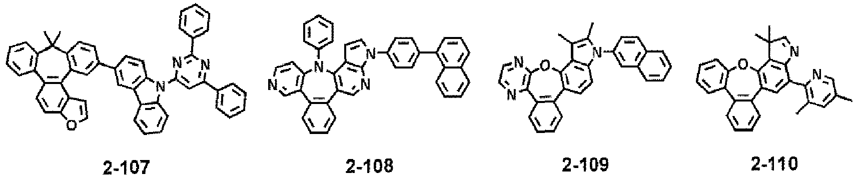

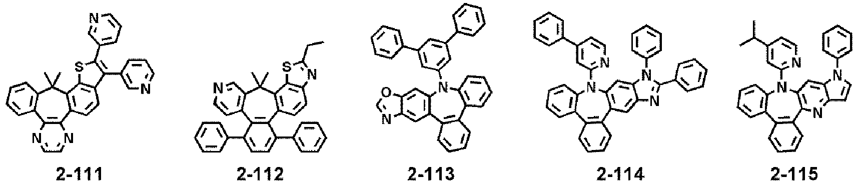

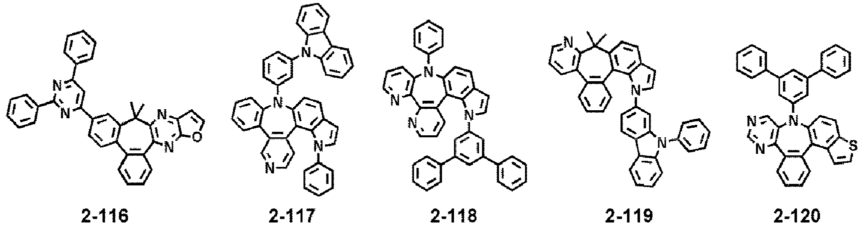

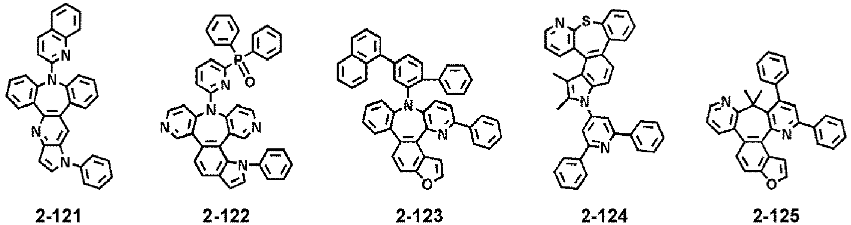

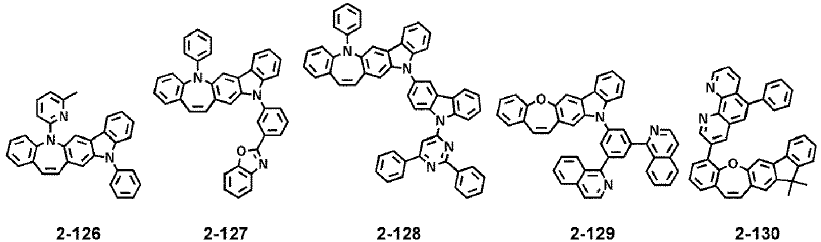

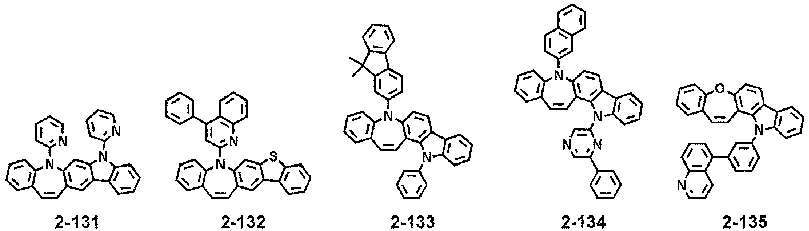

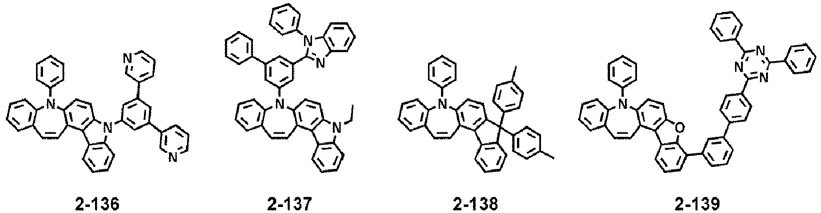

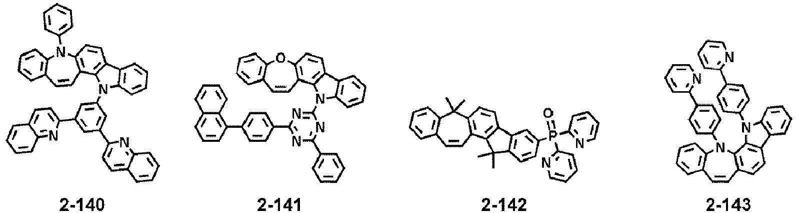

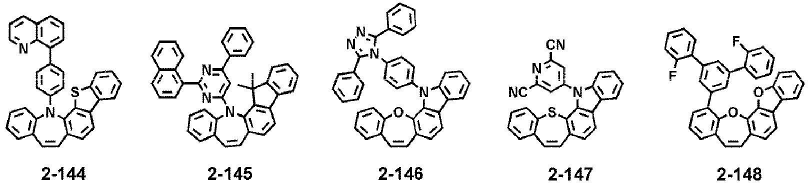

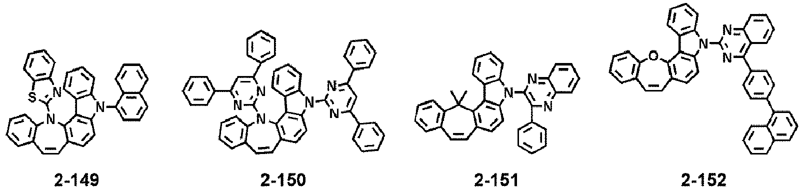

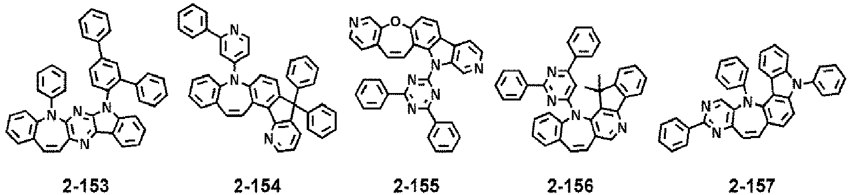

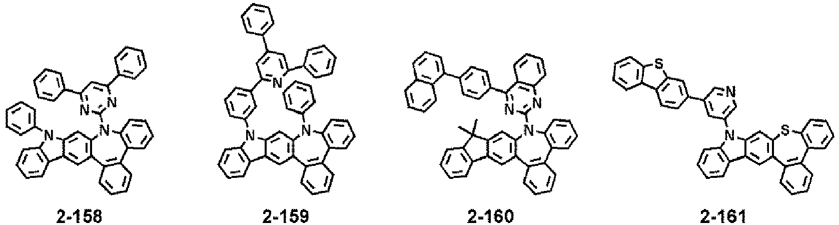

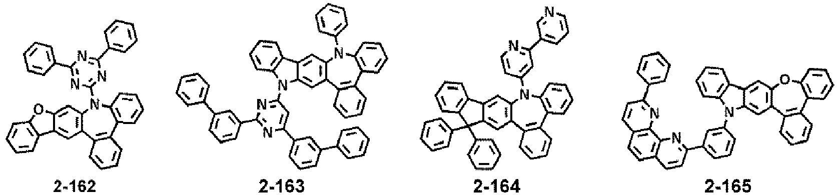

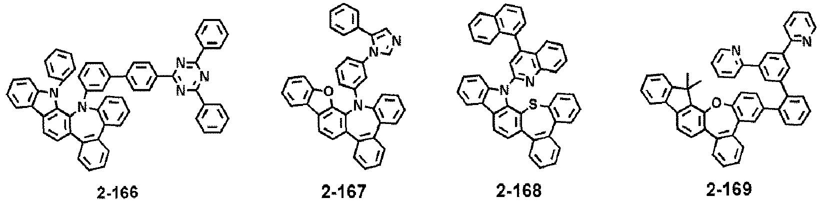

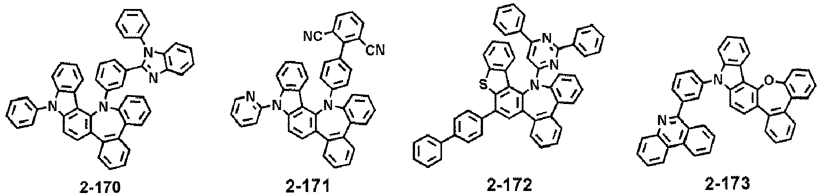

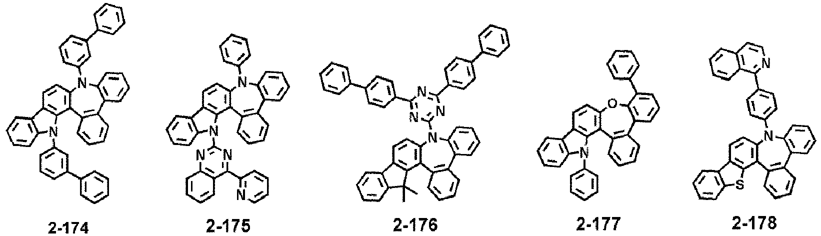

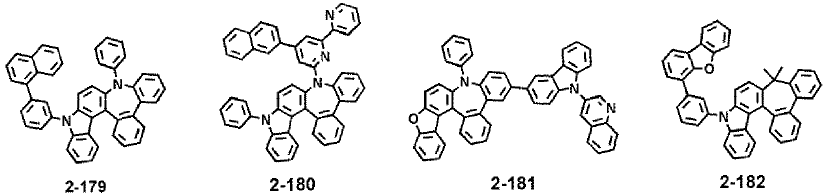

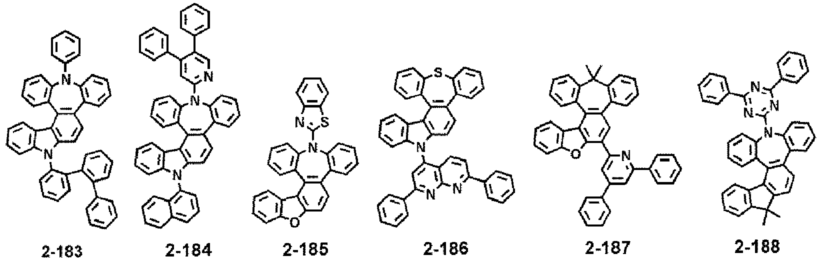

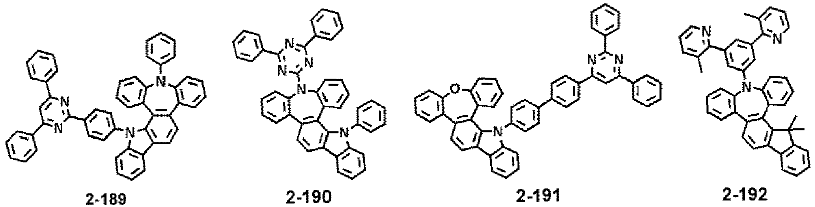

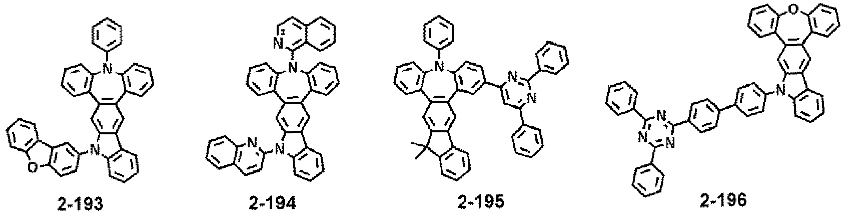

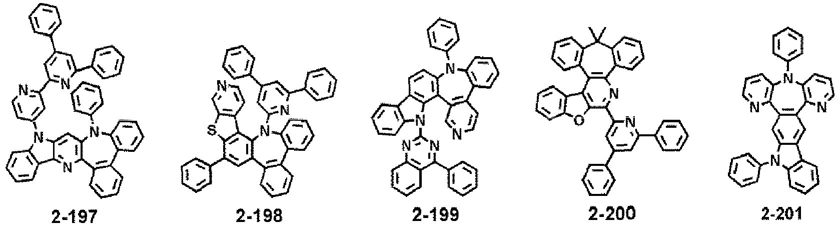

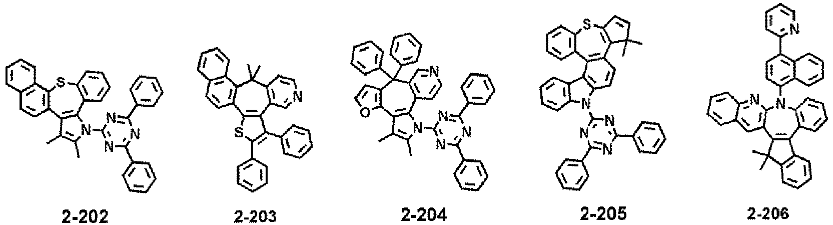

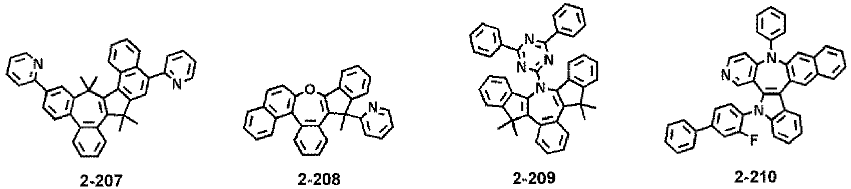

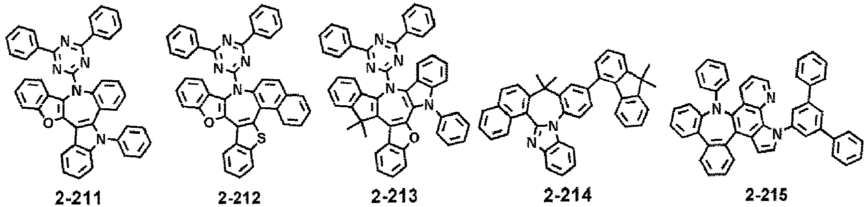

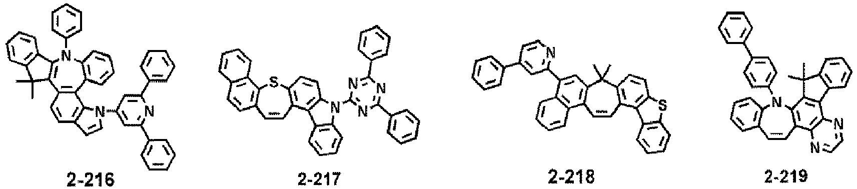

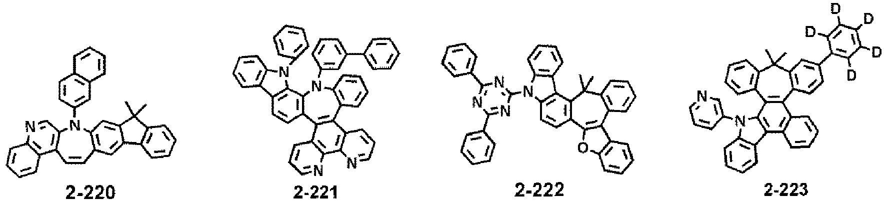

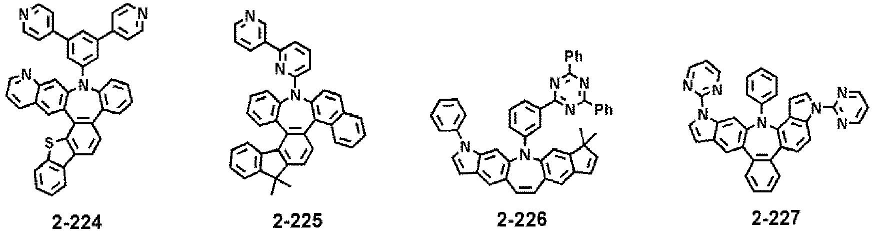

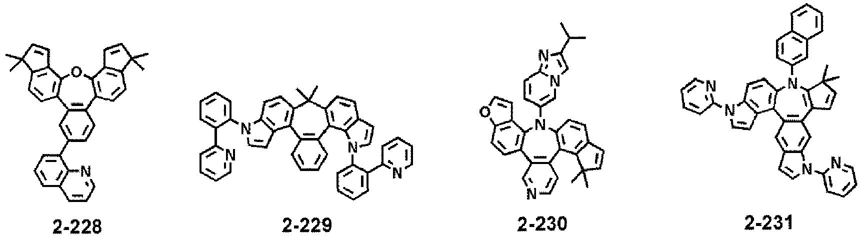

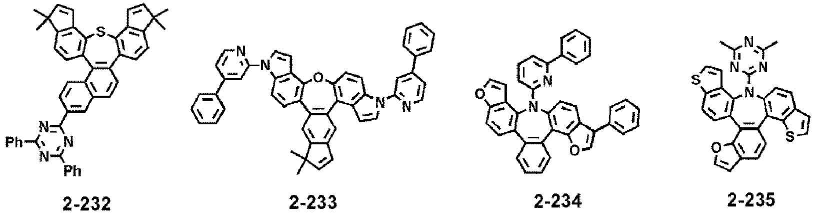

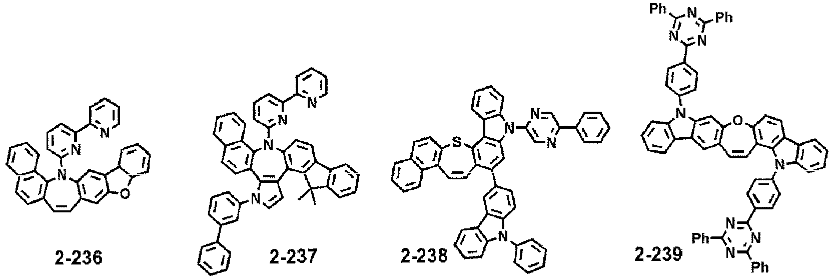

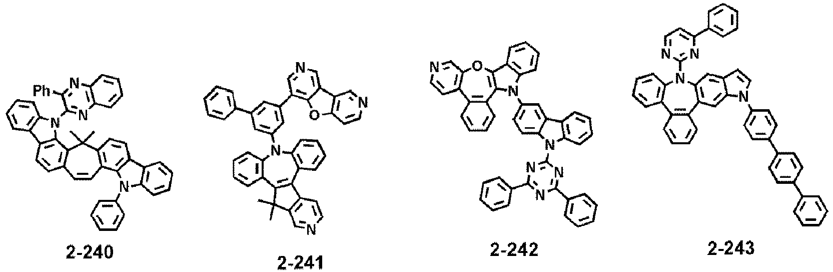

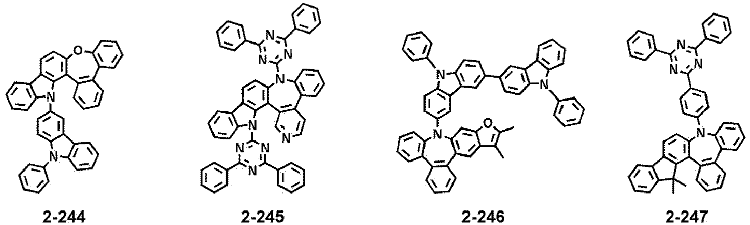

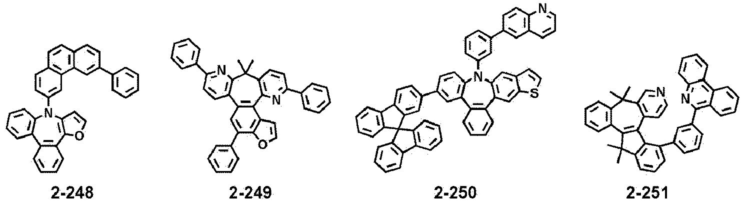

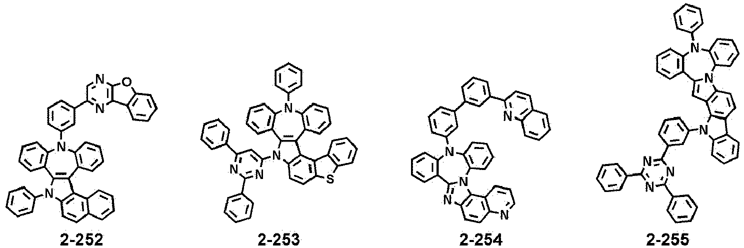

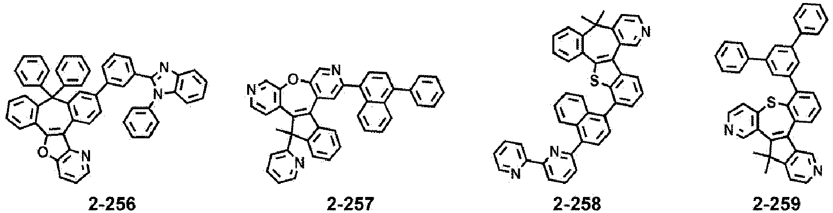

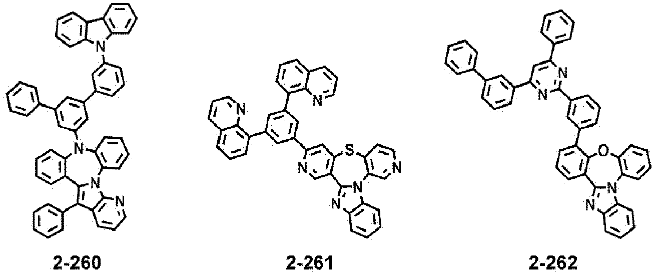

In Formulae 1A, 1B, 1-4, 1D and 1E, any suitable combinations of ring A₁₁, ring A₁₂, ring A₁₃, X₁₁, X₁₂, L₁ to L₉, a1 to a9, R₁ to R₉, b1 to b9, and c1 to c9 may be used within the scopes described herein.

In Formulae 2A and 2B, any suitable combinations of ring A₂₁, ring A₂₂, ring A₂₃, X₂₁, and T₁₁ to T₁₄ may be used within the scopes described herein. Regarding *-[(L₂₂)ₐ₂₂-(R₂₂)_{b22}], C(R₂₃)(R₂₄), Si(R₂₃)(R₂₄), and N-[(L₂₁)ₐ₂₁-(R₂₁)_{b21}], any suitable combinations of L₂₁, L₂₂, a21, a22, R₂₁ to R₂₄, b21, and b22 may be used within the scopes described herein.

In the organic light-emitting device, the emission layer may comprise the first compound, and at least one selected from the hole transport region and the electron transport region may comprise the second compound represented by Formula 2A or 2B. Accordingly, electrons and/or holes injected into or transported to the emission layer may be easily balanced to prevent current leakage, thereby enabling low driving voltage and high efficiency characteristics.

In one embodiment, the second compound represented by Formula 2A or 2B may have a triplet energy of 2.2 eV or more, for example, 2.3 eV or more, and in some embodiments, 2.4 eV or more.

When the second compound represented by Formula 2A or 2B satisfies these triplet energy ranges, for example, the luminescent efficiency of a fluorescent organic light-emitting device may be improved due to triplet-triplet fusion (TTF), or triplet excitons formed in the emission layer of a phosphorescent organic light-emitting device may not be transitioned (e.g., the probability of triplet exciton loss may be reduced), thereby preventing or reducing a decrease in efficiency of an organic light-emitting device.

In one embodiment, the emission layer may comprise the first compound represented by one selected from Formulae 1A, 1B, 1-4, 1D and 1E as a first host.

In one embodiment, the emission layer may further comprise, in addition to the first host, a second host that is different from the first host.

In one embodiment, the hole transport region may comprise an emission auxiliary layer, the emission auxiliary layer may directly contact the emission layer, and the emission auxiliary layer may comprise the second compound represented by Formula 2A or 2B.

In one or more embodiments, the electron transport region may comprise a buffer layer, the buffer layer may directly contact the emission layer, and the buffer layer may comprise the second compound represented by Formula 2A or 2B, but embodiments of the hole transport region and the electron transport region are not limited thereto.

When each of the hole transport region and the electron transport region in the organic light-emitting device comprises the second compound represented by Formula 2A or 2B, the second compound comprised in the hole transport region may be identical to or different from the second compound comprised in the electron transport region.

The emission layer may comprise a dopant, and the dopant may be an organometallic complex.

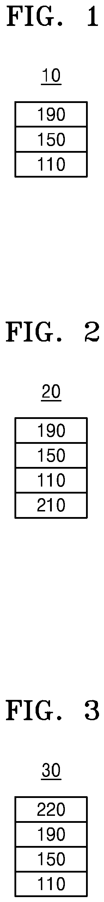

### Description of FIG. 1

FIG. 1 is a schematic view of an organic light-emitting device 10 according to an embodiment of the present disclosure. The organic light-emitting device 10 comprises a first electrode 110, an organic layer 150, and a second electrode 190.

Hereinafter, the structure of the organic light-emitting device 10 according to an embodiment of the present disclosure and a method of manufacturing the organic light-emitting device 10 will be described in connection with FIG. 1.

### First electrode 110

In FIG. 1, a substrate may be under the first electrode 110 or above the second electrode 190. The substrate may be a glass substrate or a plastic substrate, each having excellent mechanical strength, thermal stability, transparency, surface smoothness, ease of handling, and/or water-resistance.

The first electrode 110 may be formed by depositing and/or sputtering a material for forming the first electrode 110 on the substrate. When the first electrode 110 is an anode, the material for forming the first electrode 110 may be selected from materials with a high work function in order to facilitate hole injection.

The first electrode 110 may be a reflective electrode, a semi-transmissive electrode, or a transmissive electrode. When the first electrode 110 is a transmissive electrode, the material for forming the first electrode may be selected from indium tin oxide (ITO), indium zinc oxide (IZO), tin oxide (SnO₂), zinc oxide (ZnO), and combinations thereof, but embodiments of the present disclosure are not limited thereto. When the first electrode 110 is a semi-transmissive electrode or a reflective electrode, the material for forming the first electrode 110 may be selected from magnesium (Mg), silver (Ag), aluminum (Al), aluminum-lithium(Al-Li), calcium (Ca), magnesium-indium (Mg-In), magnesium-silver (Mg-Ag), and combinations thereof. However, embodiments of the material for forming the first electrode 110 are not limited thereto.

The first electrode 110 may have a single-layer structure, or a multi-layer structure comprising two or more layers. For example, the first electrode 110 may have a three-layered structure of ITO/Ag/ITO, but embodiments of the structure of the first electrode 110 are not limited thereto.

### Organic layer 150

The organic layer 150 is on the first electrode 110. The organic layer 150 may comprise an emission layer.

The organic layer 150 may comprise a hole transport region between the first electrode 110 and the emission layer, and an electron transport region between the emission layer and the second electrode 190.

### Hole transport region in organic layer 150

The hole transport region may have i) a single-layered structure including a single layer including a single material, ii) a single-layered structure including a single layer comprising a plurality of different materials, or iii) a multi-layered structure having a plurality of layers comprising a plurality of different materials.

The hole transport region may comprise at least one layer selected from a hole injection layer, a hole transport layer, an emission auxiliary layer, and an electron blocking layer.

For example, the hole transport region may have a single-layer structure including a single layer comprising a plurality of different materials, or a multi-layer structure having a structure of hole injection layer/hole transport layer, hole injection layer/hole transport layer/emission auxiliary layer, hole injection layer/emission auxiliary layer, hole transport layer/emission auxiliary layer, or hole injection layer/hole transport layer/electron blocking layer, wherein layers of each structure are sequentially stacked on the first electrode 110 in each stated order, but embodiments of the structure of the hole transport region are not limited thereto.

The hole transport region may comprise the second compound represented by Formula 2A or 2B as described above.

In one embodiment, the hole transport region may comprise an emission auxiliary layer. The emission auxiliary layer may directly contact the emission layer.

In one or more embodiments, the hole transport region may comprise a hole injection layer and a hole transport layer stacked in this stated order on the first electrode 110, a hole injection layer and an emission auxiliary layer stacked in this stated order on the first electrode 110, or a hole injection layer, a hole transport layer, and an emission auxiliary layer, stacked in this stated order on the first electrode 110, but embodiments of the present disclosure are not limited thereto.

When the hole transport region comprises an emission auxiliary layer, the emission auxiliary layer may further comprise the second compound represented by Formula 2A or 2B.

The hole transport region may comprise at least one selected from m-MTDATA, TDATA, 2-TNATA, NPB(NPD), β-NPB, TPD, Spiro-TPD, Spiro-NPB, methylated NPB, TAPC, HMTPD, 4,4',4"-tris(*N*-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, and a compound represented by Formula 202:

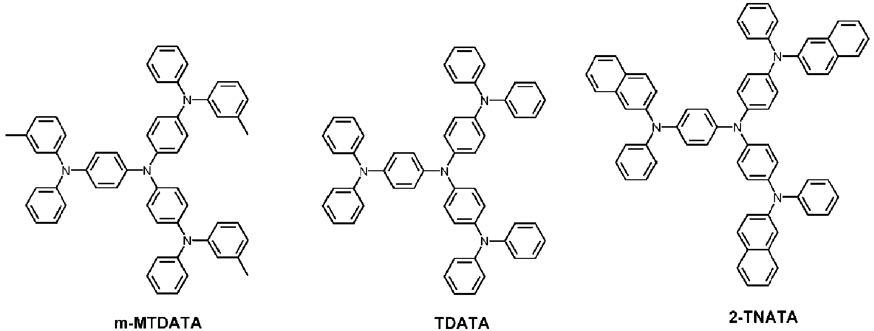

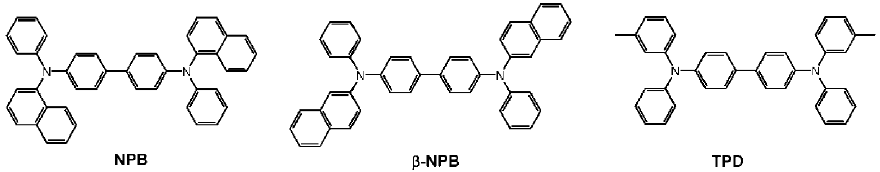

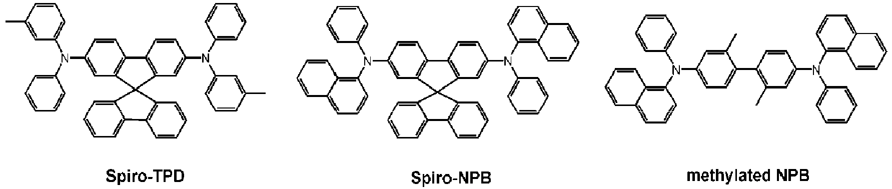

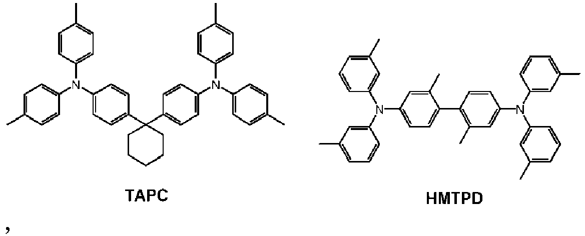

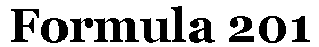

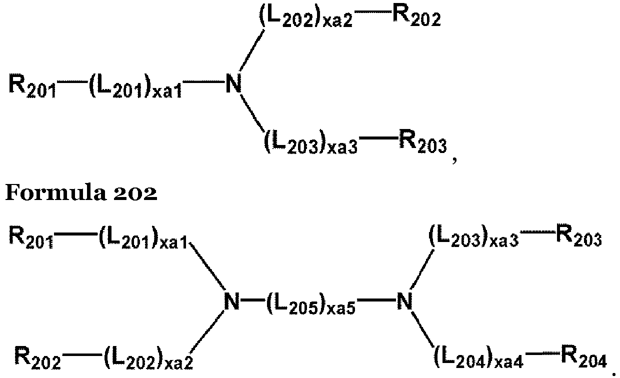

In Formulae 201 and 202,
L201 to L204 may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C6-C60 polycyclic group, and a substituted or unsubstituted divalent non-aromatic condensed 6- to 60- membered heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C6-C60 polycyclic group, and a substituted or unsubstituted divalent non-aromatic condensed 6- to 60- membered heteropolycyclic group,
xa1 to xa4 may each independently be an integer selected from 0 to 3,
xa5 may be an integer selected from 1 to 10, and
R201 to R204 and Q201 may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C6-C60 polycyclic group, and a substituted or unsubstituted monovalent non-aromatic condensed 6- to 60- membered heteropolycyclic group.

For example, R201 and R₂₀₂ in Formula 202 may be optionally linked (e.g., coupled) via a single bond, a dimethyl-methylene group, or a diphenyl-methylene group, and R₂₀₃ and R₂₀₄ may be optionally linked (e.g., coupled) via a single bond, a dimethyl-methylene group, or a diphenyl-methylene group.

In one embodiment, in Formulae 201 and 202,

L₂₀₁ to L₂₀₅ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be an integer selected from 0, 1, or 2.

In one or more embodiments, xa5 may be 1, 2, 3, or 4.

In one or more embodiments, R₂₀₁ to R₂₀₄ and Q₂₀₁ may each independently be selected from a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ may each independently be the same as described above.

In one or more embodiments, at least one selected from R₂₀₁ to R₂₀₃ in Formula 201 may be selected from the group consisting of:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments of the present disclosure are not limited thereto.

In one or more embodiments, in Formula 202, i) R₂₀₁ and R₂₀₂ may be linked (e.g., coupled) via a single bond, and/or ii) R₂₀₃ and R₂₀₄ may be linked (e.g., coupled) via a single bond.

In one or more embodiments, at least one selected from R₂₀₁ to R₂₀₄ in Formula 202 may be selected from the group consisting of:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments of the present disclosure are not limited thereto.

A compound represented by Formula 201 may be represented by Formula 201A:

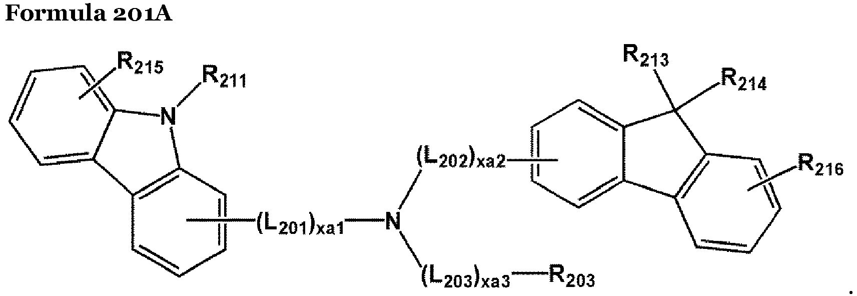

For example, the compound represented by Formula 201 may be represented by Formula 201A(1), but embodiments of the present disclosure are not limited thereto:

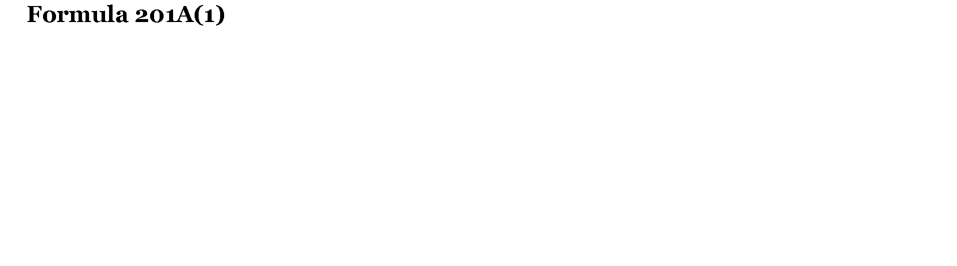

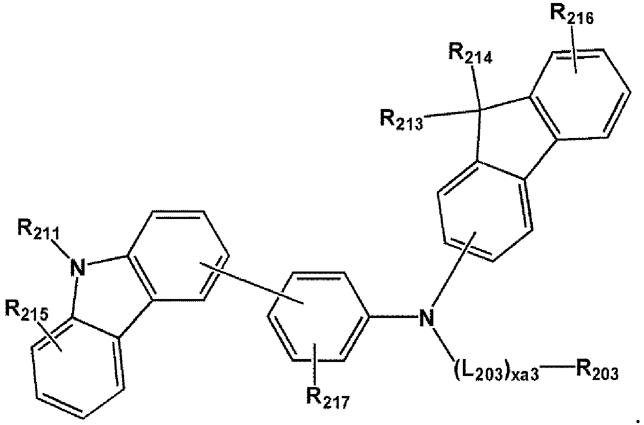

In one or more embodiments, the compound represented by Formula 201 may be represented by Formula 201A-1, but embodiments of the present disclosure are not limited thereto:

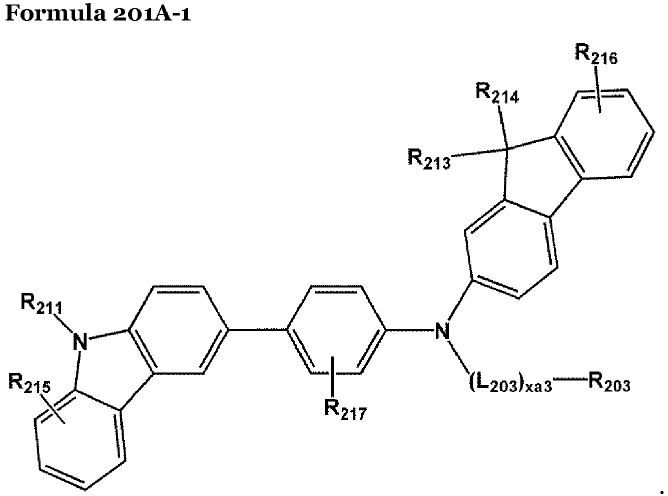

A compound represented by Formula 202 may be represented by Formula 202A:

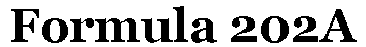

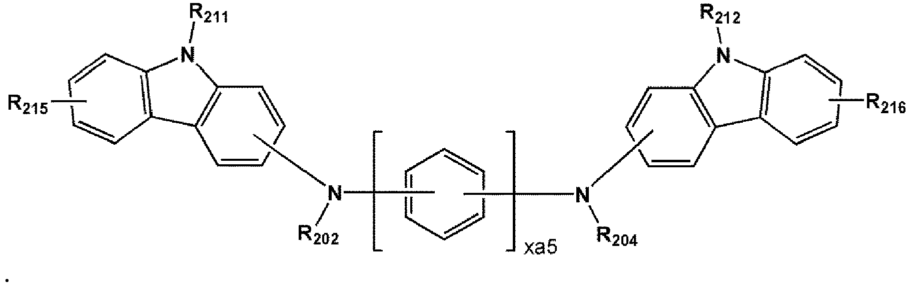

In one or more embodiments, the compound represented by Formula 202 may be represented by Formula 202A-1:

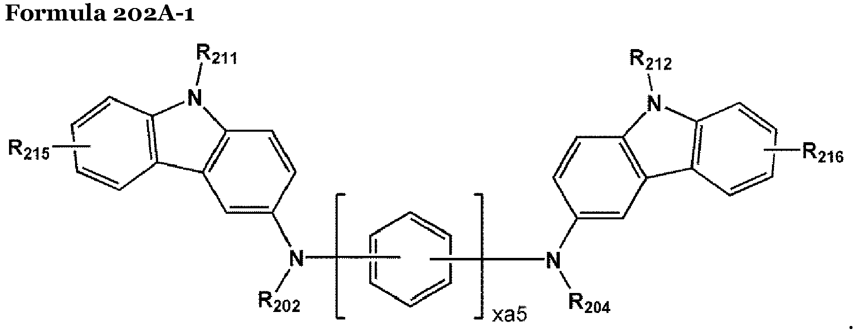

In Formulae 201A, 201A(1), 201A-1, 202A, and 202A-1,
L₂₀₁ to L₂₀₃, xa1 to xa3, xa5, and R₂₀₂ to R₂₀₄ may each independently be the same as described above,
R₂₁₁ and R₂₁₂ may each independently be the same as described herein in connection with R₂₀₃,
R₂₁₃ to R₂₁₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may comprise at least one compound selected from Compounds HT₁ to HT₃₉, but embodiments of the material to be comprised in the hole transport region are not limited thereto:

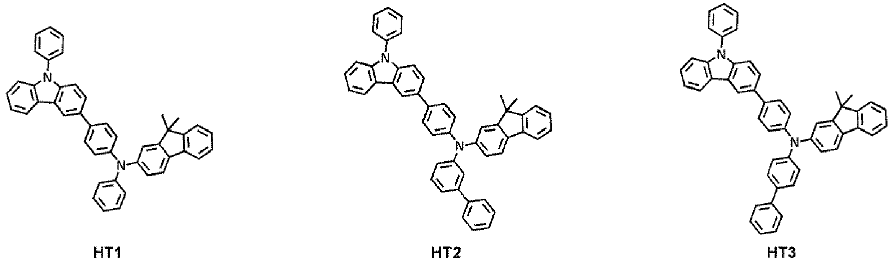

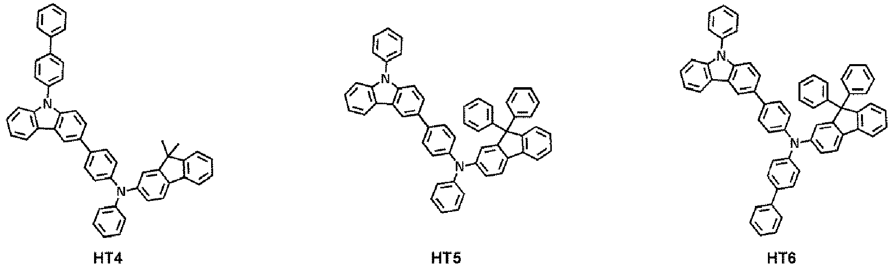

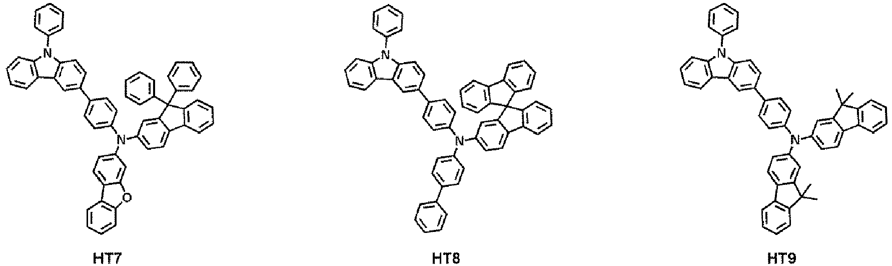

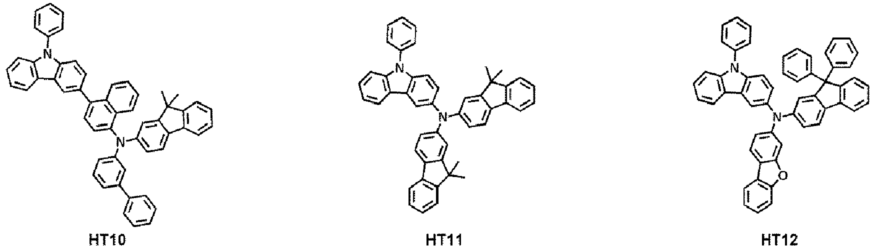

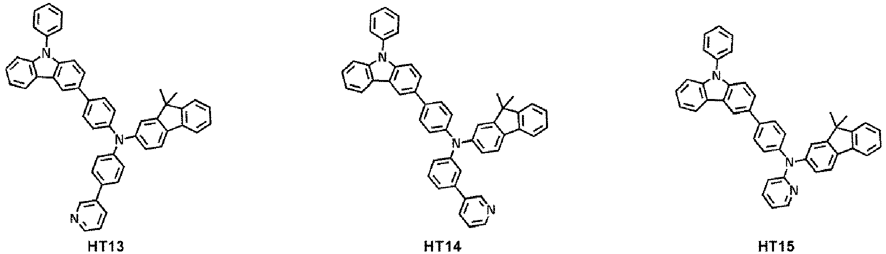

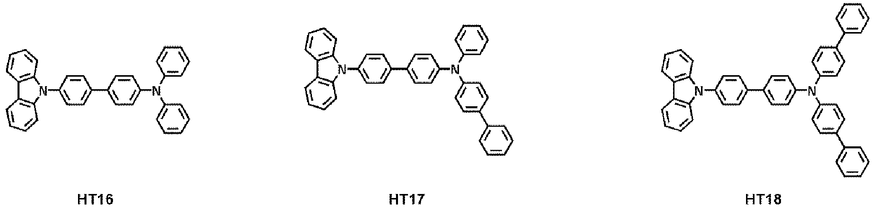

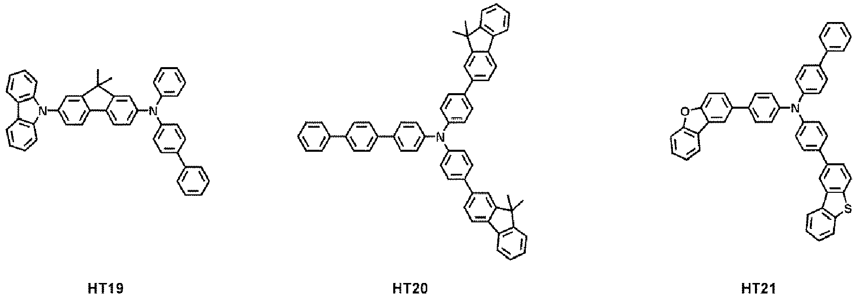

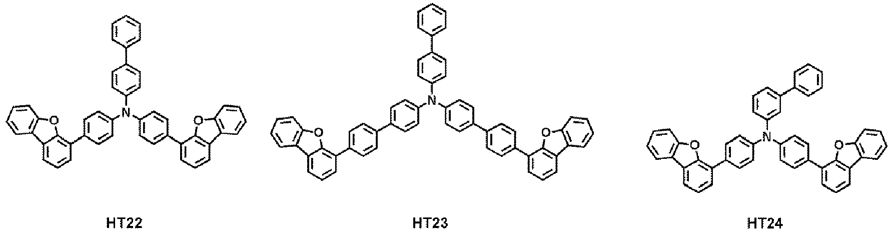

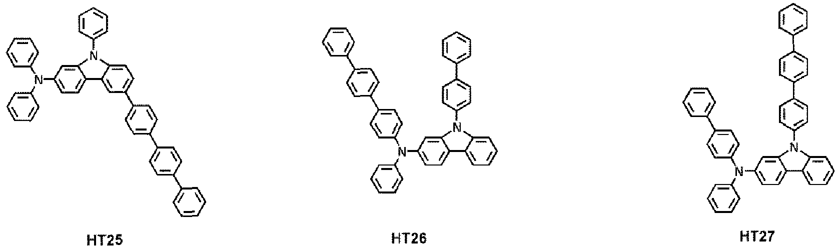

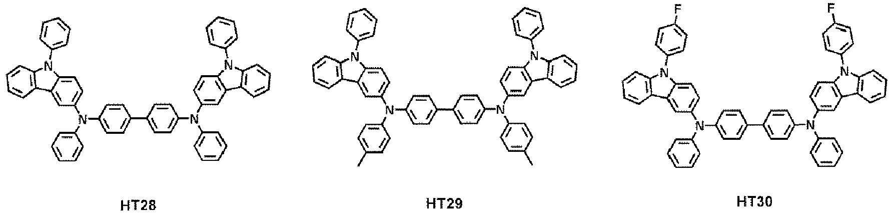

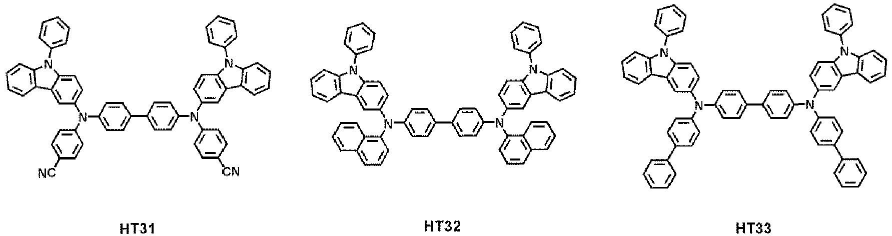

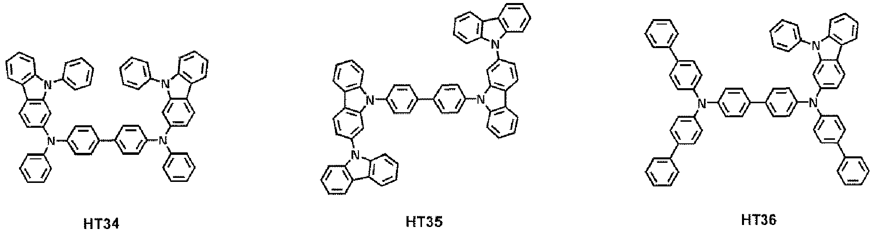

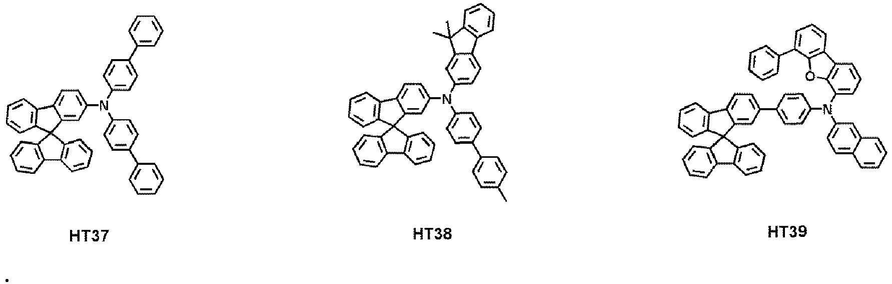

The thickness of the hole transport region may be about 100 Å to about 10,000 Å, and in some embodiments, about 100 Å to about 1,000 Å. When the hole transport region comprises at least one selected from a hole injection layer and a hole transport layer, the thickness of the hole injection layer may be about 100 Å to about 9,000 Å, and in some embodiments, about 100 Å to about 1,000 Å; the thickness of the hole transport layer may be about 50 Å to about 2,000 Å, and in some embodiments, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase the light-emission efficiency of the device by compensating for an optical resonance distance according to the wavelength of light emitted by an emission layer (e.g., by adjusting the optical resonance distance to match the wavelength of light emitted from the emission layer), and the electron blocking layer may block or reduce the flow of electrons from an electron transport region. The emission auxiliary layer and the electron blocking layer may each comprise those materials as described above.

### p-dopant

The hole transport region may further comprise, in addition to these materials, a charge-generation material for the improvement of conductive properties. The charge-generation material may be homogeneously or non-homogeneously dispersed in the hole transport region.

The charge-generation material may be, for example, a p-dopant.

The doping concentration of the p-dopant may be 0.1 wt% to 20 wt%, for example, 0.5 wt% to 10 wt%.

In one embodiment, the p-dopant may have a lowest unoccupied molecular orbital (LUMO) of -3.5 eV or less.

The p-dopant may comprise at least one selected from a quinone derivative, a metal oxide, and a cyano group-containing compound, but embodiments of the present disclosure are not limited thereto.

For example, the p-dopant may comprise at least one selected from the group consisting of:
a quinone derivative (such as tetracyanoquinodimethane (TCNQ) and/or 2,3,5,6-tetrafluoro-7,7,8,8-tetracyanoquinodimethane (F4-TCNQ));
a metal oxide (such as tungsten oxide and/or molybdenum oxide);
1,4,5,8,9,11-hexaazatriphenylene-hexacarbonitrile (HAT-CN); and
a compound represented by Formula 221, but embodiments of the present disclosure are not limited thereto:

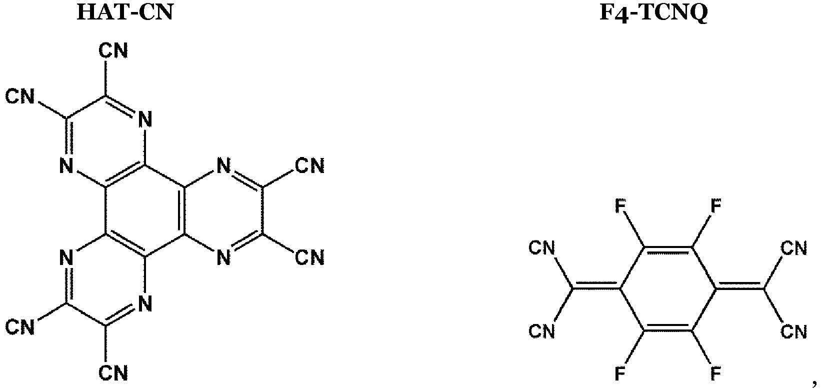

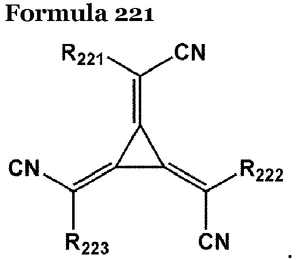

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed C6-C60 polycyclic group, and a substituted or unsubstituted monovalent non-aromatic condensed 6- to 60- membered heteropolycyclic group, wherein at least one selected from R₂₂₁ to R₂₂₃ has at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Emission layer in organic layer 150

When the organic light-emitting device 10 is a full color organic light-emitting device, the emission layer may be patterned into a red emission layer, a green emission layer, and/or a blue emission layer, according to a sub pixel. In one or more embodiments, the emission layer may have a stacked structure of two or more layers selected from a red emission layer, a green emission layer, and a blue emission layer, in which the two or more layers may contact each other or may be separated from each other. In one or more embodiments, the emission layer may comprise two or more materials selected from a red-light emission material, a green-light emission material, and a blue-light emission material, in which the two or more materials may be mixed together in a single layer to thereby emit white light.

In one embodiment, the emission layer of the organic light-emitting device 10 may be a first-color-light emitting-emission layer,
the organic light-emitting device 10 may further comprise i) at least one second-color-light emitting-emission layer or ii) at least one second-color-light emitting-emission layer and at least one third-color-light emitting-emission layer, each between the first electrode 110 and the second electrode 190,
a maximum emission wavelength of the first-color-light emitting-emission layer, a maximum emission wavelength of the second-color-light emitting-emission layer, and a maximum emission wavelength of the third-color-light emitting-emission layer may be identical to or different from each other, and
the organic light-emitting device 10 may emit a mixed light comprising a first-color-light and a second-color-light, or a mixed light comprising the first-color-light, the second-color-light, and a third-color-light, but embodiments of the present disclosure are not limited thereto.

For example, the maximum emission wavelength of the first-color-light emitting-emission layer may be different from the maximum emission wavelength of the second-color-light emitting-emission layer, and the mixed light comprising the first-color-light and the second-color-light may be white light, but embodiments of the present disclosure are not limited thereto.

In one or more embodiments, the maximum emission wavelength of the first-color-light emitting-emission layer, the maximum emission wavelength of the second-color-light emitting-emission layer, and the maximum emission wavelength of the third-color-light emitting-emission layer may be different from one another, and the mixed light comprising the first-color-light, the second-color-light, and the third-color-light may be white light. However, embodiments of the present disclosure are not limited thereto.

As used herein the maximum emission wavelength of an emission layer is the wavelength of light emitted by the emission layer with maximum intensity.

The emission layer may comprise a host and a dopant. The dopant may comprise at least one selected from a phosphorescent dopant and a fluorescent dopant.

The amount of the dopant in the emission layer may be about 0.01 to about 15 parts by weight based on 100 parts by weight of the host, but embodiments of the present disclosure are not limited thereto.

The thickness of the emission layer may be about 100 Å to about 1,000 Å, and in some embodiments, about 200 Å to about 600 Å. When the thickness of the emission layer is within these ranges, excellent light-emission characteristics may be obtained without a substantial increase in driving voltage.

### Host in emission layer

The emission layer may comprise the first compound represented by one selected from Formulae 1A, 1B, 1-4, 1D and 1E as a host. The first compound may be the same as described above.

The emission layer may comprise the first compound represented by one selected from Formulae 1A, 1B, 1-4, 1D and 1E as a first host, and may further comprise a second host that is different from the first host.

For example, the second host may be selected from compounds described above as an example of the first compound represented by one selected from Formulae 1A to 1E.

In one or more embodiments, the second host may be selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(*N*-carbazolyl)-1,1'-biphenyl (CBP), 1,3-di-9-carbazolylbenzene (mCP), and 1,3,5-tri(carbazol-9-yl)benzene (TCP), but embodiments of the present disclosure are not limited thereto.

A weight ratio of the first host to the second host in the emission layer may be, for example, 90:10 to 10:90, and in some embodiments, 80:20 to 20:80, and in some embodiments, 50:50, but embodiments of the present disclosure are not limited thereto.

### Phosphorescent dopant comprised in emission layer in organic layer 150

The phosphorescent dopant may comprise an organometallic complex represented by Formula 401 below:

**Formula 401** M(L₄₀₁)_{xc1}(L₄₀₂)_{xc2},

in which L₄₀₁ may be a ligand represented by Formula 402:

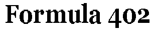

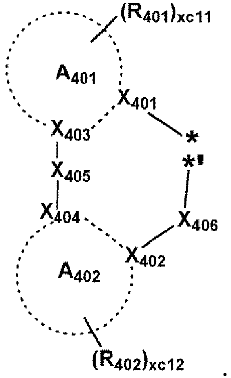

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 may be 1, 2, or 3, and when xc1 is two or more, two or more L₄₀₁(s) may be identical to or different from each other,
L₄₀₂ may be an organic ligand, xc2 may be an integer selected from 0 to 4, and when xc2 is two or more, two or more L₄₀₂(s) may be identical to or different from each other,
X₄₀₁ to X₄₀₄ may each independently be nitrogen or carbon,
X₄₀₁ may be linked to (e.g., coupled) to X₄₀₃ via a single bond or a double bond, and X₄₀₂ may be linked to (e.g., coupled) to X₄₀₄ via a single bond or a double bond,
A₄₀₁ and A₄₀₂ may each independently be a C₅-C₆₀ carbocyclic group or a C₁-C₆₀ heterocyclic group,
X₄₀₅ may be a single bond, -O-, -S-, -C(=O)-, -N(Q₄₁₁)-, -C(Q₄₁₁)(Q₄₁₂)-, - C(Q₄₁₁)=C(Q₄₁₂)-, -C(Q₄₁₁)=, or =C(Q₄₁₁)=, and Q₄₁₁ and Q₄₁₂ may each independently be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, 0, or S,
R₄₀₁ and R₄₀₂ may each independently be selected from hydrogen, deuterium, - F, -Cl, -Br, -I, -CD₃, -CF₃, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C6-C60 polycyclic group and a substituted or unsubstituted monovalent non-aromatic condensed 6- to 60- membered heteropolycyclic group - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and - P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer selected from o to 10, and
* and *' in Formula 402 may each independently indicate a binding site to M in Formula 401.

In one embodiment, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen, and X₄₀₂ may be carbon, or ii) X₄₀₁ and X₄₀₂ may both (e.g., simultaneously) be nitrogen.

In one or more embodiments, R₄₀₁ and R₄₀₂ in Formula 402 may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantyl group, a norbornanyl group, and a norbornenyl group;
a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, when xc1 in Formula 401 is two or more, two A₄₀₁(s) in two or more L₄₀₁(s) may be optionally linked (e.g., coupled) via a linking group X₄₀₇, and two A₄₀₂(s) in two or more L₄₀₁(_{S}) may be optionally linked (e.g., coupled) via a linking group X₄₀₈ (see Compounds PD1 to PD₄ and PD₇). X₄₀₇ and X₄₀₈ may each independently be a single bond, *-0-*', *-S-*', *-C(=O)-*', *-N(Q₄₁₃)-*', *-C(Q₄₁₃)(Q₄₁₄)-*', or *-C(Q₄₁₃)=C(Q₄₁₄)-*' (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but embodiments of the present disclosure are not limited thereto.

L₄₀₂ in Formula 401 may be a monovalent, divalent, or trivalent organic ligand. For example, L₄₀₂ may be selected from halogen, diketone (for example, acetylacetonate), a carboxylic acid (for example, picolinate), -C(=O), an isonitrile, -CN, and a phosphorus-based ligand (for example, phosphine or phosphite), but embodiments of the present disclosure are not limited thereto.

In one or more embodiments, the phosphorescent dopant may be selected from, for example, Compounds PD₁ to PD₂₅, but embodiments of the present disclosure are not limited thereto:

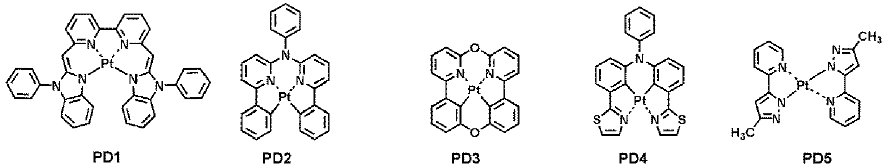

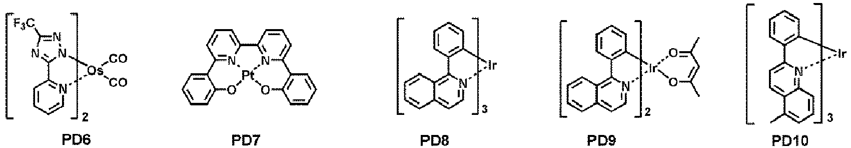

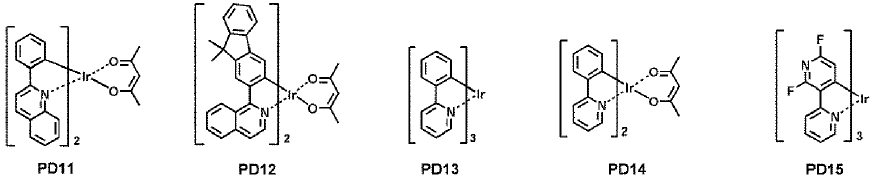

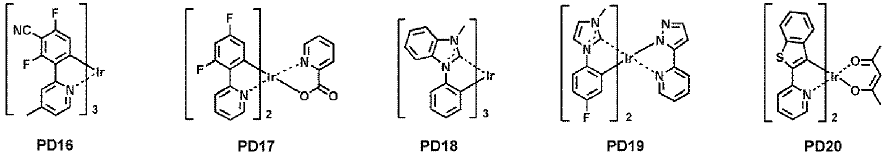

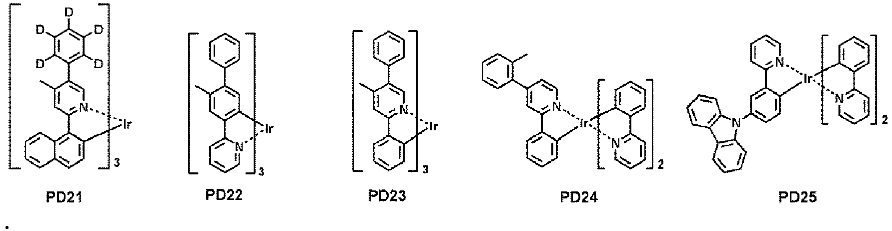

### Fluorescent dopant in emission layer

The fluorescent dopant may comprise an arylamine compound or a styrylamine compound.

In one or more embodiments, the fluorescent dopant may comprise a compound represented by Formula 501:

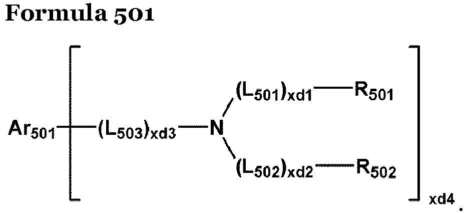

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C6-C60 polycyclic group, and a substituted or unsubstituted divalent non-aromatic condensed 6- to 60- membered heteropolycyclic group,
xd1 to xd3 may each independently be an integer selected from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C6-C60 polycyclic group, and a substituted or unsubstituted monovalent non-aromatic condensed 6- to 60- membered heteropolycyclic group,
xd4 may be an integer selected from 1 to 6.

In one embodiment, Ar₅₀₁ in Formula 501 may be selected from the group consisting of:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, L₅₀₁ to L₅₀₃ in Formula 501 may each independently be selected from a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R₅₀₁ and R₅₀₂ in Formula 501 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

For example, the fluorescent dopant may be selected from Compounds FD1 to FD22:

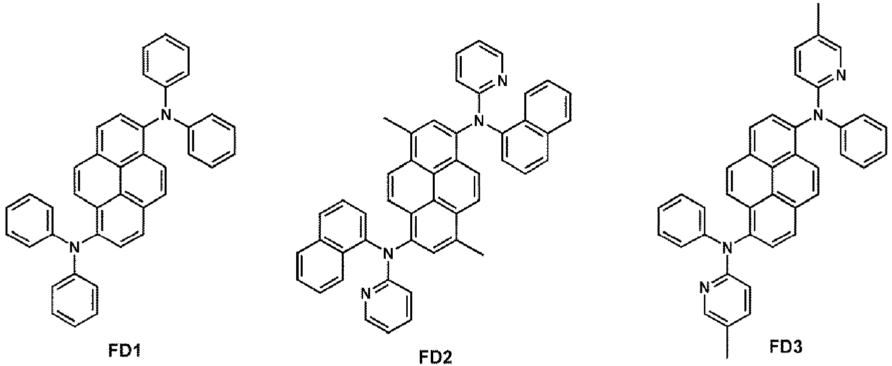

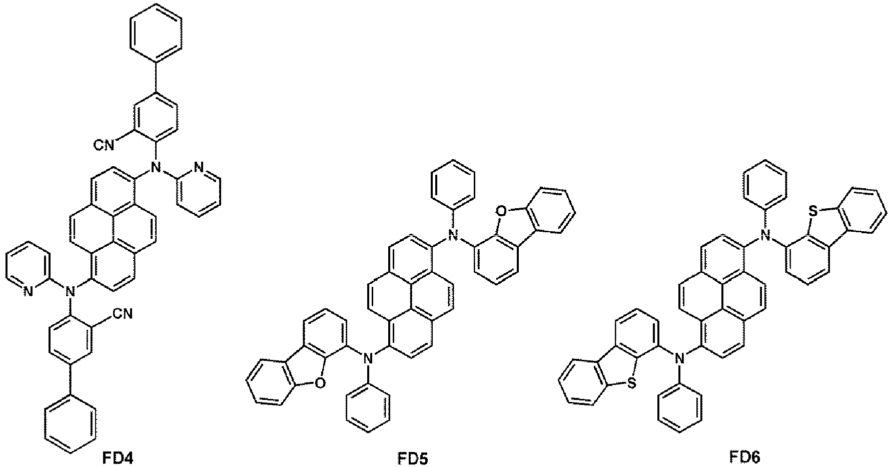

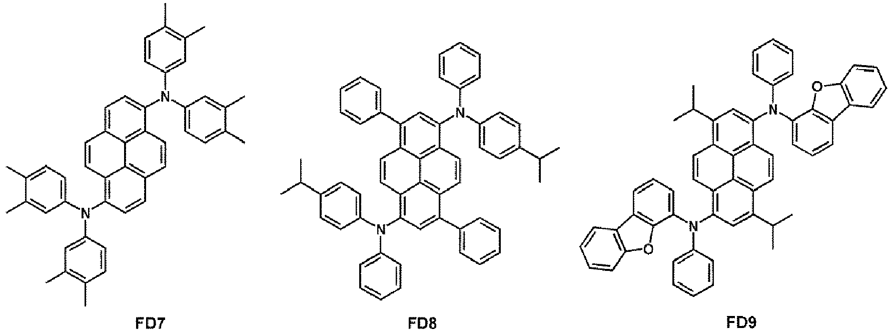

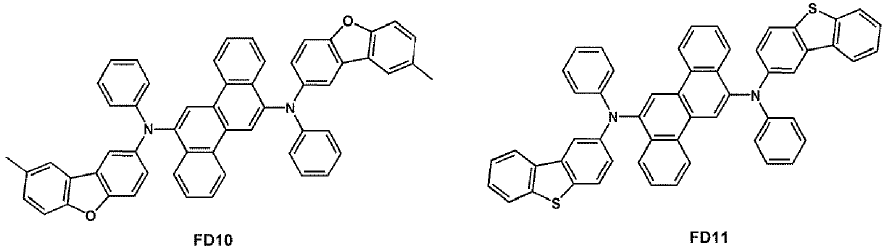

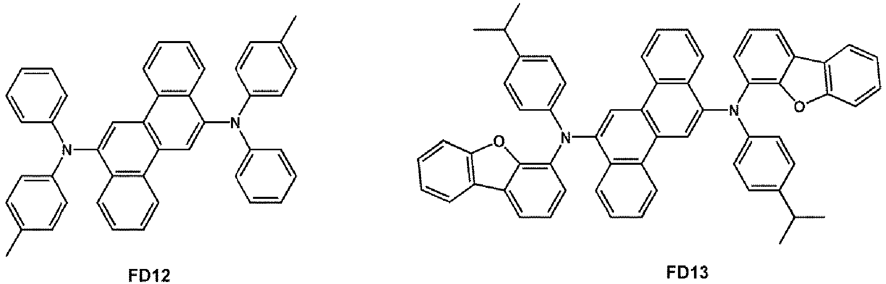

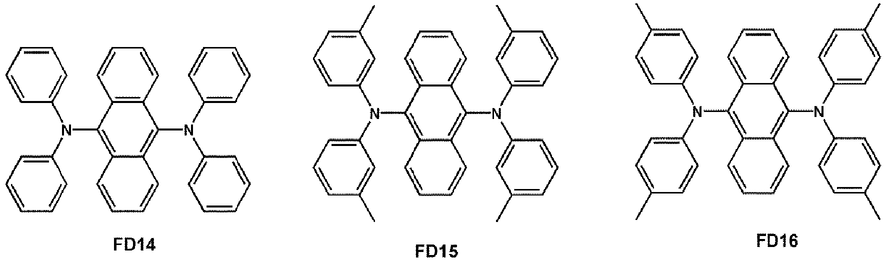

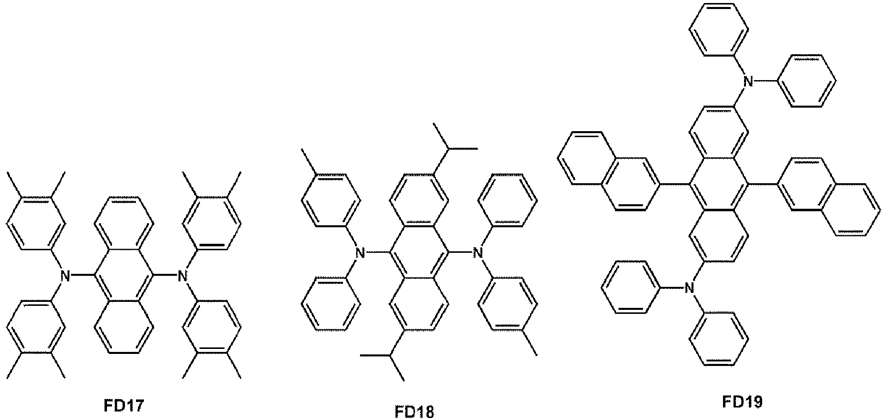

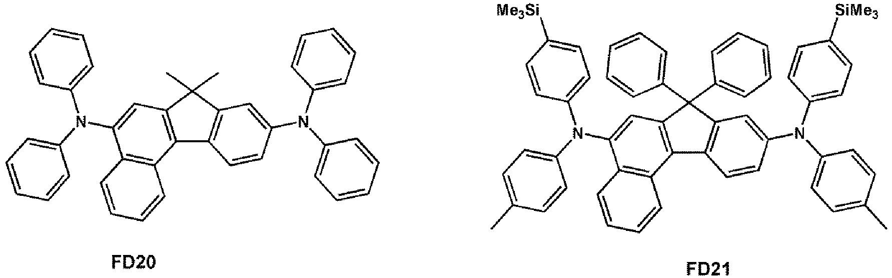

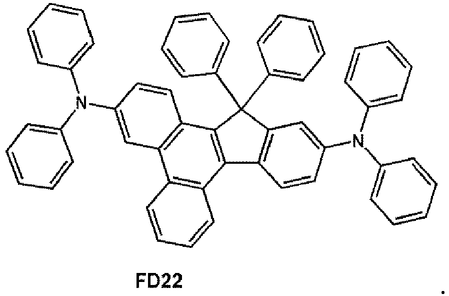

In one or more embodiments, the fluorescent dopant may be selected from the following compounds, but embodiments of the present disclosure are not limited thereto:

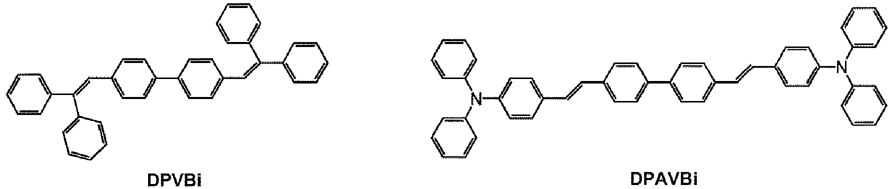

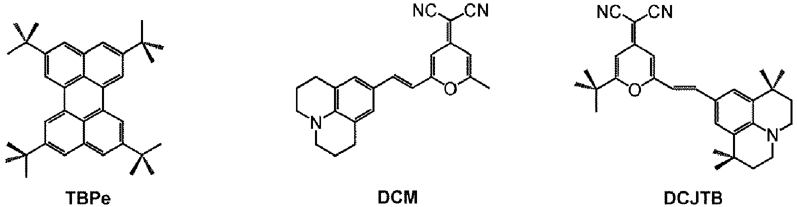

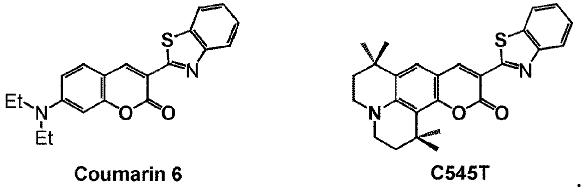

### Electron transport region in organic layer 150

The electron transport region may have i) a single-layered structure including a single layer including a single material, ii) a single-layered structure including a single layer comprising a plurality of different materials, or iii) a multi-layered structure having a plurality of layers comprising a plurality of different materials.

The electron transport region may comprise at least one selected from a buffer layer, a hole blocking layer, an electron control layer, an electron transport layer (ETL), and an electron injection layer, but embodiments of the present disclosure are not limited thereto.

For example, the electron transport region may have a structure of electron transport layer/electron injection layer, a structure of hole blocking layer/electron transport layer/electron injection layer, a structure of electron control layer/electron transport layer/electron injection layer, or a structure of buffer layer/electron transport layer/electron injection layer, wherein layers of each structure are sequentially stacked on the emission layer in each stated order. However, embodiments of the structure of the electron transport layer are not limited thereto.

The electron transport region may comprise the second compound represented by Formula 2A or 2B as described above.

In one embodiment, the electron transport region may comprise a buffer layer, the buffer layer may directly contact the emission layer, and the buffer layer may comprise the second compound represented by Formula 2A or 2B as described above.

In one or more embodiments, the electron transport region may comprise a buffer layer, an electron layer, and an electron injection layer stacked in this stated order on the emission layer, and the buffer layer may comprise the second compound represented by Formula 2A or 2B as described above.

The electron transport region (for example, a hole blocking layer, an electron control layer, and/or an electron transport layer in the electron transport region) may comprise a metal-free compound containing at least one π electron-depleted nitrogen-containing ring.

As used herein, the term "π electron-depleted nitrogen-containing ring" indicates a C₁-C₆₀ heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed with each other, or iii) a heteropolycyclic group in which at least one 5-membered to 7-membered heteromonocyclic group having at least one *-N=*' moiety is condensed with at least one C₅-C₆₀ carbocyclic group.

Non-limiting examples of the π electron-depleted nitrogen-containing ring may include an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an isobenzothiazole, a benzoxazole, an isobenzoxazole, a triazole, a tetrazole, an oxadiazole, a triazine, a thiadiazole, an imidazopyridine, an imidazopyrimidine, and an azacarbazole, but embodiments of the present disclosure are not limited thereto.

For example, the electron transport region may comprise a compound represented by Formula 601:

**Formula 601** [Ar₆₀₁]ₓₑ₁₁-[(L₆₀₁)ₓₑ₁-R₆₀₁]ₓₑ₂₁.

In Formula 601,
Ar₆₀₁ may be a substituted or unsubstituted C₅-C₆₀ carbocyclic group or a substituted or unsubstituted C₁-C₆₀ heterocyclic group,
xen may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C6-C60 polycyclic group, and a substituted or unsubstituted divalent non-aromatic condensed 6- to 60- membered heteropolycyclic group,
xe1 may be an integer selected from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C6-C60 polycyclic group, a substituted or unsubstituted monovalent non-aromatic condensed 6- to 60- membered heteropolycyclic group, -Si(Q₆₀₁)(Q₆₀₁)(Q₆₀₃), -C(=O)(Q₆₀₁), -S(=O)₂(Q₆₀₁), and - P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer selected from 1 to 5.

In one embodiment, at least one of the xen Ar₆₀₁(s) and/or at least one of the xe21 R₆₀₁(s) may comprise the π electron-depleted nitrogen-containing ring.

In one embodiment, ring Ar₆₀₁ in Formula 601 may be selected from the group consisting of:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -SC=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is two or more, two or more Ar₆₀₁(s) may be linked (e.g., coupled) via one or more single bonds.

In one or more embodiments, Ar₆₀₁ in Formula 601 may be an anthracene group.

In one or more embodiments, a compound represented by Formula 601 may be represented by Formula 601-1:

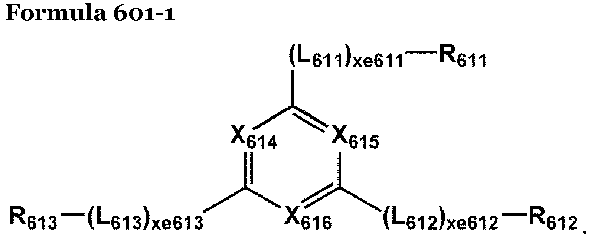

In Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ may each independently be substantially the same as described herein in connection with L₆₀₁,
xe611 to xe613 may each independently be substantially the same as described herein in connection with xe1,
R₆₁₁ to R₆₁₃ may each independently be substantially the same as described herein in connection with R₆₀₁,
R₆₁₄ to R₆₁₆ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one embodiment, L₆₀₁ and L₆₁₁ to L₆₁₃ in Formulae 601 and 601-1 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but embodiments of the present disclosure are not limited thereto.

In one or more embodiments, xe1 and xe611 to xe613 in Formulae 601 and 601-1 may each independently be 0, 1, or 2.

In one or more embodiments, R₆₀₁ and R₆₁₁ to R₆₁₃ in Formula 601 and 601-1 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ may each independently be substantially the same as described above.

The electron transport region may comprise at least one compound selected from Compounds ET1 to ET36, but embodiments of the present disclosure are not limited thereto:

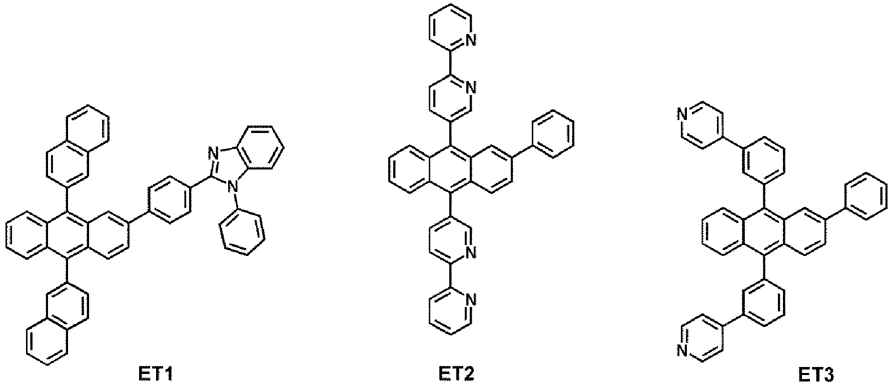

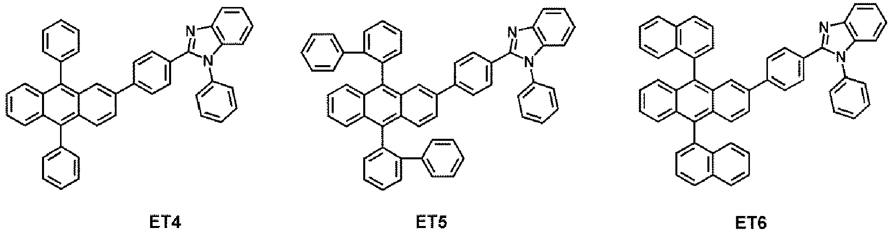

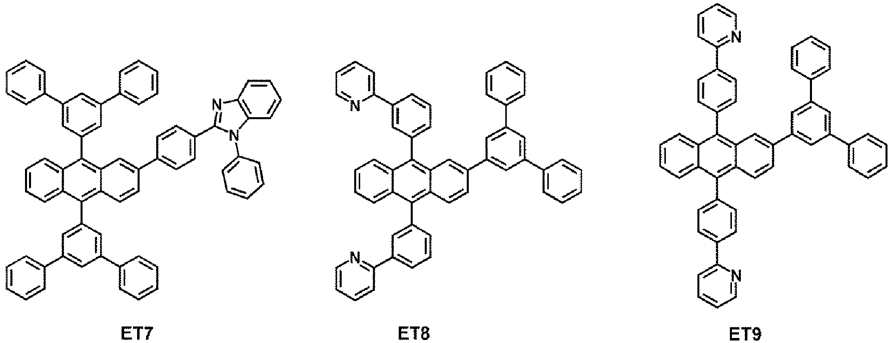

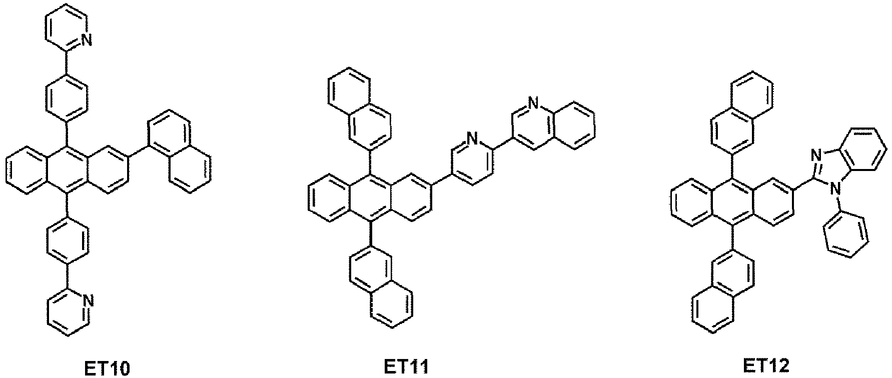

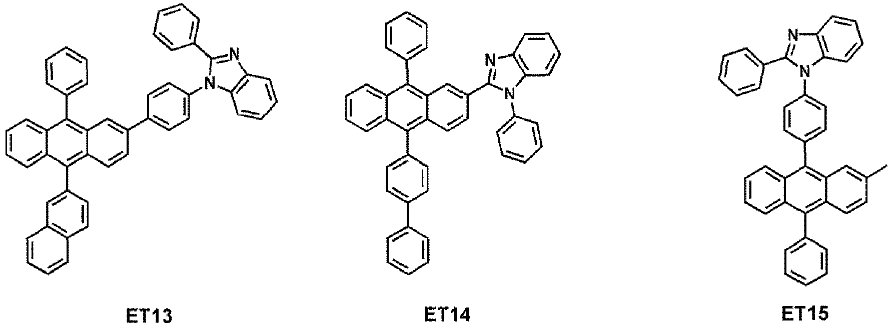

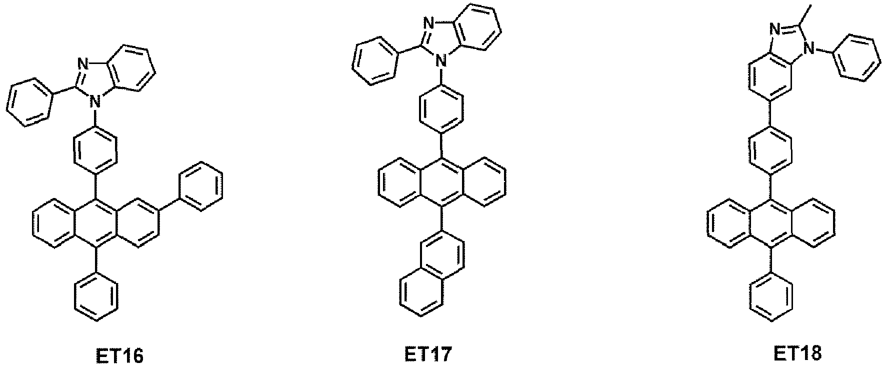

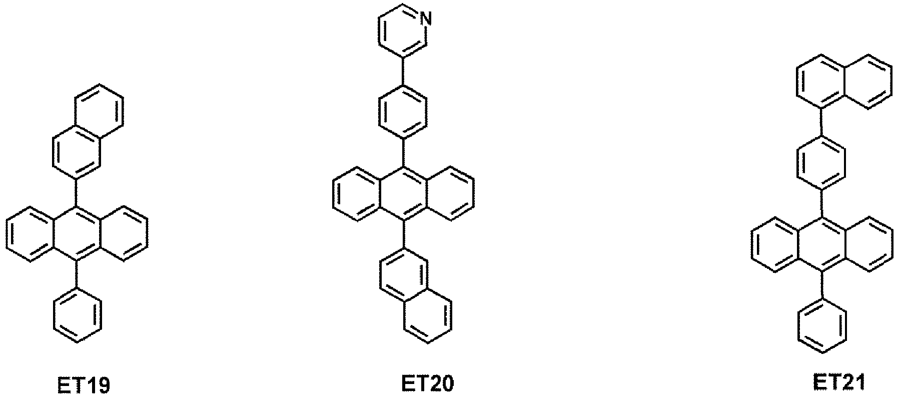

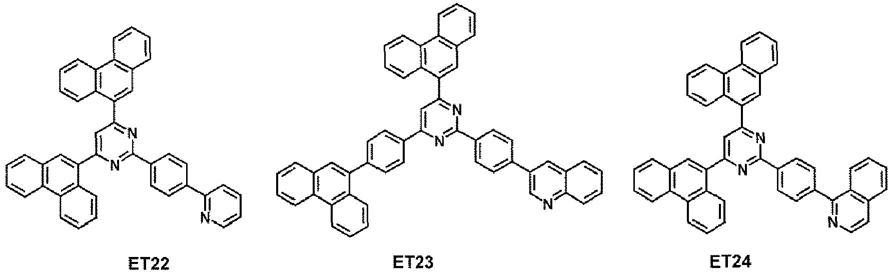

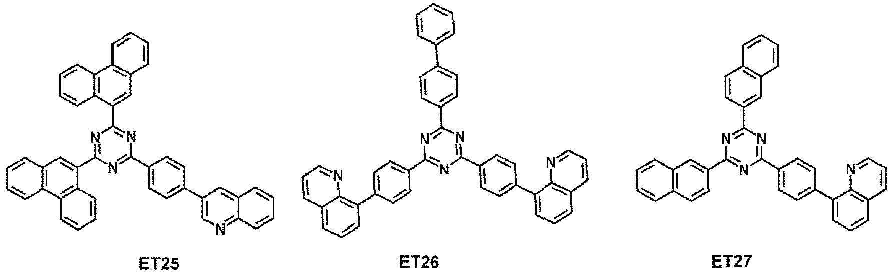

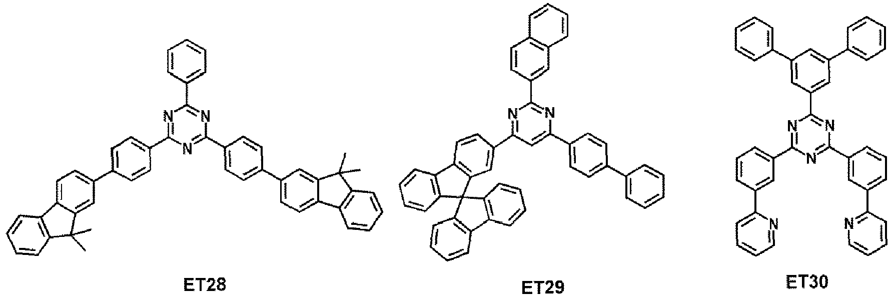

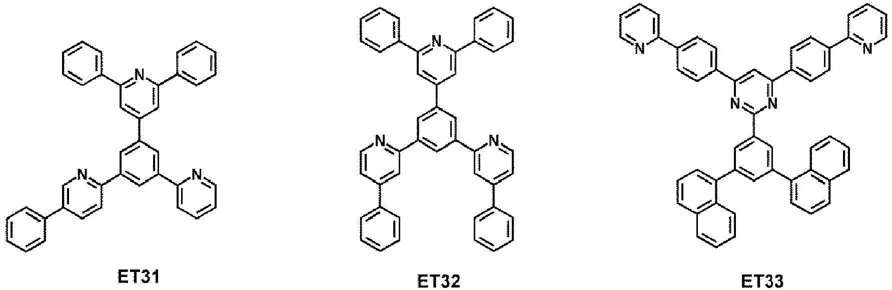

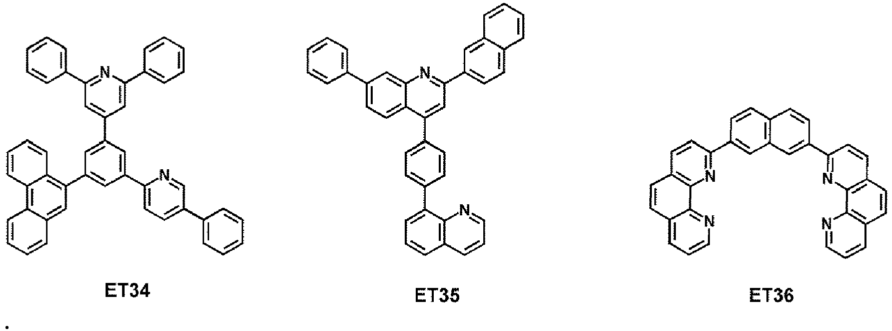

In one or more embodiments, the electron transport region may comprise at least one selected from BCP(2,9-dimethyl-4,7-diphenyl-1,10-phenanthroline), BPhen (4,7-diphenyl-1,10-phenanthroline), Alq₃, BAlq, TAZ(3-(biphenyl-4-yl)-5-(4-*tert-*butylphenyl)-4-phenyl-4*H*-1,2,4-triazole), and NTAZ.

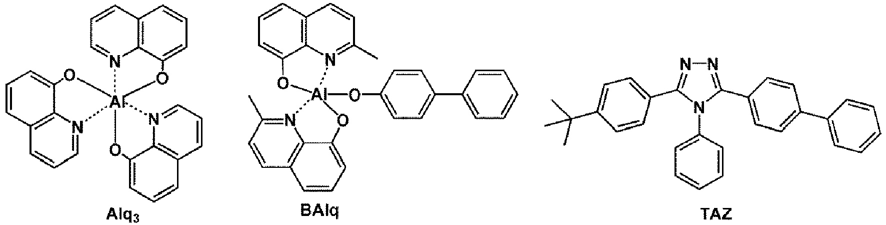

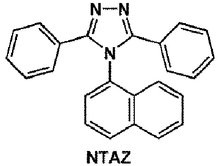

The thicknesses of the buffer layer, the hole blocking layer, and/or the electron controlling layer may each independently be about 20 Å to about 1,000 Å, and in some embodiments, about 30 Å to about 300 Å. When the thicknesses of the buffer layer, the hole blocking layer, and the electron control layer are each within these ranges, the electron blocking layer may have excellent electron blocking characteristics and/or electron control characteristics without a substantial increase in driving voltage.

The thickness of the electron transport layer may be about 100 Å to about 1,000 Å, and in some embodiments, about 150 Å to about 500 Å. When the thickness of the electron transport layer is within these ranges, the electron transport layer may have satisfactory electron transport characteristics without a substantial increase in driving voltage.

The electron transport region (for example, the electron transport layer in the electron transport region) may further comprise, in addition to the materials described above, a metal-containing material.

The metal-containing material may comprise at least one selected from an alkali metal complex and an alkaline earth metal complex. The alkali metal complex may comprise a metal ion selected from a lithium (Li) ion, a sodium (Na) ion, a potassium (K) ion, a rubidium (Rb) ion, and a cesium (Cs) ion, and the alkaline earth metal complex may comprise a metal ion selected from a beryllium (Be) ion, a magnesium (Mg) ion, a calcium (Ca) ion, a strontium (Sr) ion, and a barium (Ba) ion. Each ligand coordinated with the metal ion of the alkali metal complex or the alkaline earth metal complex may independently be selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments of the present disclosure are not limited thereto.

For example, the metal-containing material may comprise a Li complex. The Li complex may comprise, for example, Compound ET-D1 (lithium quinolate, LiQ) and/or ET-D2.

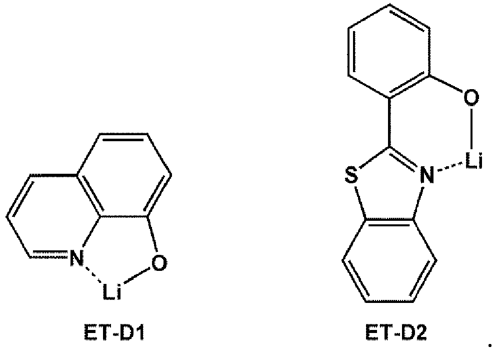

The electron transport region may comprise an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer comprising a plurality of different materials, or iii) a multi-layered structure having a plurality of layers comprising a plurality of different materials.

The electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

In one or more embodiments, the electron injection layer may comprise Li, Na, K, rubidium (Rb), cesium (Cs), Mg, Ca, erbium (Er), thulium (Tm), ytterbium (Yb), or a combination thereof. However, embodiments of the material comprised in the electron injection layer are not limited thereto.

The alkali metal may be selected from Li, Na, K, Rb, and Cs. In one embodiment, the alkali metal may be Li, Na, or Cs. In one or more embodiments, the alkali metal may be Li or Cs, but embodiments of the present disclosure are not limited thereto.

The alkaline earth metal may be selected from Mg, Ca, Sr, and Ba.

The rare earth metal may be selected from scandium (Sc), yttrium (Y), cerium (Ce), ytterbium (Yb), gadolinium (Gd), and terbium (Tb).

The alkali metal compound, the alkaline earth metal compound, and the rare earth metal compound may be selected from oxides and halides (for example, fluorides, chlorides, bromides, and/or iodides) of the alkali metal, the alkaline earth metal, and the rare earth metal.

The alkali metal compound may be selected from alkali metal oxides (such as Li_{2O}, Cs₂O, and/or K₂O) and alkali metal halides (such as LiF, NaF, CsF, KF, LiI, NaI, CsI, RbI, and/or KI). In one embodiment, the alkali metal compound may be selected from LiF, Li₂O, NaF, LiI, NaI, CsI, and KI, but embodiments of the present disclosure are not limited thereto.

The alkaline earth metal compound may be selected from alkaline earth metal compounds (such as BaO, SrO, CaO, BaₓSr₁₋ₓO(0<x<1), and/or BaₓCa₁₋ₓO(0<x<1)). In one embodiment, the alkaline earth metal compound may be selected from BaO, SrO, and CaO, but embodiments of the present disclosure are not limited thereto.

The rare earth metal compound may be selected from YbF₃, ScF₃, ScO₃, Y₂O₃, Ce₂O₃, GdF₃, and TbF₃. In one embodiment, the rare earth metal compound may be selected from YbF₃, ScF₃, TbF₃, YbI₃, ScI₃, and TbI₃, but embodiments of the present disclosure are not limited thereto.

The alkali metal complex, the alkaline earth metal complex, and the rare earth metal complex may comprise an alkali metal ion, an alkaline earth metal ion, and a rare earth metal ion, respectively, as described above, and each ligand coordinated with a metal ion of the alkali metal complex, the alkaline earth metal complex, and the rare earth metal complex may independently be selected from hydroxyquinoline, hydroxyisoquinoline, hydroxybenzoquinoline, hydroxyacridine, hydroxyphenanthridine, hydroxyphenyl oxazole, hydroxyphenyl thiazole, hydroxydiphenyl oxadiazole, hydroxydiphenyl thiadiazole, hydroxyphenyl pyridine, hydroxyphenyl benzimidazole, hydroxyphenyl benzothiazole, bipyridine, phenanthroline, and cyclopentadiene, but embodiments of the present disclosure are not limited thereto.

The electron injection layer may comprise (e.g., consist of) an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof, as described above. In one or more embodiments, the electron injection layer may further comprise an organic material. When the electron injection layer further comprises an organic material, the alkali metal, the alkaline earth metal, the rare earth metal, the alkali metal compound, the alkaline earth metal compound, the rare earth metal compound, the alkali metal complex, the alkaline earth metal complex, the rare earth metal complex, or the combination thereof may be homogeneously or non-homogeneously dispersed in a matrix comprising the organic material.

The thickness of the electron injection layer may be about 1 Å to about 100 Å, and in some embodiments, about 3 Å to about 90 Å. When the thickness of the electron injection layer is within these ranges, the electron injection layer may have satisfactory electron injection characteristics without a substantial increase in driving voltage.

At least one layer selected from the electron transport layer and the electron injection layer may comprise the alkali metal, the alkaline earth metal, the rare earth metal, the alkali metal compound, the alkaline earth metal compound, the rare earth metal compound, the alkali metal complex, the alkaline earth metal complex, the rare earth metal complex, or the combination thereof.

### Second electrode 190

The second electrode 190 may be on the organic layer 150. The second electrode 190 may be a cathode that is an electron injection electrode, and in this regard, the material for forming the second electrode 190 may be a material having a low work function, and such a material may be a metal, an alloy, an electrically conductive compound, or a combination thereof.

The second electrode 190 may comprise at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layer structure, or a multi-layer structure comprising two or more layers.

### Description of FIGS. 2 to 5

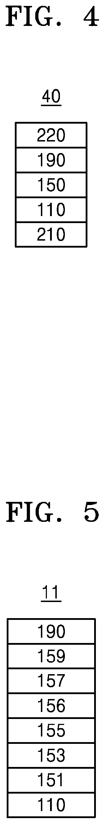

An organic light-emitting device 20 represented by FIG. 2 comprises a first capping layer 210, a first electrode 110, an organic layer 150, and a second electrode 190 sequentially stacked in this stated order. An organic light-emitting device 30 represented by FIG. 3 comprises a first electrode 110, an organic layer 150, a second electrode 190, and a second capping layer 220 sequentially stacked in this stated order. An organic light-emitting device 40 represented by FIG. 4 comprises a first capping layer 210, a first electrode 110, an organic layer 150, a second electrode 190, and a second capping layer 220.

Regarding FIGS. 2 to 4, the first electrode 110, the organic layer 150, and the second electrode 190 may each be the same as described herein in connection with FIG. 1.

In the organic layer 150 of each of the organic light-emitting devices 20 and 40, light generated in an emission layer may pass through the first electrode 110 (which may be a semi-transmissive electrode or a transmissive electrode) and the first capping layer 210 toward the outside. In the organic layer 150 of each of the organic light-emitting devices 30 and 40, light generated in an emission layer may pass through the second electrode 190 (which is a semi-transmissive electrode or a transmissive electrode) and the second capping layer 220 toward the outside.

The first capping layer 210 and the second capping layer 220 may increase the external luminescent efficiency of the device according to the principle of constructive interference.

The first capping layer 210 and the second capping layer 220 may each independently be a capping layer comprising an organic material, an inorganic capping layer comprising an inorganic material, or a composite capping layer comprising an organic material and an inorganic material.

At least one selected from the first capping layer 210 and the second capping layer 220 may comprise at least one material selected from carbocyclic compounds, heterocyclic compounds, amine-based compounds, porphyrin derivatives, phthalocyanine derivatives, naphthalocyanine derivatives, alkali metal-based complexes, and alkaline earth metal-based complexes. The carbocyclic compound, the heterocyclic compound, and the amine-based compound may each be optionally substituted with a substituent containing at least one element selected from O, N, S, Se, silicon (Si), fluorine (F), chlorine (Cl), bromine (Br), and iodine (I).

In one embodiment, at least one selected from the first capping layer 210 and the second capping layer 220 may comprise an amine-based compound.

In one embodiment, at least one selected from the first capping layer 210 and the second capping layer 220 may comprise the compound represented by Formula 201 and/or the compound represented by Formula 202.

In one or more embodiments, at least one selected from the first capping layer 210 and the second capping layer 220 may comprise a compound selected from Compounds HT28 to HT33, as described elsewhere herein, and Compounds CP1 to CP5, but embodiments of the present disclosure are not limited thereto.

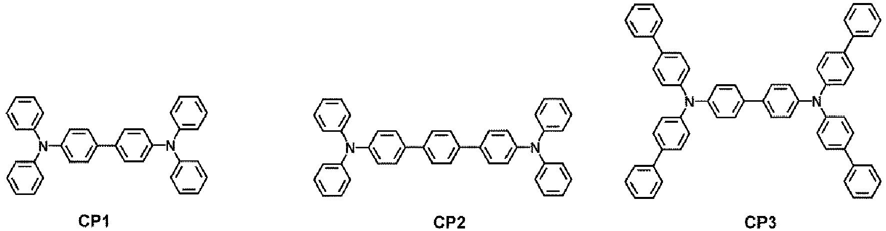

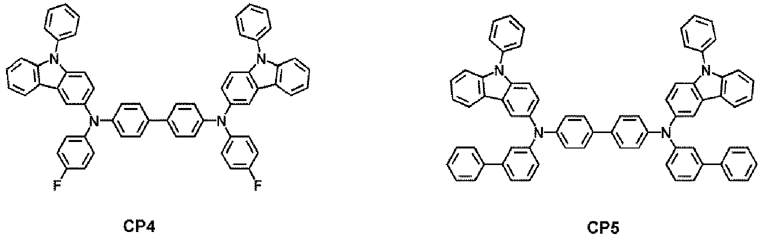

FIG. 5 is a schematic view of an organic light-emitting device 11 according to an embodiment of the present disclosure. The organic light-emitting device 11 may comprise a first electrode no, a hole transport layer 151, an emission auxiliary layer 153, an emission layer 155, a buffer layer 156, an electron transport layer 157, an electron injection layer 159, and a second electrode 190 sequentially stacked in this stated order.

The layers comprised in the organic light-emitting device 11 of FIG. 5 may be the same as described above.

Hereinbefore, an organic light-emitting device according to an embodiment of the present disclosure has been described in connection with FIGS. 1 to 5. However, embodiments of the present disclosure are not limited thereto.

The layers constituting the hole transport region, the emission layer, and the layers constituting the electron transport region may be formed in a specific region using one or more suitable methods selected from vacuum deposition, spin coating, casting, a Langmuir-Blodgett (LB) method, ink-jet printing, laser-printing, and laserinduced thermal imaging (LITI).

When the respective layers of the hole transport region, the emission layer, and the respective layers of the electron transport region are each formed by deposition, the deposition may be performed at a deposition temperature of about 100 to about 500°C, at a vacuum degree of about 10⁻⁸ to about 10⁻³ torr (wherein 1 torr = 133,322 Pa), and at a deposition rate of about 0.01 to about 100 Å/sec, depending on the material to be deposited in each layer, and the structure of each layer to be formed.

When the layers constituting the hole transport region, the emission layer, and the layers constituting the electron transport region are each formed by spin coating, the spin coating may be performed at a coating speed of about 2,000 rpm to about 5,000 rpm and at a heat treatment temperature of about 80°C to 200°C, depending on the material to be included in each layer, and the structure of each layer to be formed.

### General definitions of substituents

The term "C₁-C₆₀ alkyl group", as used herein, refers to a linear or branched aliphatic saturated hydrocarbon monovalent group having 1 to 60 carbon atoms, e.g. 1 to 30 carbon atoms, 1 to 20 carbon atoms, 1 to 10 carbon atoms, 1 to 6 carbon atoms or 1 to 4 carbon atoms. Non-limiting examples thereof may include a methyl group, an ethyl group, a propyl group, an isobutyl group, a see-butyl group, a tert-butyl group, a pentyl group, an iso-amyl group, and a hexyl group. The term "C₁-C₆₀ alkylene group", as used herein, refers to a divalent group having substantially the same structure as the C₁-C₆₀ alkyl group.

The term "C₂-C₆₀ alkenyl group", as used herein, refers to a hydrocarbon group formed by substituting at least one carbon-carbon double bond in the body (e.g., middle) or at the terminus of the C₂-C₆₀ alkyl group, and non-limiting examples thereof may include an ethenyl group, a propenyl group , and a butenyl group. The term "C₂-C₆₀ alkylene group", as used herein, refers to a divalent group having substantially the same structure as the C₂-C₆₀ alkyl group.

The term "C₂-C₆₀ alkynyl group", as used herein, refers to a hydrocarbon group formed by substituting at least one carbon-carbon triple bond in the body (e.g., middle) or at the terminus of the C₂-C₆₀ alkyl group, and non-limiting examples thereof may include an ethynyl group and a propynyl group. The term "C₂-C₆₀ alkylene group", as used herein, refers to a divalent group having substantially the same structure as the C₂-C₆₀ alkyl group.

The term "C₁-C₆₀ alkoxy group", as used herein, refers to a monovalent group represented by -O-A₁₀₁ (wherein A₁₀₁ is a C₁-C₆₀ alkyl group), and non-limiting examples thereof may include a methoxy group, an ethoxy group, and an isopropyloxy group.

The term "C₃-C₁₀ cycloalkyl group", as used herein, refers to a monovalent saturated hydrocarbon monocyclic group having 3 to 10 carbon atoms, and non-limiting examples thereof may include a cyclopropyl group, a cyclobutyl group, a cyclopentyl group, a cyclohexyl group, and a cycloheptyl group. The term "C₃-C₁₀ cycloalkylene group", as used herein, refers to a divalent group having substantially the same structure as the C₃-C₁₀ cycloalkyl group.

The term "C₁₀-C₁₀ heterocycloalkyl group", as used herein, refers to a monovalent monocyclic group having at least one heteroatom (e.g. 1, 2, 3, 4 or 5 hereoatoms) selected from N, O, Si, P, and S as a ring-forming atom and 1 to 10 carbon atoms, e.g. 1, 2, 3, 4 or 5 ring carbon atoms. Non-limiting examples thereof may include a 1,2,3,4-oxatriazolidinyl group, a tetrahydrofuranyl group, and a tetrahydrothiophenyl group. The term "C₁-C₁₀ heterocycloalkylene group", as used herein, refers to a divalent group having substantially the same structure as the C₁-C₁₀ heterocycloalkyl group.

The term "C₃-C₁₀ cycloalkenyl group", as used herein, refers to a monovalent monocyclic group that has 3 to 10 carbon atoms and at least one double bond in the ring thereof and does not have aromaticity, and non-limiting examples thereof include a cyclopentenyl group, a cyclohexenyl group, and a cycloheptenyl group. The term "C₃-C₁₀ cycloalkenylene group", as used herein, refers to a divalent group having substantially the same structure as the C₃-C₁₀ cycloalkenyl group.

The term "C₁-C₁₀ heterocycloalkenyl group", as used herein, refers to a monovalent monocyclic group that has at least one heteroatom (e.g. 1, 2, 3, 4 or 5 hereoatoms) selected from N, O, Si, P, and S as a ring-forming atom, 1 to 10 carbon atoms, e.g. 1, 2, 3, 4 or 5 ring carbon atoms, and at least one double bond in its ring. Non-limiting examples of the C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group", as used herein, refers to a divalent group having substantially the same structure as the C₁-C₁₀ heterocycloalkenyl group.

The term "C₆-C₆₀ aromatic group", as used herein, refers to a group having a carbocyclic aromatic system having 6 to 60 carbon atoms e.g. 6 to 20 ring carbon atoms, 6 to 14 ring cabon atoms or 6 to 10 ring carbon atoms. The term "C₆-C₆₀ aryl group", as used herein, refers to a monovalent group having substantially the same structure as the C₆-C₆₀ aromatic group, and the term "C₆-C₆₀ arylene group", as used herein, refers to a divalent group having substantially the same structure as the C₆-C₆₀ aromatic group. Non-limiting examples of the C₆-C₆₀ aromatic group may include benzene, naphthylene, anthracene, phenanthrene, pyrene group, and a chrysene group. Non-limiting examples of the C₆-C₆₀ aryl group may include a phenyl group, a naphthyl group, an anthracenyl group, a phenanthrenyl group, a pyrenyl group, and a chrysenyl group. Non-limiting examples of the C₆-C₆₀ arylene group may include a phenylene group, a naphthylene group, an anthracenylene group, a phenanthrenylene group, a pyrenylene group, and a chrysenylene group. When the C₆-C₆₀ aromatic group, C₆-C₆₀ aryl group and the C₆-C₆₀ arylene group each comprise two or more rings, the rings may be fused (e.g., condensed).

The term "C₁-C₆₀ heteroaromatic group", as used herein, refers to a group having a heterocyclic aromatic system that has at least one heteroatom (e.g. 1, 2, 3, 4 or 5 hereoatoms) selected from N, O, Si, P, and S as a ring-forming atom, and 1 to 60 carbon atoms e.g. 1 to 19 ring carbon atoms, 1 to 13 ring cabon atoms or 1 to 9 ring carbon atoms. The term "C₁-C₆₀ heteroaryl group", as used herein, refers to a monovalent group having substantially the same structure as the C₁-C₆₀ heteroaromatic group. The term "C₁-C₆₀ heteroarylene group", as used herein, refers to a divalent group having substantially the same structure as the C₁-C₆₀ heteroaromatic group. Non-limiting examples of the C₁-C₆₀ heteroaryl group may include a pyridine group, a pyrimidine group, a pyrazine group, a pyridazine group, a triazine group, a quinoline group, and an isoquinoline group. Non-limiting examples of the C₁-C₆₀ heteroaryl group may include a pyridinyl group, a pyrimidinyl group, a pyrazinyl group, a pyridazinyl group, a triazinyl group, a quinolinyl group, and an isoquinolinyl group. Non-limiting examples of the C₁-C₆₀ heteroarylene group may include a pyridinylene group, a pyrimidinylene group, a pyrazinylene group, a pyridazinylene group, a triazinylene group, a quinolinylene group, and an isoquinolinylene group. When the C₁-C₆₀ heteroaromatic group, C₁-C₆₀ heteroaryl group and the C₁-C₆₀ heteroarylene group each comprise two or more rings, the rings may be fused (e.g., condensed).

The term "C₆-C₆₀ aryloxy group", as used herein, refers to -O-A₁₀₂ (wherein A₁₀₂ is a C₆-C₆₀ aryl group), and the term "C₆-C₆₀ arylthio group" as used herein indicates -S-A₁₀₃ (wherein A₁₀₃ is a C₆-C₆₀ aryl group).

The term "C₆-C₆₀ non-aromatic condensed polycyclic group", as used herein, refers to a group that has two or more rings condensed (e.g., fused), 6 to 60 carbon atoms (for example, 8 to 60, 8 to 20, 8 to 14 or 8 to 10 carbon atoms) as the only ring forming atoms, and non-aromaticity in the entire molecular structure. A non-limiting example of a C₆-C₆₀ non-aromatic condensed polycyclic group is a spiro-bifluorene group. The term "monovalent non-aromatic condensed C₆-C₆₀ polycyclic group", as used herein, refers to a monovalent group having substantially the same structure as the C₆-C₆₀ non-aromatic condensed polycyclic group. The term "divalent non-aromatic condensed C₆-C₆₀ polycyclic group", as used herein, refers to a divalent group having substantially the same structure as the C₆-C₆₀ non-aromatic condensed polycyclic group.

The term "monovalent non-aromatic condensed 6- to 60-membered heteropolycyclic group", as used herein, refers to a monovalent group that has two or more rings condensed (e.g., fused), has at least one heteroatom (e.g. 1, 2, 3, 4 or 5 hereoatoms) selected from N, O, Si, P, and S, in addition to carbon atoms (for example, 1 to 59, 2 to 59, 2 to 19, 2 to 13 or 2 to 9 carbon atoms), as a ring forming atom, and has non-aromaticity in the entire molecular structure. A non-limiting example of a monovalent non-aromatic condensed heteropolycyclic group may be a carbazolyl group. The term "divalent non-aromatic condensed heteropolycyclic group", as used herein, refers to a divalent group having substantially the same structure as the monovalent non-aromatic condensed heteropolycyclic group.

The term "C₅-C₆₀ carbocyclic group", as used herein, refers to a monocyclic or polycyclic group having 5 to 60 carbon atoms as the only ring-forming atoms, e.g. 5 to 20 ring carbon atoms, 5 to 14 ring cabon atoms or 5 to 10 ring carbon atoms. The term "C₅-C₆₀ carbocyclic group", as used herein refers to an aromatic carbocyclic group or a non-aromatic carbocyclic group. The term "C₅-C₆₀ carbocyclic group", as used herein, refers to a ring (such as a benzene), a monovalent group (such as a phenyl group), or a divalent group (such as a phenylene group). In one or more embodiments, depending on the number of substituents connected to the C₅-C₆₀ carbocyclic group, the C₅-C₆₀ carbocyclic group may be a trivalent group or a quadrivalent group.

The term "C₁-C₆₀ heterocyclic group", as used herein, refers to a group having substantially the same structure as the C₁-C₆₀ carbocyclic group, except that as a ring-forming atom, at least one heteroatom (e.g. 1, 2, 3, 4 or 5 hereoatoms) selected from N, O, Si, P, S and Se is used in addition to carbon (the number of carbon atoms may be 1 to 60, e.g. 1 to 20 ring carbon atoms, 1 to 14 ring cabon atoms or 1 to 10 ring carbon atoms).

Certain groups are specified herein as being substituted or unsubstituted. Unless otherwise specified, when a group is substituted it is typically substituted with 1, 2, 3 or 4 substituents. For example, when a group is substituted it may substituted with 1, 2 or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from the group consisting of:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C6-C60 polycyclic group, a monovalent non-aromatic condensed 6- to 60- membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C6-C60 polycyclic group, and a monovalent non-aromatic condensed 6- to 60-membered heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C6-C60 polycyclic group, and a monovalent non-aromatic condensed 6- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C6-C60 polycyclic group, a monovalent non-aromatic condensed 6- to 60- membered heteropolycyclic group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and-P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with C₁-C₆₀ alkyl group, a C₁-C₆₀ heteroaryl group substituted with a C₆-C₆₀ aryl group, a monovalent non-aromatic condensed C6-C60 polycyclic group, and a monovalent non-aromatic condensed 6- to 60- membered heteropolycyclic group.

The term "Ph", as used herein, may refer to a phenyl group; the term "Me", as used herein, may refer to a methyl group; the term "Et", as used herein, may refer to an ethyl group; the terms "ter-Bu" or "Bu^{t}", as used herein, may refer to a tert-butyl group; and the term "OMe," as used herein, may refer to a methoxy group.

The term "biphenyl group", as used herein, may refer to "a phenyl group substituted with a phenyl group". In other words, a biphenyl group is a substituted phenyl group having a C₆-C₆₀ aryl group as a substituent.

The term "terphenyl group", as used herein, may refer to "a phenyl group substituted with a biphenyl group". In other words, a terphenyl group is a substituted phenyl group having a C₆-C₆₀ aryl group substituted with a C₆-C₆₀ aryl group.

The symbols * and *' used herein, unless defined otherwise, may refer to a binding site to a neighboring atom in a corresponding formula.

Hereinafter, compounds according to embodiments of the present disclosure and an organic light-emitting device according to embodiments of the present disclosure will be described in more detail with reference to Synthesis Examples and Examples. The wording "B was used instead of A" used in describing Synthesis Examples refers to that a molar equivalent of B was used in place of A.

### Example

### Example 1-1: Manufacture of red organic light-emitting device

An ITO glass substrate (a product of Corning Co., Ltd) with an ITO layer having a thickness of 15 Ω/cm² (1,200 Å) thereon was cut to a size of 50 mm x 50 mm x 0.5mm, sonicated using isopropyl alcohol and pure water for 15 minutes, and cleaned by exposure to ultraviolet rays and ozone for 30 minutes, and the ITO glass substrate (anode) was mounted on a vacuum deposition apparatus.
m-MTDATA was vacuum-deposited on the ITO glass substrate to form a hole transport layer having a thickness of 700 Å. TCTA was vacuum-deposited on the hole transport layer to form an emission auxiliary layer having a thickness of 100 Å.

Compound 1-3 (host) and PD11 (dopant) were co-deposited on the emission auxiliary layer at a weight ratio of 98:2 to form an emission layer having a thickness of 300 Å.

Compound 2-9 was deposited on the emission layer to form a buffer layer having a thickness of 100 Å, and Alq₃ was vacuum-deposited on the buffer layer to form an electron transport layer having a thickness of 200 Å. LiF was deposited on the electron transport layer to form an electron injection layer having a thickness of 10 Å.

Then, Al was deposited on the electron injection layer to form a cathode having a thickness of 2,000 Å, thereby completing the manufacture of an organic light-emitting device.

### Examples 1-2 to 1-10 and Comparative Examples 1-1 to 1-3

Additional organic light-emitting devices were manufactured in substantially the same manner as in Example 1-1, except that each emission layer and each buffer layer were formed using the compounds shown in Table 5.

### Example 2-1: Manufacture of green organic light-emitting device

An ITO glass substrate (a product of Corning Co., Ltd) with an ITO layer having a thickness of 15 Ω,/cm² (1,200 Å) thereon was cut to a size of 50 mm × 50 mm × 0.5mm, sonicated using isopropyl alcohol and pure water for 15 minutes each, and cleaned by exposure to ultraviolet rays and ozone for 30 minutes, and the ITO glass substrate (anode) was mounted on a vacuum deposition apparatus.
m-MTDATA was vacuum-deposited on the ITO glass substrate to form a hole transport layer having a thickness of 700 Å. TCTA was vacuum-deposited on the hole transport layer to form an emission auxiliary layer having a thickness of 100 Å.

Compound 1-3 (host) and PD13 (dopant) were co-deposited at a weight ratio of 90:10 on the emission auxiliary layer to form an emission layer having a thickness of 300 Å.

Compound 2-9 was deposited on the emission layer to form a buffer layer having a thickness of 100 Å, and Alq₃ was vacuum-deposited on the buffer layer to form an electron transport layer having a thickness of 200 Å. LiF was deposited on the electron transport layer to form an electron injection layer having a thickness of 10 Å.

Al was deposited on the electron injection layer to form a cathode having a thickness of 2,000 Å, thereby completing the manufacture of an organic light-emitting device.

### Examples 2-2 to 2-5 and Comparative Examples 2-1 to 2-3

Additional organic light-emitting devices were manufactured in substantially the same manner as in Example 2-1, except that each emission layer and each buffer layer were formed using the compounds shown in Table 5.

### Example 2-6

An organic light-emitting device was manufactured in substantially the same manner as in Example 2-1, except that in forming the emission layer, Compound 1-3 (first host), CBP (second host), and PD13 (dopant) were co-deposited at a weight ratio of 50:50:10.

### Examples 2-7 to 2-10

Additional organic light-emitting devices were manufactured in substantially the same manner as in Example 2-6, except that each emission layer and each buffer layer were formed using the compounds shown in Table 6.

### Examples 2-11 to 2-20

Additional organic light-emitting devices were manufactured in substantially the same manner as in Example 2-1, except that 1 wt% F4-TCNQ was doped in forming the hole transport layer, and the compounds shown in Table 5 were used in forming the emission layer and the buffer layer,.

### Evaluation Example 1

The driving voltage and efficiency of each of the organic light-emitting devices of Examples 1-1 to 1-5 and 2-1 to 2-20 and Comparative Examples 1-1 to 1-3 and 2-1 to 2-3 were measured using a Keithley SMU 236 at 5 mA/cm². The results thereof are shown in Tables 5 and 6.

**Table 5**

| | Emission layer (host) | Buffer layer | Weight ratio (host: dopant) | Driving voltage (V) | Efficiency (cd/A) |
|---|---|---|---|---|---|
| Example 1-1 | Compound 1-3 | Compound 2-9 | 98:2 | 5.7 | 24.3 |
| Example 1-2 | Compound 1-7 | Compound 2-19a | 98:2 | 5.7 | 24.0 |
| Example 1-3 | Compound 1-7 | Compound 2-149a | 98:2 | 5.5 | 23.7 |
| Example 1-4 | Compound 1-24 | Compound 2-38 | 98:2 | 5.5 | 23.5 |
| Example 1-5 | Compound 1-24 | Compound 2-58 | 98:2 | 5.6 | 23.9 |
| Example 1-6 | Compound 1-43 | Compound 2-162 | 98:2 | 5.5 | 24.1 |
| Example 1-7 | Compound 1-71 | Compound 2-176 | 98:2 | 5.4 | 23.8 |
| Example 1-8 | Compound 1-71 | Compound 2-13 | 98:2 | 5.2 | 24.5 |
| Example 1-9 | Compound 1-72 | Compound 2-217 | 98:2 | 5.3 | 24.0 |
| Example 1-10 | Compound 1-57 | Compound 2-59a | 98:2 | 5.5 | 24.2 |
| Comparative Example 1-1 | CBP | Compound 2-2 | 98:2 | 5.9 | 22.1 |
| Comparative Example 1-2 | Compound 1-3 | BAlq | 98:2 | 6.1 | 21.8 |
| Comparative Example 1-3 | CBP | BAlq | 98:2 | 6.2 | 21.6 |
| Example 2-1 | Compound 1-3 | Compound 2-9 | 90:10 | 5.8 | 39.8 |
| Example 2-2 | Compound 1-30 | Compound 2-48 | 90:10 | 5.7 | 40.3 |
| Example 2-3 | Compound 1-72 | Compound 2-136a | 90:10 | 5.8 | 40.7 |
| Example 2-4 | Compound 1-53 | Compound 2-1103 | 90:10 | 5.6 | 41-9 |
| Example 2-5 | Compound 1-56 | Compound 2-162 | 90:10 | 5.7 | 41.3 |
| Example 2-11 | Compound 1-9 | Compound 2-2a | 90:10 | 5.3 | 41.7 |
| Example 2-12 | Compound 1-9 | Compound 2-166 | 90:10 | 5.4 | 42.0 |
| Example 2-13 | Compound 1-25 | Compound 2-14a | 90:10 | 5.2 | 41.5 |
| Example 2-14 | Compound 1-34 | Compound 2-42a | 90:10 | 5.3 | 41-9 |
| Example 2-15 | Compound 1-44 | Compound 2-152a | 90:10 | 5.3 | 42.7 |
| Example 2-16 | Compound 1-44 | Compound 2-114 | 90:10 | 5.4 | 42.3 |
| Example 2-17 | Compound 1-56 | Compound 2-124 | 90:10 | 5.5 | 41.6 |
| Example 2-18 | Compound 1-66 | Compound 2-200 | 90:10 | 5.2 | 41.8 |
| Example 2-19 | Compound 1-70 | Compound 2-251 | 90:10 | 5.4 | 42.3 |
| Example 2-20 | Compound 1-84 | Compound 2-245 | 90:10 | 5.3 | 42.6 |
| Comparative Example 2-1 | CBP | Compound 2-9 | 90:10 | 5.9 | 38.7 |
| Comparative Example 2-2 | Compound 1-3 | BAlq | 90:10 | 6.0 | 36.8 |
| Comparative Example 2-3 | CBP | BAlq | 90:10 | 6.1 | 36.1 |

**Table 6**

| | Emission layer (first host: second host) | Buffer layer | Weight ratio (first host: second host: dopant) | Driving voltage (V) | Efficiency (cd/A) |
|---|---|---|---|---|---|
| Example 2-6 | Compound1-1:CPB | Compound 2-9 | 50:50:10 | 5.8 | 40.8 |
| Example 2-7 | Compound 1-3: Compound 1-72 | Compound 2-48 | 50:50:10 | 5.5 | 41.7 |
| Example 2-8 | Compound 1-76: Compound CBP | Compound 2-136a | 50:50:10 | 5.7 | 41.6 |
| Example 2-9 | Compound 1-24: Compound 1-69 | Compound 2-103 | 50:50:10 | 5.4 | 42.0 |
| Example 2-10 | Compound 1-14: Compound 1-53 | Compound 2-162 | 50:50:10 | 5.5 | 42.3 |

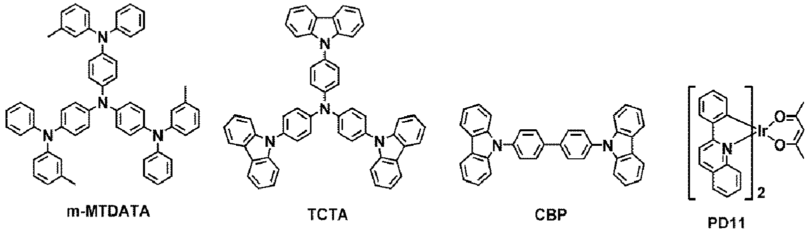

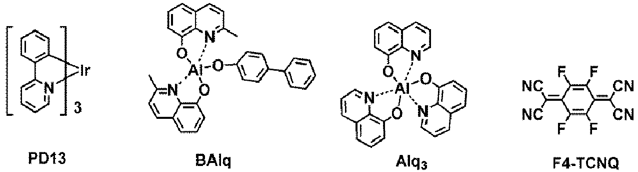

From Tables 5 and 6, it is seen that each of the organic light-emitting devices of Examples 1-1 to 1-10 have lower driving voltage and higher efficiency than each of the organic light-emitting devices of Comparative Examples 1-1 to 1-3, and each of the organic light-emitting devices of Examples 2-1 to 2-20 have lower driving voltage and higher efficiency than each of the organic light-emitting devices of Comparative Examples 2-1 to 2-3.

An organic light-emitting device according to an embodiment of the present disclosure may have low driving voltage and high efficiency.

It should be understood that the embodiments described herein should be considered in a descriptive sense only and not for purposes of limitation. Descriptions of features or aspects within each embodiment should typically be considered as being available for other similar features or aspects in other embodiments.

As used herein, the terms "use", "using", and "used" may be considered synonymous with the terms "utilize", "utilizing", and "utilized", respectively. Further, the use of "may" when describing embodiments of the present disclosure refers to "one or more embodiments of the present disclosure".

As used herein, the terms "substantially", "about", and similar terms are used as terms of approximation and not as terms of degree, and are intended to account for the inherent deviations in measured or calculated values that would be recognized by those of ordinary skill in the art.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

While one or more embodiments have been described with reference to the drawings, it will be understood by those of ordinary skill in the art that various changes in form and details may be made therein without departing from the scope of the present disclosure as defined by the following claims.

## Claims

1. An organic light-emitting device (11) comprising:
a first electrode (no);
a second electrode (190) facing the first electrode;
an emission layer (155) between the first electrode and the second electrode;
a hole transport region (151) between the first electrode and the emission layer; and
an electron transport region between the emission layer and the second electrode,
wherein the emission layer comprises a first compound,
at least one selected from the hole transport region and the electron transport region comprises a second compound,
the first compound is represented by one selected from Formulae 1A, 1B, 1-4, 1D and 1E, and
the second compound is represented by Formula 2A or 2B: 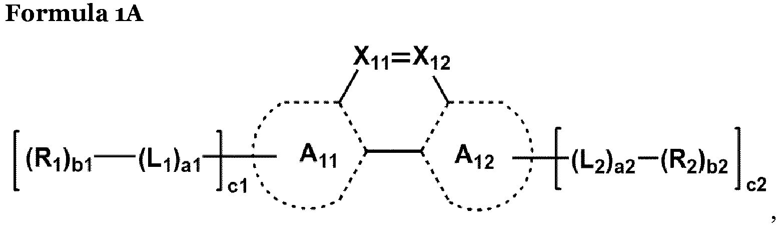 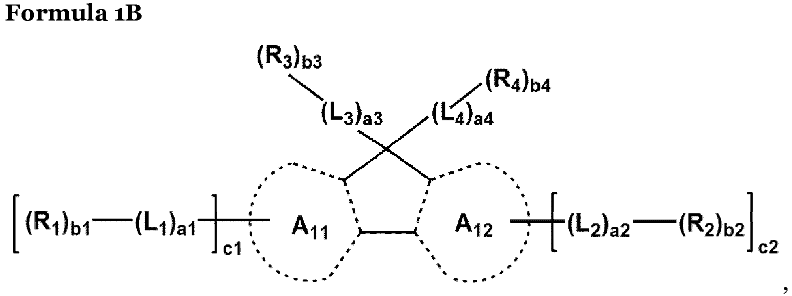 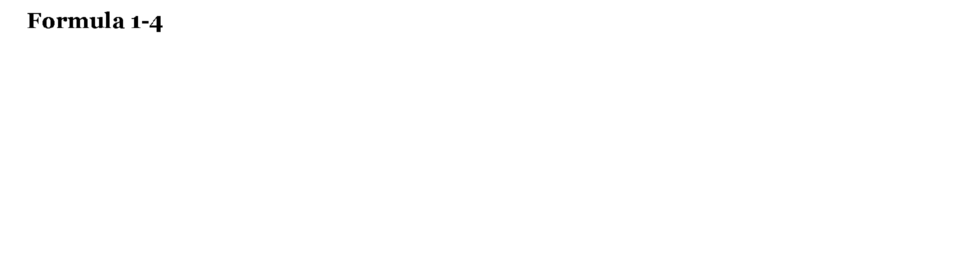 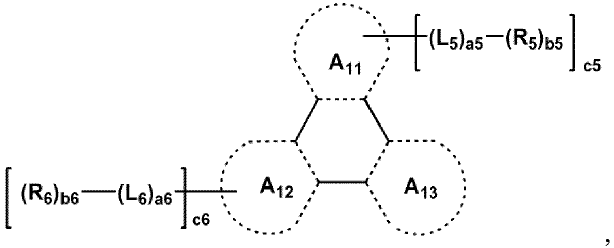 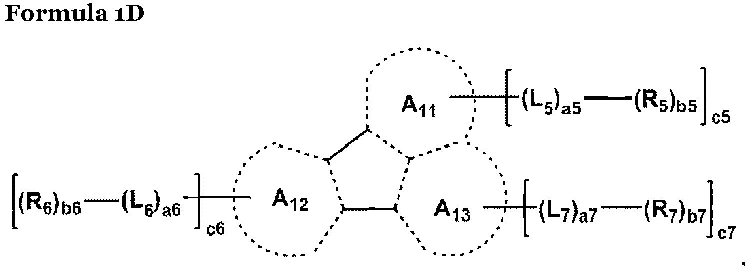 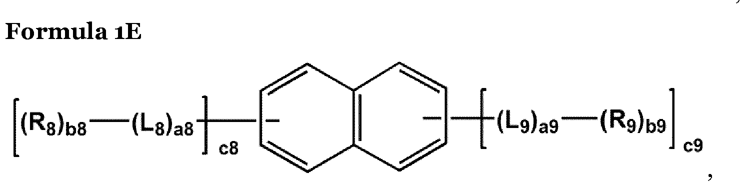 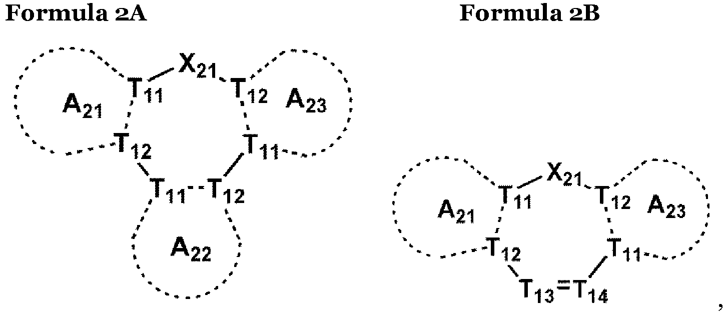
wherein, in Formulae 1A, 1B, 1-4, 1D and 1E, 2A, and 2B,
rings A₁₁ to A₁₃ are each independently selected from a C₆-C₆₀ aromatic group, a C₁-C₆₀ heteroaromatic group, a C₆-C₆₀ non-aromatic condensed polycyclic group, and a 6- to 60- membered non-aromatic condensed heteropolycyclic group,
rings A₂₁, A₂₂, and A₂₃ are each independently selected from a C₅-C₆₀ carbocyclic group and a C₁-C₆₀ heterocyclic group, each substituted with at least one *-[(L₂₂)ₐ₂₂-(R₂₂)_{b22}], wherein * indicates a binding site to the A₂₁, A₂₂ or A₂₃ ring,
each T₁₁ is independently selected from carbon and nitrogen, each T₁₂ is independently selected from carbon and nitrogen, T₁₃ is N or C(R₂₇), T₁₄ is N or C(R₂₈), and each bond between T₁₁ and T₁₂ represented in formulae 2A and 2B as a dashed line is a single bond or a double bond; wherein the six atoms represented by theT₁₁s and T₁₂s in Formula 2A are not all nitrogen, and the six atoms represented by the T₁₁s, T₁₂s, T₁₃ and T₁₄ in Formula 2B are not all nitrogen,
rings A₂₁, A₂₂, and A₂₃ are each fused with a central 7-membered ring in Formulae 2A and 2B, such that they each share a T₁₁ and a T₁₂ with the central 7-membered ring,
X₁₁ is N or C[(L₃)ₐ₃-(R₃)_{b3}], and X₁₂ is N or C[(L₄)ₐ₄-(R₄)_{b4}],
X₂₁ is selected from O, S, Se, C(R₂₃)(R₂₄), Si(R₂₃)(R₂₄), and N[(L₂₁)ₐ₂₁-(R₂₁)_{b21}],
L₁ to L₉ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, and a substituted or unsubstituted divalent non-aromatic condensed C6-C60 polycyclic group,
L₂, and L₂₂ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C6-C60 polycyclic group, and a substituted or unsubstituted divalent non-aromatic condensed 6- to 60- membered heteropolycyclic group,
a1 to a9, a21, and a22 are each independently an integer selected from 0 to 5,
R₁ to R₉ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C6-C60 polycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂),
R₂₁ to R₂₄, R₂₇, and R₂₈ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C6-C60 polycyclic group, a substituted or unsubstituted monovalent non-aromatic condensed 6- to 60- membered heteropolycyclic group, -Si(Q₄)(Q₅)(Q₆), - N(Q₄)(Q₅), -B(Q₄)(Q₅), -C(=O)(Q₄), -S(=O)₂(Q₄), and -P(=O)(Q₄)(Q₅),
b1 to b9, b21, and b22 are each independently an integer selected from 1 to 3,
c1, c2, and c5 to c7 are each independently an integer selected from 0 to 10, provided that the sum of c5, c6, and c7 is 1 or more,
c8 and c9 are each independently an integer selected from 0 to 4, provided that the sum of c8 and c9 is 1 or more, and
the substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed C6-C60 polycyclic group, substituted divalent non-aromatic condensed 6- to 60- membered heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed C6-C60 polycyclic group, and substituted monovalent non-aromatic condensed 6- to 60-membered heteropolycyclic group is substituted with one or more substituents each independently selected from the group consisting of:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C6-C60 polycyclic group, a monovalent non-aromatic condensed 6- to 60- membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C6-C60 polycyclic group, a monovalent non-aromatic condensed 6- to 60- membered heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C6-C60 polycyclic group, and a monovalent non-aromatic condensed 6- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C6-C60 polycyclic group, a monovalent non-aromatic condensed 6- to 60- membered heteropolycyclic group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and - P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₆, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C6-C60 polycyclic group, and a monovalent non-aromatic condensed 6- to 60- membered heteropolycyclic group.

2. The organic light-emitting device (11) of claim 1, wherein:
rings A₁₁ to A₁₃ in Formulae 1A, 1B, 1-4 and 1D are each independently selected from a benzene group, a naphthalene group, an anthracene group, a phenanthrene group, a pyrene group, a triphenylene group, an indene group, a fluorene group, an azafluorene group, a benzofluorene group, a spiro-bifluorene group, a pyridine group, a pyrazine group, a pyrimidine group, a pyridazine group, a pyrrole group, an imidazole group, a quinoline group, an isoquinoline group, a quinoxaline group, a quinazoline group, a triazine group, an indenopyrazine group, an indenopyridine group, a phenanthroline group, and a phenanthridine group.

3. The organic light-emitting device of (11) claim 1 or claim 2, wherein:
rings A₂₁, A₂₂, and A₂₃ in Formulae 2A and 2B are each independently selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrole group, a cyclopentanaphthalene group, a naphthosilole group, a naphthoselenothiophene group, a naphthofuran group, a naphthothiophene group, a pyrroloquinoline group, a cyclopentaquinoline group, a siloloquinoline group, a selenophenoquinoline group, a furoquinoline group, a thienoquinoline group, a pyrroloisoquinoline group, a cyclopentaisoquinoline group, a siloloisoquinoline group, a selenophenoisoquinoline group, a furoisoquinoline group, a thienoisoquinoline group, an azacarbazole group, an azafluorene group, an azadibenzosilole group, an azadibenzoselenophene group, an azadibenzofuran group, an azadibenzothiophene group, an indenoquinoline group, an indenoisoquinoline group, an indenoquinoxaline group, a phenanthroline group, and an naphthoindole group, each substituted with at least one *-[(L₂₂)ₐ₂₂-(R₂₂)_{b22}].

4. The organic light-emitting device (11) of claim 1 or claim 2, wherein:
rings A₂₁ A₂₂, and A₂₃ in Formulae 2A and 2B are each independently selected from groups represented by Formulae 2-1 to 2-36, each substituted with at least one *-[(L₂₂)ₐ₂₂-(R₂₂)b₂₂)]: 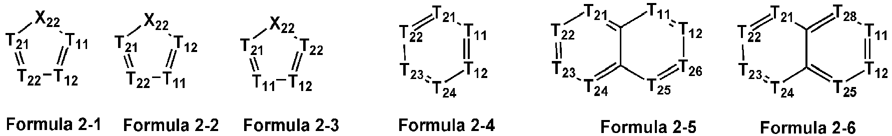 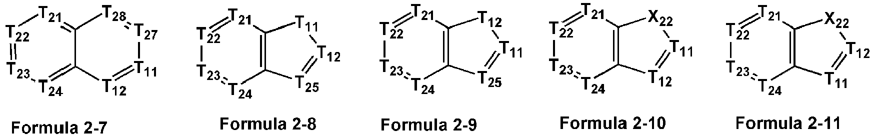 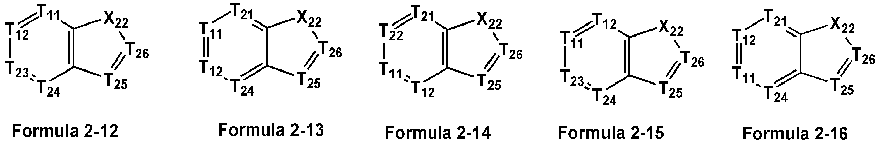 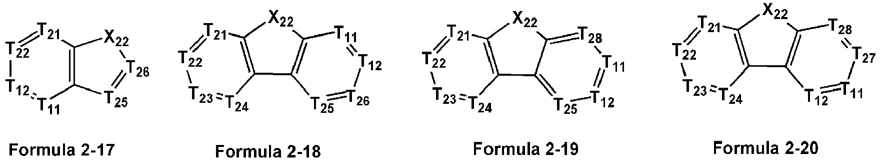 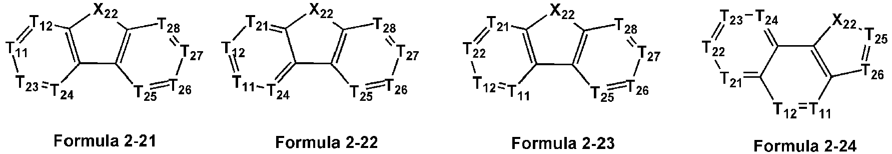 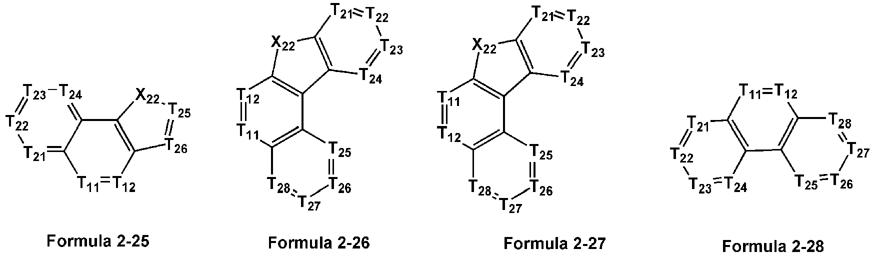 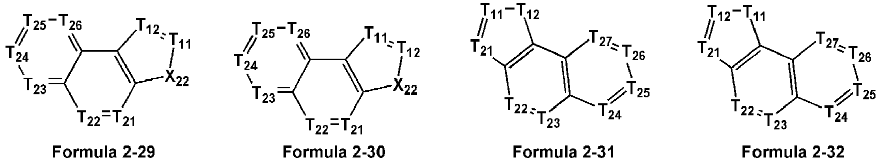 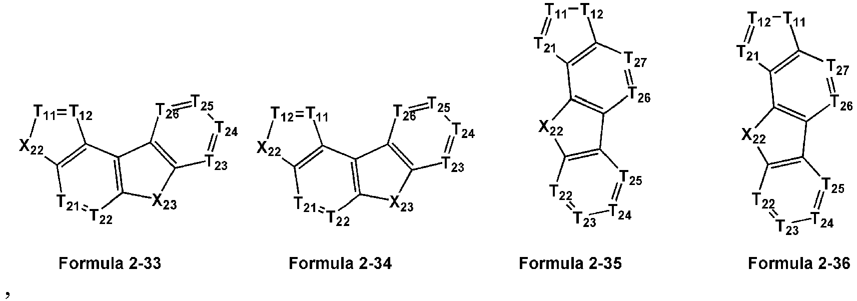
wherein, in Formulae 2-1 to 2-36,
T₁₁ and T₁₂ are as defined in claim 1,
X₂₂ and X₂₃ are each independently selected from O, S, Se, a moiety comprising C, a moiety comprising N, and a moiety comprising Si, and
T₂₁ to T₂₈ are each independently selected from N and a moiety comprising C.

5. The organic light-emitting device (11) of any one of the preceding claims, wherein X₂₁ in Formulae 2A and 2B is N[(L₂₁)ₐ₂₁-(R₂₁)_{b21}]; preferably wherein:
X₂₁ in Formulae 2A and 2B is O, S, Se, C(R₂₃)(R₂₄), or Si(R₂₃)(R₂₄),
at least one selected from rings A₂₁, A₂₂ and A₂₃ in Formula 2A and at least one selected from rings A₂₁ and A₂₃ in Formula 2B are each independently selected from groups represented by Formulae 2-1 to 2-3, 2-10 to 2-27, and 2-33 to 2-36, and
X₂₂ or X₂₃ in Formulae 2-1 to 2-3, 2-10 to 2-27, and 2-33 to 2-36 is N-[(L₂₂)ₐ₂₂-(R₂₂)b₂₂] .

6. The organic light-emitting device (11) of any one of the preceding claims, wherein:
in Formulae 1A, 1B, 1-4, 1D and 1E, 2A, and 2B,
L₁ to L₉ and L₂₁ and L₂₂ are each independently selected from the group consisting of:
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60- membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂); and
L₁ to L₉ are each not a substituted or unsubstituted carbazolylene group, a substituted or unsubstituted dibenzofuranylene group, a substituted or unsubstituted dibenzothiophenylene group, a substituted or unsubstituted dibenzosilolylene group, or a substituted or unsubstituted dibenzocarbazolylene group,
wherein Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

7. The organic light-emitting device (11) of any one of claims 1 to 5, wherein:
in Formulae 1A, 1B, 1-4, 1D and 1E, 2A, and 2B,
L₁ to L₉, L₂₁, and L₂₂ are each independently selected from the group consisting of:
a phenylene group, a pentalenylene group, an indenylene group, a naphthylene group, an azulenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pyrrolylene group, a thiophenylene group, a furanylene group, a silolylene group, an indolylene group, an isoindolylene group, a benzofuranylene group, a benzothiophenylene group, a benzosilolylene group, a dibenzofuranylene group, a dibenzothiophenylene group, a dibenzosilolylene group, a carbazolylene group, a benzocarbazolylene group, a dibenzocarbazolylene group, and a pyridinylene group; and
a phenylene group, a pentalenylene group, an indenylene group, a naphthylene group, an azulenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pyrrolylene group, a thiophenylene group, a furanylene group, a silolylene group, an indolylene group, an isoindolylene group, a benzofuranylene group, a benzothiophenylene group, a benzosilolylene group, a dibenzofuranylene group, a dibenzothiophenylene group, a dibenzosilolylene group, a carbazolylene group, a benzocarbazolylene group, a dibenzocarbazolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenylene group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pyrrolyl group, a thiophenyl group, a furanyl group, a silolyl group, a an indolyl group, an isoindolyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, a dibenzocarbazolyl group, a pyridinyl group, -Si(Q₃₁)(Q₃₂)(Q₃₃) -N(Q₃₁)(Q₃₂), - B(Q₃₁)(Q₃₂), -C(=O)(Q₃₁), -S(=O)₂(Q₃₁), and -P(=O)(Q₃₁)(Q₃₂);
L₁ to L₉ are each not a substituted or unsubstituted carbazolylene group, a substituted or unsubstituted dibenzofuranylene group, a substituted or unsubstituted dibenzothiophenylene group, a substituted or unsubstituted dibenzosilolylene group, or a substituted or unsubstituted dibenzocarbazolylene group,
Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

8. The organic light-emitting device (11) of any one of the preceding claims, wherein:
in Formulae 1A, 1B, 1-4, 1D and 1E, 2A, and 2B,
R₁ to R₉ are each independently selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a benzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂); and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl,group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60- membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
R₂₁ to R₂₄, R₂₇, and R₂₈ are each independently selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₄)(Q₅)(Q₆), -N(Q₄)(Q₅), - B(Q₄)(Q₅), -C(=O)(Q₄), -S(=O)₂(Q₄), and -P(=O)(Q₄)(Q₅); and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60-membered heteropolycyclic group, a biphenyl group, a terphenyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₆ and Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

9. The organic light-emitting device (11) of any one of claims 1 to 7, wherein:
in Formulae 1A, 1B, 1-4, 1D and 1E, 2A, and 2B,
R₁ to R₉ are each independently selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an oxadiazolyl group, a triazinyl group, a thiadiazolyl group, an imidazopyridinyl group, an imidazopyrimidinyl group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂); and
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an oxadiazolyl group, a triazinyl group, a thiadiazolyl group, an imidazopyridinyl group, and an imidazopyrimidinyl group, each substituted with at least one selected from deuterium, -F, -Cl, -Br, -I, a hydroxyl group, a cyano group, a nitro group, an amidino group, a hydrazino group, a hydrazono group, a C₁-C₁₀ alkyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60- membered heteropolycyclic group, a biphenyl group, a terphenyl group, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), and -P(=O)(Q₃₁)(Q₃₂),
R₂₁ to R₂₄, R₂₇, and R₂₈ are each independently selected from the group consisting of:
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a picenyl group, a perylenyl group, a pentaphenyl group, a hexacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, an imidazopyrimidinyl group, -Si(Q₄)(Q₅)(Q₆), -N(Q₄)(Q₅), - B(Q₄)(Q₅), -C(=O)(Q₄), -S(=O)₂(Q₄), and -P(=O)(Q₄)(Q₅); and
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, and an imidazopyrimidinyl group, each substituted with at least one selected from deuterium, - F, -Cl, -Br, -I, a hydroxyl group, a cyano group, a nitro group, an amidino group, a hydrazino group, a hydrazono group, a C₁-C₁₀ alkyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C6-C60 polycyclic group, a monovalent non-aromatic condensed 6- to 60- membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂), and
R₂₂ to R₂₄, R₂₇, and R₂₈ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, -Si(Q₄)(Q₅)(Q₆), -S(=O)₂(Q₄), and -P(=O)(Q₄)(Q₅),
wherein Q₁ to Q₆ and Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

10. The organic light-emitting device (11) of any one of the preceding claims, wherein:
the first compound is represented by one selected from Formula 1E and Formulae 1-1 to 1-6: 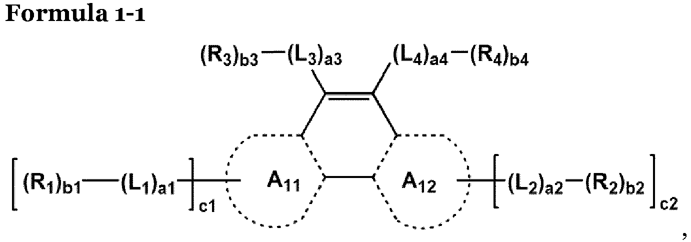 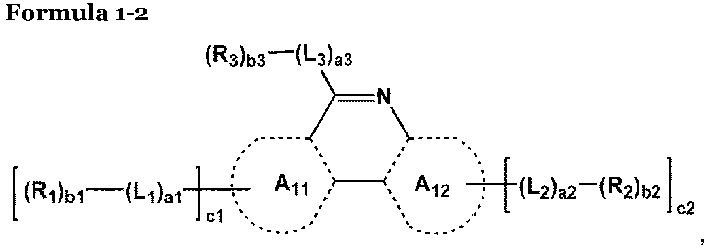 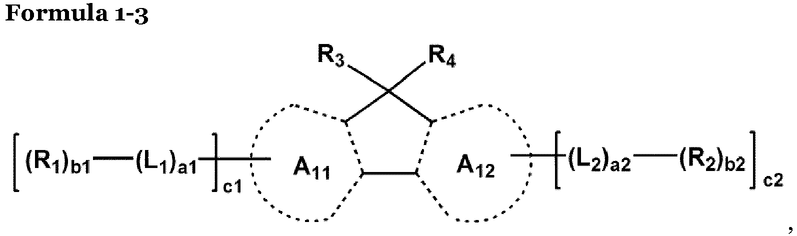 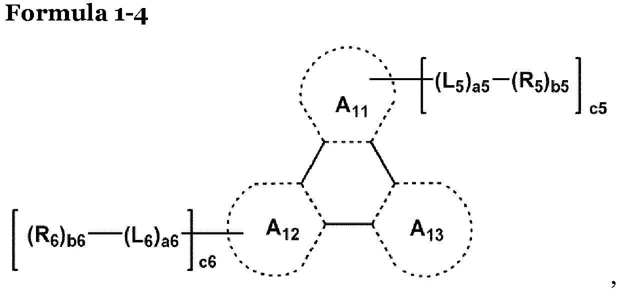 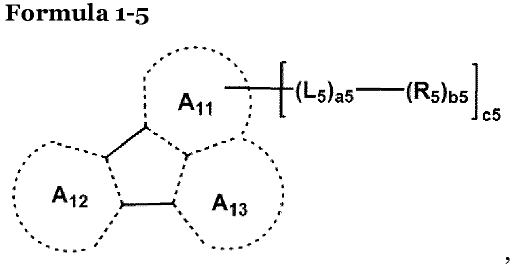 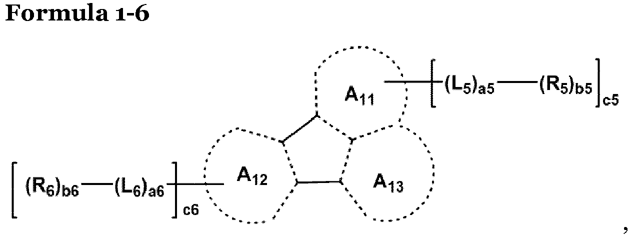
wherein Formula 1E is as defined in any one of claims 1 and 6 to 9,
rings A₁₁ to A₁₃, L₁ to L₆, a₁ to a6, R₁ to R₆, and b₁ to b6 in Formulae 1-1 to 1-6 are as defined in any one of claims 1, 2 and 6 to 9,
c1, c2, and c6 are each independently an integer selected from 0 to 10, and
c5 is an integer selected from 1 to 10.

11. The organic light-emitting device (11) of any one of the preceding claims, wherein:
(a) the second compound has a triplet energy of 2.2 eV or more; and/or
(b) the emission layer comprises a first host and a second host, and the first host comprises the first compound; and/or
(c) the electron transport region comprises a buffer layer, the buffer layer directly contacts the emission layer, and the buffer layer comprises the second compound.

12. The organic light-emitting device (11) of any one of the preceding claims, wherein the emission layer (155) comprises a dopant, wherein the dopant is an organometallic complex; preferably wherein the organometallic complex is represented by Formula 401:
**Formula 401** M(L₄₀₁)_{xc1}(L₄₀₂)_{xc2},
in which L₄₀₁ is a ligand represented by Formula 402: 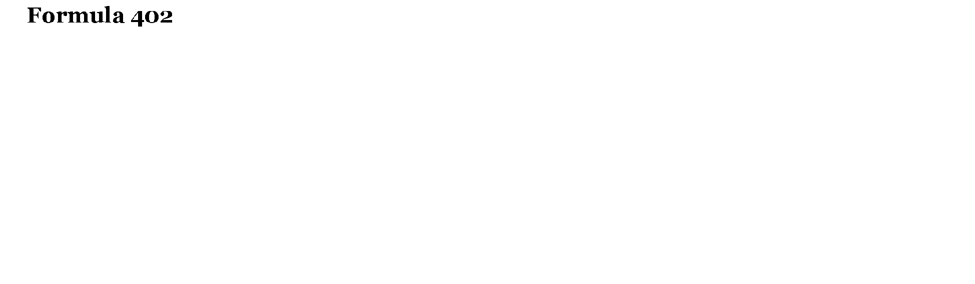 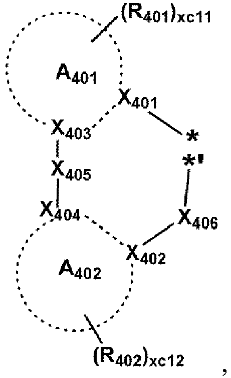
wherein, in Formulae 401 and 402,
M is selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 is 1, 2, or 3, and when xc1 is two or more, two or more L₄₀₁(s) are identical to or different from each other,
L₄₀₂ is an organic ligand, xc2 is an integer selected from 0 to 4, and when xc2 is two or more, two or more L₄₀₂(s) are identical to or different from each other,
X₄₀₁ to X₄₀₄ are each independently nitrogen or carbon,
X₄₀₁ is linked to X₄₀₃ via a single bond or a double bond, and X₄₀₂ is linked to X₄₀₄ via a single bond or a double bond,
A₄₀₁ and A₄₀₂ are each independently a C₅-C₆₀ carbocyclic group or a C₁-C₆₀ heterocyclic group,
X₄₀₅ is a single bond, -O-, -S-, -C(=O)-, -N(Q₄₁₁)-, -C(Q₄₁₁)(Q₄₁₂)-, - C(Q₄₁₁)=C(Q₄₁₂)-, -C(Q₄₁₁)=, or =C(Q₄₁₁)=, and Q₄₁₁ and Q₄₁₂ are each independently hydrogen, deuterium, a C₁-C₂₀ alkyl group, a C₁-C₂₀ alkoxy group, a phenyl group, a biphenyl group, a terphenyl group, or a naphthyl group,
X₄₀₆ is a single bond, O, or S, and
R₄₀₁ and R₄₀₂ are each independently selected from hydrogen, deuterium, -F, - Cl, -Br, -I, -CD₃, -CF₃, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C6-C60 polycyclic group and a substituted or unsubstituted monovalent non-aromatic condensed 6- to 60- membered heteropolycyclic group - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and - P(=O)(Q₄₀₁)(Q₄₀₁), wherein Q₄₀₁ to Q₄₀₃ are each independently selected from a C₁-C₁₀ alkyl group, a C₁-C₁₀ alkoxy group, a C₆-C₂₀ aryl group, and a C₁-C₂₀ heteroaryl group,
xc11 and xc12 are each independently an integer selected from 0 to 10, and
* and *' in Formula 402 each independently indicate a binding site to M in Formula 401.

13. The organic light-emitting device (11) of any one of the preceding claims, wherein:
the electron transport region comprises a buffer layer (156), an electron transport layer (157), and an electron injection layer (159), and
at least one selected from the electron transport layer (157) and the electron injection layer (159) comprises an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

14. The organic light-emitting device (11) of any one of the preceding claims, wherein:
the hole transport region (151) comprises a p-dopant, and
the p-dopant has a lowest unoccupied molecular orbital (LUMO) of -3.5 eV or less; preferably wherein the p-dopant comprises a cyano group-containing compound.

15. The organic light-emitting device (11) of any one of the preceding claims, wherein:
the emission layer (155) comprises a first-color-light emitting-emission layer,
the organic light-emitting device (11) further comprises i) at least one second-color-light emitting-emission layer or ii) at least one second-color-light emitting-emission layer and at least one third-color-light emitting-emission layer, each between the first electrode (110) and the second electrode (190) ,
a maximum emission wavelength of the first-color-light emitting-emission layer, a maximum emission wavelength of the second-color-light emitting-emission layer, and a maximum emission wavelength of the third-color-light emitting-emission layer are identical to or different from each other, and
the organic light-emitting device (11) emits a mixed light comprising a first-color-light and a second-color-light, or a mixed light comprising the first-color-light, the second-color-light, and a third-color-light.

## Patentansprüche

1. Organische lichtemittierende Vorrichtung (11), umfassend:
eine erste Elektrode (110);
eine zweite Elektrode (190), die der ersten Elektrode zugewandt ist;
eine Emissionsschicht (155) zwischen der ersten Elektrode und der zweiten Elektrode;
eine Lochtransportregion (151) zwischen der ersten Elektrode und der Emissionsschicht;
und
eine Elektronentransportregion zwischen der Emissionsschicht und der zweiten Elektrode,
wobei die Emissionsschicht eine erste Verbindung umfasst,
wobei zumindest eine, ausgewählt aus der Lochtransportregion und der Elektronentransportregion, eine zweite Verbindung umfasst,
wobei die erste Verbindung durch eine dargestellt ist, ausgewählt aus den Formeln 1A, 1B, 1-4, 1D und 1E, und
wobei die zweite Verbindung dargestellt ist durch die Formeln 2A oder 2B: 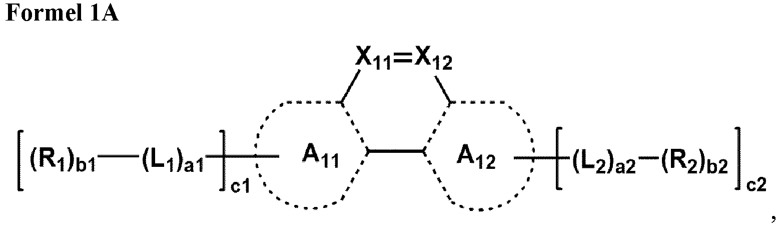 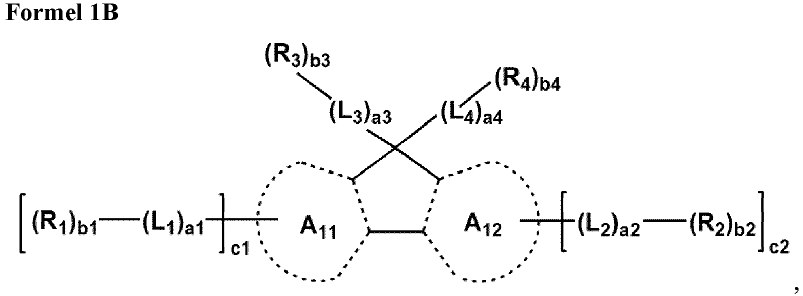 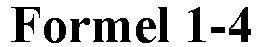 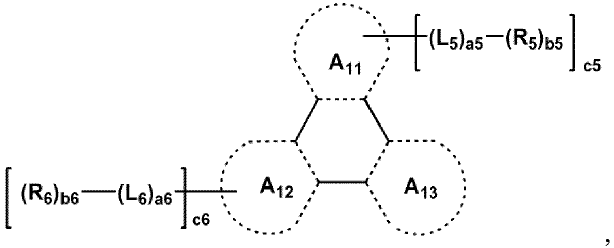 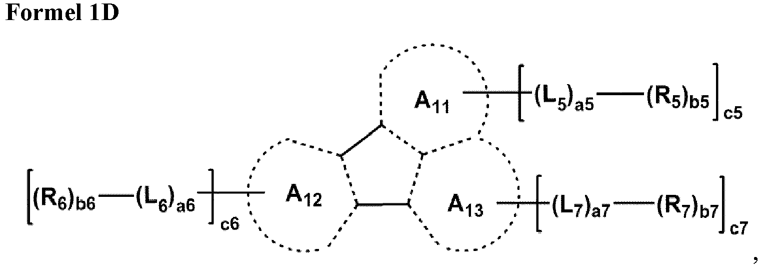 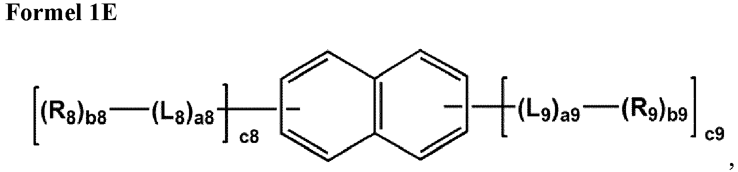 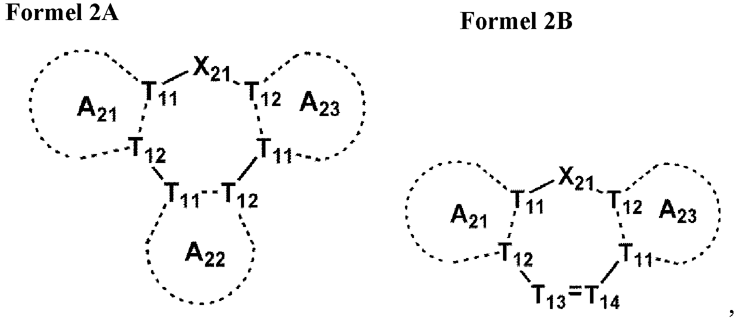
wobei in den Formeln 1A, 1B, 1-4, 1D und 1E, 2A und 2B
die Ringe A₁₁ bis A₁₃ jeweils unabhängig aus einer aromatischen C₆-C₆₀-Gruppe, einer heteroaromatischen C₁-C₆₀-Gruppe, einer nicht-aromatischen kondensierten polyzyklischen C₆-C₆₀-Gruppe und einer 6- bis 60-gliedrigen nicht-aromatischen kondensierten heteropolyzyklischen Gruppe ausgewählt sind,
die Ringe A₂₁, A₂₂ und A₂₃ jeweils unabhängig ausgewählt sind aus einer carbozyklischen C₅-C₆₀-Gruppe und einer heterozyklischen C₁-C₆₀-Gruppe, jeweils substituiert mit zumindest einem *-[(L₂₂)ₐ₂₂-(R₂₂)_{b22}], wobei * eine Bindungsstelle an den A₂₁-, A₂₂- oder A₂₃-Ring anzeigt,
jedes T₁₁ unabhängig ausgewählt ist aus Kohlenstoff und Stickstoff, jedes T₁₂ unabhängig ausgewählt ist aus Kohlenstoff und Stickstoff, T₁₃ N oder C(R₂₇) ist, T₁₄ N oder C(R₂₈) ist, und jede Bindung zwischen T₁₁ und T₁₂, die in den Formeln 2A und 2B als eine gestrichelte Linie dargestellt ist, eine Einfachbindung oder eine Doppelbindung ist; wobei die sechs durch das Tus und T₁₂s in Formel 2A dargestellten Atome nicht alle Stickstoff sind und die sechs durch das T₁₁s, T₁₂s, T₁₃ und T₁₄ in Formel 2B dargestellten Atome nicht alle Stickstoff sind,
die Ringe A₂₁, A₂₂ und A₂₃ jeweils mit einem zentralen 7-gliedrigen Ring in den Formeln 2A und 2B fusioniert sind, so dass sie jeweils ein T₁₁ und ein T₁₂ mit dem zentralen 7-gliedrigen Ring gemeinsam haben,
X₁₁ N oder C[(L₃)ₐ₃-(R₃)b₃] ist und X₁₂ N oder C[(L₄)ₐ₄-(R₄)_{b4}] ist,
X₂₁ ausgewählt ist aus O, S, Se, C(R₂₃)(R₂₄), Si(R₂₃)(R₂₄) und N[(L₂₁)ₐ₂₁-(R₂₁)b₂₁],
L₁ bis L₉ jeweils unabhängig ausgewählt sind aus einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe und einer substituierten oder unsubstituierten zweiwertigen nicht-aromatischen kondensierten polyzyklischen C6-C60-Gruppe,
L₂₁ und L₂₂ jeweils unabhängig ausgewählt sind aus einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nicht-aromatischen kondensierten polyzyklischen C6-C60-Gruppe und einer substituierten oder unsubstituierten zweiwertigen nicht-aromatischen kondensierten 6-bis 60-gliedrigen heteropolyzyklischen Gruppe,
a1 bis a9, a21 und a22 jeweils unabhängig eine aus 0 bis 5 ausgewählte Ganzzahl sind,
R₁ bis R₉ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polyzyklischen C6-C60-Gruppe, -Si(Q₁)(Q₂)(Q₃), -N(Q₁)(Q₂), -B(Q₁)(Q₂), - C(=O)(Q₁), -S(=O)₂(Q₁) und -P(=O)(Q₁)(Q₂),
R₂₁ bis R₂₄, R₂₇ und R₂₈ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆o-Arylthiogruppe, einer substituierten oder unsubstituierten C₁-C₆₀-Heteroarylgruppe, einer substituierten oder unsubstituierten einwertigen nicht-aromatischen kondensierten polyzyklischen C6-C60-Gruppe, einer substituierten oder unsubstituierten einwertigen nicht-aromatischen kondensierten 6- bis 60-gliedrigen heteropolyzyklischen Gruppe, -Si(Q₄)(Q₅)(Q₆), -N(Q₄)(Q₅), -B(Q₄)(Q₅), -C(=O)(Q₄), - S(=O)₂(Q₄) und -P(=O)(Q₄)(Q₅),
b1 bis b9, b21 und b22 jeweils unabhängig eine aus 1 bis 3 ausgewählte Ganzzahl sind,
c1, c2, und c5 bis c7 jeweils unabhängig eine aus 0 bis 10 ausgewählte Ganzzahl sind, vorausgesetzt, dass die Summe von c5, c6 und c7 1 oder mehr ist,
c8 und c9 jeweils unabhängig eine aus 0 bis 4 ausgewählte Ganzzahl sind, vorausgesetzt, dass die Summe von c8 und c9 1 oder mehr ist, und
die substituierte C₃-C₁₀-Cycloalkylengruppe, substituierte C₁-C₁₀-Heterocycloalkylengruppe, substituierte C₃-C₁₀-Cycloalkenylengruppe, substituierte C₁-C₁₀-Heterocycloalkenylengruppe, substituierte C₆-C₆₀-Arylengruppe, substituierte C₁-C₆₀-Heteroarylengruppe, substituierte zweiwertige nicht-aromatische kondensierte polyzyklische C6-C60-Gruppe, substituierte zweiwertige nicht-aromatische kondensierte 6- bis 60-gliedrige heteropolyzyklische Gruppe, substituierte C₁-C₆₀-Alkylgruppe, substituierte C₂-C₆₀-Alkenylgruppe, substituierte C₂-C₆₀-Alkinylgruppe, substituierte C₁-C₆₀-Alkoxygruppe, substituierte C₃-C₁₀-Cycloalkylgruppe, substituierte C₁-C₁₀-Heterocycloalkylgruppe, substituierte C₃-C₁₀-Cycloalkenylgruppe, substituierte C₁-C₁₀-Heterocycloalkenylgruppe, substituierte C₆-C₆₀-Arylgruppe, substituierte C₆-C₆₀-Aryloxygruppe, substituierte C₆-C₆₀-Arylthiogruppe, substituierte C₁-C₆₀-Heteroarylgruppe, substituierte einwertige nichtaromatische kondensierte polyzyklische C6-C60-Gruppe und substituierte einwertige nichtaromatische kondensierte 6- bis 60-gliedrige heteropolyzyklische Gruppe substituiert ist mit einem oder mehreren Substituenten, die jeweils unabhängig ausgewählt sind aus der Gruppe bestehend aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit zumindest einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen C6-C60-Gruppe, einer einwertigen nicht-aromatischen kondensierten 6- bis 60-gliedrigen heteropolyzyklischen Gruppe, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen C6-C60-Gruppe, einer einwertigen nicht-aromatischen kondensierten 6- bis 60-gliedrigen heteropolyzyklischen Gruppe, einer Biphenylgruppe und einer Terphenylgruppe,
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen C6-C60-Gruppe und einer einwertigen nicht-aromatischen kondensierten 6- bis 60-gliedrigen heteropolyzyklischen Gruppe, jeweils substituiert mit zumindest einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen C6-C60-Gruppe, einer einwertigen nicht-aromatischen kondensierten 6- bis 60-gliedrigen heteropolyzyklischen Gruppe, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂),
wobei Q₁ bis Q₆, Q₁₁ bis Q₁₃, Q₂₁ bis Q₂₃ und Q₃₁ bis Q₃₃ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe substituiert mit einer C₁-C₆₀-Alkylgruppe, einer C₆-C₆₀-Arylgruppe substituiert mit einer C₆-C₆₀-Arylgruppe, einer Terphenylgruppe, einer C₁-C₆₀-Heteroarylgruppe, einer C₁-C₆₀-Heteroarylgruppe substituiert mit einer C₁-C₆₀-Alkylgruppe, einer C₁-C₆₀-Heteroarylgruppe substituiert mit einer C₆-C₆₀-Arylgruppe, einer einwertigen nicht-aromatischen kondensierten polyzyklischen C6-C60-Gruppe und einer einwertigen nicht-aromatischen kondensierten 6-bis 60-gliedrigen heteropolyzyklischen Gruppe.

2. Organische lichtemittierende Vorrichtung (11) nach Anspruch 1, wobei:
die Ringe A₁₁ bis A₁₃ in den Formeln 1A, 1B, 1-4 und 1D jeweils unabhängig ausgewählt sind aus einer Benzolgruppe, einer Naphthalingruppe, einer Anthracengruppe, einer Phenanthrengruppe, einer Pyrengruppe, einer Triphenylengruppe, einer Indengruppe, einer Fluorengruppe, einer Azafluorengruppe, einer Benzofluorengruppe, einer Spiro-Bifluorengruppe, einer Pyridingruppe, einer Pyrazingruppe, einer Pyrimidingruppe, einer Pyridazingruppe, einer Pyrrolgruppe, einer Imidazolgruppe, einer Chinolingruppe, einer Isochinolingruppe, einer Chinoxalingruppe, eine Chinazolingruppe, einer Triazingruppe, einer Indenopyrazingruppe, einer Indenopyridingruppe, einer Phenanthrolingruppe und einer Phenanthridingruppe.

3. Organische lichtemittierende Vorrichtung (11) nach Anspruch 1 oder Anspruch 2, wobei:
die Ringe A₂₁, A₂₂ und A₂₃ in den Formeln 2A und 2B jeweils unabhängig ausgewählt sind aus einer Benzolgruppe, einer Naphthalingruppe, einer Anthracengruppe, einer Indengruppe, einer Fluorengruppe, einer Pyridingruppe, einer Pyrimidingruppe, einer Pyrazingruppe, einer Pyridazingruppe, einer Chinolingruppe, einer Isochinolingruppe, einer Pyrrolgruppe, einer Pyrazolgruppe, einer Imidazolgruppe, einer Oxazolgruppe, einer Thiazolgruppe, einer Cyclopentadiengruppe, einer Silolgruppe, einer Selenophengruppe, einer Furangruppe, einer Thiophengruppe, einer Indolgruppe, einer Benzimidazolgruppe, einer Benzoxazolgruppe, einer Benzothiazolgruppe, einer Indengruppe, einer Benzosilolgruppe, einer Benzoselenophengruppe, einer Benzofurangruppe, einer Benzothiophengruppe, einer Carbazolgruppe, einer Fluorengruppe, einer Dibenzosilolgruppe, einer Dibenzoselenophengruppe, einer Dibenzofurangruppe, einer Dibenzothiophengruppe, einer Pyrrolopyridingruppe, einer Cyclopentapyridingruppe, einer Silolopyridingruppe, einer Selenophenopyridingruppe, einer Furopyridingruppe, einer Thienopyridingruppe, einer Pyrrolopyrimidingruppe, einer Cyclopentapyrimidingruppe, einer Silolopyrimidingruppe, einer Selenophenopyrimidingruppe, einer Furopyrimidingruppe, einer Thienopyrimidingruppe, einer Pyrrolopyrazingruppe, einer Cyclopentapyrazingruppe, einer Silolopyrazingruppe, einer Selenophenopyrazingruppe, einer Furopyrazingruppe, einer Thienopyrazingruppe, einer Naphthopyrrolgruppe, einer Cyclopentanaphthalingruppe, einer Naphthosilolgruppe, einer Naphthoselenothiophengruppe, einer Naphthofurangruppe, einer Naphthothiophengruppe, einer Pyrrolochinolingruppe, einer Cyclopentachinolingruppe, einer Silolochinolingruppe, einer Selenophenochinolingruppe, einer Furochinolingruppe, einer Thienochinolingruppe, einer Pyrroloisochinolingruppe, einer Cyclopentaisochinolingruppe, einer Siloloisochinolingruppe, einer Selenophenoisochinolingruppe, einer Furoisochinolingruppe, einer Thienoisochinolingruppe, einer Azacarbazolgruppe, einer Azafluorengruppe, einer Azadibenzosilolgruppe, einer Azadibenzoselenophengruppe, einer Azadibenzofurangruppe, einer Azadibenzothiophengruppe, einer Indenochinolingruppe, einer Indenoisochinolingruppe, einer Indenochinoxalingruppe, einer Phenanthrolingruppe und einer Naphthoindolgruppe, jeweils substituiert mit zumindest einem *-[(L₂₂)ₐ₂₂-(R₂₂)_{b22}].

4. Organische lichtemittierende Vorrichtung (11) nach Anspruch 1 oder Anspruch 2, wobei:
die Ringe A₂₁ A₂₂ und A₂₃ in den Formeln 2A und 2B jeweils unabhängig ausgewählt sind aus Gruppen, die durch die Formeln 2-1 bis 2-36 dargestellt sind, jeweils substituiert mit zumindest einem *-[(L₂₂)ₐ₂₂-(R₂₂)_{b22})]: 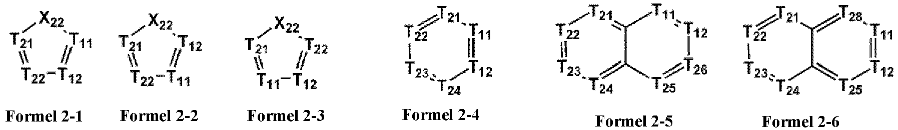 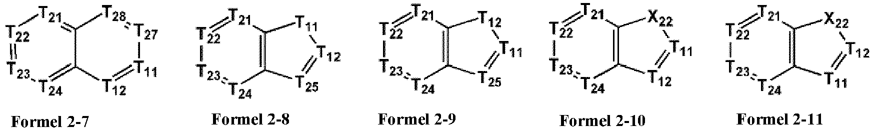 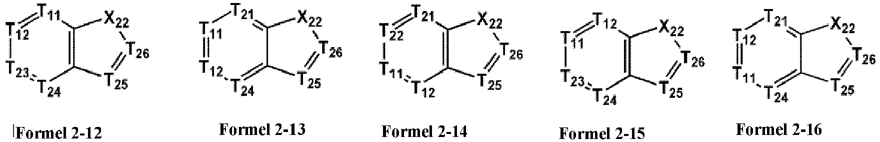 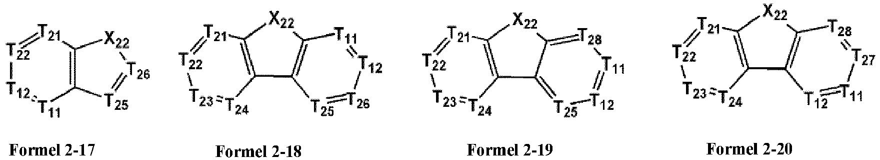 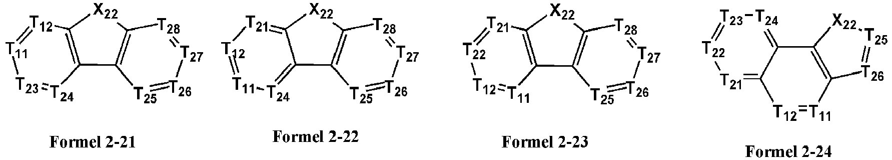 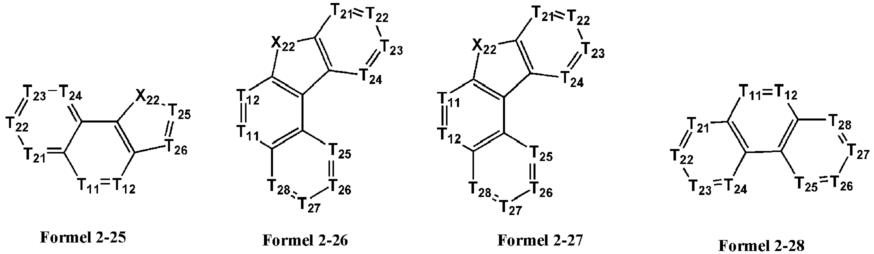 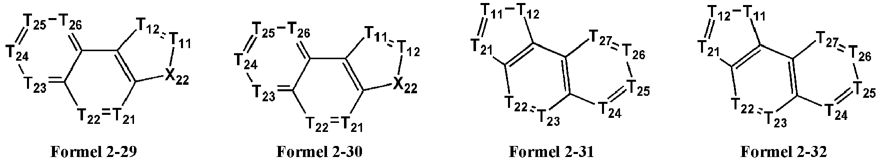 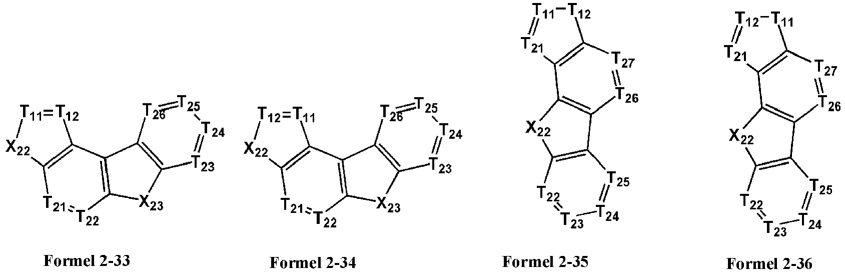
wobei in den Formeln 2-1 bis 2-36
T₁₁ und T₁₂ wie in Anspruch 1 definiert sind,
X₂₂ und X₂₃ jeweils unabhängig ausgewählt sind aus O, S, Se, einer Einheit, die C umfasst, einer Einheit, die N umfasst, und einer Einheit, die Si umfasst, und
T₂₁ bis T₂₈ jeweils unabhängig ausgewählt sind aus N und einer Einheit, die C umfasst.

5. Organische lichtemittierende Vorrichtung (11) nach einem der vorhergehenden Ansprüche, wobei X₂₁ in den Formeln 2A und 2B N[(L₂₁)ₐ₂₁-(R₂₁)_{b21}] ist; wobei vorzugsweise:
X₂₁ in den Formeln 2A und 2B O, S, Se, C(R₂₃)(R₂₄) oder Si(R₂₃)(R₂₄) ist,
zumindest einer, ausgewählt aus den Ringen A₂₁, A₂₂ und A₂₃ in Formel 2A, und zumindest einer, ausgewählt aus den Ringen A₂₁ und A₂₃ in Formel 2B, jeweils unabhängig ausgewählt sind aus Gruppen, die durch die Formeln 2-1 bis 2-3, 2-10 bis 2-27 und 2-33 bis 2-36 dargestellt sind, und
X₂₂ oder X₂₃ in den Formeln 2-1 bis 2-3, 2-10 bis 2-27 und 2-33 bis 2-36 N-[(L₂₂)ₐ₂₂-(R₂₂)_{b22}] ist.

6. Organische lichtemittierende Vorrichtung (11) nach einem der vorhergehenden Ansprüche, wobei:
in den Formeln 1A, 1B, 1-4, 1D und 1E, 2A und 2B,
L₁ bis L₉ und L₂₁ und L₂₂ jeweils unabhängig ausgewählt sind aus der Gruppe bestehend aus:
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-Bifluorenylengruppe, einer Spiro-Benzofluoren-Fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspiro-Bifluorenylengruppe, einer Azacarbazolylengruppe, einer Azadibenzofuranylengruppe, einer Azadibenzothiophenylengruppe und einer Azadibenzosilolylengruppe; und
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-Bifluorenylengruppe, einer Spiro-Benzofluoren-Fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspiro-Bifluorenylengruppe, einer Azacarbazolylengruppe, einer Azadibenzofuranylengruppe, einer Azadibenzothiophenylengruppe und einer Azadibenzosilolylengruppe, jeweils substituiert mit zumindest einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nicht-aromatischen kondensierten polyzyklischen C6-C60-Gruppe, einer einwertigen nicht-aromatischen kondensierten 6- bis 60-gliedrigen heteropolyzyklischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁) und -P(=O)(Q₃₁)(Q₃₂); und
L₁ bis L₉ jeweils keine substituierte oder unsubstituierte Carbazolylengruppe, keine substituierte oder unsubstituierte Dibenzofuranylengruppe, keine substituierte oder unsubstituierte Dibenzothiophenylengruppe, keine substituierte oder unsubstituierte Dibenzosilolylengruppe oder keine substituierte oder unsubstituierte Dibenzocarbazolylengruppe sind,
wobei Q₃₁ bis Q₃₃ jeweils unabhängig ausgewählt sind aus der Gruppe bestehend aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit zumindest einer, ausgewählt aus einer C₁-C₁₀-Alkylgruppe, einer C₁-C₁₀-Alkoxygruppe und einer Phenylgruppe.

7. Organische lichtemittierende Vorrichtung (11) nach einem der Ansprüche 1 bis 5, wobei:
in den Formeln 1A, 1B, 1-4, 1D und 1E, 2A und 2B
L₁ bis L₉, L₂₁ und L₂₂ jeweils unabhängig ausgewählt sind aus der Gruppe bestehend aus:
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-Bifluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Hexacenylengruppe, einer Pyrrolylengruppe, einer Thiophenylengruppe, einer Furanylengruppe, einer Silolylengruppe, einer Indolylengruppe, einer Isoindolylengruppe, einer Benzofuranylengruppe, einer Benzothiophenylengruppe, einer Benzosilolylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe und einer Pyridinylengruppe; und
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-Bifluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Hexacenylengruppe, einer Pyrrolylengruppe, einer Thiophenylengruppe, einer Furanylengruppe, einer Silolylengruppe, einer Indolylengruppe, einer Isoindolylengruppe, einer Benzofuranylengruppe, einer Benzothiophenylengruppe, einer Benzosilolylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe und einer Pyridinylengruppe, jeweils substituiert mit zumindest einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorenylengruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Hexacenylgruppe, einer Pyrrolylgruppe, einer Thiophenylgruppe, einer Furanylgruppe, einer Silolylgruppe, einer Indolylgruppe, einer Isoindolylgruppe, einer Benzofuranylgruppe, einer Benzothiophenylgruppe, einer Benzosilolylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Pyridinylgruppe, -Si(Q₃₁)(Q₃₂)(Q₃₃) -N(Q₃₁)(Q₃₂), -B(Q₃₁)(Q₃₂), -C(=O)(Q₃₁), -S(=O)₂(Q₃₁) und -P(=O)(Q₃₁)(Q₃₂);
L₁ bis L₉ jeweils keine substituierte oder unsubstituierte Carbazolylengruppe, keine substituierte oder unsubstituierte Dibenzofuranylengruppe, keine substituierte oder unsubstituierte Dibenzothiophenylengruppe, keine substituierte oder unsubstituierte Dibenzosilolylengruppe oder keine substituierte oder unsubstituierte Dibenzocarbazolylengruppe sind,
Q₃₁ bis Q₃₃ jeweils unabhängig ausgewählt sind aus der Gruppe bestehend aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit zumindest einer, ausgewählt aus einer C₁-C₁₀-Alkylgruppe, einer C₁-C₁₀-Alkoxygruppe und einer Phenylgruppe.

8. Organische lichtemittierende Vorrichtung (11) nach einem der vorhergehenden Ansprüche, wobei:
in den Formeln 1A, 1B, 1-4, 1D und 1E, 2A und 2B
R₁ bis R₉ jeweils unabhängig ausgewählt sind aus der Gruppe bestehend aus:
Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe und einer C₁-C₂₀-Alkoxygruppe;
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorenylgruppe, einer Spiro-Benzofluoren-Fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Quinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Benzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspiro-Bifluorenylgruppe, einer Azacarbazolylgruppe, einer Azadibenzofuranylgruppe, einer Azadibenzothiophenylgruppe, einer Azadibenzosilolylgruppe, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂); und
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorenylgruppe, einer Spiro-Benzofluoren-Fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspiro-Bifluorenylgruppe, einer Azacarbazolylgruppe, einer Azadibenzofuranylgruppe, einer Azadibenzothiophenylgruppe und einer Azadibenzosilolylgruppe, jeweils substituiert mit zumindest einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer C₃-C₁₀-Cycloalkyl,gruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nicht-aromatischen kondensierten polyzyklischen C6-C60-Gruppe, einer einwertigen nicht-aromatischen kondensierten 6- bis 60-gliedrigen heteropolyzyklischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂),
R₂₁ bis R₂₄, R₂₇ und R₂₈ jeweils unabhängig ausgewählt sind aus der Gruppe bestehend aus:
Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe und einer C₁-C₂₀-Alkoxygruppe;
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorfluorenylgruppe, einer Spiro-Benzofluoren-Fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspiro-Bifluorenylgruppe, einer Azacarbazolylgruppe, einer Azadibenzofuranylgruppe, einer Azadibenzothiophenylgruppe, einer Azadibenzosilolylgruppe, - Si(Q₄)(Q₅)(Q₆), -N(Q₄)(Q₅), -B(Q₄)(Q₅), -C(=O)(Q₄), -S(=O)₂(Q₄) und -P(=O)(Q₄)(Q₅); und
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorenylgruppe, einer Spiro-Benzofluoren-Fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspiro-Bifluorenylgruppe, einer Azacarbazolylgruppe, einer Azadibenzofuranylgruppe, einer Azadibenzothiophenylgruppe und einer Azadibenzosilolylgruppe, jeweils substituiert mit zumindest einem, ausgewählt aus Deuterium, - F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nicht-aromatischen kondensierten polyzyklischen C6-C60-Gruppe, einer einwertigen nicht-aromatischen kondensierten 6- bis 60-gliedrigen heteropolyzyklischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁) und - P(=O)(Q₃₁)(Q₃₂),
wobei Q₁ bis Q₆ und Q₃₁ bis Q₃₃ jeweils unabhängig ausgewählt sind aus der Gruppe bestehend aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit zumindest einer, ausgewählt aus einer C₁-C₁₀-Alkylgruppe, einer C₁-C₁₀-Alkoxygruppe und einer Phenylgruppe.

9. Organische lichtemittierende Vorrichtung (11) nach einem der Ansprüche 1 bis 7, wobei:
in den Formeln 1A, 1B, 1-4, 1D und 1E, 2A und 2B,
R₁ bis R₉ jeweils unabhängig ausgewählt sind aus der Gruppe bestehend aus:
Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe und einer C₁-C₂₀-Alkoxygruppe;
einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorenylgruppe, einer Benzofluorenylgruppe, einer Dibenzofluorenylgruppe, einer Spiro-Benzofluoren-Fluorenylgruppe, einer Indenofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Hexacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Thiadiazolylgruppe, einer Imidazopyridinylgruppe, einer Imidazopyrimidinylgruppe, - Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂); und
einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorenylgruppe, einer Benzofluorenylgruppe, einer Dibenzofluorenylgruppe, einer Spiro-Benzofluoren-Fluorenylgruppe, einer Indenofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Hexacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Thiadiazolylgruppe, einer Imidazopyridinylgruppe und einer Imidazopyrimidinylgruppe, jeweils substituiert mit zumindest einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₁₀-Alkylgruppe, einer C₁-C₁₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nicht-aromatischen kondensierten polyzyklischen C6-C60-Gruppe, einer einwertigen nicht-aromatischen kondensierten 6- bis 60-gliedrigen heteropolyzyklischen Gruppe, einer Biphenylgruppe, einer Terphenylgruppe, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂),
R₂₁ bis R₂₄, R₂₇ und R₂₈ jeweils unabhängig ausgewählt sind aus der Gruppe bestehend aus:
einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorenylgruppe, einer Benzofluorenylgruppe, einer Dibenzofluorenylgruppe, einer Spiro-Benzofluoren-Fluorenylgruppe, einer Indenofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Picenylgruppe, einer Perylenylgruppe, einer Pentaphenylgruppe, einer Hexacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Thiadiazolylgruppe, einer Imidazopyridinylgruppe, einer Imidazopyrimidinylgruppe, - Si(Q₄)(Q₅)(Q₆), -N(Q₄)(Q₅), -B(Q₄)(Q₅), -C(=O)(Q₄), -S(=O)₂(Q₄) und -P(=O)(Q₄)(Q₅); und
einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorenylgruppe, einer Benzofluorenylgruppe, einer Dibenzofluorenylgruppe, einer Spiro-Benzofluoren-Fluorenylgruppe, einer Indenofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pentacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Thiadiazolylgruppe, einer Imidazopyridinylgruppe und einer Imidazopyrimidinylgruppe, jeweils substituiert mit zumindest einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₁₀-Alkylgruppe, einer C₁-C₁₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nicht-aromatischen kondensierten polyzyklischen C6-C60-Gruppe, einer einwertigen nicht-aromatischen kondensierten 6- bis 60-gliedrigen heteropolyzyklischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁) und -P(=O)(Q₃₁)(Q₃₂), und
R₂₂ bis R₂₄, R₂₇ und R₂₈ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, -Si(Q₄)(Q₅)(Q₆), -S(=O)₂(Q₄) und -P(=O)(Q₄)(Q₅),
wobei Q₁ bis Q₆ und Q₃₁ bis Q₃₃ jeweils unabhängig ausgewählt sind aus der Gruppe bestehend aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit zumindest einer, ausgewählt aus einer C₁-C₁₀-Alkylgruppe, einer C₁-C₁₀-Alkoxygruppe und einer Phenylgruppe.

10. Organische lichtemittierende Vorrichtung (11) nach einem der vorhergehenden Ansprüche, wobei:
die erste Verbindung durch eine dargestellt ist, die aus der Formel 1E und den Formeln 1-1 bis 1-6 ausgewählt ist: 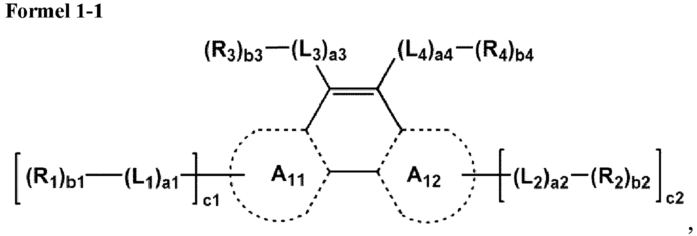 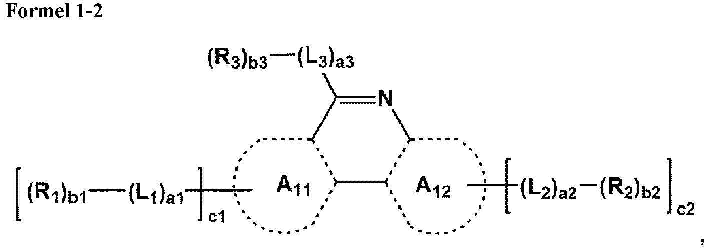 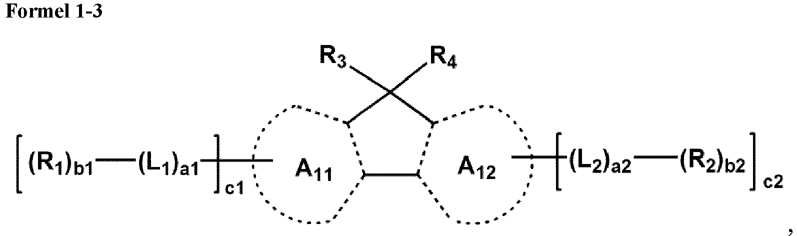 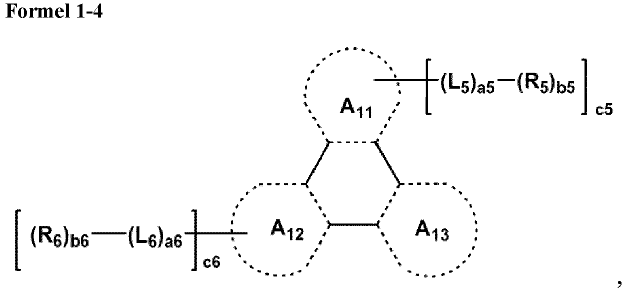 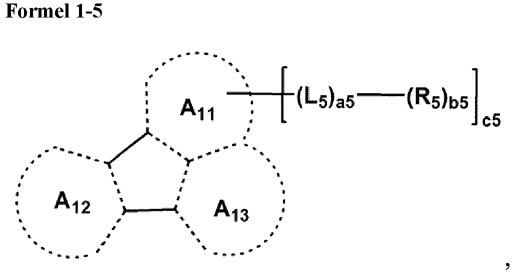 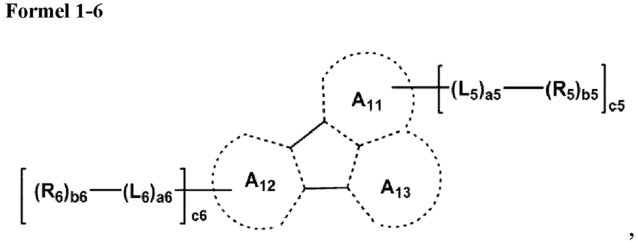
wobei Formel 1E wie in einem der Ansprüche 1 und 6 bis 9 definiert ist,
die Ringe A₁₁ bis A₁₃, L₁ bis L₆, a1 bis a6, R₁ bis R₆ und b1 bis b6 in den Formeln 1-1 bis 1-6 wie in einem der Ansprüche 1, 2 und 6 bis 9 definiert sind,
c1, c2 und c6 jeweils unabhängig eine aus 0 bis 10 ausgewählte Ganzzahl sind, und
c5 eine Ganzzahl ist, ausgewählt aus 1 bis 10.

11. Organische lichtemittierende Vorrichtung (11) nach einem der vorhergehenden Ansprüche, wobei:
(a) die zweite Verbindung eine Triplettenergie von 2,2 eV oder mehr aufweist; und/oder
(b) die Emissionsschicht einen ersten Wirt und einen zweiten Wirt umfasst, und der erste Wirt die erste Verbindung umfasst; und/oder
(c) die Elektronentransportregion eine Pufferschicht umfasst, die Pufferschicht die Emissionsschicht direkt berührt und die Pufferschicht die zweite Verbindung umfasst.

12. Organische lichtemittierende Vorrichtung (11) nach einem der vorhergehenden Ansprüche, wobei die Emissionsschicht (155) ein Dotierungsmittel umfasst, wobei das Dotierungsmittel ein metallorganischer Komplex ist; wobei der metallorganische Komplex vorzugsweise durch die Formel 401 dargestellt ist:
**Formel 401** M(L₄₀₁)_{xc1}(L₄₀₂)_{xc2},
in welcher L₄₀₁ ein Ligand ist, dargestellt durch Formel 402: 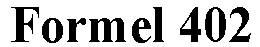 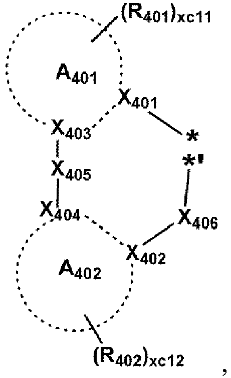
wobei in den Formeln 401 und 402
M ausgewählt ist aus Iridium (Ir), Platin (Pt), Palladium (Pd), Osmium (Os), Titan (Ti), Zirkonium (Zr), Hafnium (Hf), Europium (Eu), Terbium (Tb), Rhodium (Rh) und Thulium (Tm),
xc1 1, 2 oder 3 ist, und wenn xc1 zwei oder mehr ist, zwei oder mehr L₄₀₁(s) identisch miteinander oder voneinander verschieden sind,
L₄₀₂ ein organischer Ligand ist, xc2 eine Ganzzahl ausgewählt von 0 bis 4 ist, und wenn xc2 zwei oder mehr ist, zwei oder mehr L₄₀₂(s) identisch miteinander oder voneinander verschieden sind,
X₄₀₁ bis X₄₀₄ jeweils unabhängig Stickstoff oder Kohlenstoff sind,
X₄₀₁ über eine Einfachbindung oder eine Doppelbindung mit X₄₀₃ aneinander gebunden ist und X₄₀₂ über eine Einfachbindung oder eine Doppelbindung mit X₄₀₄ aneinander gebunden ist,
A₄₀₁ und A₄₀₂ jeweils unabhängig eine carbozyklische C₅-C₆₀-Gruppe oder eine heterozyklische C₁-C₆₀-Gruppe sind,
X₄₀₅ eine Einfachbindung ist, -O-, -S-, -C(=O)-, -N(Q₄₁₁)-, -C(Q₄₁₁)(Q₄₁₂)-, - C(Q₄₁₁)=C(Q₄₁₂)-, -C(Q₄₁₁)= oder =C(Q₄₁₁)= und Q₄₁₁ und Q₄₁₂ jeweils unabhängig Wasserstoff, Deuterium, eine C₁-C₂₀-Alkylgruppe, eine C₁-C₂₀-Alkoxygruppe, eine Phenylgruppe, eine Biphenylgruppe, eine Terphenylgruppe oder eine Naphthylgruppe sind,
X₄₀₆ eine Einfachbindung, O oder S ist, und
R₄₀₁ und R₄₀₂ jeweils unabhängig ausgewählt sind aus Wasserstoff, Deuterium, -F, -Cl, - Br, -I, -CD₃, -CF₃, einer Hydroxylgruppe, einer Cyanogruppe, einer Nitrogruppe, einer Amidinogruppe, einer Hydrazinogruppe, einer Hydrazonogruppe, einer substituierten oder unsubstituierten C₁-C₂₀-Alkylgruppe, einer substituierten oder unsubstituierten C₁-C₂₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polyzyklischen C6-C60-Gruppe und einer substituierten oder unsubstituierten einwertigen nicht-aromatischen kondensierten 6- bis 60-gliedrigen heteropolyzyklischen Gruppe -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁) und - P(=O)(Q₄₀₁)(Q₄₀₂), wobei Q₄₀₁ bis Q₄₀₃ jeweils unabhängig aus einer C₁-C₁₀-Alkylgruppe, einer C₁-C₁₀-Alkoxygruppe, einer C₆-C₂₀-Arylgruppe und einer C₁-C₂₀-Heteroarylgruppe ausgewählt sind,
xc11 und xc12 jeweils unabhängig eine Ganzzahl sind, ausgewählt aus 0 bis 10, und
* und *' in Formel 402 jeweils unabhängig eine Bindungsstelle für M in Formel 401 anzeigen.

13. Organische lichtemittierende Vorrichtung (11) nach einem der vorhergehenden Ansprüche, wobei:
der Elektronentransportbereich eine Pufferschicht (156), eine Elektronentransportschicht (157) und eine Elektroneninjektionsschicht (159) umfasst, und
wobei zumindest eine, ausgewählt aus der Elektronentransportschicht (157) und der Elektroneninjektionsschicht (159), ein Alkalimetall, ein Erdalkalimetall, ein Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex oder eine Kombination davon umfasst.

14. Organische lichtemittierende Vorrichtung (11) nach einem der vorhergehenden Ansprüche, wobei:
die Lochtransportregion (151) ein p-Dotierungsmittel umfasst, und
das p-Dotierungsmittel ein niedrigstes unbesetztes Molekülorbital (LUMO) von -3,5 eV oder weniger aufweist; wobei das p-Dotierungsmittel vorzugsweise eine Cyanogruppen enthaltende Verbindung umfasst.

15. Organische lichtemittierende Vorrichtung (11) nach einem der vorhergehenden Ansprüche, wobei:
die Emissionsschicht (155) eine erste-Farbe-lichtemittierende Emissionsschicht umfasst,
die organische lichtemittierende Vorrichtung (11) ferner i) zumindest eine zweite-Farbe-lichtemittierende Emissionsschicht oder ii) zumindest eine zweite-Farbe-lichtemittierende Emissionsschicht und zumindest eine dritte-Farbe-lichtemittierende Emissionsschicht jeweils zwischen der ersten Elektrode (110) und der zweiten Elektrode (190) umfasst,
eine maximale Emissionswellenlänge der erste-Farbe-lichtemittierenden Emissionsschicht, eine maximale Emissionswellenlänge der zweite-Farbe-lichtemittierenden Emissionsschicht und eine maximale Emissionswellenlänge der dritte-Farbe-lichtemittierenden Emissionsschicht identisch miteinander oder voneinander verschieden sind, und
die organische lichtemittierende Vorrichtung (11) ein Mischlicht, das ein Erste-Farbe-Licht und ein Zweite-Farbe-Licht umfasst, oder ein Mischlicht emittiert, das das Erste-Farbe-Licht, das Zweite-Farbe-Licht und ein Dritte-Farbe-Licht umfasst.

## Revendications

1. Dispositif électroluminescent organique (11) comprenant :
une première électrode (110) ;
une seconde électrode (190) faisant face à la première électrode ;
une couche d'émission (155) entre la première électrode et la seconde électrode ;
une zone de transport de trous (151) entre la première électrode et la couche d'émission ; et
une zone de transport d'électrons entre la couche d'émission et la seconde électrode,
ladite couche d'émission comprenant un premier composé,
au moins une zone choisie parmi la zone de transport de trous et la zone de transport d'électrons comprenant un second composé,
ledit premier composé étant représenté par une formule choisie parmi les formules 1A, 1B, 1-4, 1D et 1E, et
ledit second composé étant représenté par la formule 2A ou 2B : 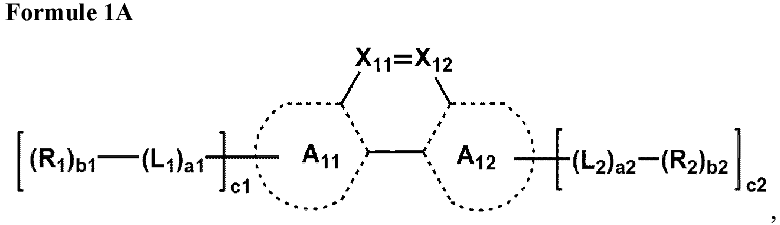 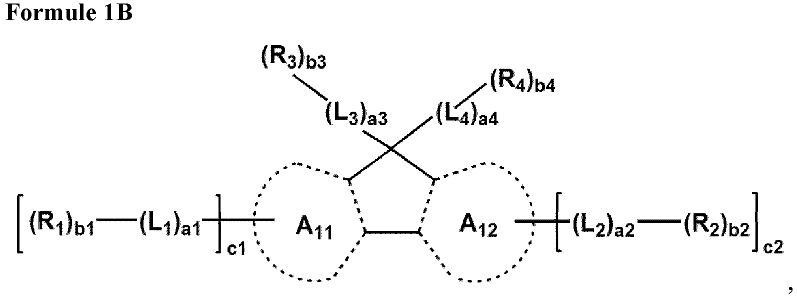 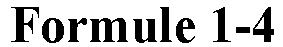 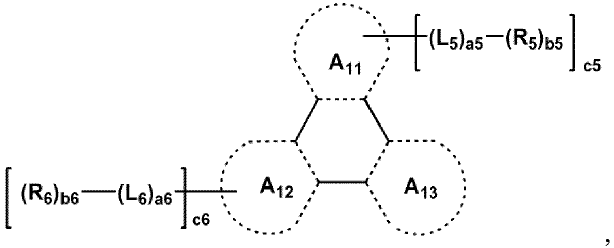 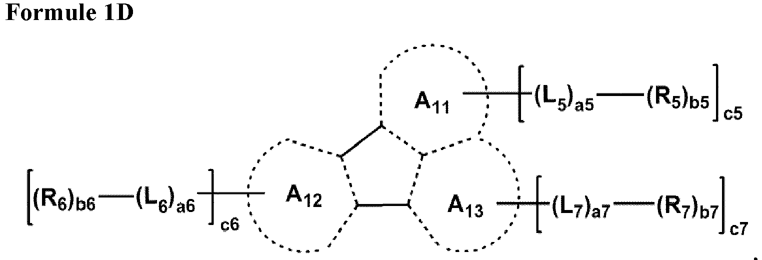 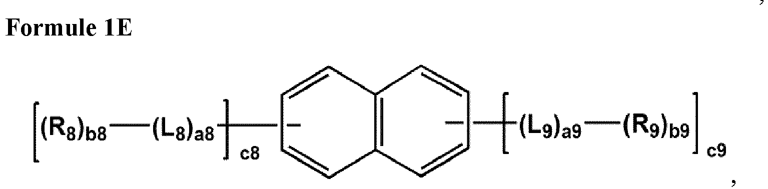 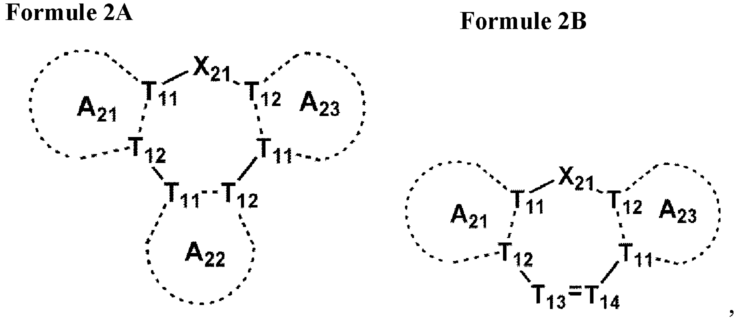
dans lesquelles, dans les formules 1A, 1B, 1-4, 1D et 1E, 2A et 2B,
les noyaux A₁₁ à A₁₃ sont chacun indépendamment choisis parmi un groupe C₆-C₆₀ aromatique, un groupe C₁-C₆₀ hétéroaromatique, un groupe C₆-C₆₀ polycyclique condensé non aromatique, et un groupe hétéropolycyclique de 6 à 60 chaînons condensé non aromatique,
les noyaux A₂₁, A₂₂ et A₂₃ sont chacun indépendamment choisis parmi un groupe C₅-C₆₀ carbocyclique et un groupe C₁-C₆₀ hétérocyclique, chacun substitué par au moins un groupe *-[(L₂₂)ₐ₂₂- (R₂₂)_{b22}], dans lequel * indique un site de liaison au noyau A₂₁, A₂₂ ou A₂₃,
chaque T₁₁ est indépendamment choisi parmi les atomes de carbone et d'azote, chaque T₁₂ est indépendamment choisi parmi les atomes de carbone et d'azote, T₁₃ représente un atome N ou un groupe C(R₂₇), T₁₄ représente un atome N ou un groupe C(R₂₈), et chaque liaison entre T₁₁ et T₁₂ représentée dans les formules 2A et 2B sous la forme d'une ligne pointillée est une liaison simple ou une double liaison ; les six atomes représentés par les T₁₁ et les T₁₂ dans la formule 2A n'étant pas tous des atomes d'azote et les six atomes représentés par les T₁₁, les T₁₂, le T₁₃ et le T₁₄ dans la formule 2B n'étant pas tous des atomes d'azote,
les noyaux A₂₁, A₂₂ et A₂₃ sont chacun fusionnés avec un noyau central de 7 chaînons dans les formules 2A et 2B, de sorte qu'ils partagent chacun un T₁₁ et un T₁₂ avec le noyau central de 7 chaînons,
X₁₁ représente un atome N ou un groupe C[(L₃)ₐ₃-(R₃)b₃], et X₁₂ représente un atome N ou un groupe C[(L₄)ₐ₄-(R₄)_{b4}],
X₂₁ est choisi parmi les atomes O, S, Se, les groupes C(R₂₃)(R₂₄), Si(R₂₃)(R₂₄) etN[(L₂₁)ₐ₂₁-(R₂₁)_{b21}],
L₁ à L₉ sont chacun indépendamment choisis parmi un groupe C₃-C₁₀ cycloalkylène substitué ou non substitué, un groupe C₁-C₁₀ hétérocycloalkylène substitué ou non substitué, un groupe C₃-C₁₀ cycloalcénylène substitué ou non substitué, un groupe C₁-C₁₀ hétérocycloalcénylène substitué ou non substitué, un groupe C₆-C₆₀ arylène substitué ou non substitué, un groupe C₁-C₆₀ hétéroarylène substitué ou non substitué, et un groupe C6-C60 polycyclique condensé non aromatique divalent substitué ou non substitué,
L₂₁ et L₂₂ sont chacun indépendamment choisis parmi un groupe C₃-C₁₀ cycloalkylène substitué ou non substitué, un groupe C₁-C₁₀ hétérocycloalkylène substitué ou non substitué, un groupe C₃-C₁₀ cycloalcénylène substitué ou non substitué, un groupe C₁-C₁₀ hétérocycloalcénylène substitué ou non substitué, un groupe C₆-C₆₀ arylène substitué ou non substitué, un groupe C₁-C₆₀ hétéroarylène substitué ou non substitué, un groupe C6-C60 polycyclique condensé non aromatique divalent substitué ou non substitué, et un groupe hétéropolycyclique de 6 à 60 chaînons condensé non aromatique divalent substitué ou non substitué,
a1 à a9, a21 et a22 représentent chacun indépendamment un entier choisi parmi 0 à 5,
R₁ à R₉ sont chacun indépendamment choisis parmi les atomes d'hydrogène, de deutérium, les groupes -F, -Cl, -Br, -I, un groupe hydroxy, un groupe cyano, un groupe nitro, un groupe amidino, un groupe hydrazino, un groupe hydrazono, un groupe C₁-C₆₀ alkyle substitué ou non substitué, un groupe C₂-C₆₀ alcényle substitué ou non substitué, un groupe C₂-C₆₀ alcynyle substitué ou non substitué, un groupe C₁-C₆₀ alcoxy substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe C6-C60 polycyclique condensé non aromatique monovalent substitué ou non substitué, les groupes -Si(Q₁)(Q₂)(Q₃), - N(Q₁)(Q₂), -B(Q₁)(Q₂), -C(=O)(Q₁), -S(=O)₂(Q₁) et -P(=O)(Q₁)(Q₂),
R₂₁ à R₂₄, R₂₇ et R₂₈ sont chacun indépendamment choisis parmi les atomes d'hydrogène, de deutérium, les groupes -F, -Cl, -Br, -I, un groupe hydroxy, un groupe cyano, un groupe nitro, un groupe amidino, un groupe hydrazino, un groupe hydrazono, un groupe C₁-C₆₀ alkyle substitué ou non substitué, un groupe C₂-C₆₀ alcényle substitué ou non substitué, un groupe C₂-C₆₀ alcynyle substitué ou non substitué, un groupe C₁-C₆₀ alcoxy substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe C6-C60 polycyclique condensé non aromatique monovalent substitué ou non substitué, un groupe hétéropolycyclique de 6 à 60 chaînons condensé non aromatique monovalent substitué ou non substitué, les groupes - Si(Q₄)(Q₅)(Q₆), -N(Q₄)(Q₅), -B(Q₄)(Q₅), -C(=O)(Q₄), -S(=O)₂(Q₄), et -P(=O)(Q₄)(Q₅),
b1 à b9, b21 et b22 représentent chacun indépendamment un entier choisi parmi 1 à 3,
c1, c2 et c5 à c7 représentent chacun indépendamment un entier choisi parmi 0 à 10, à condition que la somme de c5, c6 et c7 vaille 1 ou plus,
c8 et c9 représentent chacun indépendamment un entier choisi parmi 0 à 4, à condition que la somme de c8 et c9 vaille 1 ou plus, et
le groupe C₃-C₁₀ cycloalkylène substitué, le groupe C₁-C₁₀ hétérocycloalkylène substitué, le groupe C₃-C₁₀ cycloalcénylène substitué, le groupe C₁-C₁₀ hétérocycloalcénylène substitué, le groupe C₆-C₆₀ arylène substitué, le groupe C₁-C₆₀ hétéroarylène substitué, le groupe C6-C60 polycyclique condensé non aromatique divalent substitué, le groupe hétéropolycyclique de 6 à 60 chaînons condensé non aromatique divalent substitué, le groupe C₁-C₆₀ alkyle substitué, le groupe C₂-C₆₀ alcényle substitué, le groupe C₂-C₆₀ alcynyle substitué, le groupe C₁-C₆₀ alcoxy substitué, le groupe C₃-C₁₀ cycloalkyle substitué, le groupe C₁-C₁₀ hétérocycloalkyle substitué, le groupe C₃-C₁₀ cycloalcényle substitué, le groupe C₁-C₁₀ hétérocycloalcényle substitué, le groupe C₆-C₆₀ aryle substitué, le groupe C₆-C₆₀ aryloxy substitué, le groupe C₆-C₆₀ arylthio substitué, le groupe C₁-C₆₀ hétéroaryle substitué, le groupe C6-C60 polycyclique condensé non aromatique monovalent substitué, et le groupe hétéropolycyclique de 6 à 60 chaînons condensé non aromatique monovalent substitué est substitué par un ou plusieurs substituants chacun indépendamment choisis dans le groupe constitué par :
un atome de deutérium, les groupes -F, -Cl, -Br, -I, un groupe hydroxy, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle, et un groupe C₁-C₆₀ alcoxy ;
un groupe C₁-C₆₀ alkyle, un groupe C₂-C₆₀ alcényle, un groupe C₂-C₆₀ alcynyle, et un groupe C₁-C₆₀ alcoxy, chacun substitué par au moins un substituant choisi parmi un atome de deutérium, les groupes -F, -Cl, -Br, -I, un groupe hydroxy, un groupe cyano, un groupe nitro, un groupe amidino, un groupe hydrazino, un groupe hydrazono, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C6-C60 polycyclique condensé non aromatique monovalent, un groupe hétéropolycyclique de 6 à 60 chaînons condensé non aromatique monovalent, les groupes -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁) et -P(=O)(Q₁₁)(Q₁₂) ;
un groupe C₃-C₁₀ cycloalkyle, un groupe C₁-C₁₀ hétérocycloalkyle, un groupe C₃-C₁₀ cycloacényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C6-C60 polycyclique condensé non aromatique monovalent, un groupe hétéropolycyclique de 6 à 60 chaînons condensé non aromatique monovalent, un groupe biphényle et un groupe terphényle ;
un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C6-C60 polycyclique condensé non aromatique monovalent, et un groupe hétéropolycyclique de 6 à 60 chaînons condensé non aromatique monovalent, chacun substitué par au moins un substituant choisi parmi un atome de deutérium, les groupes -F, -Cl, -Br, -I, un groupe hydroxy, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle, un groupe C₁-C₆₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C6-C60 polycyclique condensé non aromatique monovalent, un groupe hétéropolycyclique de 6 à 60 chaînons condensé non aromatique monovalent, les groupes -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁) et -P(=O)(Q₂₁)(Q₂₂) ; et
les groupes -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et - P(=O)(Q₃₁)(Q₃₂),
dans lesquels Q₁ à Q₆, Q₁₁ à Q₁₃, Q₂₁ à Q₂₃, et Q₃₁ à Q₃₃ sont chacun indépendamment choisis parmi les atomes d'hydrogène, de deutérium, les groupes -F, -Cl, -Br, -I, un groupe hydroxy, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle, un groupe C₁-C₆₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryle substitué par un groupe C₁-C₆₀ alkyle, un groupe C₆-C₆₀ aryle substitué par un groupe C₆-C₆₀ aryle, un groupe terphényle, un groupe C₁-C₆₀ hétéroaryle, un groupe C₁-C₆₀ hétéroaryle substitué par un groupe C₁-C₆₀ alkyle, un groupe C₁-C₆₀ hétéroaryle substitué par un groupe C₆-C₆₀ aryle, un groupe C6-C60 polycyclique condensé non aromatique monovalent, et un groupe hétéropolycyclique de 6 à 60 chaînons condensé non aromatique monovalent.

2. Dispositif électroluminescent organique (11) selon la revendication 1 :
lesdits noyaux A₁₁ à A₁₃ dans les formules 1A, 1B, 1-4 et 1D étant chacun indépendamment choisis parmi un groupe benzène, un groupe naphtalène, un groupe anthracène, un groupe phénanthrène, un groupe pyrène, un groupe triphénylène, un groupe indène, un groupe fluorène, un groupe azafluorène, un groupe benzofluorène, un groupe spiro-bifluorène, un groupe pyridine, un groupe pyrazine, un groupe pyrimidine, un groupe pyridazine, un groupe pyrrole, un groupe imidazole, un groupe quinoline, un groupe isoquinoline, un groupe quinoxaline, un groupe quinazoline, un groupe triazine, un groupe indénopyrazine, un groupe indénopyridine, un groupe phénanthroline, et un groupe phénanthridine.

3. Dispositif électroluminescent organique (11) selon la revendication 1 ou la revendication 2 :
lesdits noyaux A₂₁, A₂₂ et A₂₃ dans les formules 2A et 2B étant chacun indépendamment choisis parmi un groupe benzène, un groupe naphtalène, un groupe anthracène, un groupe indène, un groupe fluorène, un groupe pyridine, un groupe pyrimidine, un groupe pyrazine, un groupe pyridazine, un groupe quinoline, un groupe isoquinoline, un groupe pyrrole, un groupe pyrazole, un groupe imidazole, un groupe oxazole, un groupe thiazole, un groupe cyclopentadiène, un groupe silole, un groupe sélénophène, un groupe furane, un groupe thiophène, un groupe indole, un groupe benzimidazole, un groupe benzoxazole, un groupe benzothiazole, un groupe indène, un groupe benzosilole, un groupe benzosélénophène, un groupe benzofurane, un groupe benzothiophène, un groupe carbazole, un groupe fluorène, un groupe dibenzosilole, un groupe dibenzosélénophène, un groupe dibenzofurane, un groupe dibenzothiophène, un groupe pyrrolopyridine, un groupe cyclopentapyridine, un groupe silolopyridine, un groupe sélénophénopyridine, un groupe furopyridine, un groupe thiénopyridine, un groupe pyrrolopyrimidine, un groupe cyclopentapyrimidine, un groupe silolopyrimidine, un groupe sélénophénopyrimidine, un groupe furopyrimidine, un groupe thiénopyrimidine, un groupe pyrrolopyrazine, un groupe cyclopentapyrazine, un groupe silolopyrazine, un groupe sélénophénopyrazine, un groupe furopyrazine, un groupe thiénopyrazine, un groupe naphtopyrrole, un groupe cyclopentanaphtalène, un groupe naphtosilole, un groupe naphtosélénothiophène, un groupe naphtofurane, un groupe naphtothiophène, un groupe pyrroloquinoline, un groupe cyclopentaquinoline, un groupe siloloquinoline, un groupe sélénophénoquinoline, un groupe furoquinoline, un groupe thiénoquinoline, un groupe pyrroloisoquinoline, un groupe cyclopentaisoquinoline, un groupe siloloisoquinoline, un groupe sélénophénoisoquinoline, un groupe furoisoquinoline, un groupe thiénoisoquinoline, un groupe azacarbazole, un groupe azafluorène, un groupe azadibenzosilole, un groupe azadibenzosélénophène, un groupe azadibenzofurane, un groupe azadibenzothiophène, un groupe indénoquinoline, un groupe indénoisoquinoline, un groupe indénoquinoxaline, un groupe phénanthroline, et un groupe naphtoindole, chacun substitué par au moins un groupe *-[(L₂₂)ₐ₂₂-(R₂₂)_{b22}].

4. Dispositif électroluminescent organique (11) selon la revendication 1 ou la revendication 2 :
lesdits noyaux A₂₁ A₂₂, et A₂₃ dans les formules 2A et 2B étant chacun indépendamment choisis parmi les groupes représentés par les formules 2-1 à 2-36, chacun substitué par au moins un groupe *-[(L₂₂)ₐ₂₂-(R₂₂)_{b22})] : 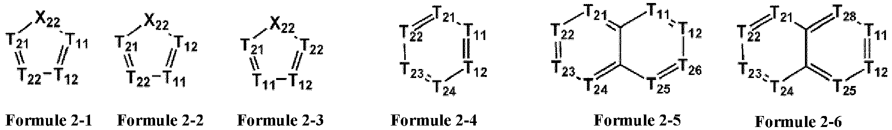 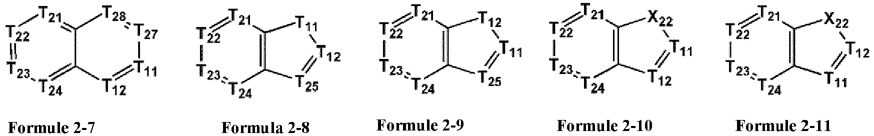 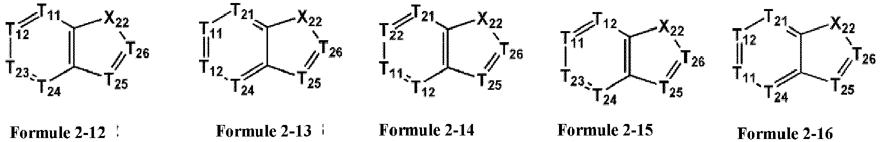 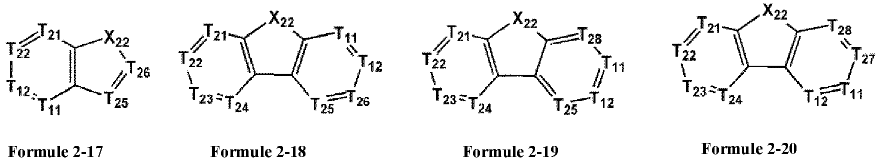 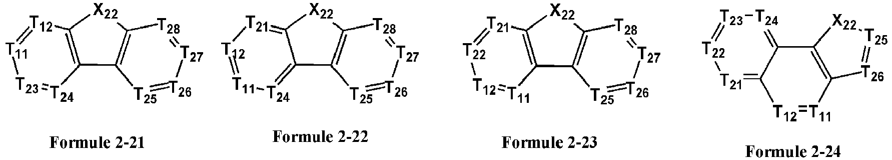 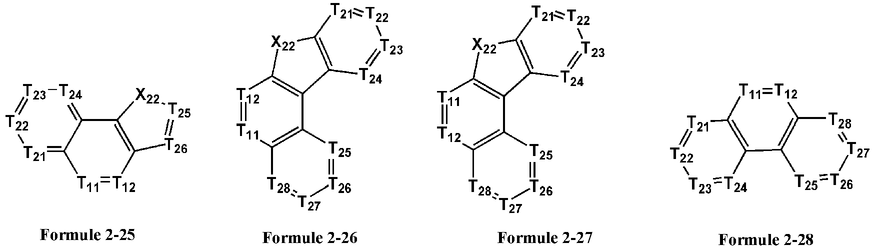 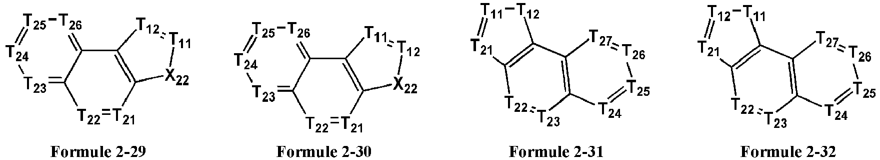 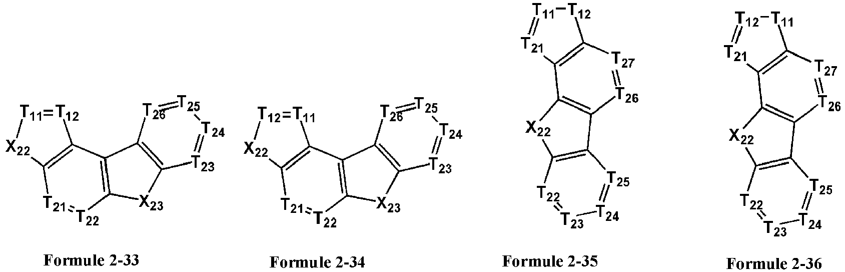
dans lesquelles, dans les formules 2-1 à 2-36,
T₁₁ et T₁₂ sont tels que définis dans la revendication 1,
X₂₂ et X₂₃ sont chacun indépendamment choisis parmi les atomes O, S, Se, un groupement comprenant un atome C, un groupement comprenant un atome N, et un groupement comprenant un atome Si, et
T₂₁ à T₂₈ sont chacun indépendamment choisis parmi un atome N et un groupement comprenant un atome C.

5. Dispositif électroluminescent organique (11) selon l'une quelconque des revendications précédentes, X₂₁ dans les formules 2A et 2B représentant un groupe N[(L₂₁)ₐ₂₁-(R₂₁)_{b21}] ; de préférence :
X₂₁ dans les formules 2A et 2B représentant un atome O, S, Se, un groupe C(R₂₃)(R₂₄) ou Si(R₂₃)(R₂₄),
au moins un noyau choisi parmi les noyaux A₂₁, A₂₂ et A₂₃ dans la formule 2A et au moins un noyau choisi parmi les noyaux A₂₁ et A₂₃ dans la formule 2B étant chacun indépendamment choisis parmi les groupes représentés par les formules 2-1 à 2-3, 2-10 à 2-27, et 2-33 à 2-36, et
X₂₂ ou X₂₃ dans les formules 2-1 à 2-3, 2-10 à 2-27, et 2-33 à 2-36 représentant un groupe N-[(L₂₂)ₐ₂₂-(R₂₂)_{b22}].

6. Dispositif électroluminescent organique (11) selon l'une quelconque des revendications précédentes :
dans les formules 1A, 1B, 1-4, 1D et 1E, 2A, et 2B,
L₁ à L₉ et L₂₁ et L₂₂ étant chacun indépendamment choisis dans le groupe constitué par :
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe perylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène, et un groupe azadibenzosilolylène ; et
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène, et un groupe azadibenzosilolylène, chacun substitué par au moins un substituant choisi parmi un atome de deutérium, les groupes -F, -Cl, -Br, -I, un groupe hydroxy, un groupe cyano, un groupe nitro, un groupe amidino, un groupe hydrazino, un groupe hydrazono, un groupe C₁-C₂₀ alkyle, un groupe C₁-C₂₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₁-C₆₀ hétéroaryle, un groupe C6-C60 polycyclique condensé non aromatique monovalent, un groupe hétéropolycyclique de 6 à 60 chaînons condensé non aromatique monovalent, un groupe biphényle, un groupe terphényle, les groupes -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁) et -P(=O)(Q₃₁)(Q₃₂) ; et
L₁ à L₉ ne représentant chacun pas un groupe carbazolylène substitué ou non substitué, un groupe dibenzofuranylène substitué ou non substitué, un groupe dibenzothiophénylène substitué ou non substitué, un groupe dibenzosilolylène substitué ou non substitué, ou un groupe dibenzocarbazolylène substitué ou non substitué,
Q₃₁ à Q₃₃ étant chacun indépendamment choisis dans le groupe constitué par :
un groupe C₁-C₁₀ alkyle, un groupe C₁-C₁₀ alcoxy, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle, et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle, et un groupe quinazolinyle, chacun substitué par au moins un substituant choisi parmi un groupe C₁-C₁₀ alkyle, un groupe C₁-C₁₀ alcoxy, et un groupe phényle.

7. Dispositif électroluminescent organique (11) selon l'une quelconque des revendications 1 à 5 :
dans les formules 1A, 1B, 1-4, 1D et 1E, 2A et 2B,
L₁ à L₉, L₂₁ et L₂₂ étant chacun indépendamment choisis dans le groupe constitué par :
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe perylénylène, un groupe pentaphénylène, un groupe hexacénylène, un groupe pyrrolylène, un groupe thiophénylène, un groupe furanylène, un groupe silolylène, un groupe indolylène, un groupe isoindolylène, un groupe benzofuranylène, un groupe benzothiophénylène, un groupe benzosilolylène, un groupe dibenzofuranylène, un groupe dibenzothiophénylène, un groupe dibenzosilolylène, un groupe carbazolylène, un groupe benzocarbazolylène, un groupe dibenzocarbazolylène, et un groupe pyridinylène ; et
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe perylénylène, un groupe pentaphénylène, un groupe hexacénylène, un groupe pyrrolylène, un groupe thiophénylène, un groupe furanylène, un groupe silolylène, un groupe indolylène, un groupe isoindolylène, un groupe benzofuranylène, un groupe benzothiophénylène, un groupe benzosilolylène, un groupe dibenzofuranylène, un groupe dibenzothiophénylène, un groupe dibenzosilolylène, un groupe carbazolylène, un groupe benzocarbazolylène, un groupe dibenzocarbazolylène, et un groupe pyridinylène, chacun substitué par au moins un substituant choisi parmi un atome de deutérium, les groupes -F, -Cl, -Br, -I, un groupe hydroxy, un groupe cyano, un groupe nitro, un groupe amidino, un groupe hydrazino, un groupe hydrazono, un groupe C₁-C₂₀ alkyle, un groupe C₁₋C₂₀ alcoxy, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorénylène, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe perylényle, un groupe pentaphényle, un groupe hexacényle, un groupe pyrrolyle, un groupe thiophényle, un groupe furanyle, un groupe silolyle, un groupe indolyle, un groupe isoindolyle, un groupe benzofuranyle, un groupe benzothiophényle, un groupe benzosilolyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe pyridinyle, les groupes -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et - P(=O)(Q₃₁)(Q₃₂) ;
L₁ à L₉ ne représentant chacun pas un groupe carbazolylène substitué ou non substitué, un groupe dibenzofuranylène substitué ou non substitué, un groupe dibenzothiophénylène substitué ou non substitué, un groupe dibenzosilolylène substitué ou non substitué, ou un groupe dibenzocarbazolylène substitué ou non substitué,
Q₃₁ à Q₃₃ étant chacun indépendamment choisis dans le groupe constitué par :
un groupe C₁-C₁₀ alkyle, un groupe C₁-C₁₀ alcoxy, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle, et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle, et un groupe quinazolinyle, chacun substitué par au moins un substituant choisi parmi un groupe C₁-C₁₀ alkyle, un groupe C₁-C₁₀ alcoxy, et un groupe phényle.

8. Dispositif électroluminescent organique (11) selon l'une quelconque des revendications précédentes :
dans les formules 1A, 1B, 1-4, 1D et 1E, 2A et 2B,
R₁ à R₉ étant chacun indépendamment choisis dans le groupe constitué par :
les atomes d'hydrogène, de deutérium, les groupes -F, -Cl, -Br, -I, un groupe hydroxy, un groupe cyano, un groupe nitro, un groupe amidino, un groupe hydrazino, un groupe hydrazono, un groupe C₁-C₂₀ alkyle, et un groupe C₁-C₂₀ alcoxy ;
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe perylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe benzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphtyridinyle, un groupe azafluorényle, un groupe azaspiro-bifluorényle, un groupe azacarbazolyle, un groupe azadibenzofuranyle, un groupe azadibenzothiophényle, un groupe azadibenzosilolyle, -Si(Q₁)(Q₂)(Q₃), -N(Q₁)(Q₂), -B(Q₁)(Q₂), -C=O(Q₁), -S=O₂(Q₁), et - P=O(Q₁)(Q₂) ; et
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe perylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphtyridinyle, un groupe azafluorényle, un groupe azaspiro-bifluorényle, un groupe azacarbazolyle, un groupe azadibenzofuranyle, un groupe azadibenzothiophényle, et un groupe azadibenzosilolyle, chacun substitué par au moins un substituant choisi parmi un atome de deutérium, les groupes -F, -Cl, -Br, -I, un groupe hydroxy, un groupe cyano, un groupe nitro, un groupe amidino, un groupe hydrazino, un groupe hydrazono, un groupe C₁-C₂₀ alkyle, un groupe C₁-C₂₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₁-C₆₀ hétéroaryle, un groupe C6-C60 polycyclique condensé non aromatique monovalent, un groupe hétéropolycyclique de 6 à 60 chaînons condensé non aromatique monovalent, un groupe biphényle, un groupe terphényle, les groupes - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂),
R₂₁ à R₂₄, R₂₇ et R₂₈ sont chacun indépendamment choisis dans le groupe constitué par :
les atomes d'hydrogène, de deutérium, les groupes -F, -Cl, -Br, -I, un groupe hydroxy, un groupe cyano, un groupe nitro, un groupe amidino, un groupe hydrazino, un groupe hydrazono, un groupe C₁-C₂₀ alkyle, et un groupe C₁-C₂₀ alcoxy ;
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe perylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphtyridinyle, un groupe azafluorényle, un groupe azaspiro-bifluorényle, un groupe azacarbazolyle, un groupe azadibenzofuranyle, un groupe azadibenzothiophényle, un groupe azadibenzosilolyle, les groupes -Si(Q₄)(Q₅)(Q₆), -N(Q₄)(Q₅), -B(Q₄)(Q₅), -C(=O)(Q₄), -S(=O)₂(Q₄), et -P(=O)(Q₄)(Q₅) ; et
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe perylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphtyridinyle, un groupe azafluorényle, un groupe azaspiro-bifluorényle, un groupe azacarbazolyle, un groupe azadibenzofuranyle, un groupe azadibenzothiophényle, et un groupe azadibenzosilolyle, chacun substitué par au moins un substituant choisi parmi un atome de deutérium, les groupes -F, -Cl, -Br, -I, un groupe hydroxy, un groupe cyano, un groupe nitro, un groupe amidino, un groupe hydrazino, un groupe hydrazono, un groupe C₁-C₂₀ alkyle, un groupe C₁-C₂₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₁-C₆₀ hétéroaryle, un groupe C6-C60 polycyclique condensé non aromatique monovalent, un groupe hétéropolycyclique de 6 à 60 chaînons condensé non aromatique monovalent, un groupe biphényle, un groupe terphényle, les groupes - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂),
Q₁ à Q₆ et Q₃₁ à Q₃₃ étant chacun indépendamment choisis dans le groupe constitué par :
un groupe C₁-C₁₀ alkyle, un groupe C₁-C₁₀ alcoxy, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle, et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle, et un groupe quinazolinyle, chacun substitué par au moins un substituant choisi parmi un groupe C₁-C₁₀ alkyle, un groupe C₁-C₁₀ alcoxy, et un groupe phényle.

9. Dispositif électroluminescent organique (11) selon l'une quelconque des revendications 1 à7 :
dans les formules 1A, 1B, 1-4, 1D et 1E, 2A et 2B,
R₁ à R₉ étant chacun indépendamment choisis dans le groupe constitué par :
les atomes d'hydrogène, de deutérium, les groupes -F, -Cl, -Br, -I, un groupe hydroxy, un groupe cyano, un groupe nitro, un groupe amidino, un groupe hydrazino, un groupe hydrazono, un groupe C₁-C₂₀ alkyle, et un groupe C₁-C₂₀ alcoxy ;
un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe benzofluorényle, un groupe dibenzofluorényle, un groupe spiro-benzofluorène-fluorényle, un groupe indénofluorényle, un groupe phénalényle, un groupe phénanthrényle, un groupe anthracényle, un groupe fluoranthényle, un groupe triphénylényle, un groupe pyrényle, un groupe chrysényle, un groupe perylényle, un groupe pentaphényle, un groupe hexacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe thiadiazolyle, un groupe imidazopyridinyle, un groupe imidazopyrimidinyle, les groupes -Si(Q₁)(Q₂)(Q₃), -N(Q₁)(Q₂), -B(Q₁)(Q₂), -C(=O)(Q₁), - S(=O)₂(Q₁), et -P(=O)(Q₁)(Q₂) ; et
un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe benzofluorényle, un groupe dibenzofluorényle, un groupe spiro-benzofluorène-fluorényle, un groupe indénofluorényle, un groupe phénalényle, un groupe phénanthrényle, un groupe anthracényle, un groupe fluoranthényle, un groupe triphénylényle, un groupe pyrényle, un groupe chrysényle, un groupe perylényle, un groupe pentaphényle, un groupe hexacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe thiadiazolyle, un groupe imidazopyridinyle, et un groupe imidazopyrimidinyle, chacun substitué par au moins un substituant choisi parmi un atome de deutérium, les groupes -F, -Cl, -Br, -I, un groupe hydroxy, un groupe cyano, un groupe nitro, un groupe amidino, un groupe hydrazino, un groupe hydrazono, un groupe C₁-C₁₀ alkyle, un groupe C₁-C₁₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₁-C₆₀ hétéroaryle, un groupe C6-C60 polycyclique condensé non aromatique monovalent, un groupe hétéropolycyclique de 6 à 60 chaînons condensé non aromatique monovalent, un groupe biphényle, un groupe terphényle, les groupes -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), et -P(=O)(Q₃₁)(Q₃₂),
R₂₁ à R₂₄, R₂₇ et R₂₈ sont chacun indépendamment choisis dans le groupe constitué par :
un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe benzofluorényle, un groupe dibenzofluorényle, un groupe spiro-benzofluorène-fluorényle, un groupe indénofluorényle, un groupe phénalényle, un groupe phénanthrényle, un groupe anthracényle, un groupe fluoranthényle, un groupe triphénylényle, un groupe pyrényle, un groupe chrysényle, un groupe picényle, un groupe perylényle, un groupe pentaphényle, un groupe hexacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe dibenzosilolyle, un groupe thiadiazolyle, un groupe imidazopyridinyle, un groupe imidazopyrimidinyle, les groupes - Si(Q₄)(Q₅)(Q₆), -N(Q₄)(Q₅), -B(Q₄)(Q₅), -C(=O)(Q₄), -S(=O)₂(Q₄) et -P(=O)(Q₄)(Q₅) ; et
un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe benzofluorényle, un groupe dibenzofluorényle, un groupe spiro-benzofluorène-fluorényle, un groupe indénofluorényle, un groupe phénalényle, un groupe phénanthrényle, un groupe anthracényle, un groupe fluoranthényle, un groupe triphénylényle, un groupe pyrényle, un groupe chrysényle, un groupe perylényle, un groupe pentaphényle, un groupe pentacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe dibenzosilolyle, un groupe thiadiazolyle, un groupe imidazopyridinyle, et un groupe imidazopyrimidinyle, chacun substitué par au moins un substituant choisi parmi un atome de deutérium, les groupes -F, -Cl, -Br, -I, un groupe hydroxy, un groupe cyano, un groupe nitro, un groupe amidino, un groupe hydrazino, un groupe hydrazono, un groupe C₁-C₁₀ alkyle, un groupe C₁-C₁₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₁-C₆₀ hétéroaryle, un groupe C6-C60 polycyclique condensé non aromatique monovalent, un groupe hétéropolycyclique de 6 à 60 chaînons condensé non aromatique monovalent, un groupe biphényle, un groupe terphényle, les groupes -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et - P(=O)(Q₃₁)(Q₃₂), et
R₂₂ à R₂₄, R₂₇, et R₂₈ sont chacun indépendamment choisis parmi les atomes d'hydrogène, de deutérium, les groupes -F, -Cl, -Br, -I, un groupe hydroxy, un groupe cyano, un groupe nitro, un groupe amidino, un groupe hydrazino, un groupe hydrazono, un groupe C₁-C₂₀ alkyle, un groupe C₁-C₂₀ alcoxy, les groupes -Si(Q₄)(Q₅)(Q₆), -S(=O)₂(Q₄) et -P(=O)(Q₄)(Q₅),
Q₁ à Q₆ et Q₃₁ à Q₃₃ étant chacun indépendamment choisis dans le groupe constitué par :
un groupe C₁-C₁₀ alkyle, un groupe C₁-C₁₀ alcoxy, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle, et un groupe quinazolinyle, chacun substitué par au moins un substituant choisi parmi un groupe C₁-C₁₀ alkyle, un groupe C₁-C₁₀ alcoxy et un groupe phényle.

10. Dispositif électroluminescent organique (11) selon l'une quelconque des revendications précédentes :
ledit premier composé étant représenté par une formule choisie parmi les formules 1E et les formules 1-1 à 1-6 : 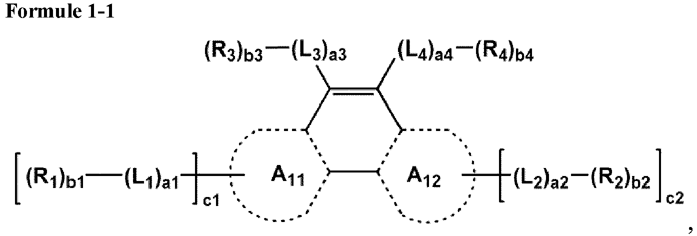 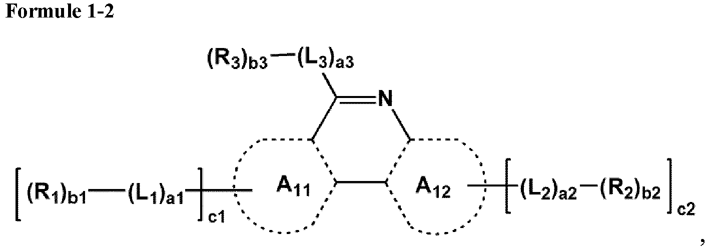 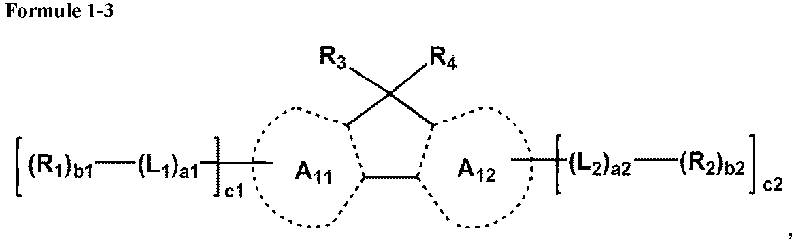 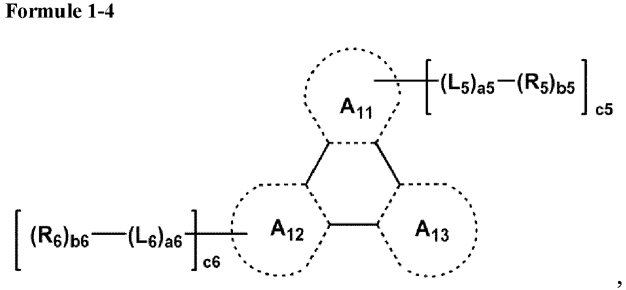 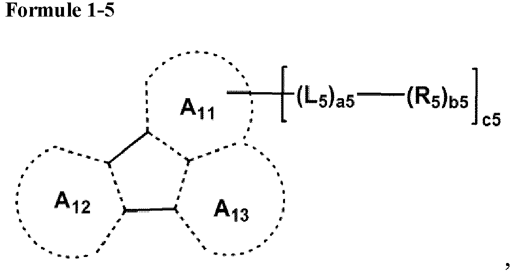 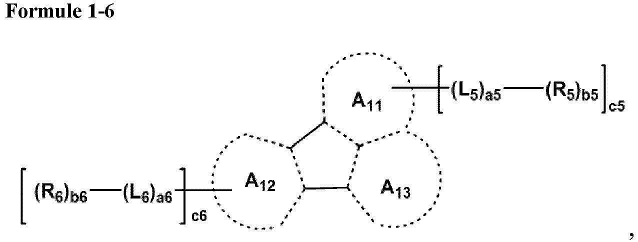
dans lesquelles la formule 1E est telle que définie selon l'une quelconque des revendications 1 et 6 à 9,
les noyaux A₁₁ à A₁₃, L₁ à L₆, a1 to a6, R₁ à R₆, et b1 à b6 dans les formules 1-1 à 1-6 sont tels que définis selon l'une quelconque des revendications 1, 2 et 6 à 9,
c1, c2 et c6 représentent chacun indépendamment un entier choisi parmi 0 à 10, et
c5 représente un entier choisi parmi 1 à 10.

11. Dispositif électroluminescent organique (11) selon l'une quelconque des revendications précédentes :
(a) ledit second composé comportant une énergie de triplet supérieure ou égale à 2,2 eV ; et/ou
(b) ladite couche d'émission comprenant un premier hôte et un second hôte, et ledit premier hôte comprenant le premier composé ; et/ou
(c) ladite zone de transport d'électrons comprenant un couche tampon, ladite couche tampon étant en contact direct avec la couche d'émission et ladite couche tampon comprenant le second composé.

12. Dispositif électroluminescent organique (11) selon l'une quelconque des revendications précédentes, ladite couche d'émission (155) comprenant un dopant, ledit dopant étant un complexe organométallique ; de préférence ledit complexe organométallique étant représenté par la formule 401 :
**Formule 401** M(L₄₀₁)_{xc1}(L₄₀₂)_{xc2},
dans laquelle L₄₀₁ est un ligand représenté par la formule 402 : 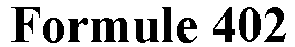 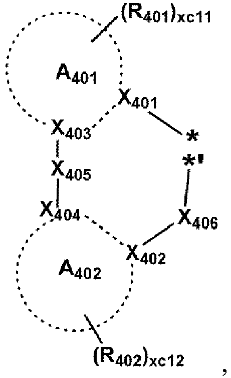
dans lesquelles, dans les formules 401 et 402,
M est choisi parmi l'iridium (Ir), le platine (Pt), le palladium (Pd), l'osmium (Os), le titane (Ti), le zirconium (Zr), le hafnium (Hf), l'europium (Eu), le terbium (Tb), le rhodium (Rh), et le thulium (Tm),
xc1 vaut 1, 2 ou 3, et lorsque xc1 est supérieur ou égal à deux, deux groupes L₄₀₁ ou plus sont identiques les uns aux autres ou différents les uns des autres,
L₄₀₂ représente un ligand organique, xc2 représente un entier choisi parmi 0 à 4, et lorsque xc2 est supérieur ou égal à deux, deux groupes L₄₀₂ ou plus sont identiques les uns aux autres ou différents les uns des autres,
X₄₀₁ à X₄₀₄ représentent chacun indépendamment un atome d'azote ou de carbone,
X₄₀₁ est lié à X₄₀₃ par une liaison simple ou une double liaison, et X₄₀₂ est lié à X₄₀₄ par une liaison simple ou une double liaison,
A₄₀₁ et A₄₀₂ représentent chacun indépendamment un groupe C₅-C₆₀ carbocyclique ou un groupe C₁-C₆₀ hétérocyclique,
X₄₀₅ représente une liaison simple, un groupe -O-, -S-, -C(=O)-, -N(Q₄₁₁)-, -C(Q₄₁₁)(Q₄₁₂)-, -C(Q₄₁₁)=C(Q₄₁₂)-, -C(Q₄₁₁)= ou =C(Q₄₁₁)=, et Q₄₁₁ et Q₄₁₂ représentent chacun indépendamment un atome d'hydrogène, de deutérium, un groupe C₁-C₂₀ alkyle, un groupe C₁-C₂₀ alcoxy, un groupe phényle, un groupe biphényle, un groupe terphényle, ou un groupe naphtyle,
X₄₀₆ représente une liaison simple, un atome O ou S, et
R₄₀₁ et R₄₀₂ sont chacun indépendamment choisis parmi les atomes d'hydrogène, de deutérium, -F, - Cl, -Br, -I, -CD₃, -CF₃, un groupe hydroxy, un groupe cyano, un groupe nitro, un groupe amidino, un groupe hydrazino, un groupe hydrazono, un groupe C₁-C₂₀ alkyle substitué ou non substitué, un groupe C₁-C₂₀ alcoxy substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe C6-C60 polycyclique condensé non aromatique monovalent substitué ou non substitué, et un groupe hétéropolycyclique de 6 à 60 chaînons condensé non aromatique monovalent substitué ou non substitué, les groupes - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁) et - P(=O)(Q₄₀₁)(Q₄₀₂), dans lesquels Q₄₀₁ à Q₄₀₃ sont chacun indépendamment choisis parmi un groupe C₁-C₁₀ alkyle, un groupe C₁-C₁₀ alcoxy, un groupe C₆-C₂₀ aryle, et un groupe C₁-C₂₀ hétéroaryle,
xc11 et xc12 représentent chacun indépendamment un entier choisi parmi 0 à 10, et
* et *' dans la formule 402 indiquent chacun indépendamment un site de liaison à M dans la formule 401.

13. Dispositif électroluminescent organique (11) selon l'une quelconque des revendications précédentes :
ladite zone de transport d'électrons comprenant une couche tampon (156), une couche de transport d'électrons (157), et une couche d'injection d'électrons (159), et
au moins une couche choisie parmi la couche de transport d'électrons (157) et la couche d'injection d'électrons (159) comprenant un métal alcalin, un métal alcalino-terreux, un métal de terre rare, un composé de métal alcalin, un composé de métal alcalino-terreux, un composé de métal de terre rare, un complexe de métal alcalin, un complexe de métal alcalino-terreux, un complexe de métal de terre rare, ou une combinaison de ceux-ci.

14. Dispositif électroluminescent organique (11) selon l'une quelconque des revendications précédentes :
ladite zone de transport de trous (151) comprenant un dopant p, et
ledit dopant p comportant une orbitale moléculaire inoccupée la plus basse (LUMO) inférieure ou égale à -3,5 eV ; de préférence ledit dopant p comprenant un composé contenant un groupe cyano.

15. Dispositif électroluminescent organique (11) selon l'une quelconque des revendications précédentes :
ladite couche d'émission (155) comprenant une couche d'émission émettant une première lumière de couleur,
ledit dispositif électroluminescent organique (11) comprenant en outre i) au moins une couche d'émission émettant une deuxième lumière de couleur, ou ii) au moins une couche d'émission émettant une deuxième lumière de couleur et au moins une couche d'émission émettant une troisième lumière de couleur, chacune entre la première électrode (110) et la seconde électrode (190),
la longueur d'onde d'émission maximale de la couche d'émission émettant la première lumière de couleur, la longueur d'onde d'émission maximale de la couche d'émission émettant la deuxième lumière de couleur, et la longueur d'onde d'émission maximale de la couche d'émission émettant la troisième lumière de couleur étant identiques les unes aux autres ou différentes les unes des autres, et
ledit dispositif électroluminescent organique (11) émettant une lumière mixte comprenant première lumière de couleur et une deuxième lumière de couleur, ou une lumière mixte comprenant la première lumière de couleur, la deuxième lumière de couleur et une troisième lumière de couleur.
